# EUROPEAN PATENT SPECIFICATION

(11) **EP 3 067 361 B1**
(45) Date of publication and mention of the grant of the patent: **20.11.2019**
(21) Application number: 16159735.6
(22) Date of filing: 10.03.2016
(51) Int. Cl.: C07F 15/00, C09K 11/06, H01L 51/50

(54) **ORGANOMETALLIC COMPOUND AND ORGANIC LIGHT-EMITTING DEVICE INCLUDING THE SAME**
ORGANOMETALLISCHE VERBINDUNG UND ORGANISCHE LICHTEMITTIERENDE VORRICHTUNG DAMIT
COMPOSÉ ORGANOMÉTALLIQUE ET DISPOSITIF ÉLECTROLUMINESCENT ORGANIQUE L'INCLUANT

(30) Priority: 13.03.2015 KR 20150035155
(43) Date of publication of application: 14.09.2016
(73) Proprietor: Samsung Electronics Co., Ltd., Gyeonggi-do 16677 (KR)
(72) Inventor: LEE, Jiyoun, Yeongtong-gu 16678 Gyeonggi-do (KR); KWAK, Yoonhyun, Yeongtong-gu 16678 Gyeonggi-do (KR); KWON, Ohyun, Yeongtong-gu 16678 Gyeonggi-do (KR); KIM, Sangdong, Yeongtong-gu 16678 Gyeonggi-do (KR); LEE, Banglin, Yeongtong-gu 16678 Gyeonggi-do (KR); CHOI, Byoungki, Yeongtong-gu 16678 Gyeonggi-do (KR)
(74) Representative: Elkington and Fife LLP

(56) References cited:
- WO-A1-2014/007565

## Description

### FIELD OF THE INVENTION

The present disclosure relates to relate to an organometallic compound and an organic light-emitting device including the same.

### BACKGROUND OF THE INVENTION

Organic light emitting devices (OLEDs) are self-emission devices that have wide viewing angles, high contrast ratios, and short response times. In addition, OLEDs have good brightness, driving voltage, and response speed characteristics, and produce full-color images.

In an example, an organic light-emitting device includes an anode, a cathode, and an organic layer that is disposed between the anode and the cathode, and further includes an emission layer. A hole transport region may be disposed between the anode and the emission layer, and an electron transport region may be disposed between the emission layer and the cathode. Holes provided from the anode may move toward the emission layer through the hole transport region, and electrons provided from the cathode may move toward the emission layer through the electron transport region. The holes and the electrons are recombined in the emission layer to produce excitons. These excitons change from an excited state to a ground state, thereby generating light.

Different types of organic light emitting devices are known. However, there still remains a need in OLEDs having low driving voltage, high efficiency, high brightness, and long lifespan.

WO 2014/007565 A1 relates to iridium complexes for an organic optoelectric device, an organic optoelectric device comprising same, and a display apparatus comprising the organic optoelectric device.

### SUMMARY OF THE INVENTION

Provided are a novel organometallic compound and an organic light-emitting device including the same.

Additional aspects will be set forth in part in the description which follows and, in part, will be apparent from the description, or may be learned by practice of the presented exemplary embodiments.

According to an aspect of an exemplary embodiment, there is provided an organometallic compound represented by Formula 1:

Formula 1 M(L₁)ₙ₁(L₂)ₙ₂

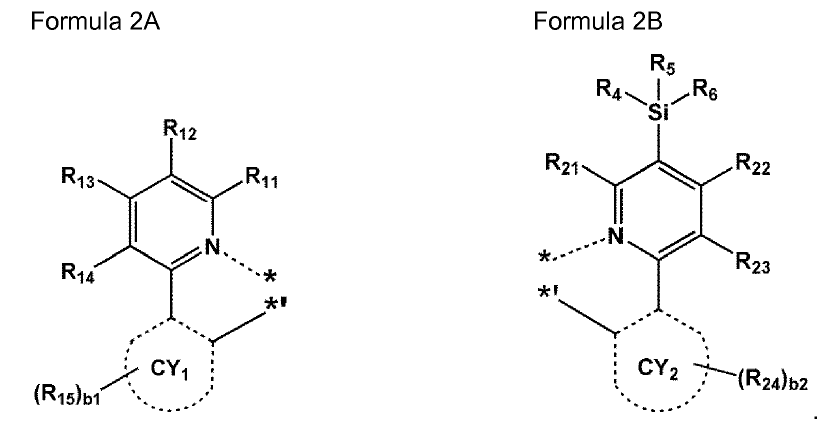

M in Formula 1 may be selected from iridium, platinum, osmium, titanium, zirconium, hafnium, europium, terbium, thulium, and rhodium,
in Formula 1, L₁ may be selected from ligands represented by Formula 2A, n1 may be 1 or 2, and when n1 is 2, two groups L₁ may be identical to or different from each other,
in Formula 1, L₂ may be selected from ligands represented by Formula 2B, n2 may be 1 or 2, and when n2 is 2, two groups L₂ may be identical to or different from each other,
in Formula 1, L₁ and L₂ may be different from each other, and the sum of n1 and n2 may be 2 or 3,
each of * and *' in Formulae 2A and 2B may indicate a binding site to M in Formula 1,
CY₁ and CY₂ in Formulae 2A and 2B may be each independently selected from a C₅-C₆₀ carbocyclic group and a C₁-C₆₀ heterocyclic group, provided that CY₂ is none of a dibenzofuran, a dibenzothiophene, a dibenzothiophene sulfone, a carbazole, and a dibenzosilole,
R₁₁ to R₁₅ in Formula 2A may be each independently selected from a hydrogen, a deuterium, -F, -CI, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₆ cycloalkyl group, a substituted or unsubstituted C₁-C₁₆ heterocycloalkyl group, a substituted or unsubstituted C₃-C₁₆ cycloalkenyl group, a substituted or unsubstituted C₁-C₁₆ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₇-C₆₀ arylalkyl group, a substituted or unsubstituted C₁-C₆₀ heteroaryl group, a substituted or unsubstituted C₁-C₆₀ heteroaryloxy group, a substituted or unsubstituted C₁-C₆₀ heteroarylthio group, a substituted or unsubstituted C₂-C₆₀ heteroarylalkyl group, a substituted or unsubstituted monovalent non-aromatic condensed polycyclic group, a substituted or unsubstituted monovalent non-aromatic condensed heteropolycyclic group, -Si(R₁)(R₂)(R₃), -N(Q₁)(Q₂), -B(Q₃)(Q₄), and - P(=O)(Q₅)(Q₆),
R₂₁ to R₂₄ in Formula 2B may be each independently selected from a hydrogen, a deuterium, -F, -CI, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₆ cycloalkyl group, a substituted or unsubstituted C₁-C₁₆ heterocycloalkyl group, a substituted or unsubstituted C₃-C₁₆ cycloalkenyl group, a substituted or unsubstituted C₁-C₁₆ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₇-C₆₀ arylalkyl group, a substituted or unsubstituted C₁-C₆₀ heteroaryl group, a substituted or unsubstituted C₁-C₆₀ heteroaryloxy group, a substituted or unsubstituted C₁-C₆₀ heteroarylthio group, a substituted or unsubstituted C₂-C₆₀ heteroarylalkyl group, a substituted or unsubstituted monovalent non-aromatic condensed polycyclic group, a substituted or unsubstituted monovalent non-aromatic condensed heteropolycyclic group, -N(Q₁)(Q₂), -B(Q₃)(Q₄), and -P(=O)(Q₅)(Q₆),
b1 and b2 in Formulae 2A and 2B may be each independently an integer selected from 0 to 4, provided that
i) one selected from R₁₁ to R₁₄ in Formula 2A or ii) one selected from R₁₅ in the number of b1 in Formula 2A, may be -Si(R₁)(R₂)(R₃),
at least one of R₂₁ to R₂₃ in Formula 2B may not be a hydrogen,
R₁ to R₃ in -Si(R₁)(R₂)(R₃) of Formula 2A and R₄ to R₆ in Formula 2B may be each independently selected from a hydrogen, a deuterium, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₆ cycloalkyl group, a substituted or unsubstituted C₁-C₁₆ heterocycloalkyl group, a substituted or unsubstituted C₃-C₁₆ cycloalkenyl group, a substituted or unsubstituted C₁-C₁₆ heterocycloalkenyl group, a substituted or unsubstituted C₆-C₆₀ aryl group, a substituted or unsubstituted C₆-C₆₀ aryloxy group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, and -Si(Q51)(Q52)(Q53), and
at least one of substituents of the substituted C₁-C₆₀ alkyl group, substituted C₂-C₆₀ alkenyl group, substituted C₂-C₆₀ alkynyl group, substituted C₁-C₆₀ alkoxy group, substituted C₃-C₁₆ cycloalkyl group, substituted C₁-C₁₆ heterocycloalkyl group, substituted C₃-C₁₆ cycloalkenyl group, substituted C₁-C₁₆ heterocycloalkenyl group, substituted C₆-C₆₀ aryl group, substituted C₆-C₆₀ aryloxy group, substituted C₆-C₆₀ arylthio group, a substituted C₇-C₆₀ arylalkyl group, substituted C₁-C₆₀ heteroaryl group, a substituted C₁-C₆₀ heteroaryloxy group, a substituted C₁-C₆₀ heteroarylthio group, a substituted C₂-C₆₀ heteroarylalkyl group, substituted monovalent non-aromatic condensed polycyclic group, and substituted monovalent non-aromatic condensed heteropolycyclic group may be selected from :
   a deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, and a C₁-C₆₀ alkoxy group;
   a C₁-C₆₀ alkyl group, a C₂-C₆₀ alkenyl group, a C₂-C₆₀ alkynyl group, and a C₁-C₆₀ alkoxy group, each substituted with at least one of a deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₆ cycloalkyl group, a C₁-C₁₆ heterocycloalkyl group, a C₃-C₁₆ cycloalkenyl group, a C₁-C₁₆ heterocycloalkenyl group, a C₆-C₆₀ aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, a monovalent non-aromatic condensed heteropolycyclic group, -N(Q₁₁)(Q₁₂), -B(Q₁₃)(Q₁₄), and -P(=O)(Q₁₅)(Q₁₆);
   a C₃-C₁₆ cycloalkyl group, a C₁-C₁₆ heterocycloalkyl group, a C₃-C₁₆ cycloalkenyl group, a C₁-C₁₆ heterocycloalkenyl group, a C₆-C₆₀ aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, and a monovalent non-aromatic condensed heteropolycyclic group;
   a C₃-C₁₆ cycloalkyl group, a C₁-C₁₆ heterocycloalkyl group, a C₃-C₁₆ cycloalkenyl group, a C₁-C₁₆ heterocycloalkenyl group, a C₆-C₆₀ aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, and a monovalent non-aromatic condensed heteropolycyclic group, each substituted with at least one of a deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₆ cycloalkyl group, a C₁-C₁₆ heterocycloalkyl group, a C₃-C₁₆ cycloalkenyl group, a C₁-C₁₆ heterocycloalkenyl group, a C₆-C₆₀ aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, a monovalent non-aromatic condensed heteropolycyclic group, -N(Q₂₁)(Q₂₂), - B(Q₂₃)(Q₂₄), and -P(=O)(Q₂₅)(Q₂₆); and
   -N(Q₃₁)(Q₃₂), -B(Q₃₃)(Q₃₄), and -P(=O)(Q₃₅)(Q₃₆),
wherein Q₁ to Q₆, Q₁₁ to Q₁₆, Q₂₁ to Q₂₆, Q₃₁ to Q₃₆ and Q₅₁ to Q₅₃ may be each independently selected from a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₆ heterocycloalkyl group, a substituted or unsubstituted C₃-C₁₀ cycloalkenyl group, a substituted or unsubstituted C₁-C₁₆ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₇-C₆₀ arylalkyl group, a substituted or unsubstituted C₁-C₆₀ heteroaryl group, a substituted or unsubstituted C₁-C₆₀ heteroaryloxy group, a substituted or unsubstituted C₁-C₆₀ heteroarylthio group, a substituted or unsubstituted C₂-C₆₀ heteroarylalkyl group, a substituted or unsubstituted monovalent non-aromatic condensed polycyclic group, and a substituted or unsubstituted monovalent non-aromatic condensed heteropolycyclic group.

According to an aspect of another exemplary embodiment, an organic light-emitting device includes:
a first electrode,
a second electrode, and
an organic layer disposed between the first electrode and the second electrode,
wherein the organic layer includes an emission layer and at least one organometallic compound represented by Formula 1.

The emission layer may include the organometallic compound represented by Formula 1.

### BRIEF DESCRIPTION OF THE DRAWINGS

These and/or other aspects will become apparent and more readily appreciated from the following description of the exemplary embodiments, taken in conjunction with the accompanying drawings in which:

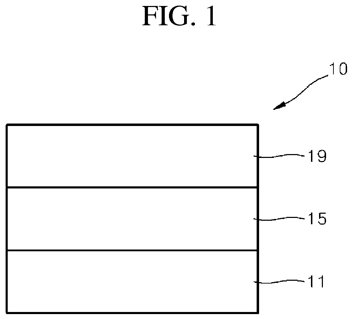

FIG. 1 is a schematic cross-sectional view of an organic light-emitting device according to an embodiment.

### DETAILED DESCRIPTION OF THE EMBODIMENTS

Reference will now be made in detail to exemplary embodiments, examples of which are illustrated in the accompanying drawings, wherein like reference numerals refer to like elements throughout. In this regard, the present exemplary embodiments may have different forms and should not be construed as being limited to the descriptions set forth herein. Accordingly, the exemplary embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

It will be understood that when an element is referred to as being "on" another element, it can be directly in contact with the other element or intervening elements may be present therebetween. In contrast, when an element is referred to as being "directly on" another element, there are no intervening elements present.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

The terminology used herein is for the purpose of describing particular embodiments only and is not intended to be limiting. As used herein, the singular forms "a," "an," and "the" are intended to include the plural forms as well, unless the context clearly indicates otherwise.

The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

An organometallic compound according to an embodiment is represented by Formula 1 below:

Formula 1 M(L₁)ₙ₁(L₂)ₙ₂

M in Formula 1 may be selected from iridium (Ir), platinum (Pt), osmium (Os), titanium (Ti), zirconium (Zr), hafnium (Hf), europium (Eu), terbium (Tb), thulium (Tm), and rhodium (Rh).

For example, M in Formula 1 may be selected from iridium (Ir), platinum (Pt), osmium (Os), and rhodium (Rh).

In some embodiments, M in Formula 1 may be iridium (Ir) or platinum (Pt), but is not limited thereto.

In Formula 1, L₁ may be selected from ligands represented by Formula 2A, n1 may be 1 or 2, and when n1 is 2, two groups L₁ may be identical to or different from each other. In Formula 1, L₂ may be selected from ligands represented by Formula 2B, n2 may be 1 or 2, and when n2 is 2, two groups L₂ may be identical to or different from each other.

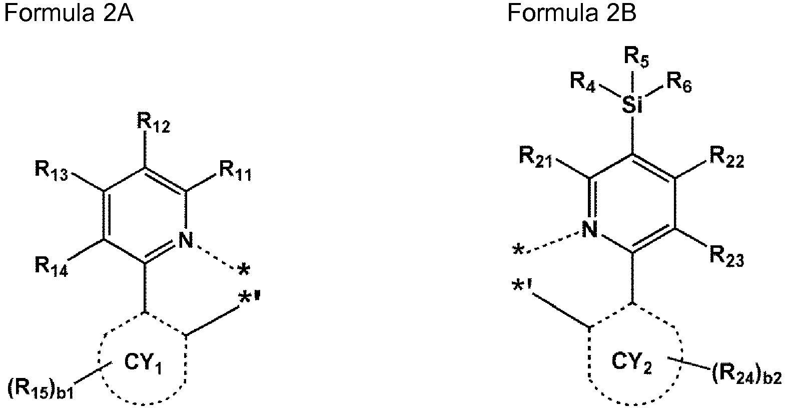

Formulae 2A and 2B may be understood by referring to the following description.

In Formula 1, L₁ and L₂ may be different from each other, and the sum of n1 and n2 may be 2 or 3.

Each of * and *' in Formulae 2A and 2B may indicate a binding site to M in Formula 1.

In some embodiments, M in Formula 1 may be Ir, and the sum of n1 and n2 may be 3; or M may be Pt, and the sum of n1 and n2 may be 2.

In some embodiments, the organometallic compound represented by Formula 1 may not be a salt consisting of an ion pair but may be a neutral compound, for example, a complex in which the metal atom and the ligand are coordination bond or a covalent bond. In other, words, in some embodiments, the interaction between the metal and the ligand in the organometallic compound represented by Formula 1 may not be purely electrostatic.

CY₁ and CY₂ in Formulae 2A and 2B may be each independently selected from a C₅-C₆₀ carbocyclic group and a C₁-C₆₀ heterocyclic group, provided that CY₂ is none of a dibenzofuran, a dibenzothiophene, a dibenzothiophene sulfone, a carbazole, and a dibenzosilole.

For example, CY₁ in Formula 2A may be selected from a benzene, an indene, a naphthalene, an azulene, a heptalene, an indacene, an acenaphthylene, a fluorene, a spiro-fluorene, a benzofluorene, a dibenzofluorene, a phenalene, a phenanthrene, an anthracene, a fluoranthene, a triphenylene, a pyrene, a chrysene, a naphthacene, a picene, a perylene, a pentacene, a hexacene, a pentaphene, a rubicene, a coronene, an ovalene, an isoindole, an indole, an indazole, a purine, a quinoline, an isoquinoline, a benzoquinoline, a phthalazine, a naphthyridine, a quinoxaline, a quinazoline, a cinnoline, a phenanthridine, an acridine, a phenanthroline, a phenazine, a benzoimidazole, a benzofuran, a benzothiophene, an isobenzothiazole, a benzoxazole, an isobenzoxazole, a benzocarbazole, a dibenzocarbazole, an imidazopyridine, an imidazopyrimidine, a dibenzofuran, a dibenzothiophene, a dibenzothiophene sulfone, a carbazole, and a dibenzosilole, and CY₂ in Formula 2B may be selected from a benzene, an indene, a naphthalene, an azulene, a heptalene, an indacene, an acenaphthylene, a fluorene, a spiro-fluorene, a benzofluorene, a dibenzofluorene, a phenalene, a phenanthrene, an anthracene, a fluoranthene, a triphenylene, a pyrene, a chrysene, a naphthacene, a picene, a perylene, a pentacene, a hexacene, a pentaphene, a rubicene, a coronene, an ovalene, an isoindole, an indole, an indazole, a purine, a quinoline, an isoquinoline, a benzoquinoline, a phthalazine, a naphthyridine, a quinoxaline, a quinazoline, a cinnoline, a phenanthridine, an acridine, a phenanthroline, a phenazine, a benzoimidazole, a benzofuran, a benzothiophene, an isobenzothiazole, a benzoxazole, an isobenzoxazole, a benzocarbazole, a dibenzocarbazole, an imidazopyridine, and an imidazopyrimidine.

In some embodiments, CY₁ in Formula 2A may be selected from a benzene, a naphthalene, a fluorene, a phenalene, a phenanthrene, an anthracene, a triphenylene, a pyrene, a chrysene, a benzofuran, a benzothiophene, a a dibenzothiophene, a dibenzothiophene sulfone, a carbazole, and a dibenzosilole, and
CY₂ in Formula 2B may be selected from a benzene, a naphthalene, a fluorene, a phenalene, a phenanthrene, an anthracene, a triphenylene, a pyrene, and a chrysene.

In some embodiments, CY₁ in Formula 2A may be selected from a benzene, a naphthalene, a fluorene, a dibenzofuran, a dibenzothiophene, a dibenzothiophene sulfone, a carbazole, and a dibenzosilole, and
CY₂ in Formula 2B may be a benzene.

In some embodiments, CY₁ and CY₂ in Formulae 2A and 2B may simultaneously be a benzene, but are not limited thereto.

R₁₁ to R₁₅ in Formula 2A may be each independently selected from a hydrogen, a deuterium, -F, -CI, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₆ cycloalkyl group, a substituted or unsubstituted C₁-C₁₆ heterocycloalkyl group, a substituted or unsubstituted C₃-C₁₆ cycloalkenyl group, a substituted or unsubstituted C₁-C₁₆ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₇-C₆₀ arylalkyl group, a substituted or unsubstituted C₁-C₆₀ heteroaryl group, a substituted or unsubstituted C₁-C₆₀ heteroaryloxy group, a substituted or unsubstituted C₁-C₆₀ heteroarylthio group, a substituted or unsubstituted C₂-C₆₀ heteroarylalkyl group, a substituted or unsubstituted monovalent non-aromatic condensed polycyclic group, a substituted or unsubstituted monovalent non-aromatic condensed heteropolycyclic group, -Si(R₁)(R₂)(R₃), -N(Q₁)(Q₂), -B(Q₃)(Q₄), and - P(=O)(Q₅)(Q₆), and
R₂₁ to R₂₄ in Formula 2B may be each independently selected from a hydrogen, a deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₆ cycloalkyl group, a substituted or unsubstituted C₁-C₁₆ heterocycloalkyl group, a substituted or unsubstituted C₃-C₁₆ cycloalkenyl group, a substituted or unsubstituted C₁-C₁₆ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₇-C₆₀ arylalkyl group, a substituted or unsubstituted C₁-C₆₀ heteroaryl group, a substituted or unsubstituted C₁-C₆₀ heteroaryloxy group, a substituted or unsubstituted C₁-C₆₀ heteroarylthio group, a substituted or unsubstituted C₂-C₆₀ heteroarylalkyl group, a substituted or unsubstituted monovalent non-aromatic condensed polycyclic group, a substituted or unsubstituted monovalent non-aromatic condensed heteropolycyclic group, -N(Q₁)(Q₂), -B(Q₃)(Q₄), and -P(=O)(Q₅)(Q₆).

For example, R₁₁ to R₁₅ in Formula 2A may be each independently selected from
a hydrogen, a deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, and a C1-C₂₀ alkoxy group;
a C₁-C₂₀ alkyl group and a C₁-C₂₀ alkoxy group, each substituted with at least one selected from a deuterium, -F, -Cl, -Br, -I, -CD₃, -CD₂H, -CDH₂, -CF₃, -CF₂H,-CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₆ alkyl group, a C₁-C₁₆ alkoxy group, a C₃-C₁₆ cycloalkyl group, a C₁-C₁₀ heterocycloalkyl group, a C₃-C₁₆ cycloalkenyl group, a C₁-C₁₆ heterocycloalkenyl group, a C₆-C₁₄ aryl group, a C₁-C₁₄ heteroaryl group, a monovalent non-aromatic condensed polycyclic group, and a monovalent non-aromatic condensed heteropolycyclic group;
a C₃-C₁₆ cycloalkyl group, a C₁-C₁₆ heterocycloalkyl group, a C₃-C₁₆ cycloalkenyl group, a C₁-C₁₆ heterocycloalkenyl group, a C₆-C₁₄ aryl group, a C₁-C₁₄ heteroaryl group, a monovalent non-aromatic condensed polycyclic group, and a monovalent non-aromatic condensed heteropolycyclic group;
a C₃-C₁₆ cycloalkyl group, a C₁-C₁₆ heterocycloalkyl group, a C₃-C₁₆ cycloalkenyl group, a C₁-C₁₆ heterocycloalkenyl group, a C₆-C₁₄ aryl group, a C₁-C₁₄ heteroaryl group, a monovalent non-aromatic condensed polycyclic group, and a monovalent non-aromatic condensed heteropolycyclic group, each substituted with at least one selected from a deuterium, -F, -CI, -Br, -I, -CD₃, -CD₂H, -CDH₂, -CF₃, - CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₃-C₁₆ cycloalkyl group, a C₁-C₁₀ heterocycloalkyl group, a C₃-C₁₆ cycloalkenyl group, a C₁-C₁₆ heterocycloalkenyl group, a C₆-C₁₄ aryl group, a C₁-C₁₄ heteroaryl group, a monovalent non-aromatic condensed polycyclic group, and a monovalent non-aromatic condensed heteropolycyclic group; and
-Si(R₁)(R₂)(R₃), -N(Q₁)(Q₂), -B(Q₃)(Q₄), and -P(=O)(Q₅)(Q₆), and
R₂₁ to R₂₄ in Formula 2B may be each independently selected from
a hydrogen, a deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, and a C₁-C₂₀ alkoxy group;
a C₁-C₂₀ alkyl group and a C₁-C₂₀ alkoxy group, each substituted with at least one selected from a deuterium, -F, -Cl, -Br, -I, -CD₃, -CD₂H, -CDH₂, -CF₃, -CF₂H,-CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₆ alkyl group, a C₁-C₁₆ alkoxy group, a C₃-C₁₆ cycloalkyl group, a C₁-C₁₀ heterocycloalkyl group, a C₃-C₁₆ cycloalkenyl group, a C₁-C₁₆ heterocycloalkenyl group, a C₆-C₁₄ aryl group, a C₁-C₁₄ heteroaryl group, a monovalent non-aromatic condensed polycyclic group, and a monovalent non-aromatic condensed heteropolycyclic group;
a C₃-C₁₆ cycloalkyl group, a C₁-C₁₆ heterocycloalkyl group, a C₃-C₁₆ cycloalkenyl group, a C₁-C₁₆ heterocycloalkenyl group, a C₆-C₁₄ aryl group, a C₁-C₁₄ heteroaryl group, a monovalent non-aromatic condensed polycyclic group, and a monovalent non-aromatic condensed heteropolycyclic group;
a C₃-C₁₆ cycloalkyl group, a C₁-C₁₆ heterocycloalkyl group, a C₃-C₁₆ cycloalkenyl group, a C₁-C₁₆ heterocycloalkenyl group, a C₆-C₁₄ aryl group, a C₁-C₁₄ heteroaryl group, a monovalent non-aromatic condensed polycyclic group, and a monovalent non-aromatic condensed heteropolycyclic group, each substituted with at least one selected from a deuterium, -F, -Cl, -Br, -I, -CD₃, -CD₂H, -CDH₂, -CF₃,-CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₃-C₁₆ cycloalkyl group, a C₁-C₁₀ heterocycloalkyl group, a C₃-C₁₆ cycloalkenyl group, a C₁-C₁₆ heterocycloalkenyl group, a C₆-C₁₄ aryl group, a C₁-C₁₄ heteroaryl group, a monovalent non-aromatic condensed polycyclic group, and a monovalent non-aromatic condensed heteropolycyclic group; and
-N(Q₁)(Q₂), -B(Q₃)(Q₄), and -P(=O)(Q₅)(Q₆),
wherein Q₁ to Q₆ may be each independently selected from a substituted or unsubstituted C₁-C₂₀ alkyl group, a substituted or unsubstituted C₁-C₂₀ alkoxy group, a substituted or unsubstituted C₃-C₁₆ cycloalkyl group, a substituted or unsubstituted C₁-C₁₆ heterocycloalkyl group, a substituted or unsubstituted C₃-C₁₆ cycloalkenyl group, a substituted or unsubstituted C₁-C₁₆ heterocycloalkenyl group, a substituted or unsubstituted C₆-C₁₄ aryl group, a substituted or unsubstituted C₁-C₁₄ heteroaryl group, a substituted or unsubstituted monovalent non-aromatic condensed polycyclic group, and a substituted or unsubstituted monovalent non-aromatic condensed heteropolycyclic group.

In some embodiments, R₁₁ to R₁₅ in Formula 2A may be each independently selected from
a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt a phosphoric acid group or a salt thereof, -SF₅, a C₁-C₂₀ alkyl group, and a C₁-C₂₀ alkoxy group;
a C₁-C₂₀ alkyl group and a C₁-C₂₀ alkoxy group, each substituted with at least one selected from a deuterium, -F, -Cl, -Br, -I, -CD₃, -CD₂H, -CDH₂, -CF₃, -CF₂H,-CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₆ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, and a pyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group, each substituted with at least one selected from a deuterium, -F, -Cl, -Br, -I, -CD₃, -CD₂H, -CDH₂,--CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group; and
-Si(R₁)(R₂)(R₃), -B(Q₃)(Q₄), and -P(=O)(Q₅)(Q₆), and
R₂₁ to R₂₄ in Formula 2B may be each independently selected from
a hydrogen, a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a C₁-C₂₀ alkyl group, and a C₁-C₂₀ alkoxy group;
a C₁-C₂₀ alkyl group and a C₁-C₂₀ alkoxy group, each substituted with at least one selected from a deuterium, -F, -Cl, -Br, -I, -CD₃, -CD₂H, -CDH₂, -CF₃, -CF₂H,-CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₆ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, and a pyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group, each substituted with at least one selected from a deuterium, -F, -Cl, -Br, -I, -CD₃, -CD₂H, -CDH₂,--CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group; and
-B(Q₃)(Q₄) and -P(=O)(Q₅)(Q₆),
wherein Q₃ to Q₆ may be each independently selected from
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₆ alkyl group, and a phenyl group.

In some embodiments, R₁₁ to R₁₅ in Formula 2A may be each independently selected from
a hydrogen, a deuterium, -F, a cyano group, a nitro group, -SF₅, a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzofuranyl group, and a dibenzothiophenyl group;
a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzofuranyl group, and a dibenzothiophenyl group, each substituted with at least one selected from a deuterium, -F, -CD₃, -CD₂H, -CDH₂, -CF₃, -CF₂H, -CFH₂, a cyano group, a nitro group, a C₁-C₁₆ alkyl group, a C₁-C₁₆ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzofuranyl group, and a dibenzothiophenyl group; and
-Si(R₁)(R₂)(R₃), -B(Q₃)(Q₄), and -P(=O)(Q₅)(Q₆), and
R₂₁ to R₂₄ in Formula 2B may be each independently selected from
a hydrogen, a deuterium, -F, a cyano group, a nitro group, -SF₅, a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzofuranyl group, and a dibenzothiophenyl group;
a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzofuranyl group, and a dibenzothiophenyl group, each substituted with at least one selected from a deuterium, -F, -CD₃, -CD₂H, -CDH₂, -CF₃, -CF₂H, -CFH₂, a cyano group, a nitro group, a C₁-C₁₆ alkyl group, a C₁-C₁₆ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzofuranyl group, and a dibenzothiophenyl group; and
-B(Q₃)(Q₄) and -P(=O)(Q₅)(Q₆),
wherein Q₃ to Q₆ may be each independently selected from
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₆ alkyl group, and a phenyl group.

In some embodiments, R₁₁ to R₁₅ in Formula 2A may be each independently selected from a hydrogen, a deuterium, -F, a cyano group, a nitro group, -SF₅, -CH₃, -CD₃, -CD₂H, -CDH₂, -CF₃, -CF₂H, -CFH₂, groups represented by Formulae 9-1 to 9-19 below, groups represented by Formulae 10-1 to 10-36 below, and -Si(R₁)(R₂)(R₃), and
R₂₁ to R₂₄ in Formula 2B may be each independently selected from a hydrogen, a deuterium, -F, a cyano group, a nitro group, -SF₅, -CH₃, -CD₃, -CD₂H, -CDH₂, -CF₃, - CF₂H, -CFH₂, groups represented by Formulae 9-1 to 9-19 below, and groups represented by Formulae 10-1 to 10-36 below. However, one or more embodiments are not limited thereto:

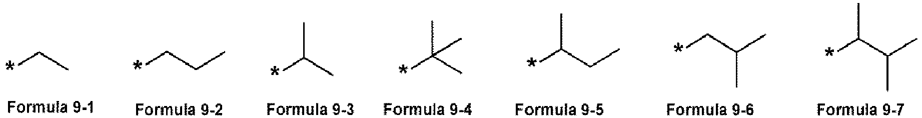

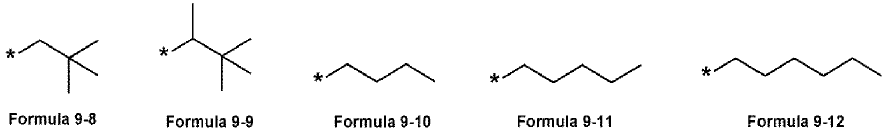

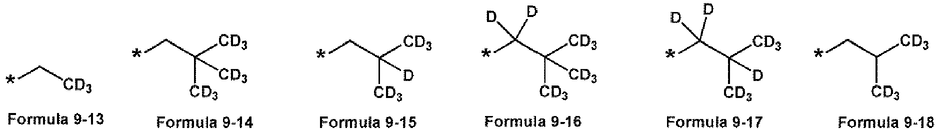

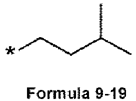

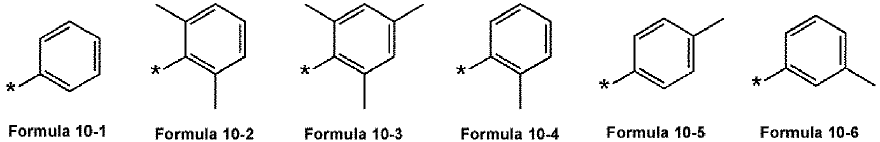

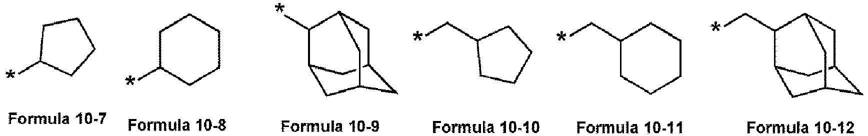

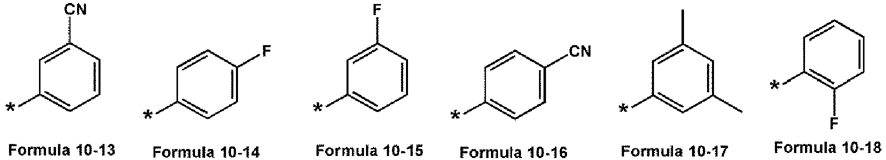

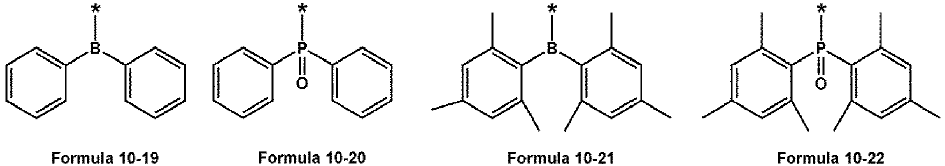

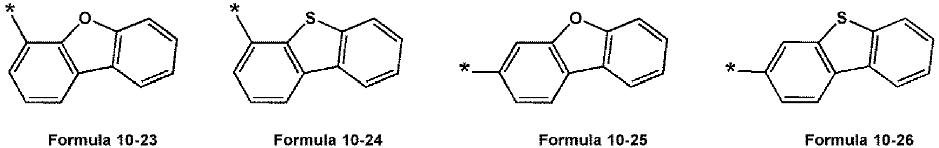

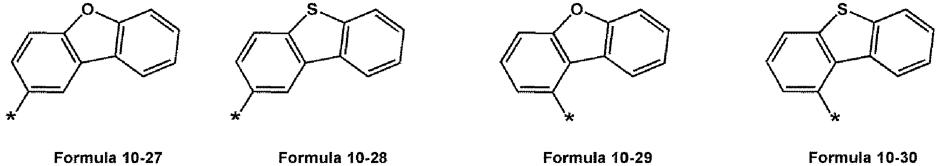

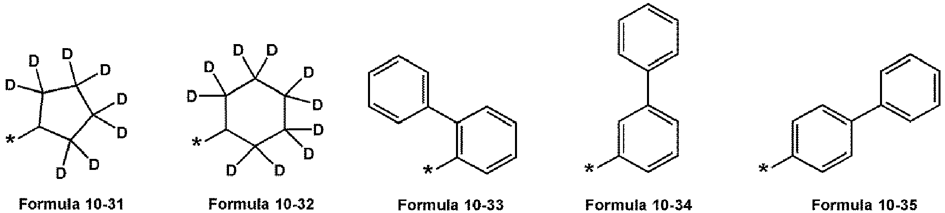

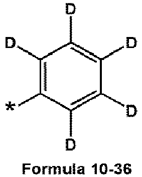

* in Formulae in 9-1 to 9-19 and 10-1 to 10-36 may indicate a binding site to a neighboring atom.

b1 and b2 in Formulae 2A and 2B may be each independently an integer selected from 0 to 4. b1 may be the number of R₁₅ in Formula 2A, and when b1 is 2 or greater, two or more groups R₁₅ may be identical to or different from each other. b2 may be the number of R₂₄ in Formula 2B, and when b2 is 2 or greater, two or more groups R₂₄ may be identical to or different from each other.
i) one selected from R₁₁ to R₁₄ in Formula 2A or ii) one selected from R₁₅ in the number of b1 in Formula 2A, may be -Si(R₁)(R₂)(R₃). That is, Ligand L₁ represented by Formula 2A essentially has one substituent represented by - Si(R₁)(R₂)(R₃).

Meanwhile, at least one selected from R₂₁ to R₂₃ in Formula 2B may not be a hydrogen. That is, a case in which all of R₂₁ to R₂₃ in Formula 2B are simultaneously a hydrogen is excluded.

In some embodiments, R₂₂ in Formula 2B may not be a hydrogen.

In some embodiments, R₂₂ in Formula 2B may be neither a hydrogen nor a methyl group.

In some embodiments, R₂₂ in Formula 2B may be selected from
a deuterium, -F, a cyano group, a nitro group, -SF₅, a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzofuranyl group, and a dibenzothiophenyl group;
a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzofuranyl group, and a dibenzothiophenyl group, each substituted with at least one selected from a deuterium, -F, -CD₃, -CD₂H, -CDH₂, -CF₃, -CF₂H, -CFH₂, a cyano group, a nitro group, a C₁-C₁₆ alkyl group, a C₁-C₁₆ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzofuranyl group, and a dibenzothiophenyl group; and
-B(Q₃)(Q₄) and -P(=O)(Q₅)(Q₆),
wherein Q₃ to Q₆ may be each independently selected from
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₆ alkyl group, and a phenyl group.

In some embodiments, R₂₂ in Formula 2B may be selected from a deuterium, -F, a cyano group, a nitro group, -SF₅, -CH₃, -CD₃, -CD₂H, -CDH₂, -CF₃, -CF₂H, - CFH₂, groups represented by Formulae 9-1 to 9-19, and groups represented by Formulae 10-1 to 10-36 (for example, -CD₃, -CD₂H, -CDH₂, -CF₃, -CF₂H, -CFH₂, groups represented by Formulae 9-1 to 9-19, and groups represented by Formulae 10-1 to 10-36), but is not limited thereto.

R₁ to R₃ in -Si(R₁)(R₂)(R₃) of Formula 2A and R₄ to R₆ in Formula 2B may be each independently selected from a hydrogen, a deuterium, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₆ heterocycloalkyl group, a substituted or unsubstituted C₃-C₁₀ cycloalkenyl group, a substituted or unsubstituted C₁-C₁₆ heterocycloalkenyl group, a substituted or unsubstituted C₆-C₆₀ aryl group, a substituted or unsubstituted C₆-C₆₀ aryloxy group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, and -Si(Q₅₁)(Q₅₂)(Q₅₃).

For example, R₁ to R₃ in -Si(R₁)(R₂)(R₃) of Formula 2A and R₄ to R₆ in Formula 2B may be each independently selected from
a hydrogen, a deuterium, a C₁-C₂₀ alkyl group, a C₁-C₂₀ alkoxy group, and - Si(Q₅₁)(Q₅₂)(Q₅₃);
a C₁-C₂₀ alkyl group and a C₁-C₂₀ alkoxy group, each substituted with at least one selected from a deuterium, -F, -Cl, -Br, -I, -CD₃, -CD₂H, -CDH₂, -CF₃, -CF₂H,-CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₆ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, and a pyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group; and
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group, each substituted with at least one selected from a deuterium, -F, -Cl, -Br, -I, -CD₃, -CD₂H, -CDH₂,--CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group,
wherein Q₅₁ to Q₅₃ may be each independently selected from
a hydrogen, a deuterium, -CH₃, -CD₃, -CD₂H, -CDH₂, -CH₂CH₃, -CH₂CD₃, - CH₂CD₂H, -CH₂CDH₂, -CHDCH₃, -CHDCD₂H, -CHDCDH₂, -CHDCD₃, -CD₂CD₃, - CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₆ alkyl group, and a phenyl group.

In some embodiments, R₁ to R₃ in -Si(R₁)(R₂)(R₃) of Formula 2A and R₄ to R₆ in Formula 2B may be each independently selected from
a hydrogen, a deuterium, -CH₃, -CD₃, -CD₂H, -CDH₂, -CH₂CH₃, -CH₂CD₃, - CH₂CD₂H, -CH₂CDH₂, -CHDCH₃, -CHDCD₂H, -CHDCDH₂, -CHDCD₃, -CD₂CD₃, - CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, and - Si(Q₅₁)(Q₅₂)(Q₅₃); and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group and, a naphthyl group, each substituted with at least one selected from a deuterium, a C₁-C₁₆ alkyl group, and a phenyl group,
wherein Q₅₁ to Q₅₃ may be each independently selected from
a hydrogen, a deuterium, -CH₃, -CD₃, -CD₂H, -CDH₂, -CH₂CH₃, -CH₂CD₃, - CH₂CD₂H, -CH₂CDH₂, -CHDCH₃, -CHDCD₂H, -CHDCDH₂, -CHDCD₃, -CD₂CD₃, - CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₆ alkyl group, and a phenyl group.

In some embodiments, R₁ to R₃ in -Si(R₁)(R₂)(R₃) of Formula 2A and R₄ to R₆ in Formula 2B may be each independently selected from
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₆ alkyl group, and a phenyl group, but are not limited thereto.

In some embodiments, R₁ to R₃ in -Si(R₁)(R₂)(R₃) of Formula 2A and R₄ to R₆ in Formula 2B may be each independently selected from -CH₃, -CD₃, -CD₂H, -CDH₂, groups represented by Formulae 9-1 to 9-19, and groups represented by Formulae 10-1 to 10-18, but are not limited thereto.

Meanwhile, in -Si(R₁)(R₂)(R₃) of Formula 2A,
all of R₁ to R₃ may simultaneously be the same; or
R₁ and R₃ may be identical to each other, and R₂ may be different from R₁, and
in Formula 2B,
all of R₄ to R₆ may simultaneously be the same; or
R₄ and R₆ may be identical to each other, and R₅ may be different from R₄.

In some embodiments,
R₁ to R₃ in -Si(R₁)(R₂)(R₃) of Formula 2A and R₄ to R₆ in Formula 2B may be each independently selected from -CH₃, -CD₃, -CD₂H, -CDH₂, and a phenyl group,
in -Si(R₁)(R₂)(R₃) of Formula 2A,
all of R₁ to R₃ may simultaneously be the same; or
R₁ and R₃ may be identical to each other, and R₂ may be different from R₁, and
in Formula 2B,
all of R₄ to R₆ may simultaneously be the same; or
R₄ and R₆ may be identical to each other, and R₅ may be different from R₄. In some embodiments, L₁ in Formula 1 may be selected from ligands represented by Formulae 2A-1 to 2A-5 below:

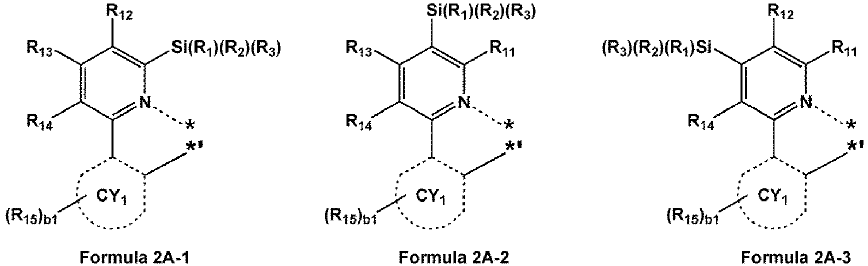

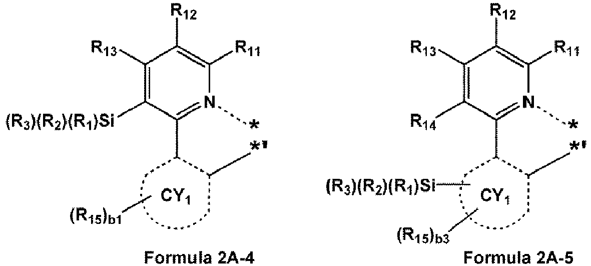

In Formulae 2A-1 to 2A-5, CY₁, R₁₁ to R₁₅, b1, and R₁ to R₃ may be understood by referring to the description provided herein, each of * and *' may indicate a binding site to M in Formula 1, and b3 may be an integer selected from 0 to 3.

In some embodiments, L₁ in Formula 1 may be selected from ligands represented by Formulae 2A-2 and 2A-5.

For example, in Formulae 2A-1 to 2A-5,
CY₁ may be selected from a benzene, a naphthalene, a fluorene, a phenalene, a phenanthrene, an anthracene, a triphenylene, a pyrene, a chrysene, a benzofuran, a benzothiophene, a dibenzofuran, a dibenzothiophene, a dibenzothiophene sulfone, a carbazole, and a dibenzosilole,
R₁₁ to R₁₅ may be each independently selected from
a hydrogen, a deuterium, -F, a cyano group, a nitro group, -SF₅, a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzofuranyl group, and a dibenzothiophenyl group;
a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzofuranyl group, and a dibenzothiophenyl group, each substituted with at least one selected from a deuterium, -F, -CD₃, -CD₂H, -CDH₂, -CF₃, -CF₂H, -CFH₂, a cyano group, a nitro group, a C₁-C₁₆ alkyl group, a C₁-C₁₆ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzofuranyl group, and a dibenzothiophenyl group; and
-B(Q₃)(Q₄) and -P(=O)(Q₅)(Q₆),
wherein Q₃ to Q₆ may be each independently selected from
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₆ alkyl group, and a phenyl group,
b1 and b3 may be each independently an integer selected from 0 to 3,
R₁ to R₃ may be each independently selected from
a hydrogen, a deuterium, -CH₃, -CD₃, -CD₂H, -CDH₂, -CH₂CH₃, -CH₂CD₃, - CH₂CD₂H, -CH₂CDH₂, -CHDCH₃, -CHDCD₂H, -CHDCDH₂, -CHDCD₃, -CD₂CD₃, - CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, and - Si(Q₅₁)(Q₅₂)(Q₅₃); and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₆ alkyl group, and a phenyl group,
wherein Q₅₁ to Q₅₃ may be each independently selected from
a hydrogen, a deuterium, -CH₃, -CD₃, -CD₂H, -CDH₂, -CH₂CH₃, -CH₂CD₃, - CH₂CD₂H, -CH₂CDH₂, -CHDCH₃, -CHDCD₂H, -CHDCDH₂, -CHDCD₃, -CD₂CD₃, - CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₆ alkyl group, and a phenyl group, and
each of * and *' may indicate a binding site to M in Formula 1. However, one or more embodiments are not limited thereto.

In some embodiments, R₁₁ to R₁₅ in Formulae 2A-1 and 2A-5 may be each independently selected from a hydrogen, a deuterium, -F, a cyano group, a nitro group, -SF₅, -CH₃, -CD₃, -CD₂H, -CDH₂, -CF₃, -CF₂H, -CFH₂, groups represented by Formulae 9-1 to 9-19, and groups represented by Formulae 10-1 to 10-36, but are not limited thereto.
In some embodiments, L₁ in Formula 1 may be selected from ligands represented by Formulae 2A(1) to 2A(192) below:

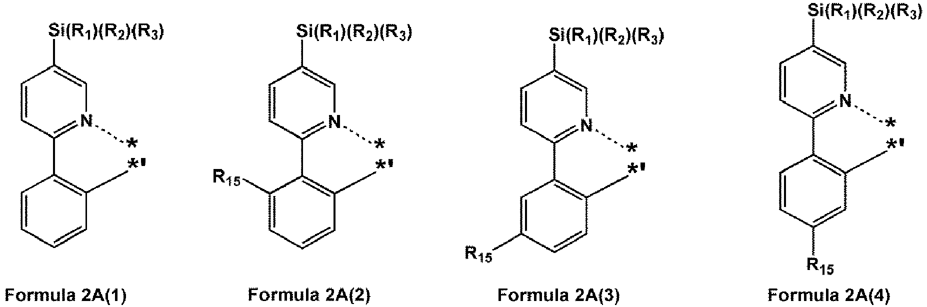

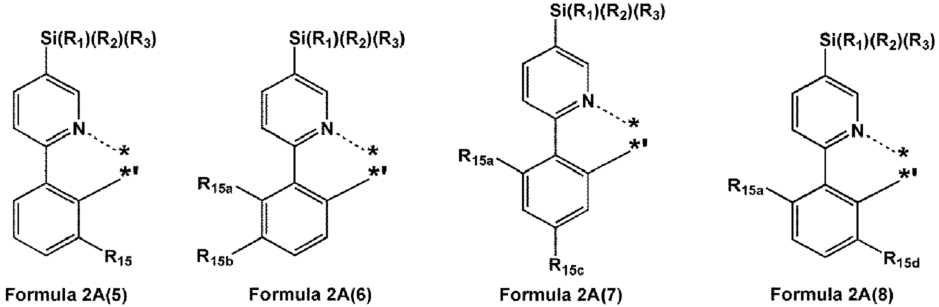

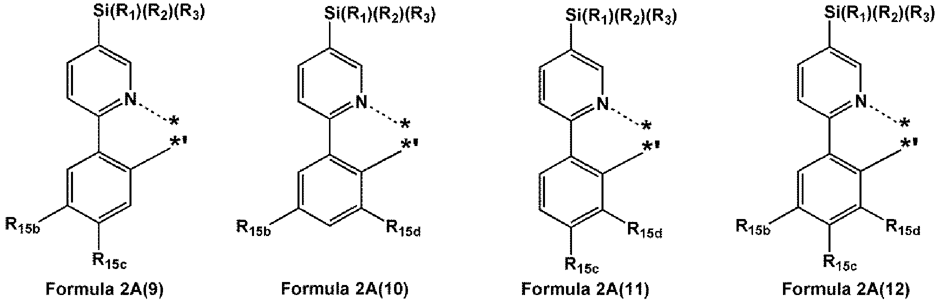

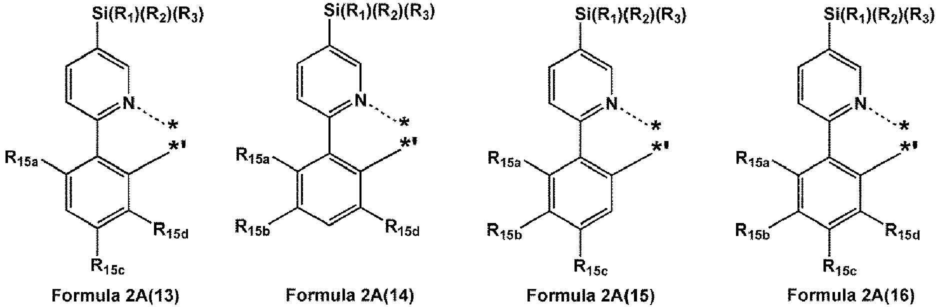

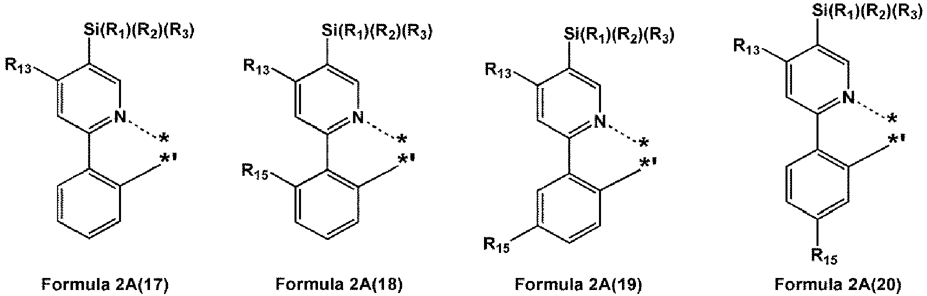

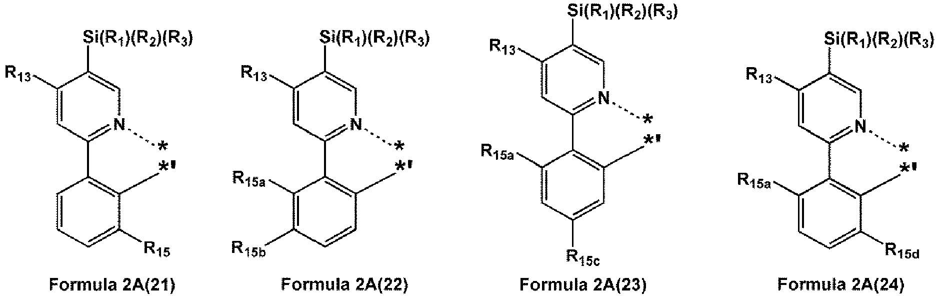

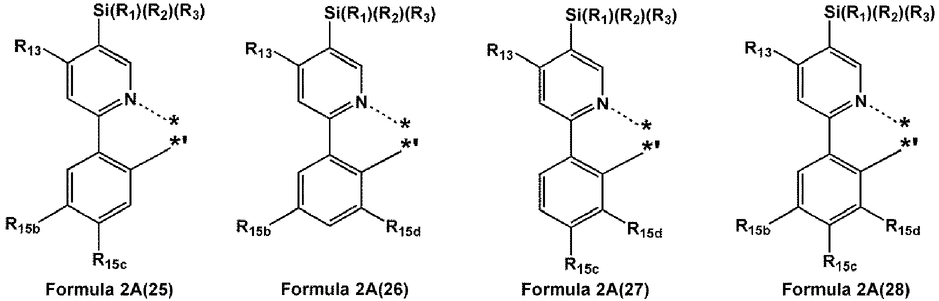

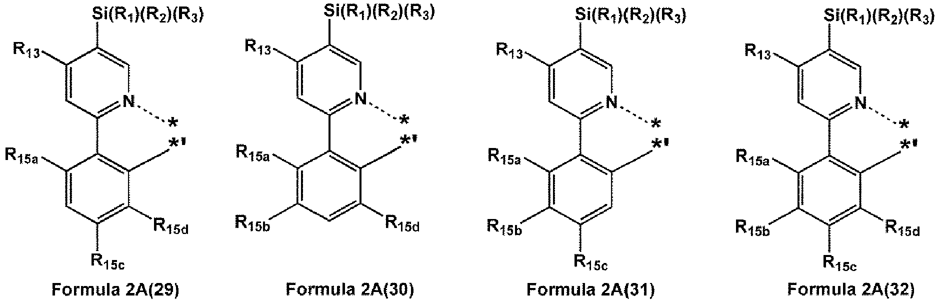

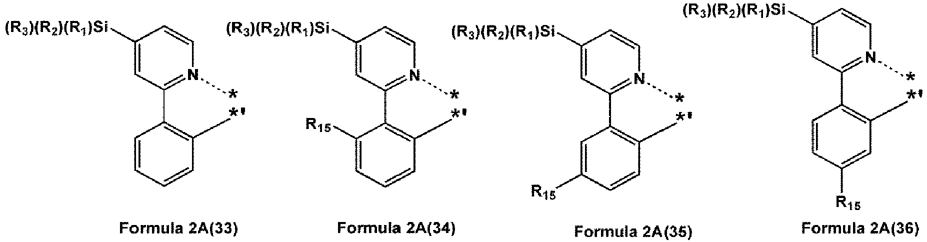

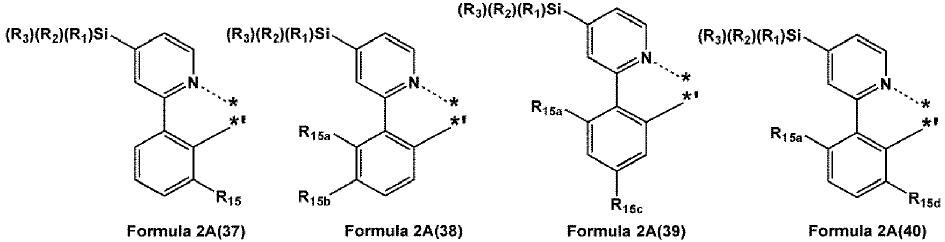

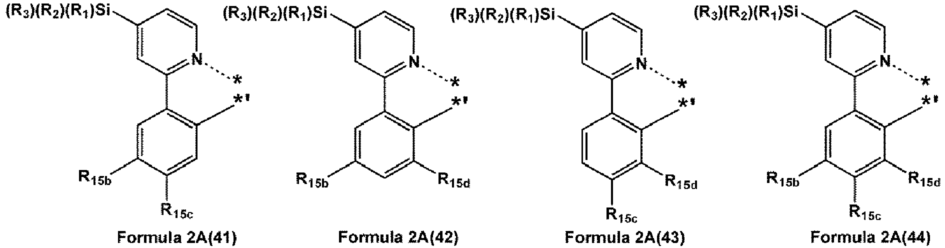

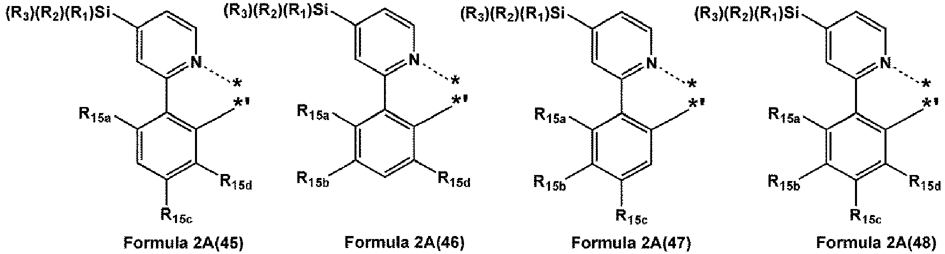

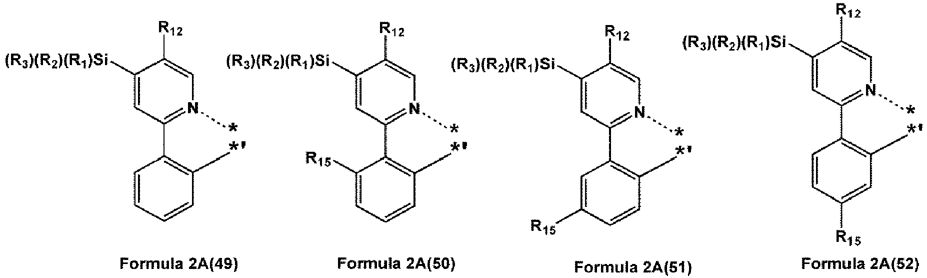

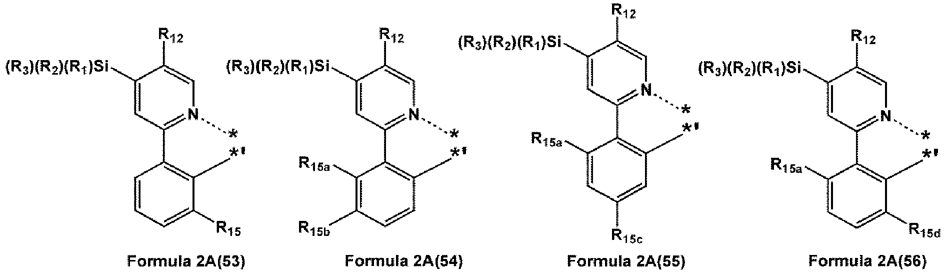

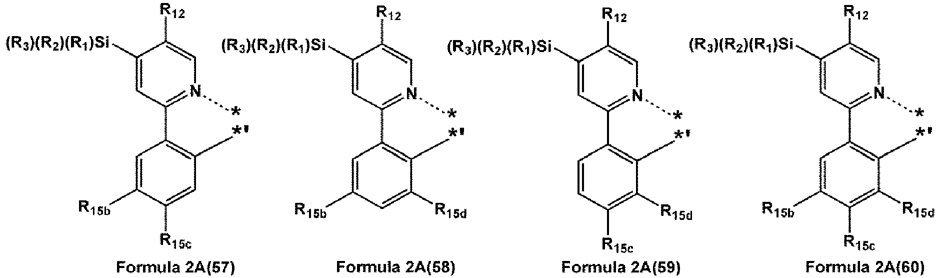

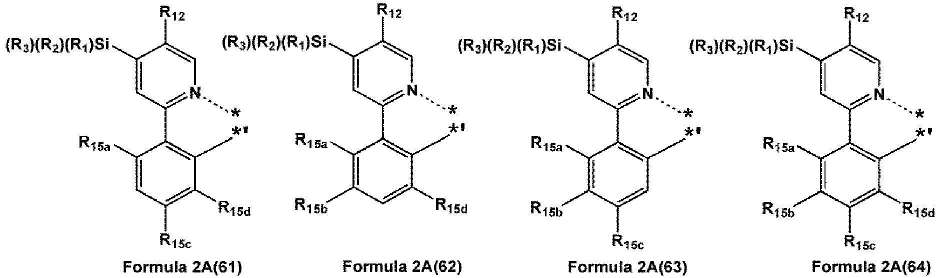

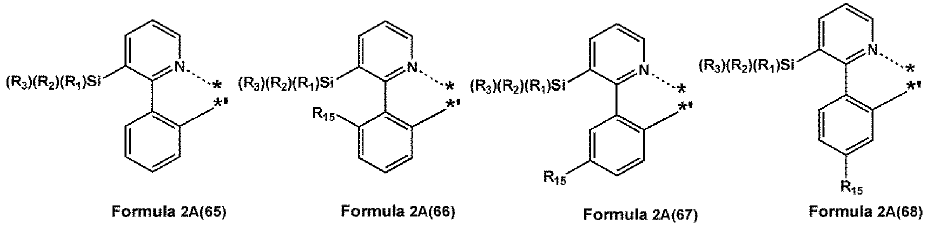

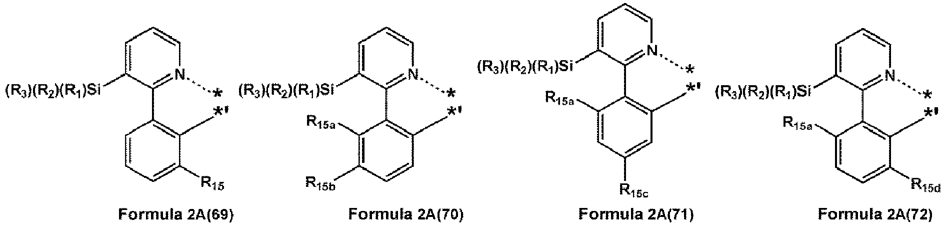

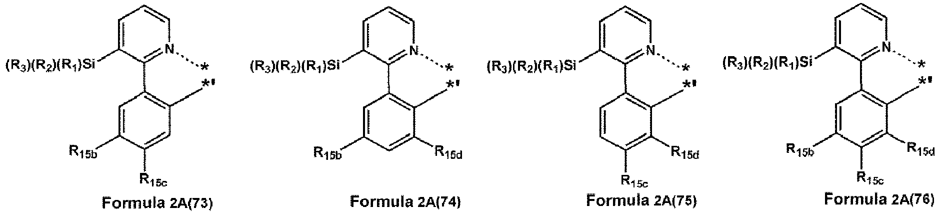

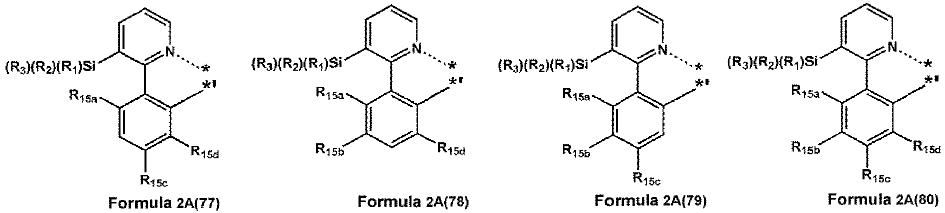

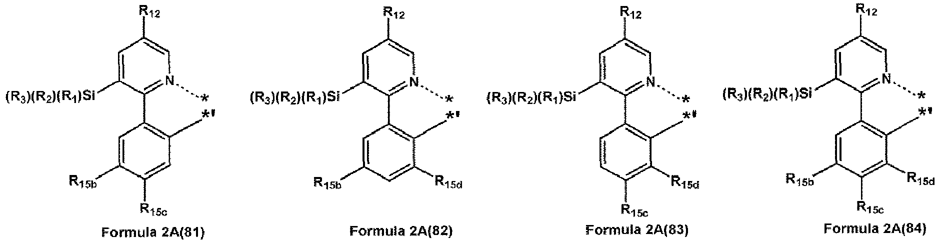

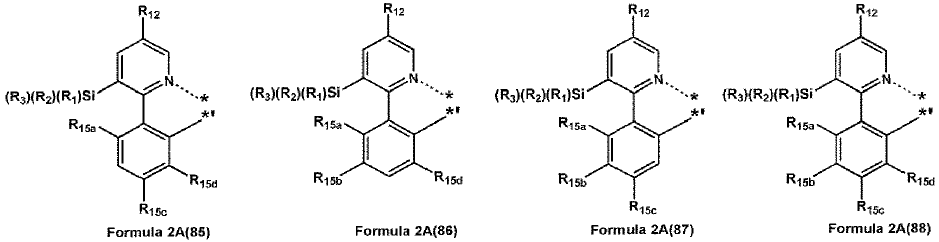

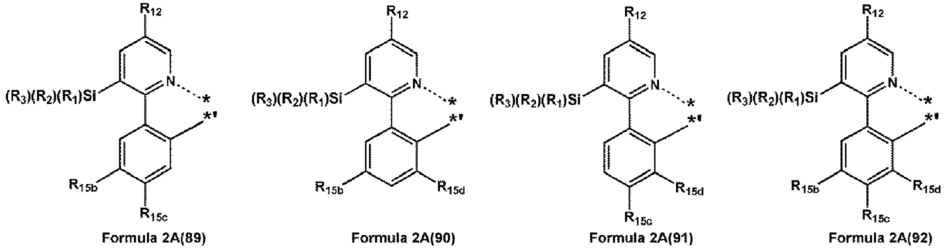

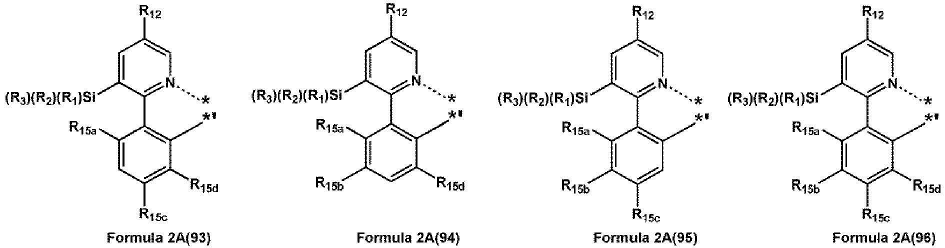

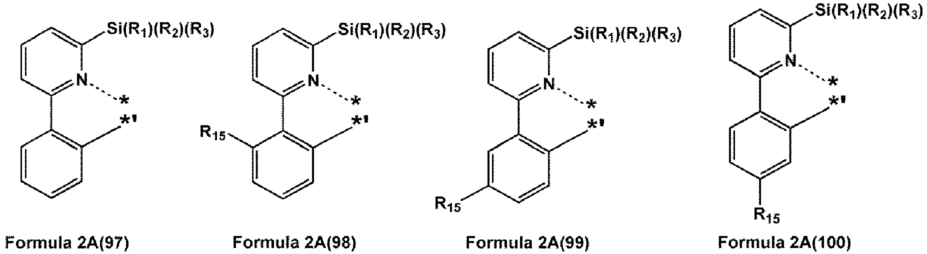

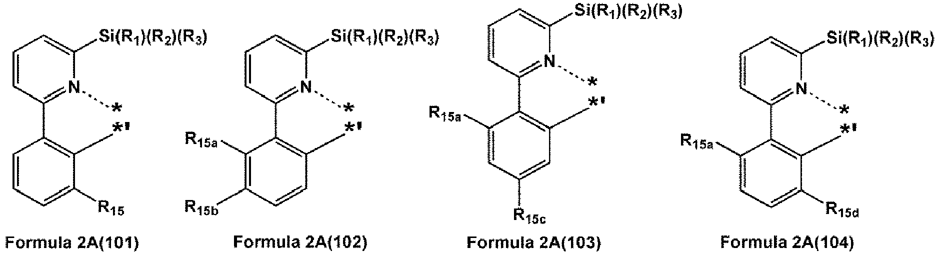

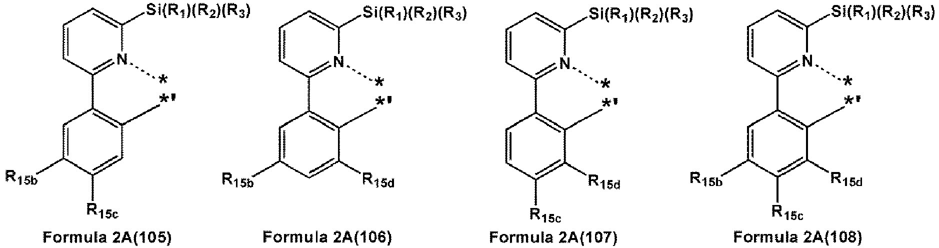

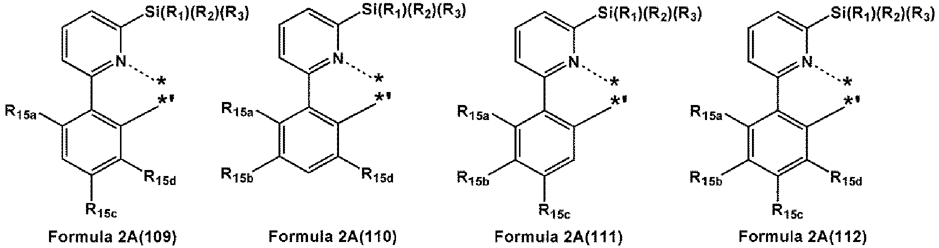

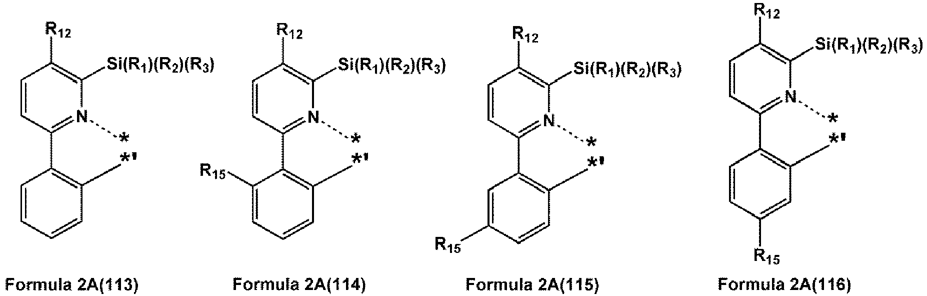

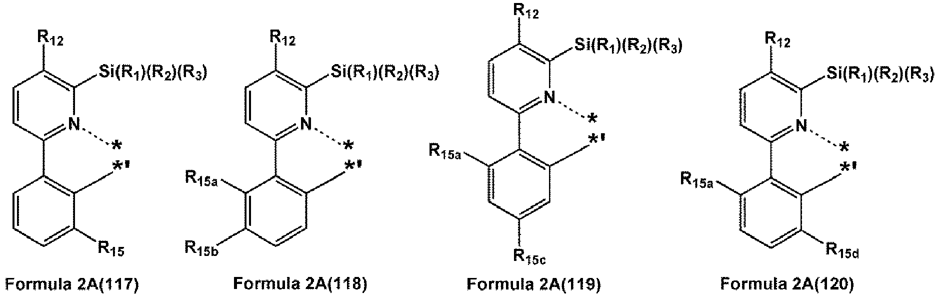

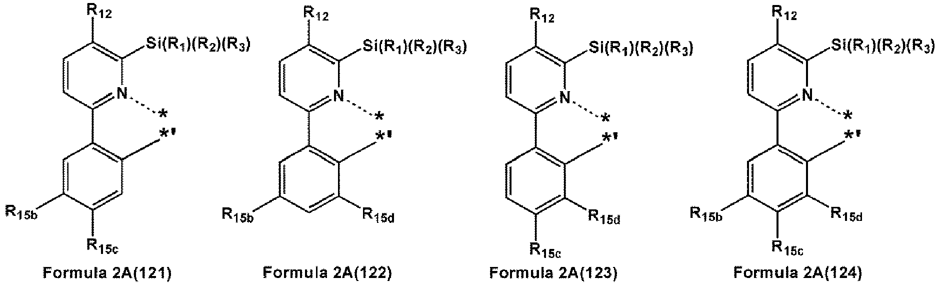

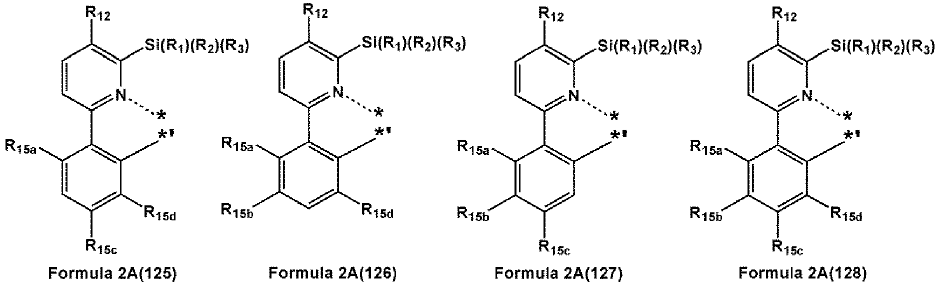

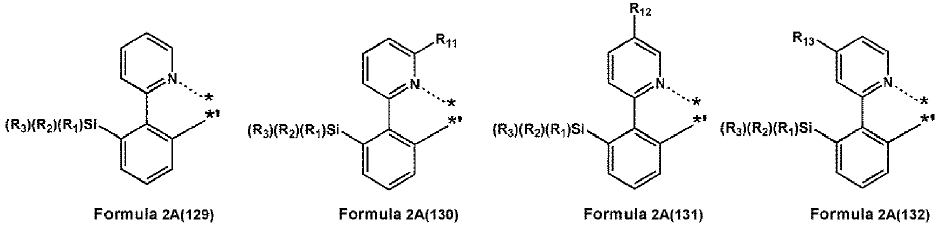

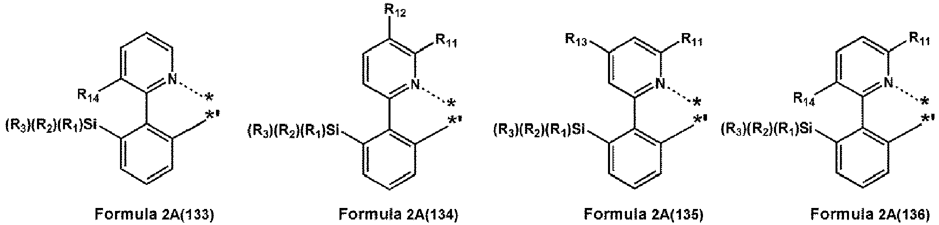

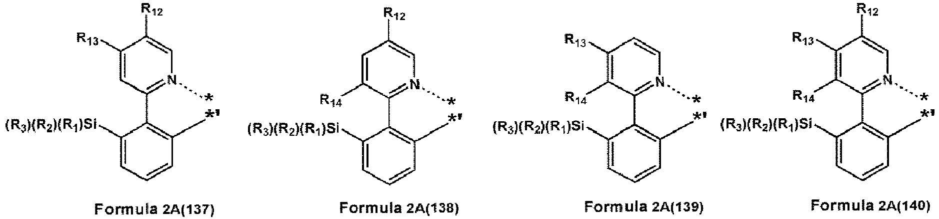

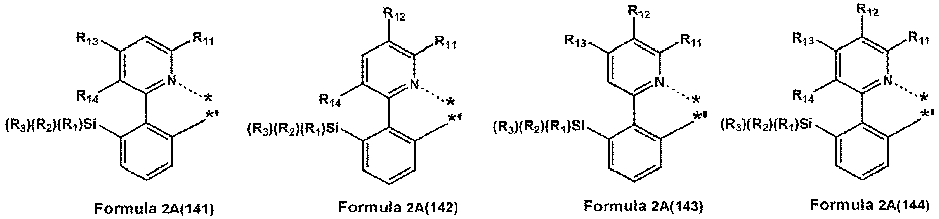

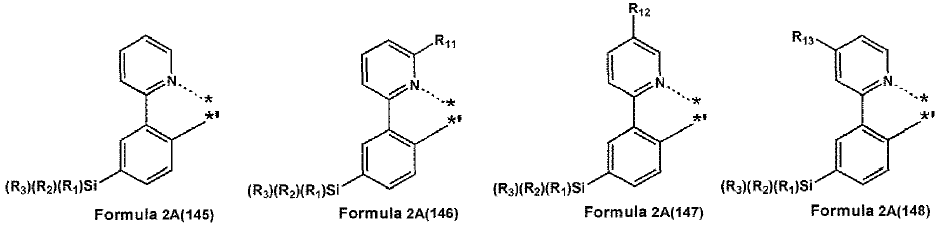

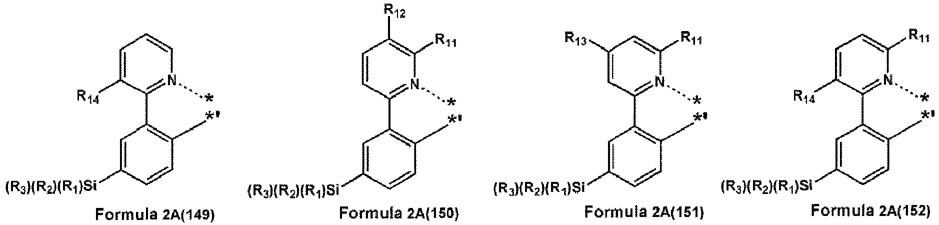

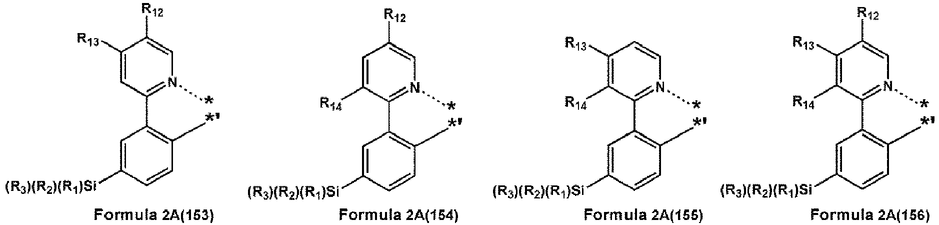

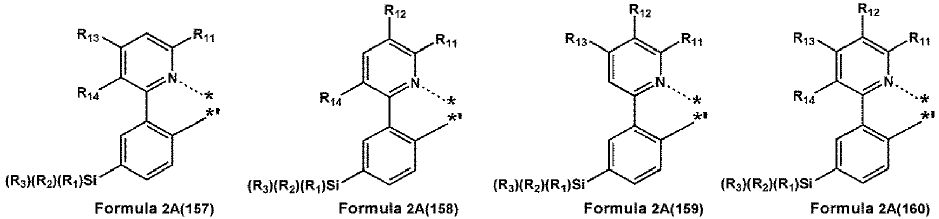

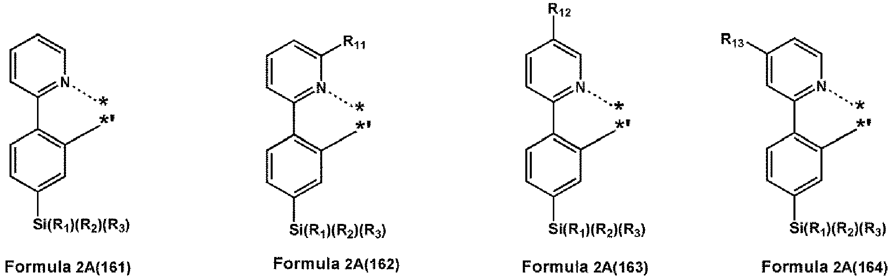

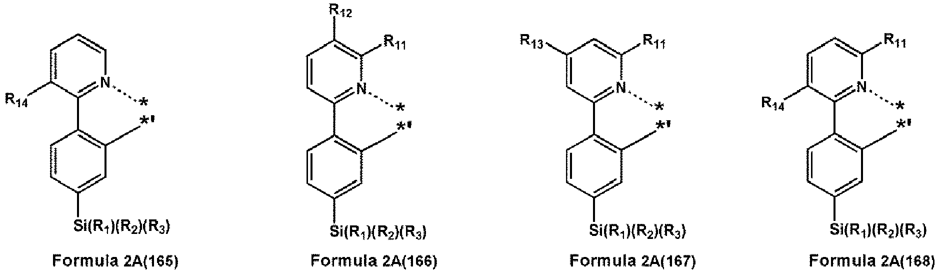

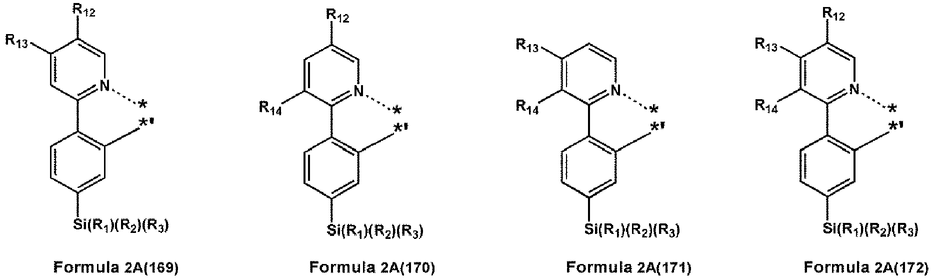

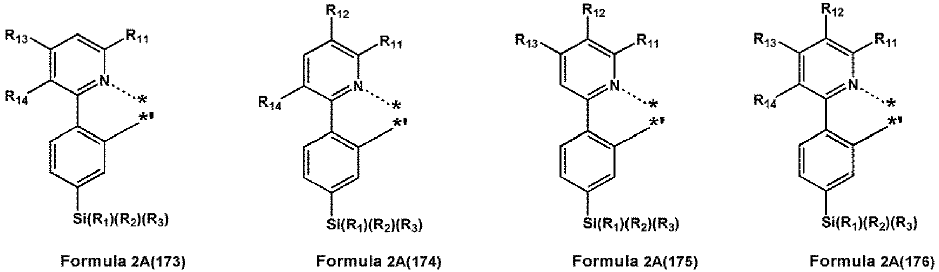

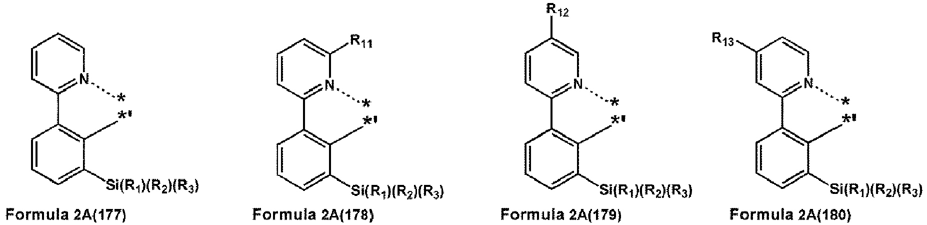

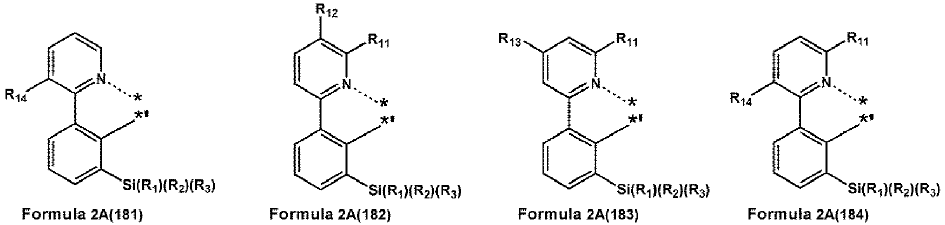

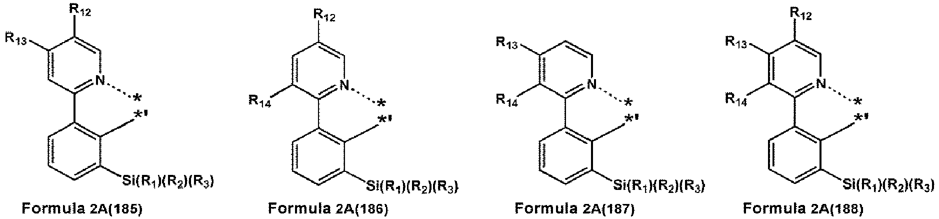

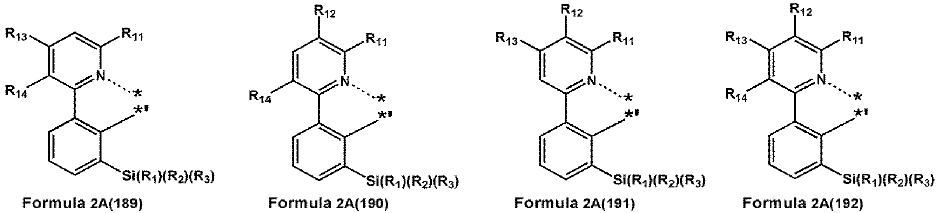

In Formulae 2A(1) to 2A(192), R₁₁ to R₁₅ and R₁ to R₃ may be understood by referring to the description provided herein, each of * and *' may indicate a binding site to M in Formula 1, and R₁₅ₐ to R_{15d} may be understood by referring to the description of R₁₅ herein, provided that all of R₁₁ to R₁₅ and R₁₅ₐ to R_{15d} are not simultaneously a hydrogen.

In some embodiments, L₁ in Formula 1 may be selected from ligands represented by Formulae 2A(1) to 2A(48), 2A(65) to 2A(80), 2A(97) to 2A(112), and 2A(129) to 2A(192), but are not limited thereto.

For example, in Formulae 2A(1) to 2A(192),
R₁₁ to R₁₅ and R₁₅ₐ to R_{15d} may be each independently selected from
a deuterium, -F, a cyano group, a nitro group, -SF₅, a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzofuranyl group, and a dibenzothiophenyl group;
a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzofuranyl group, and a dibenzothiophenyl group, each substituted with at least one selected from a deuterium, -F, -CD₃, -CD₂H, -CDH₂, -CF₃, -CF₂H, -CFH₂, a cyano group, a nitro group, a C₁-C₁₆ alkyl group, a C₁-C₁₆ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzofuranyl group, and a dibenzothiophenyl group; and
-B(Q₃)(Q₄) and -P(=O)(Q₅)(Q₆),
wherein Q₃ to Q₆ may be each independently selected from
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₆ alkyl group, and a phenyl group,
R₁ to R₃ may be each independently selected from
a hydrogen, a deuterium, -CH₃, -CD₃, -CD₂H, -CDH₂, -CH₂CH₃, -CH₂CD₃, - CH₂CD₂H, -CH₂CDH₂, -CHDCH₃, -CHDCD₂H, -CHDCDH₂, -CHDCD₃, -CD₂CD₃, - CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, and - Si(Q₅₁)(Q₅₂)(Q₅₃); and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₆ alkyl group, and a phenyl group,
wherein Q₅₁ to Q₅₃ may be each independently selected from
a hydrogen, a deuterium, -CH₃, -CD₃, -CD₂H, -CDH₂, -CH₂CH₃, -CH₂CD₃, - CH₂CD₂H, -CH₂CDH₂, -CHDCH₃, -CHDCD₂H, -CHDCDH₂, -CHDCD₃, -CD₂CD₃, - CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₆ alkyl group, and a phenyl group, and
each of * and *' may indicate a binding site to M in Formula 1.

For example, R₁₁ to R₁₅ and R₁₅ₐ to R_{15d} in Formulae 2A(1) to 2A(192) may be each independently selected from a deuterium, -F, a cyano group, a nitro group, - SF₅, -CH₃, -CD₃, -CD₂H, -CDH₂, -CF₃, -CF₂H, -CFH₂, groups represented by Formulae 9-1 to 9-19, and groups represented by Formulae 10-1 to 10-36, but are not limited thereto.

In some embodiments, L₁ in Formula 1 may be selected from ligands represented by Formulae 2A(1) to 2A(48), 2A(65) to 2A(80), 2A(97) to 2A(112), and 2A(129) to 2A(192), and
in Formulae 2A(1) to 2A(48), 2A(65) to 2A(80), 2A(97) to 2A(112), and 2A(129) to 2A(192),
R₁ to R₃ may be each independently selected from
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₆ alkyl group, and a phenyl group, (for example, -CH₃, -CD₃, -CD₂H, -CDH₂, and a phenyl group),
all of R₁ to R₃ may simultaneously be the same; or R₁ and R₃ may be identical to each other, and R₂ may be different from R₁, and
R₁₁ to R₁₅ and R₁₅ₐ to R_{15d} may be each independently selected from a deuterium, -F, a cyano group, a nitro group, -SF₅, -CH₃, -CD₃, -CD₂H, -CDH₂, -CF₃, - CF₂H, -CFH₂, groups represented by Formulae 9-1 to 9-19, and groups represented by Formulae 10-1 to 10-36.
In some embodiments, L₂ in Formula 1 may be selected from ligands represented by Formulae 2B-1 to 2B-14:

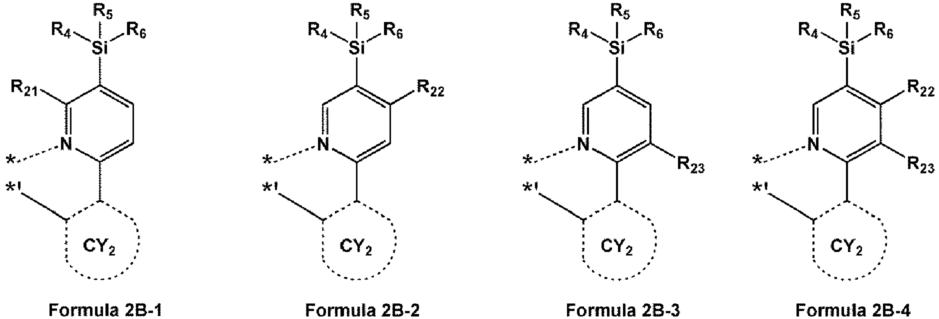

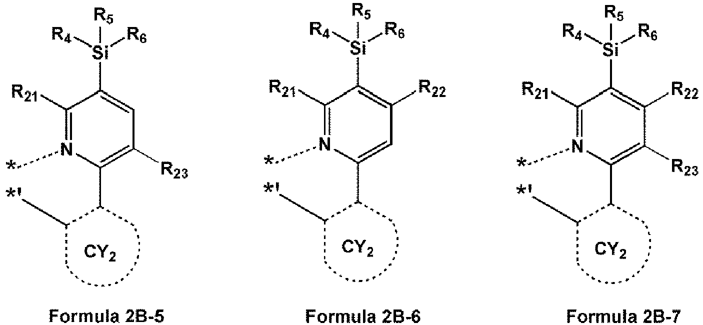

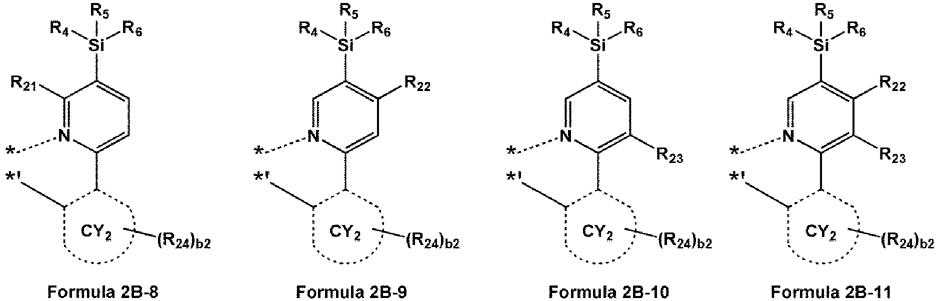

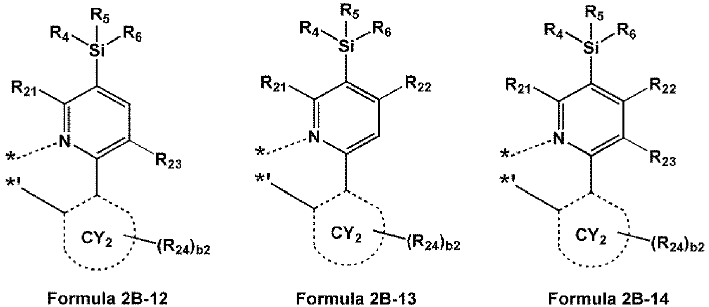

In Formulae 2B-1 to 2B-14, CY₂, R₂₁ to R₂₄, b2, and R₄ to R₆ may be understood by referring to the description provided herein, and each of * and *' may indicate a binding site to M in Formula 1, provided that all of R₂₁ to R₂₄ are not simultaneously a hydrogen.

In some embodiments, L₂ in Formula 1 may be selected from ligands represented by Formulae 2B-2, 2B-4, 2B-6, 2B-7, 2B-9, 2B-11, 2B-13, and 2B-14.

For example, in Formulae 2B-1 to 2B-14,
CY₂ may be selected from a benzene, a naphthalene, a fluorene, a phenalene, a phenanthrene, an anthracene, a triphenylene, a pyrene, and a chrysene,
R₂₁ to R₂₄ may be each independently selected from
a deuterium, -F, a cyano group, a nitro group, -SF₅, a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzofuranyl group, and a dibenzothiophenyl group;
a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzofuranyl group, and a dibenzothiophenyl group, each substituted with at least one selected from a deuterium, -F, -CD₃, -CD₂H, -CDH₂, -CF₃, -CF₂H, -CFH₂, a cyano group, a nitro group, a C₁-C₁₀ alkyl group, a C₁-C₁₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzofuranyl group, and a dibenzothiophenyl group; and
-B(Q₃)(Q₄) and -P(=O)(Q₅)(Q₆),
wherein Q₃ to Q₆ may be each independently selected from
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₀ alkyl group, and a phenyl group,
R₄ to R₆ may be each independently selected from
a hydrogen, a deuterium, -CH₃, -CD₃, -CD₂H, -CDH₂, -CH₂CH₃, -CH₂CD₃, - CH₂CD₂H, -CH₂CDH₂, -CHDCH₃, -CHDCD₂H, -CHDCDH₂, -CHDCD₃, -CD₂CD₃, - CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, and - Si(Q₅₁)(Q₅₂)(Q₅₃); and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₀ alkyl group, and a phenyl group,
wherein Q₅₁ to Q₅₃ may be each independently selected from
a hydrogen, a deuterium, -CH₃, -CD₃, -CD₂H, -CDH₂, -CH₂CH₃, -CH₂CD₃, - CH₂CD₂H, -CH₂CDH₂, -CHDCH₃, -CHDCD₂H, -CHDCDH₂, -CHDCD₃, -CD₂CD₃, - CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₀ alkyl group, and a phenyl group, and
each of * and *' may indicate a binding site to M in Formula 1.

For example, R₂₁ to R₂₄ in Formulae 2B-1 to 2B-14 may be each independently selected from a deuterium, -F, a cyano group, a nitro group, -SF₅, - CH₃, -CD₃, -CD₂H, -CDH₂, -CF₃, -CF₂H, -CFH₂, groups represented by Formulae 9-1 to 9-19, and groups represented by Formulae 10-1 to 10-36, but are not limited thereto.
In some embodiments, L₂ in Formula 1 may be selected from ligands represented by Formulae 2B(1) to 2B(96) below:

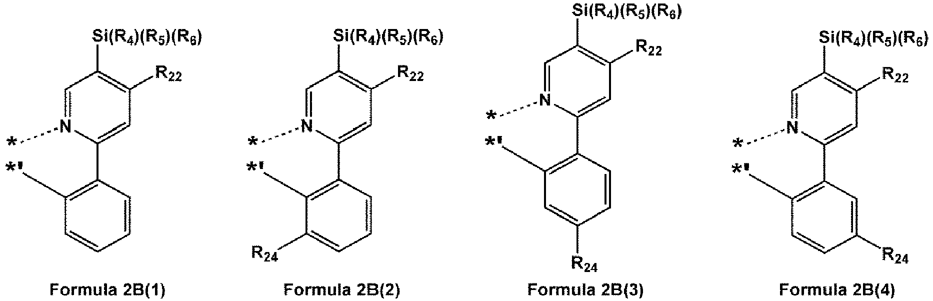

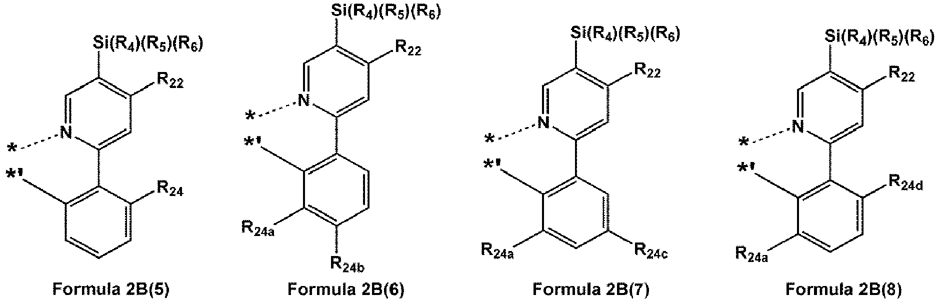

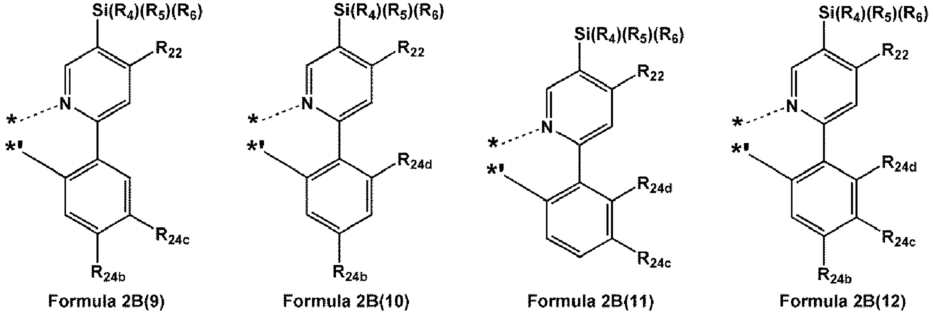

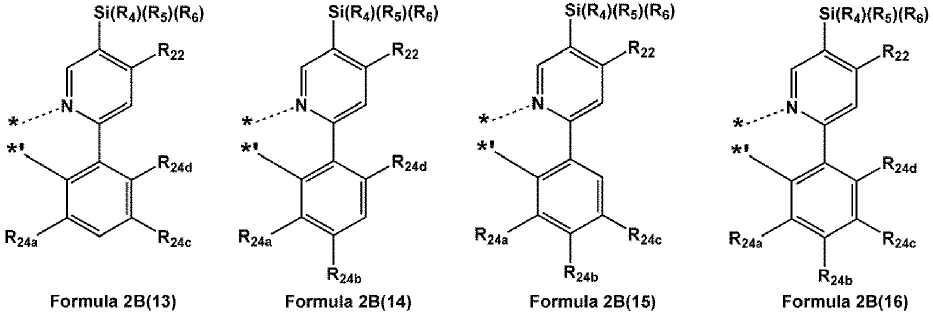

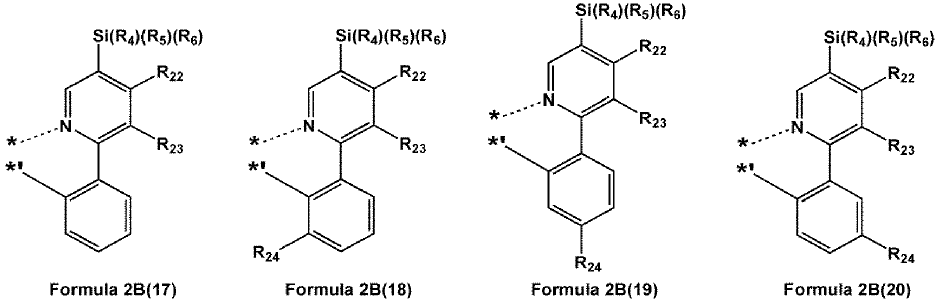

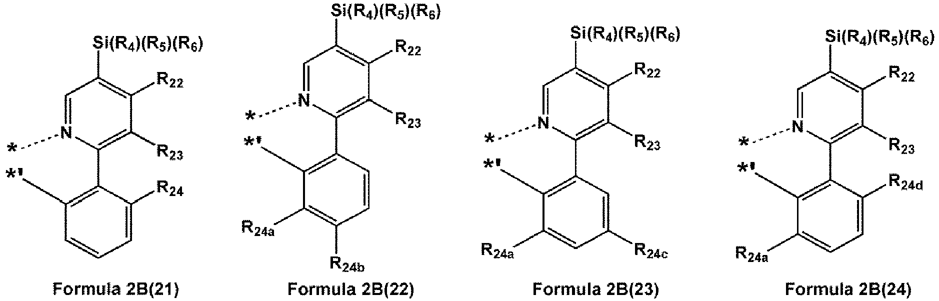

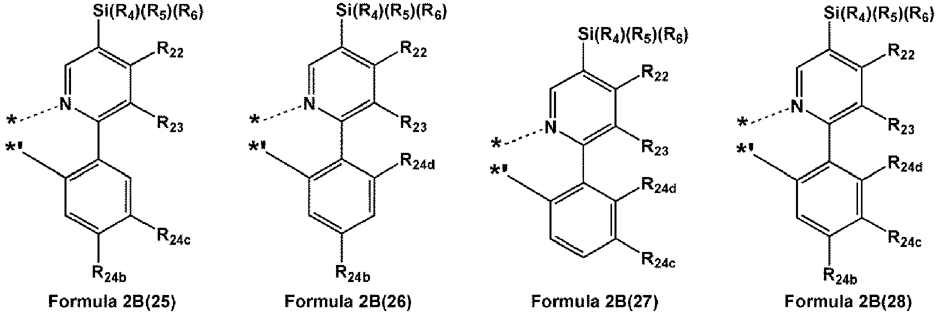

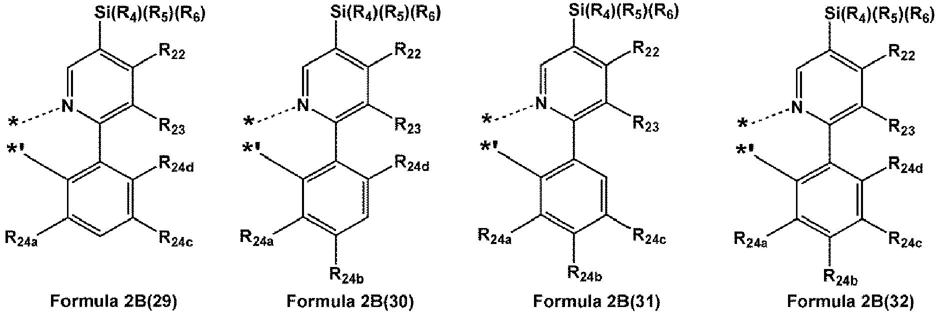

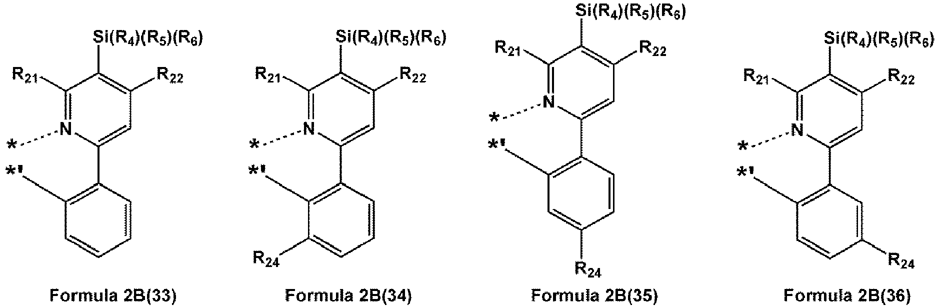

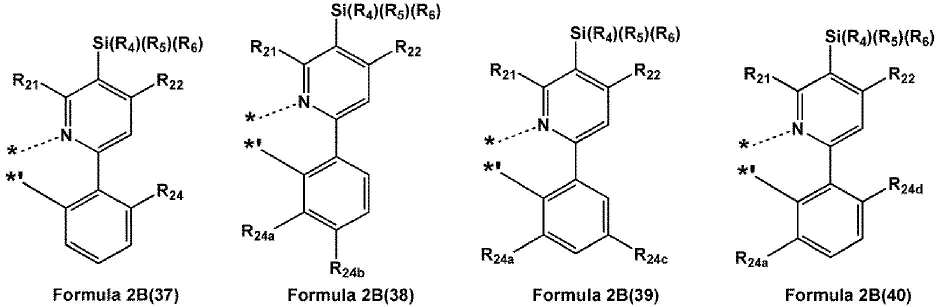

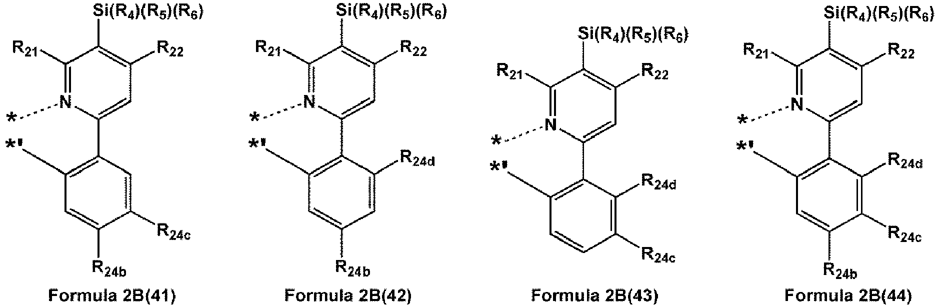

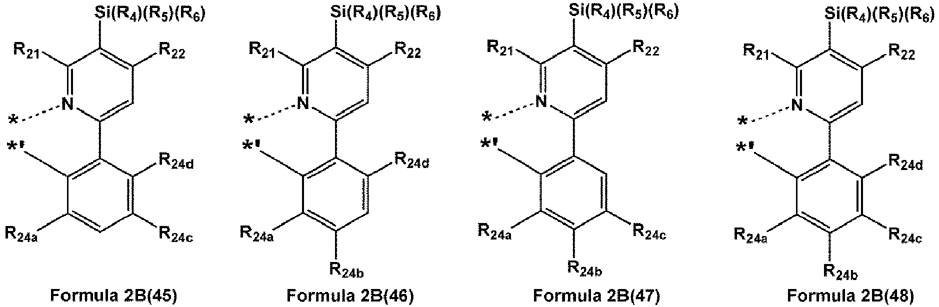

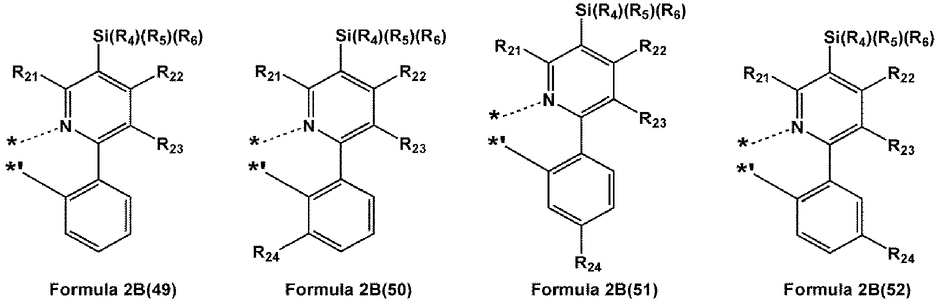

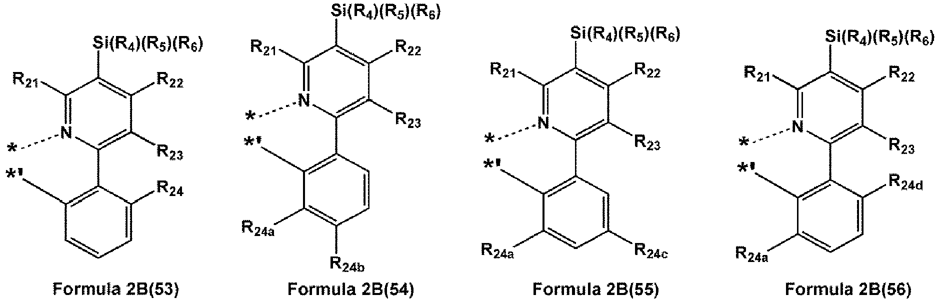

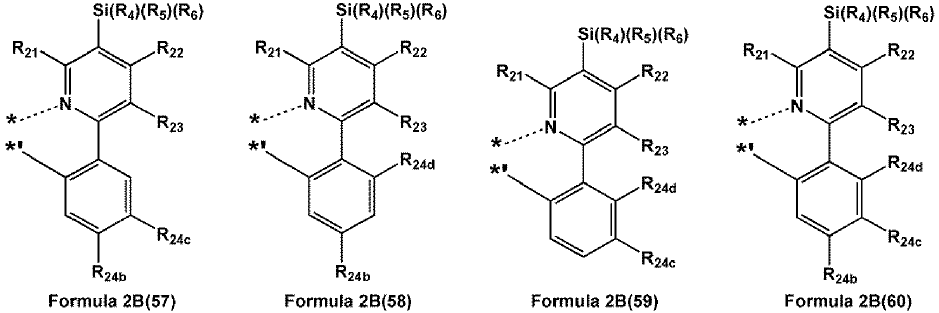

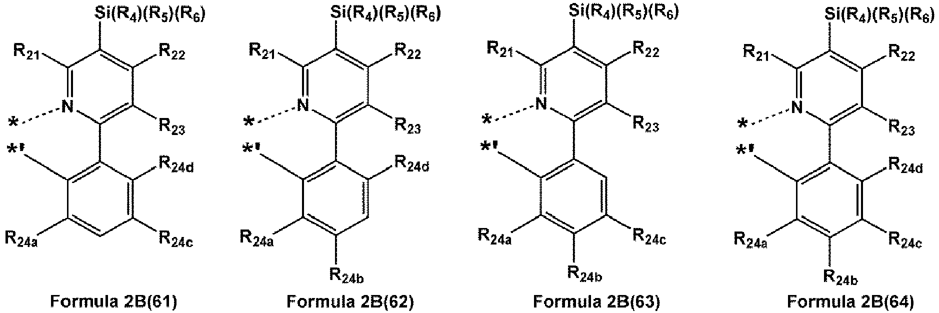

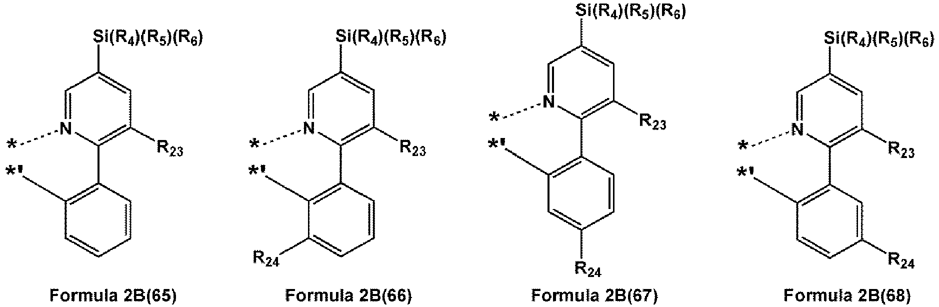

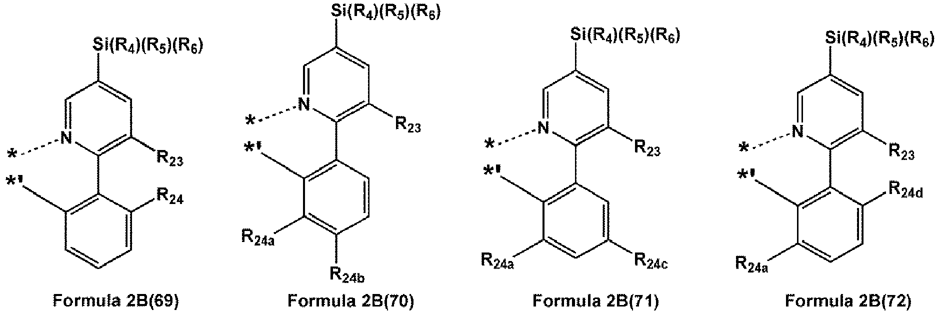

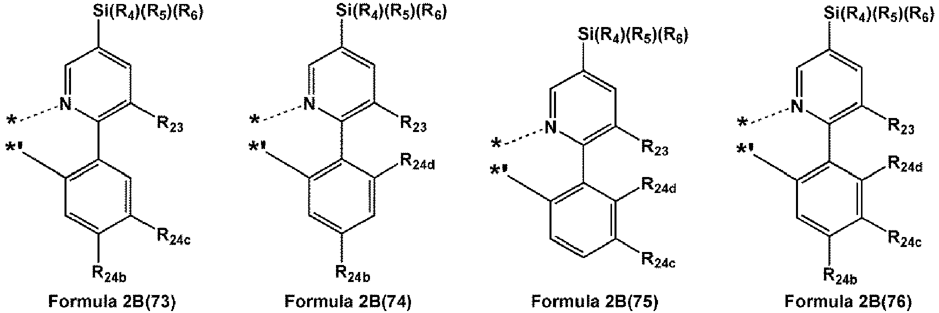

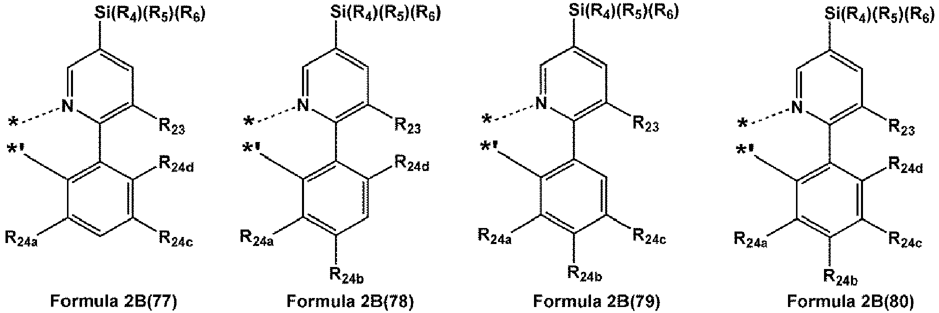

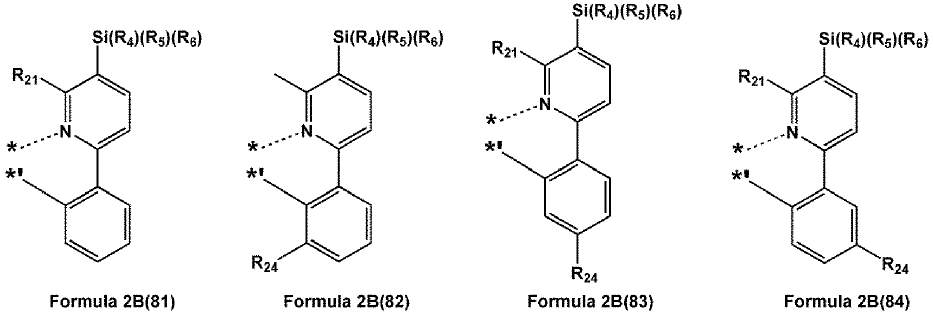

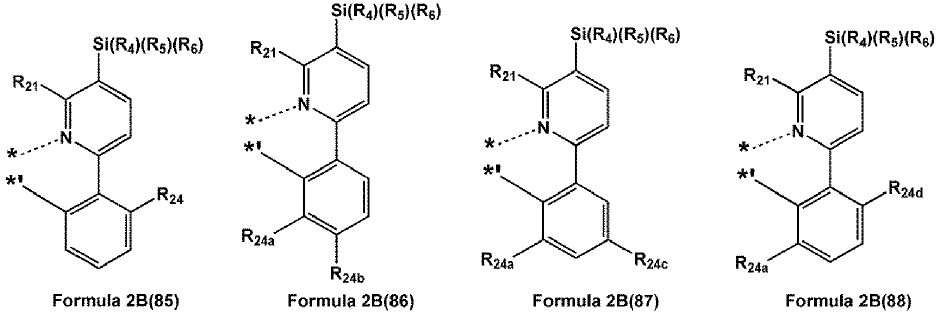

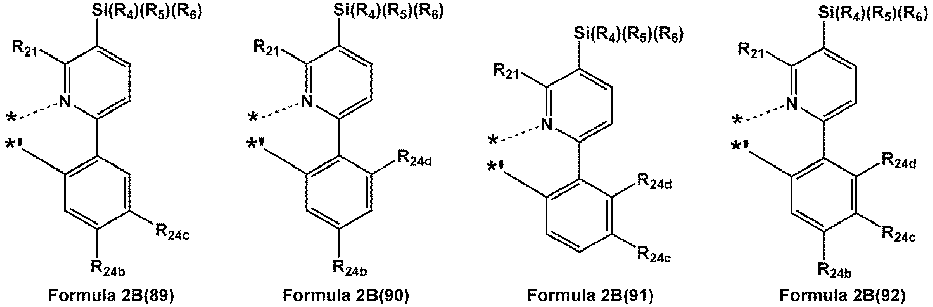

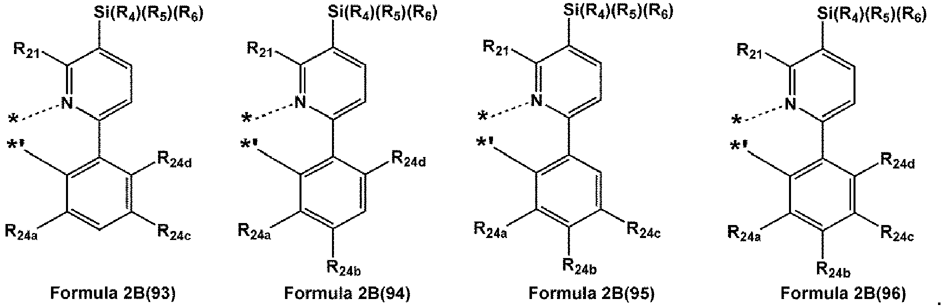

In Formulae 2B(1) to 2B(96), R₂₁ to R₂₄ and R₄ to R₆ may be understood by referring to the description provided herein, each of * and *' may indicate a binding site to M in Formula 1, and R₂₄ₐ to R_{24d} may be understood by referring to the description of R₂₄ herein, provided that all of R₂₁ to R₂₄ and R₂₄ₐ to R_{24d} are not simultaneously a hydrogen.

For example, in Formulae 2B(1) to 2B(96),
R₂₁ to R₂₄ and R₂₄ₐ to R_{24d} may be each independently selected from
a deuterium, -F, a cyano group, a nitro group, -SF₅, a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzofuranyl group, and a dibenzothiophenyl group;
a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, a tert-decyl group, a methoxy group, an ethoxy group, a propoxy group, a butoxy group, a pentoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzofuranyl group, and a dibenzothiophenyl group, each substituted with at least one selected from a deuterium, -F, -CD₃, -CD₂H, -CDH₂, -CF₃, -CF₂H, -CFH₂, a cyano group, a nitro group, a C₁-C₁₀ alkyl group, a C₁-C₁₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, a dibenzofuranyl group, and a dibenzothiophenyl group; and
-B(Q₃)(Q₄) and -P(=O)(Q₅)(Q₆),
wherein Q₃ to Q₆ may be each independently selected from
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₀ alkyl group, and a phenyl group, and
R₄ to R₆ may be each independently selected from
a hydrogen, a deuterium, -CH₃, -CD₃, -CD₂H, -CDH₂, -CH₂CH₃, -CH₂CD₃, - CH₂CD₂H, -CH₂CDH₂, -CHDCH₃, -CHDCD₂H, -CHDCDH₂, -CHDCD₃, -CD₂CD₃, - CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, and - Si(Q₅₁)(Q₅₂)(Q₅₃); and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₀ alkyl group, and a phenyl group,
wherein Q₅₁ to Q₅₃ may be each independently selected from
a hydrogen, a deuterium, -CH₃, -CD₃, -CD₂H, -CDH₂, -CH₂CH₃, -CH₂CD₃, - CH₂CD₂H, -CH₂CDH₂, -CHDCH₃, -CHDCD₂H, -CHDCDH₂, -CHDCD₃, -CD₂CD₃, - CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₀ alkyl group, and a phenyl group.

For example, R₂₁ to R₂₄ and R₂₄ₐ to R_{24d} in Formulae 2B(1) to 2B(96) may be each independently selected from a deuterium, -F, a cyano group, a nitro group, - SF₅, -CH₃, -CD₃, -CD₂H, -CDH₂, -CF₃, -CF₂H, -CFH₂, groups represented by Formulae 9-1 to 9-19, and groups represented by Formulae 10-1 to 10-36, but are not limited thereto.

In some embodiments, L₂ in Formula 1 may be selected from ligands represented by Formulae 2B(1) to 2B(48) and 2B(65) to 2B(80), and

in Formulae 2B(1) to 2B(48) and 2B(65) to 2B(80),
R₄ to R₆ may be each independently selected from
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₀ alkyl group, and a phenyl group, (for example, -CH₃, -CD₃, -CD₂H, -CDH₂, and a phenyl group),
all of R₄ to R₆ may simultaneously be the same; or R₄ and R₆ may be identical to each other, and R₅ may be different from R₄, and
R₂₁ to R₂₄ and R₂₄ₐ to R_{24d} may be each independently selected from a deuterium, -F, a cyano group, a nitro group, -SF₅, -CH₃, -CD₃, -CD₂H, -CDH₂, -CF₃, - CF₂H, -CFH₂, groups represented by Formulae 9-1 to 9-19, and groups represented by Formulae 10-1 to 10-36.

In some embodiments, in Formula 1, L₁ may be selected from ligands represented by Formulae 2A-1 to 2A-5, and L₂ may be selected from ligands represented by Formulae 2B-1 to 2B-14.

In some embodiments, in Formula 1, L₁ may be selected from ligands represented by Formulae 2A-1 to 2A-5, and L₂ may be selected from ligands represented by Formulae 2B(1) to 2B(96).

In some embodiments, in Formula 1, L₁ may be selected from ligands represented by Formulae 2A(1) to 2A(192), and L₂ may be selected from ligands represented by Formulae 2B-1 to 2B-14.

In some embodiments, in Formula 1, L₁ may be selected from ligands represented by Formulae 2A(1) to 2A(192), and L₂ may be selected from ligands represented by Formulae 2B(1) to 2B(96).

In some embodiments, in Formula 1, L₁ may be selected from ligands represented by Formulae 2A(1) to 2A(48), 2A(65) to 2A(80), 2A(97) to 2A(112), and 2A(129) to 2A(192), and L₂ may be selected from ligands represented by Formulae 2B(1) to 2B(48) and 2B(65) to 2A(80).

In some embodiments, in Formula 1,
M may be Ir, and the sum of n1 and n2 may be 3; or M may be Pt, and the sum of n1 and n2 may be 2,
L₁ may be selected from ligands represented by Formulae 2A-1 to 2A-5,
L₂ may be selected from ligands represented by Formulae 2B-1 to 2B-14, and
the organometallic compound represented by Formula 1 may be an electrically neutral molecule, which does not consist of a pair of ions.

In some embodiments, in Formula 1,
M may be Ir, and the sum of n1 and n2 may be 3; or M may be Pt, and the sum of n1 and n2 may be 2,
L₁ may be selected from ligands represented by Formulae 2A-1 to 2A-5,
L₂ may be selected from ligands represented by Formulae 2B(1) to 2B(96), and
the organometallic compound represented by Formula 1 may be an electrically neutral molecule, which does not consist of a pair of ions.

In some embodiments, in Formula 1,
M may be Ir, and the sum of n1 and n2 may be 3; or M may be Pt, and the sum of n1 and n2 may be 2,
L₁ may be selected from ligands represented by Formulae 2A(1) to 2A(192),
L₂ may be selected from ligands represented by Formulae 2B-1 to 2B-14, and
the organometallic compound represented by Formula 1 may be an electrically neutral molecule, which does not consist of a pair of ions.

In some embodiments, in Formula 1,
M may be Ir, and the sum of n1 and n2 may be 3; or M may be Pt, and the sum of n1 and n2 may be 2,
L₁ may be selected from ligands represented by Formulae 2A(1) to 2A(192),
L₂ may be selected from ligands represented by Formulae 2B(1) to 2B(96), and
the organometallic compound represented by Formula 1 may be an electrically neutral molecule, which does not consist of a pair of ions.

In some embodiments, in Formula 1,
M may be Ir, and the sum of n1 and n2 may be 3; or M may be Pt, and the sum of n1 and n2 may be 2,
L₁ may be selected from ligands represented by Formulae 2A(1) to 2A(192), and
L₂ may be selected from ligands represented by Formulae 2B(1) to 2B(96),
in Formulae 2A(1) to 2A(192) and 2B(1) to 2B(96),
R₁ to R₆ may be each independently selected from
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₀ alkyl group, and a phenyl group, (for example, -CH₃, -CD₃, -CD₂H, -CDH₂, and a phenyl group),
all of R₁ to R₃ may simultaneously be the same; or R₁ and R₃ may be identical to each other, and R₂ may be different from R₁,
all of R₄ to R₆ may simultaneously be the same; or R₄ and R₆ may be identical to each other, and R₅ may be different from R₄, and
R₁₁ to R₁₅, R₁₅ₐ to R_{15d}, R₂₁ to R₂₄, and R₂₄ₐ to R_{24d} may be each independently selected from a deuterium, -F, a cyano group, a nitro group, -SF₅, - CH₃, -CD₃, -CD₂H, -CDH₂, -CF₃, -CF₂H, -CFH₂, groups represented by Formulae 9-1 to 9-19, and groups represented by Formulae 10-1 to 10-36, and
the organometallic compound represented by Formula 1 may be neutral. However, one or more embodiments are not limited thereto.
An organometallic compound represented by Formula 1 may be one selected from Compounds 1 to 292 below, but is not limited thereto:

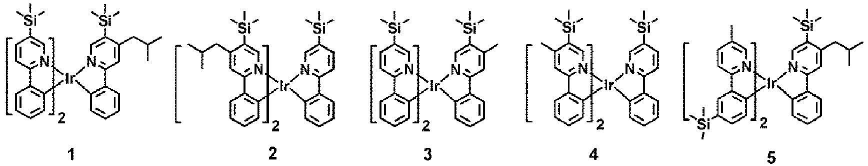

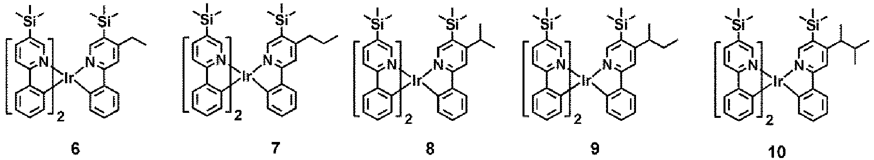

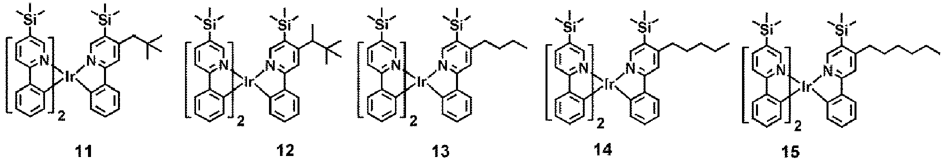

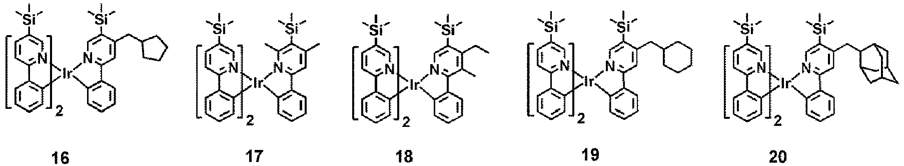

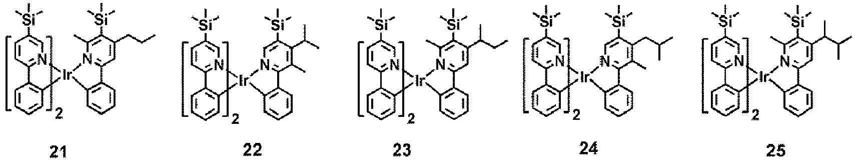

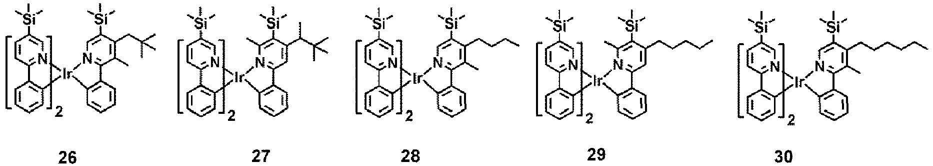

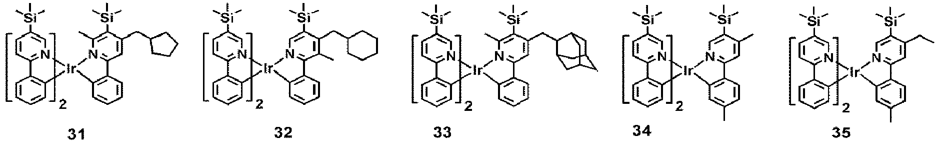

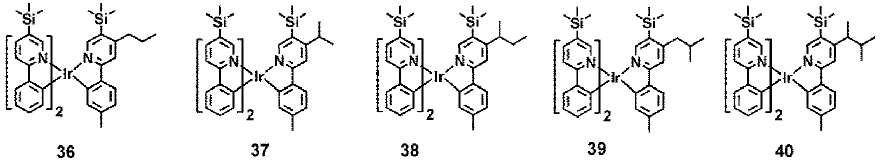

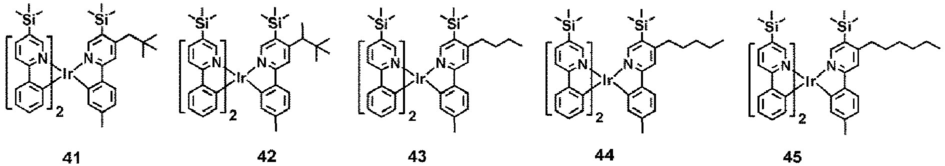

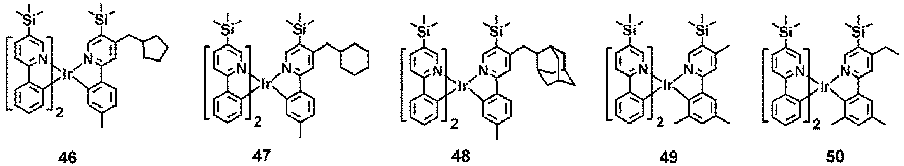

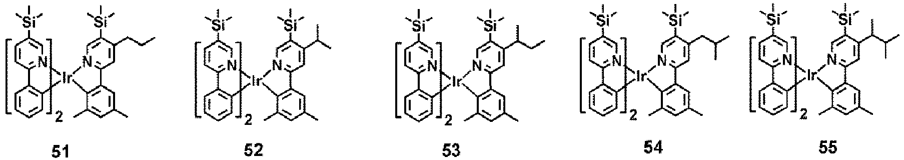

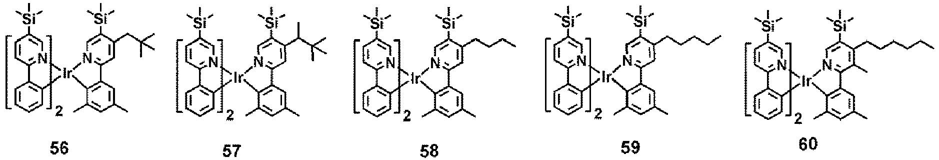

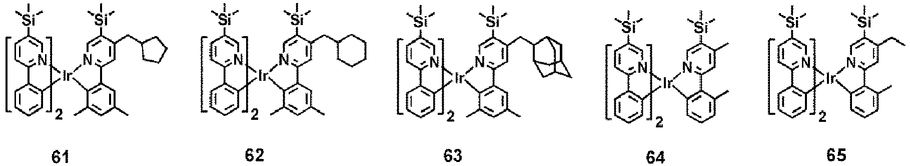

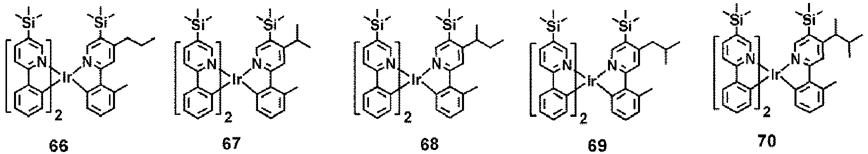

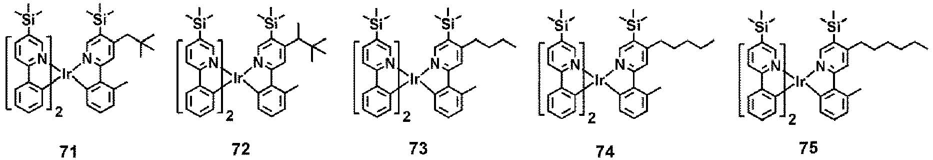

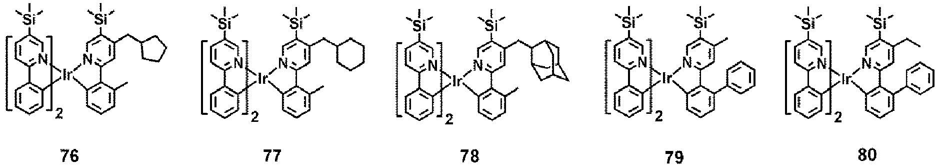

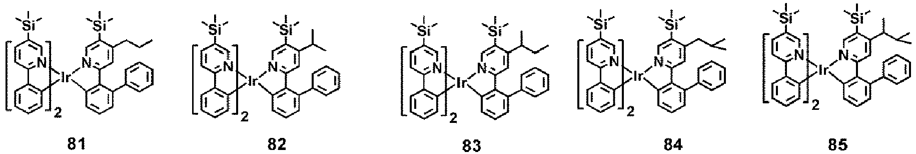

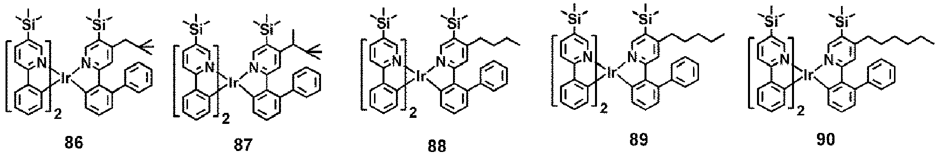

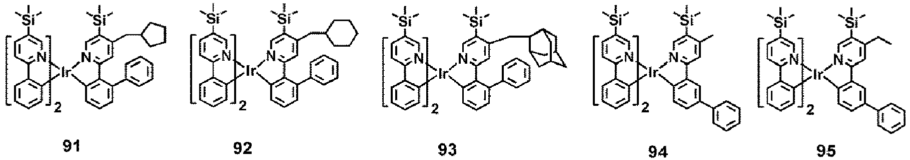

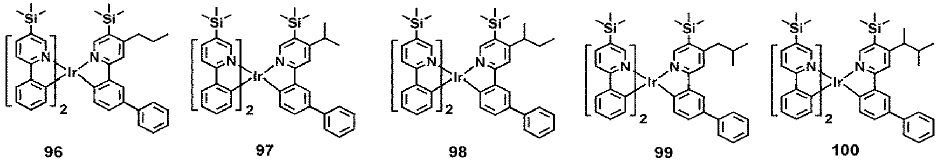

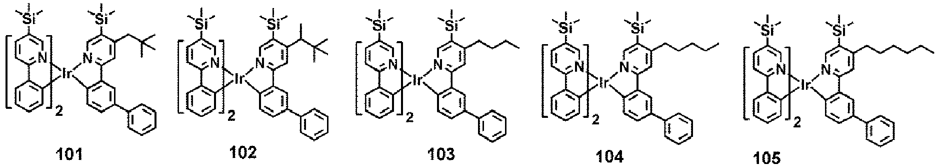

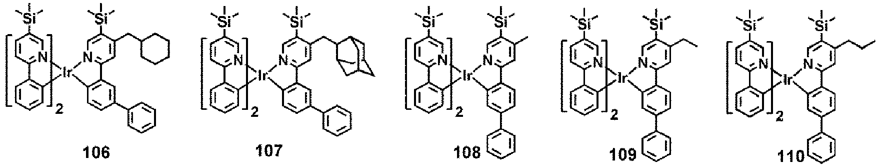

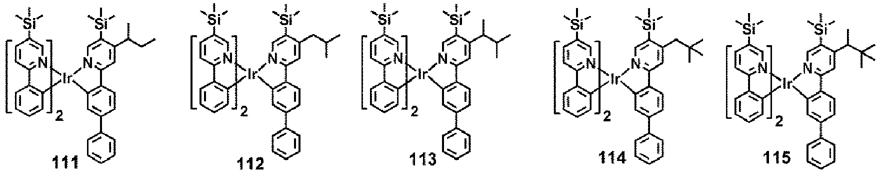

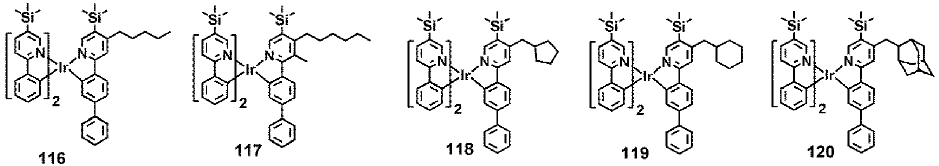

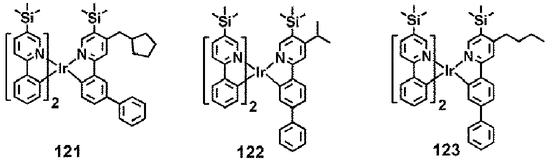

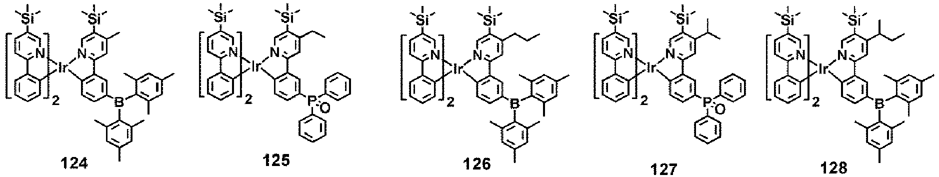

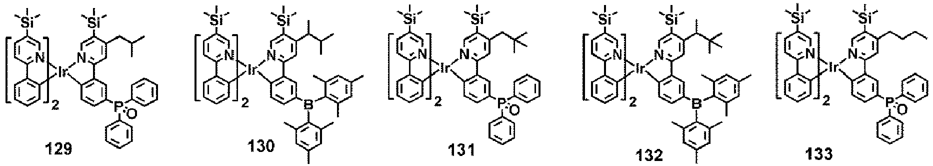

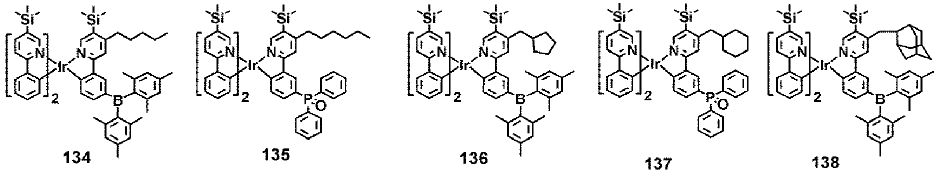

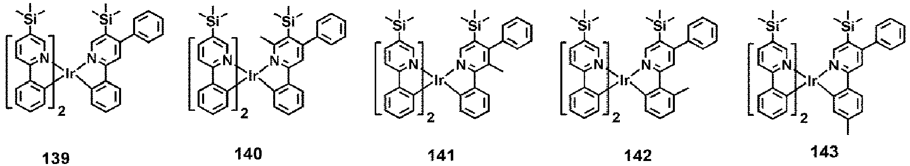

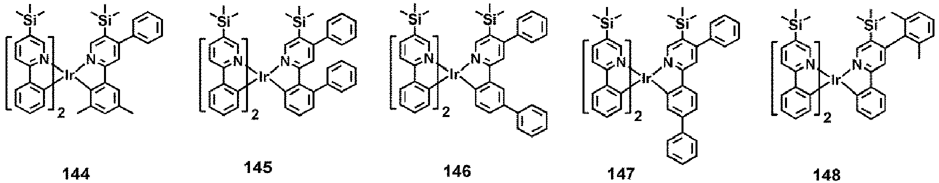

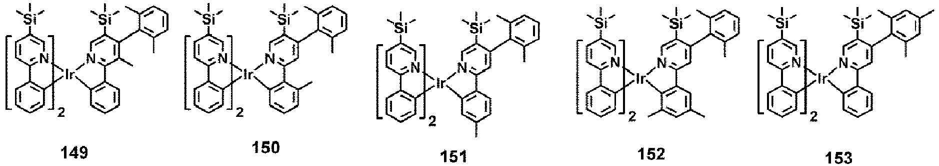

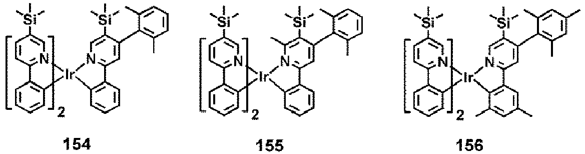

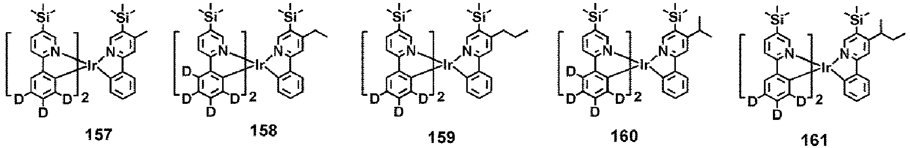

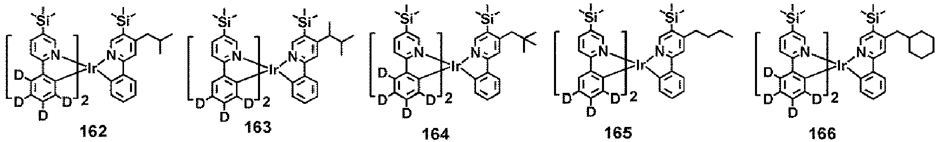

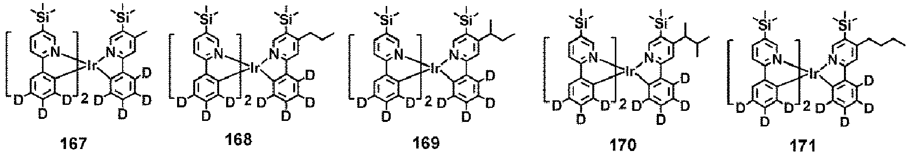

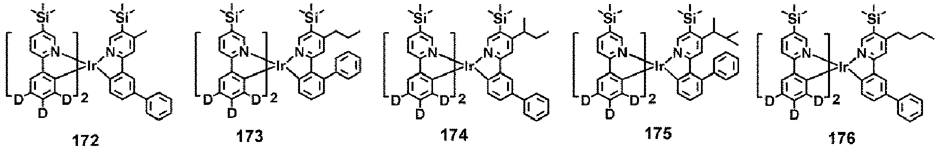

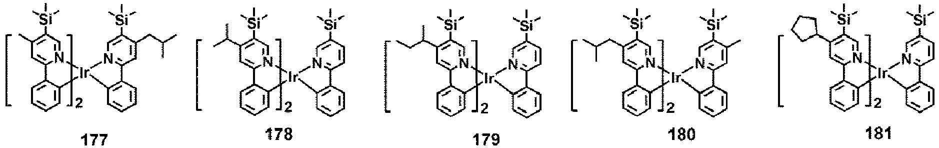

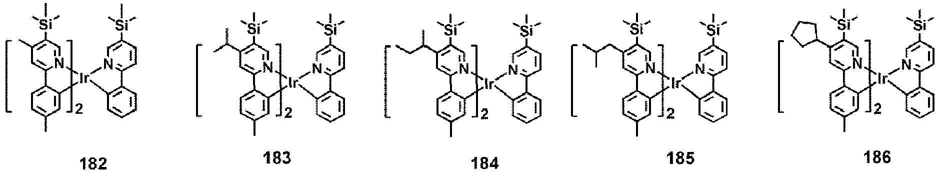

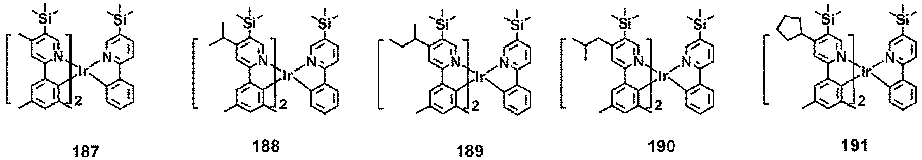

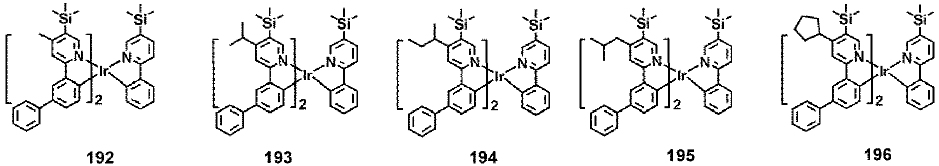

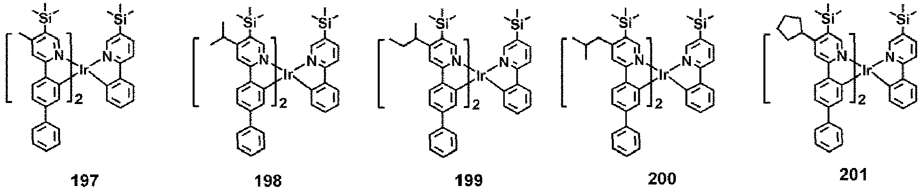

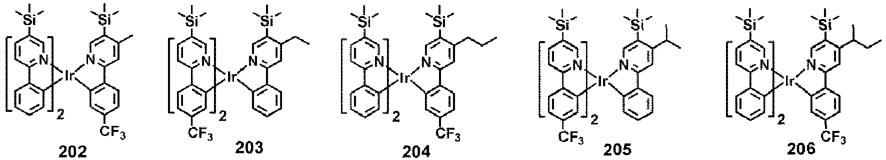

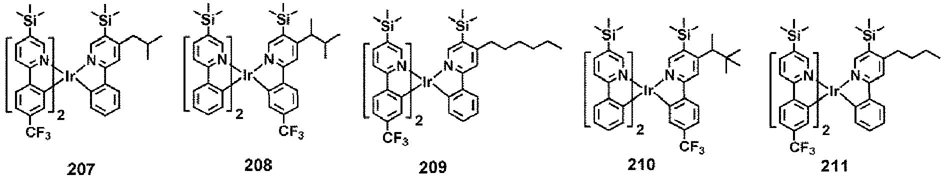

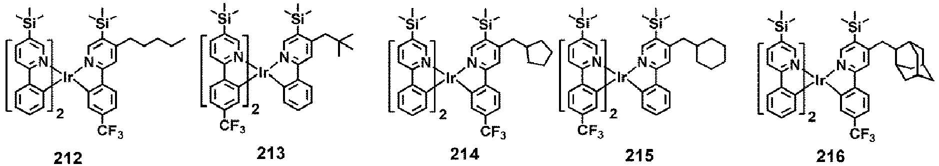

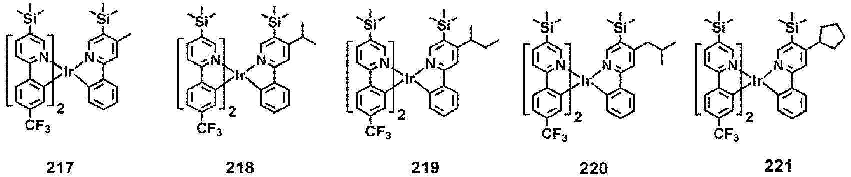

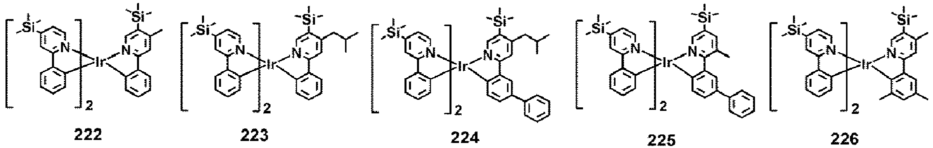

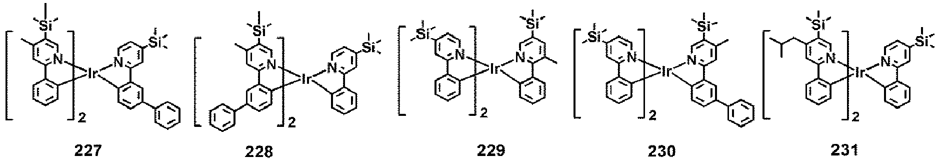

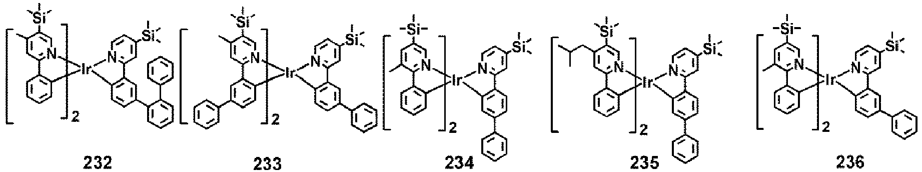

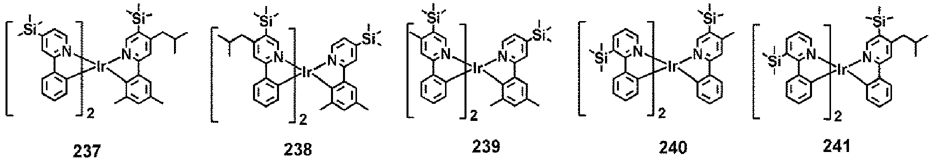

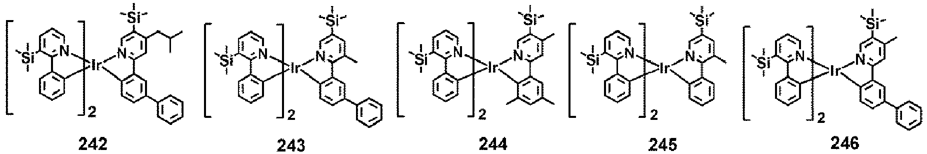

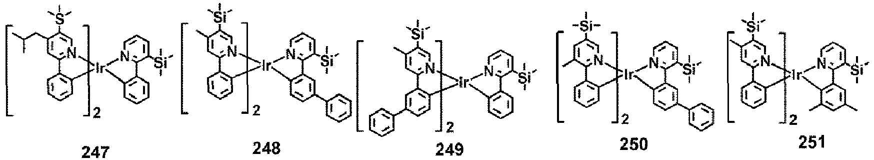

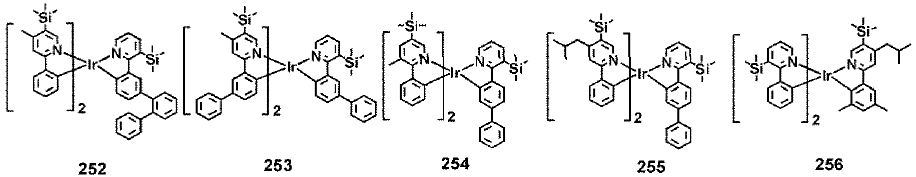

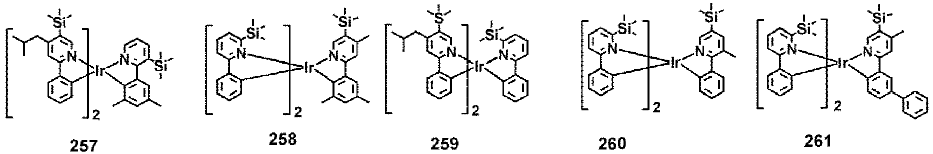

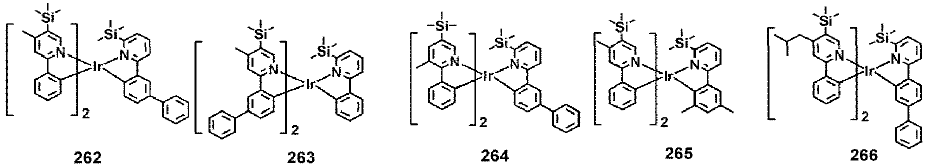

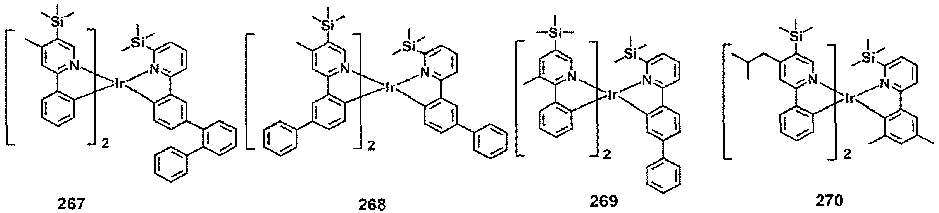

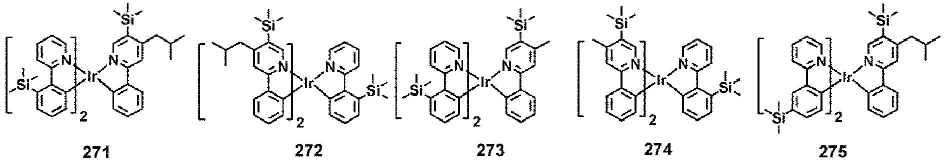

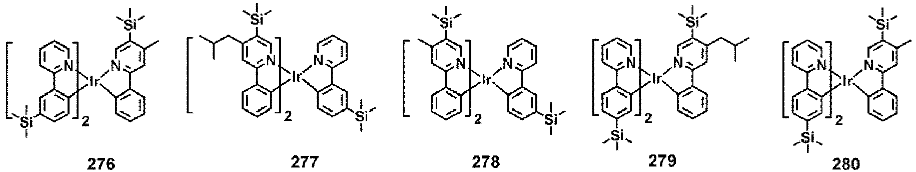

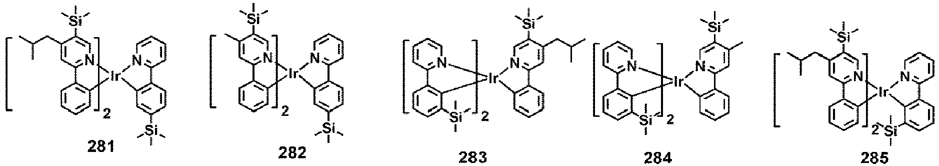

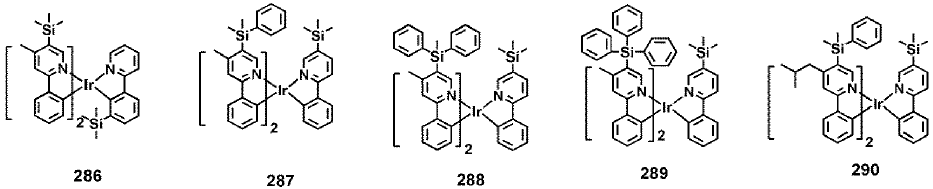

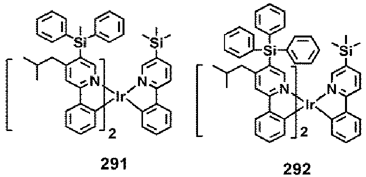

L₁ in the organometallic compound represented by Formula 1 may be represented by Formula 2A, provided that i) one selected from R₁₁ to R₁₄ in Formula 2A or ii) one selected from R₁₅ in the number of b1 in Formula 2A, is -Si(R₁)(R₂)(R₃). That is, Ligand L₁ represented by Formula 2A essentially has one substituent represented by -Si(R₁)(R₂)(R₃). Accordingly, a device including the organometallic compound, for example, an organic light-emitting device including the organometallic compound, may have a high efficiency and a long lifespan.

Also, at least one selected from R₂₁ to R₂₃ in Formula 2B may not be a hydrogen. That is, a case that all of R₂₁ to R₂₃ in Formula 2B are simultaneously a hydrogen is excluded. In some embodiments, R₂₂ in Formula 2B may not be a hydrogen. Accordingly, the organometallic compound represented by Formula 1 may emit blue light, green light or blue-green light shifted to a relatively short wavelength, and a device including the organometallic compound, for example, an organic light-emitting device including the organometallic compound, may have a high efficiency and a long lifespan.

A silyl group (-Si(R₄)(R₅)(R₆)) in Formula 2B may bond to the fifth position of a pyridine ring (with reference to Formula 2B). Due to the bonding, the organometallic compound including a ligand represented by Formula 2B may have excellent heat resistance and decomposition resistance characteristics. Accordingly, a device including the organometallic compound, for example, an organic light-emitting device including the organometallic compound, may have a high stability during manufacturing, preserving, and/or driving, and a long lifespan.

For example, highest occupied molecular orbital (HOMO), lowest unoccupied molecular orbital (LUMO), singlet (S₁) and triplet (T₁) energy levels of some of the organometallic compounds were evaluated by using a density functional theory (DFT) method of Gaussian program (structurally optimized at a level of B3LYP, 6-31G(d,p)). Evaluation results are shown in Table 1 below.

**Table 1**

| Compound No. | HOMO (eV) | LUMO (eV) | S₁ energy level (eV) | T₁ energy level (eV) |
|---|---|---|---|---|
| 1 | -4.77 | -1.208 | 2.828 | 2.573 |
| 2 | -4.740 | -1.164 | 2.848 | 2.587 |
| 3 | -4.770 | -1.223 | 2.820 | 2.57 |
| 4 | -4.743 | -1.203 | 2.817 | 2.567 |
| 5 | -4.793 | -1.168 | 2.892 | 2.631 |
| 79 | -4.794 | -1.225 | 2.839 | 2.574 |
| 99 | -4.762 | -1.249 | 2.819 | 2.559 |
| 112 | -4.799 | -1.270 | 2.821 | 2.522 |
| 139 | -4.795 | -1.297 | 2.785 | 2.545 |
| 162 | -4.770 | -1.208 | 2.828 | 2.573 |
| 180 | -4.710 | -1.167 | 2.821 | 2.572 |
| 195 | -4.757 | -1.262 | 2.809 | 2.533 |
| 231 | -4.724 | -1.178 | 2.797 | 2.558 |
| 279 | -4.821 | -1.248 | 2.827 | 2.567 |
| 288 | -4.755 | -1.236 | 2.805 | 2.562 |
| 290 | -4.812 | -1.302 | 2.784 | 2.440 |
| 292 | -4.715 | -1.195 | 2.790 | 2.553 |
| A | -5.112 | -1.536 | 2.859 | 2.579 |

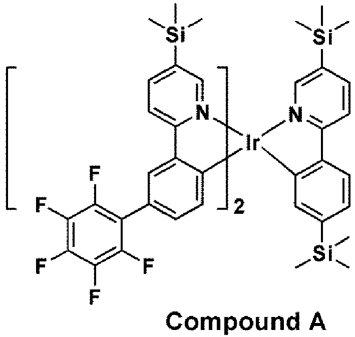

Based on Table 1, the organometallic compound represented by Formula 1 has a high HOMO energy level (that is, a small HOMO energy level absolute value) compared to Compound A, so the organometallic compound represented by Formula 1 may have an excellent hole injection balance. Accordingly, an electronic device including the organometallic compound represented by Formula 1, for example, an organic light-emitting device including the organometallic compound represented by Formula 1, may have a high efficiency and a long lifespan.

Synthesis methods of the organometallic compound represented by Formula 1 may be understood to one of ordinary skill in the art by referring to Synthesis Example, which will be described later.

Accordingly, the organometallic compound represented by Formula 1 may be used as a dopant for an organic layer of an organic light-emitting device, for example, an emission layer in the organic layer, and therefore, according to an aspect of another exemplary embodiment, there is provided an organic light-emitting device including:
a first electrode,
a second electrode, and
an organic layer disposed between the first electrode and the second electrode,
wherein the organic layer includes an emission layer and at least one organometallic compound represented by Formula 1.

Due to the inclusion of an organic layer including the organometallic compound represented by Formula 1, the organic light-emitting device may have a low driving voltage, a high efficiency, a high power, a high quantum efficiency, a long lifespan, and excellent color purity.

The organometallic compound represented by Formula 1 may be used between a pair of electrodes of an organic light-emitting device. For example, the organometallic compound represented by Formula 1 may be included in the emission layer. In this regard, the organometallic compound may serve as a dopant, and the emission layer may further include a host (that is, an amount of the organometallic compound represented by Formula 1 in the emission layer is smaller than that of the host in the emission layer).

"(For example, the organic layer) including at least one organometallic compound" used herein may be interpreted as "(the organic layer) including one of the organometallic compounds of Formula 1 or at least two different organometallic compounds of Formula 1."

For example, the organic layer may include only Compound 1 as the organometallic compound. In this regard, Compound 1 may be present in the emission layer of the organic light-emitting device. In some embodiments, the organic layer may include Compound 1 and Compound 2 as the organometallic compounds. In this regard, Compound 1 and Compound 2 may be present in the same layer (for example, both of Compound 1 and Compound 2 may be present in the emission layer).

The first electrode may be an anode, which is a hole injection electrode, and the second electrode may be a cathode, which is an electron injection electrode; or the first electrode may be a cathode, which is an electron injection electrode, or the second electrode may be an anode, which is a hole injection electrode.

For example, the first electrode may be an anode, the second electrode may be a cathode, and the organic layer may include:
i) a hole transport region disposed between the first electrode and the emission layer, wherein the hole transport region includes at least one selected from a hole injection layer, a hole transport layer, and an electron blocking layer, and
ii) an electron transport region disposed between the emission layer and the second electrode, wherein the electron transport region includes at least one selected from a hole blocking layer, an electron transport layer, and an electron injection layer.

The term "organic layer" used herein refers to a single layer and/or a plurality of layers disposed between the first electrode and the second electrode of the organic light-emitting device. The "organic layer" may include not only an organic compound but also an organometallic complex including a metal.

FIG. 1 is a schematic cross-sectional view of an organic light-emitting device 10 according to an embodiment. Hereinafter, a structure of an organic light-emitting device according to an embodiment and a method of manufacturing the same will be described with reference to FIG. 1. The organic light-emitting device 10 includes a first electrode 11, an organic layer 15, and a second electrode 19 that are sequentially stacked.

A substrate may be additionally disposed under the first electrode 11 or on the second electrode 19. For use as the substrate, a substrate used in a general organic light-emitting device may be used, and the substrate may be a glass or transparent plastic substrate with excellent mechanical strength, thermal stability, transparency, surface smoothness, ease of handling, and water-resistance.

For example, the first electrode 11 may be formed by depositing or sputtering a material for forming the first electrode 11 on the substrate. The first electrode 11 may be an anode. The material for forming the first electrode 11 may be selected from materials having a high work function to facilitate hole injection. The first electrode 11 may be a reflective electrode, a semi-transmissive electrode, or a transmissive electrode. Indium tin oxide (ITO), indium zinc oxide (IZO), tin oxide (SnO₂), or zinc oxide (ZnO) may be used as the material for forming the first electrode 11. Alternatively, a metal such as magnesium (Mg), aluminum (Al), aluminum-lithium (Al-Li), calcium (Ca), magnesium-indium (Mg-In), or magnesium-silver (Mg-Ag) may be used.

The first electrode 11 may have a single-layer structure or a multi-layer structure including two or more layers. For example, the first electrode 11 may have a three-layered structure of ITO/Ag/ITO, but the structure of the first electrode 110 is not limited thereto.

The organic layer 15 is disposed on the first electrode 11.

The organic layer 15 may include a hole transport region, an emission layer, and an electron transport region.

The hole transport region may be disposed between the first electrode 11 and the emission layer.

The hole transport region may include at least one of a hole injection layer, a hole transport layer, an electron blocking layer, and a buffer layer.

The hole transport region may include only either a hole injection layer or a hole transport layer. In some embodiments, the hole transport region may have a structure of hole injection layer/hole transport layer or hole injection layer/hole transport layer/electron blocking layer, which are sequentially stacked on the first electrode 11 in the order stated above.

When the hole transport region includes a hole injection layer, the hole injection layer may be formed on the first electrode 11 by using any of a variety of methods, for example, by using vacuum deposition, spin coating, casting, Langmuir-Blodgett (LB) deposition, or the like.

When the hole injection layer is formed using vacuum deposition, the deposition conditions may vary depending on a compound used to form the hole injection layer, an intended structure of the hole injection layer, thermal properties of the hole injection layer, and the like. For example, the deposition conditions may be selected from the following conditions: a deposition temperature of about 100°C to about 500°C, a degree of vacuum of about 10⁻⁸ torr to about 10⁻³ torr, and a deposition rate of about 0.001 nanometers per second (nm/sec) (0.01 Angstroms per second (Å/sec)) to about 10 nm/sec (100 Å/sec). However, the deposition conditions are not limited thereto.

When the hole injection layer is formed using spin coating, the coating conditions may vary depending on a compound used to form the hole injection layer, an intended structure of the hole injection layer, thermal properties of the hole injection layer, and the like. For example, the coating conditions may be selected from the following conditions: a coating rate of about 2,000 revolutions per minute (rpm) to about 5,000 rpm, and a temperature at which heat treatment is performed to remove a solvent after coating of about 80°C to about 200°C. However, the coating conditions are not limited thereto.

Conditions for forming the hole transport layer and the electron blocking layer may be understood by referring to the above conditions for forming the hole injection layer.

The hole transport region may include, for example, at least one selected from m-MTDATA, TDATA, 2-TNATA, NPB, β-NPB, TPD, Spiro-TPD, Spiro-NPB, methylated-NPB, TAPC, HMTPD, 4,4',4"-tris(N-carbazolyl)triphenylamine (TCTA), polyaniline/dodecylbenzene sulfonic acid (Pani/DBSA), poly(3,4-ethylenedioxythiophene)/poly(4-styrenesulfonate) (PEDOT/PSS), polyaniline/camphor sulfonic acid (Pani/CSA), polyaniline/poly(4-styrenesulfonate) (PANI/PSS), a compound represented by Formula 201 below, and a compound represented by Formula 202 below:

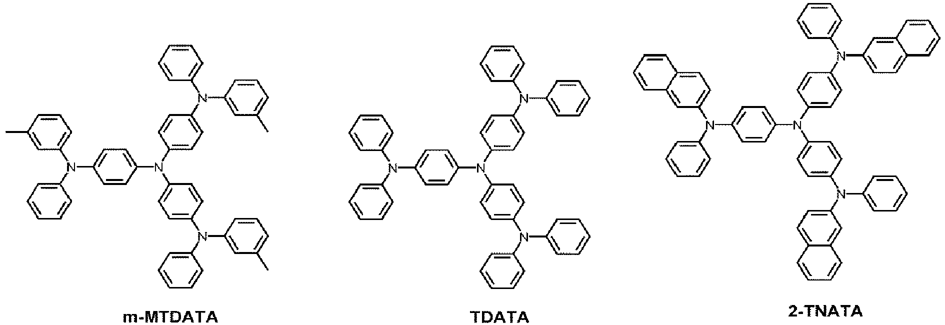

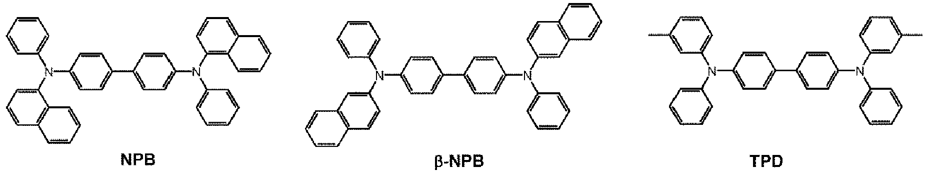

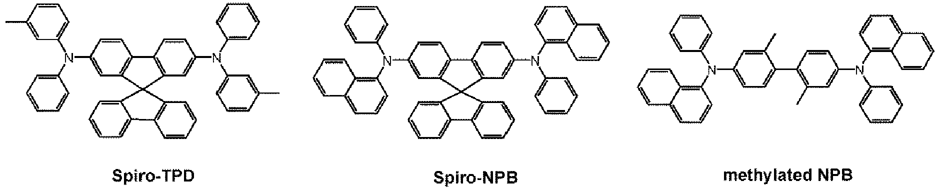

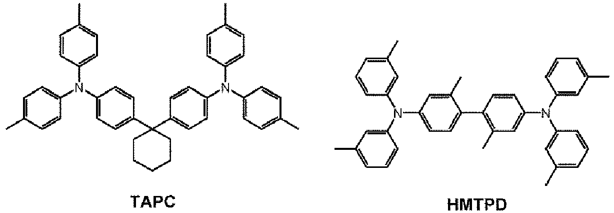

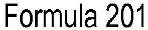

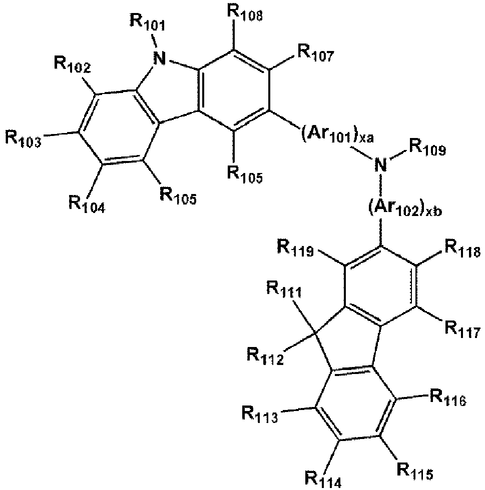

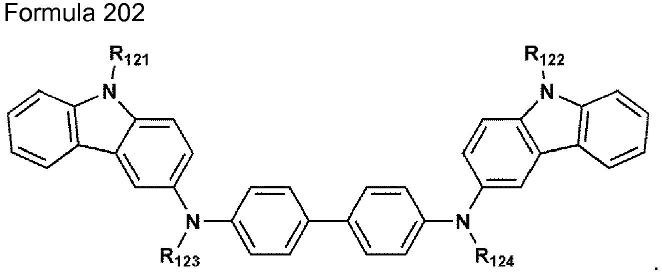

Ar₁₀₁ and Ar₁₀₂ in Formula 201 may be each independently selected from
a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group; and
a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, and a pentacenylene group, each substituted with at least one selected from a deuterium, - F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₆-C₆₀ aryloxy group, a C₆-C₆₀ arylthio group, a substituted or unsubstituted C₇-C₆₀ arylalkyl group, a C₁-C₆₀ heteroaryl group, a substituted or unsubstituted C₁-C₆₀ heteroaryloxy group, a substituted or unsubstituted C₁-C₆₀ heteroarylthio group, a substituted or unsubstituted C₂-C₆₀ heteroarylalkyl group, a monovalent non-aromatic condensed polycyclic group, and a monovalent non-aromatic condensed heteropolycyclic group.
xa and xb in Formula 201 may be each independently an integer of 0 to 5, or 0, 1, or 2. For example, xa may be 1, and xb may be 0, but xa and xb are not limited thereto.
R₁₀₁ to R₁₀₈, R₁₁₁ to R₁₁₉, and R₁₂₁ to R₁₂₄ in Formulae 201 and 202 may be each independently selected from
a hydrogen, a deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (for example, a methyl group, an ethyl group, a propyl group, a butyl group, a pentyl group, a hexyl group, and so on), and a C₁-C₁₀ alkoxy group (for example, a methoxy group, an ethoxy group, a propoxy group, a butoxy group, a pentoxy group, and so on);
a C₁-C₁₀ alkyl group or a C₁-C₁₀ alkoxy group, each substituted with at least one selected from a deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, and a phosphoric acid group or a salt thereof;
a phenyl group, a naphthyl group, an anthracenyl group, a fluorenyl group, and a pyrenyl group; and
a phenyl group, a naphthyl group, an anthracenyl group, a fluorenyl group, and a pyrenyl group, each substituted with at least one selected from a deuterium, - F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, and a C₁-C₁₀ alkoxy group, but are not limited thereto.

R₁₀₉ in Formula 201 may be selected from
a phenyl group, a naphthyl group, an anthracenyl group, and a pyridinyl group; and
a phenyl group, a naphthyl group, an anthracenyl group, and a pyridinyl group, each substituted with at least one selected from a deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, an anthracenyl group, and a pyridinyl group.

In some embodiments, the compound represented by Formula 201 may be represented by Formula 201A, but is not limited thereto:

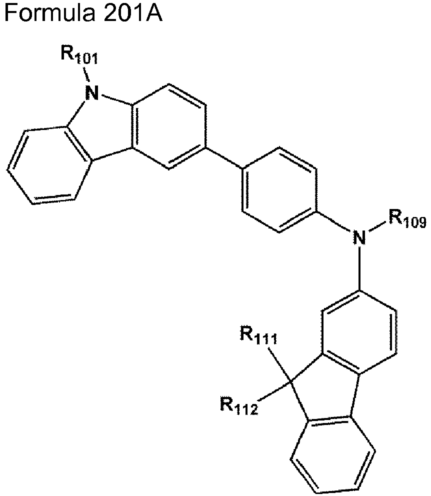

R₁₀₁, R₁₁₁, R₁₁₂, and R₁₀₉ in Formula 201A may be understood by referring to the description provided herein.

For example, the compound represented by Formula 201 and the compound represented by Formula 202 may include Compounds HT1 to HT20 illustrated below, but are not limited thereto:

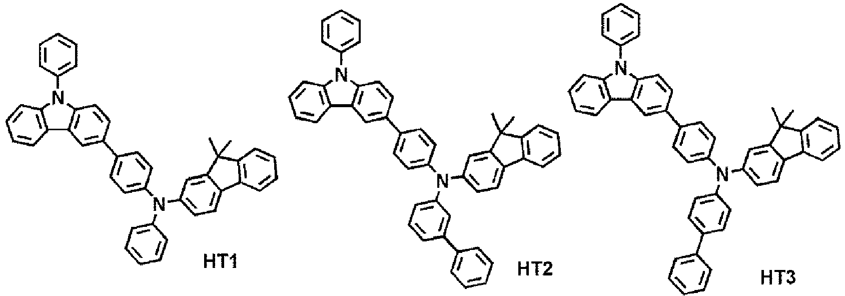

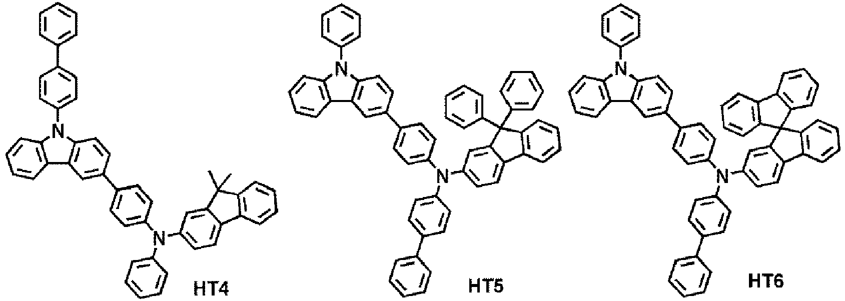

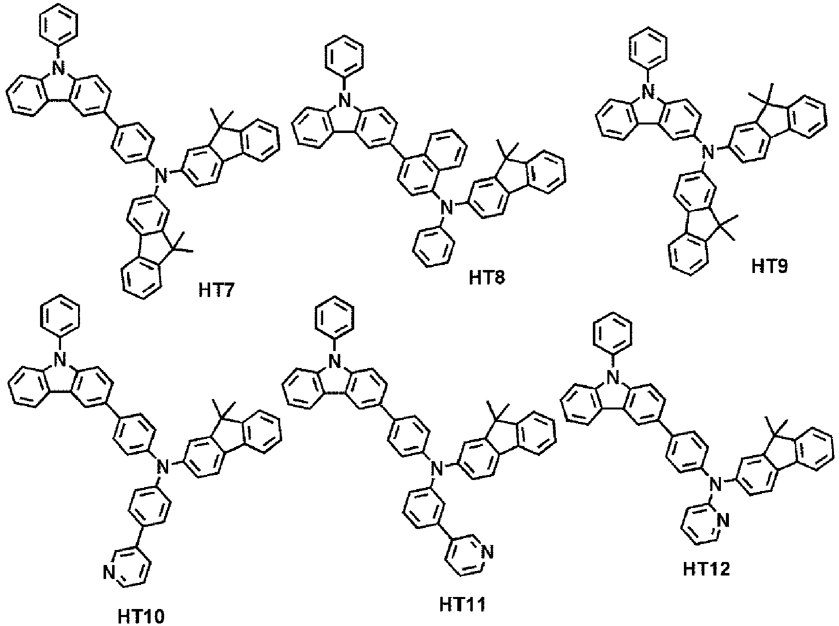

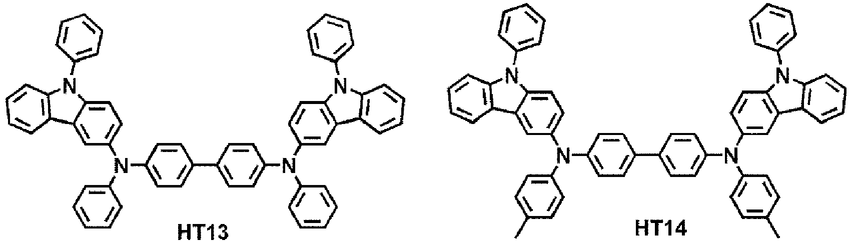

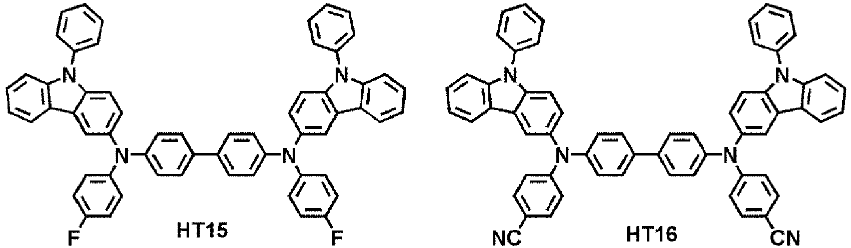

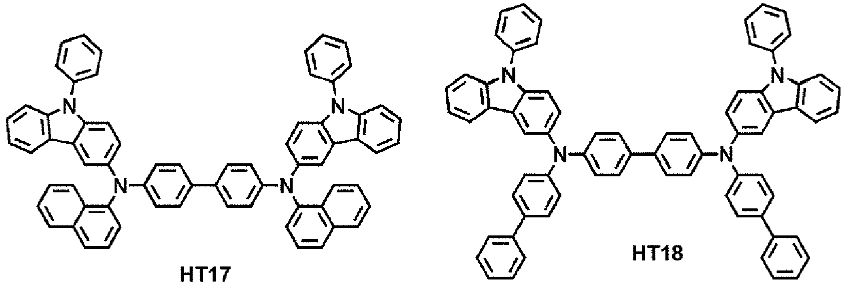

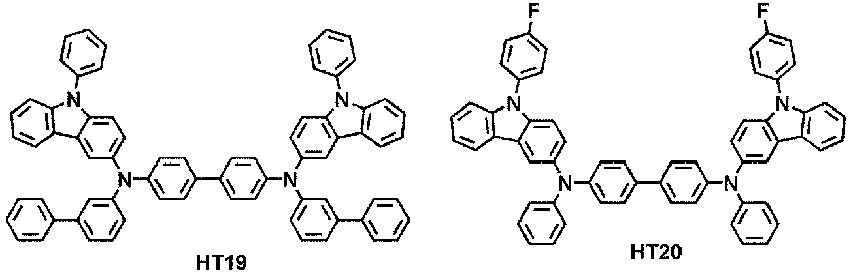

A thickness of the hole transport region may be from about 10 nm (100 Å) to about 1,000 nm (10,000 Å), for example, about 10 nm (100 Å) to about 100 nm (1,000 Å). While not wishing to be bound by a theory, it is understood that when the hole transport region includes a hole injection layer and a hole transport layer, a thickness of the hole injection layer may be from about 10 nm (100 Å) to about 1,000 nm (10,000 Å), for example, about 10 nm (100 Å) to about 100 nm (1,000 Å), and a thickness of the hole transport layer may be from about 5 nm (50 Å) to about 200 nm (2,000 Å), for example, about 10 nm (100 Å) to about 150 nm (1,500 Å). While not wishing to be bound by a theory, it is understood that when the thicknesses of the hole transport region, the hole injection layer, and the hole transport layer are within these ranges, satisfactory hole transport characteristics may be obtained without a substantial increase in driving voltage.

In addition to the materials as described above, the hole transport region may further include a charge-generating material for the improvement of conductivity. The charge-generating material may be homogeneously or non-homogeneously dispersed in the hole transport region.

The charge-generating material may be, for example, a p-dopant. The p-dopant may be one of a quinone derivative, a metal oxide, and a cyano group-containing compound, but is not limited thereto. Non-limiting examples of the p-dopant are a quinone derivative such as tetracyanoquinonedimethane (TCNQ) or 2,3,5,6-tetrafluoro-tetracyano-1,4-benzoquinonedimethane (F4-TCNQ); a metal oxide such as a tungsten oxide or a molybdenium oxide; and a cyano group-containing compound such as Compound HT-D1 below, but are not limited thereto.

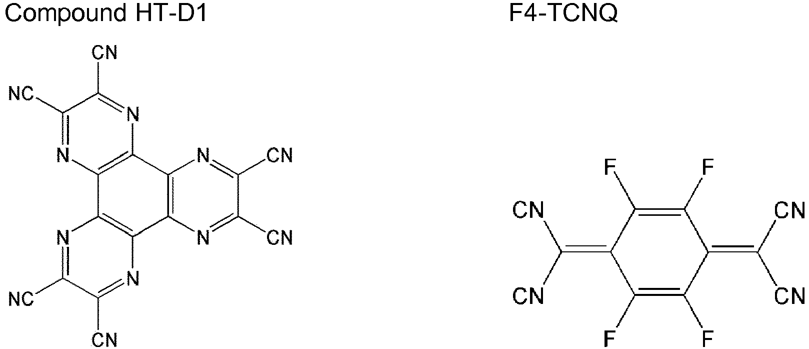

The hole transport region may include a buffer layer.

The buffer layer may compensate for an optical resonance distance according to a wavelength of light emitted from the emission layer, and thus may improve light-emission efficiency.

The emission layer may be formed on the hole transport region by using vacuum deposition, spin coating, casting, LB deposition, or the like. When the emission layer is formed using vacuum deposition or spin coating, the deposition and coating conditions for forming the emission layer may vary depending on a compound that is used to form the emission layer. However, the deposition and coating conditions for forming the emission layer may be selected from ranges almost identical with those for forming the hole injection layer.

Meanwhile, when the hole transport region includes an electron blocking layer, a material for forming the electron blocking layer may be selected from a material as described above that may be used for the hole transport region and a material for a host, which will be explained later. However, the material for forming the electron blocking layer is not limited thereto. For example, when the hole transport region includes an electron blocking layer, a material for forming the electron blocking layer may be mCP, which will be explained later.

The emission layer may include a host and a dopant, and the dopant may include the organometallic compound represented by Formula 1.

The host may include at least one selected form TPBi, TBADN, ADN (also referred to as "DNA"), CBP, CDBP, TCP, mCP, Compound H50, and Compound H51 below:

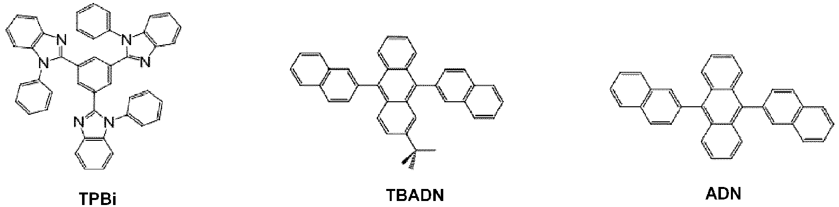

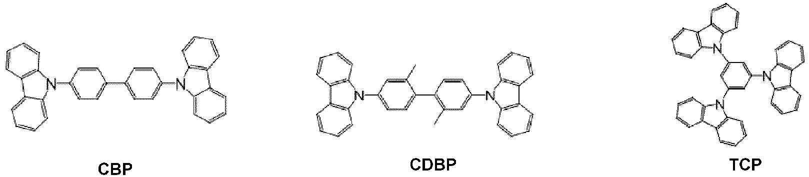

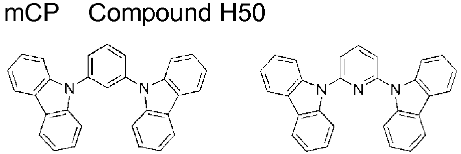

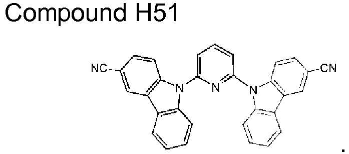

In some embodiments, the host may further include a compound represented by Formula 301 below:

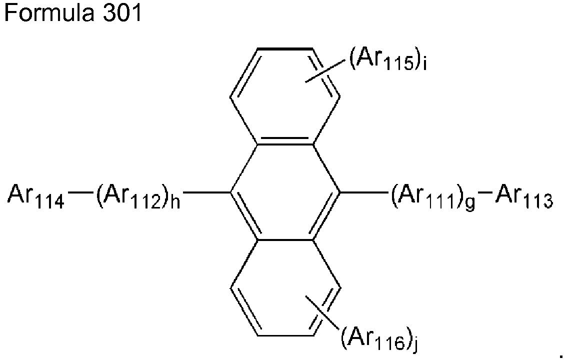

Ar₁₁₁ and Ar₁₁₂ in Formula 301 may be each independently selected from
a phenylene group, a naphthylene group, a phenanthrenylene group, and a pyrenylene group; and
a phenylene group, a naphthylene group, a phenanthrenylene group, and a pyrenylene group, each substituted with at least one selected from a phenyl group, a naphthyl group, and an anthracenyl group.
Ar₁₁₃ to Ar₁₁₆ in Formula 301 may be each independently selected from
a C₁-C₁₀ alkyl group, a phenyl group, a naphthyl group, a phenanthrenyl group, and a pyrenyl group; and
a phenyl group, a naphthyl group, a phenanthrenyl group, and a pyrenyl group, each substituted with at least one selected from a phenyl group, a naphthyl group, and an anthracenyl group.
g, h, i, and j in Formula 301 may be each independently an integer of 0 to 4, for example, 0, 1, or 2.
Ar₁₁₃ to Ar₁₁₆ in Formula 301 may be each independently selected from
a C₁-C₁₀ alkyl group substituted with at least one selected from a phenyl group, a naphthyl group, and an anthracenyl group;
a phenyl group, a naphthyl group, an anthracenyl group, a pyrenyl, a phenanthrenyl group, and a fluorenyl group;
a phenyl group, a naphthyl group, an anthracenyl group, a pyrenyl group, a phenanthrenyl group, and a fluorenyl group, each substituted with at least one selected from a deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a phenyl group, a naphthyl group, an anthracenyl group, a pyrenyl group, a phenanthrenyl group, and a fluorenyl group; and 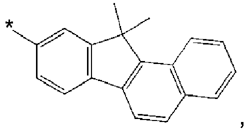 but are not limited thereto.

In some embodiments, the host may include a compound represented by Formula 302 below:

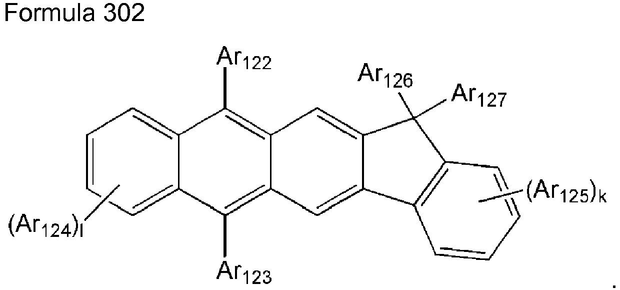

Ar₁₂₂ to Ar₁₂₅ in Formula 302 may be understood by referring to the description of Ar₁₁₃ in Formula 301.

Ar₁₂₆ and Ar₁₂₇ in Formula 302 may be each independently a C₁-C₁₀ alkyl group (for example, a methyl group, an ethyl group, or a propyl group).

k and I in Formula 302 may be each independently an integer of 0 to 4. For example, k and I may be 0, 1, or 2.

The compound represented by Formula 301 and the compound represented by Formula 302 may include Compounds H1 to H42 below, but are not limited thereto.

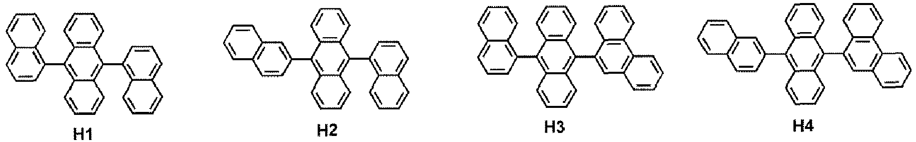

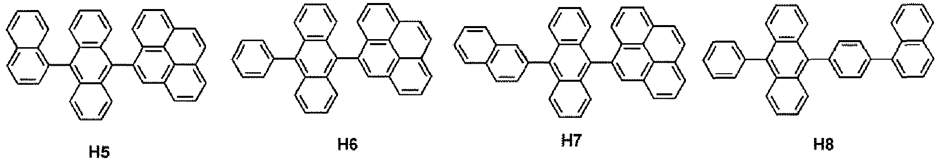

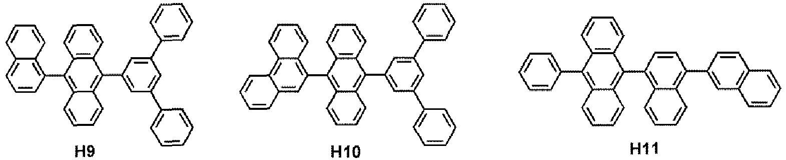

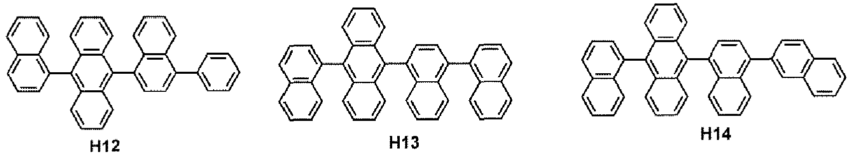

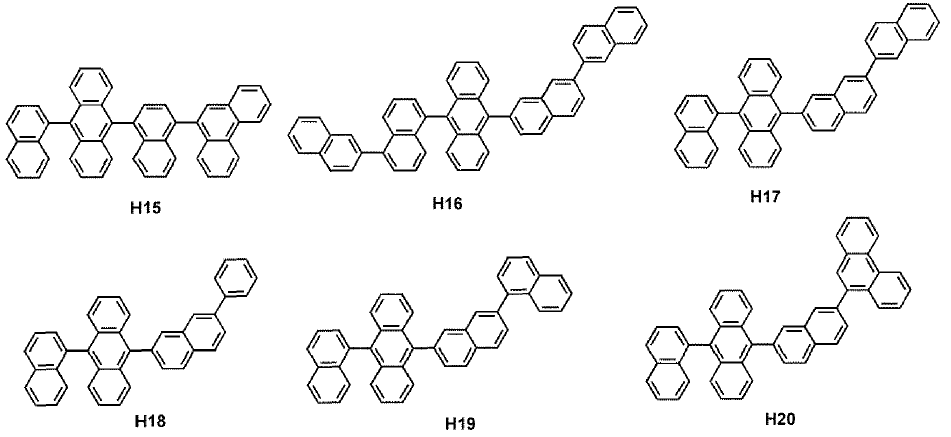

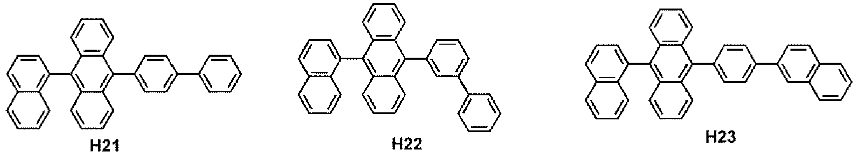

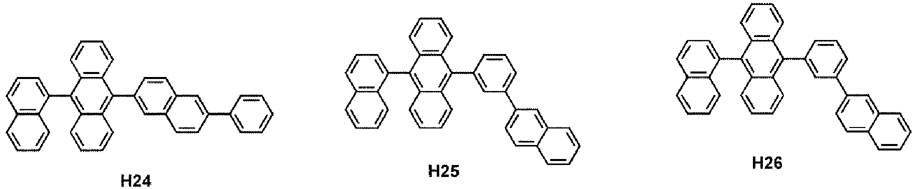

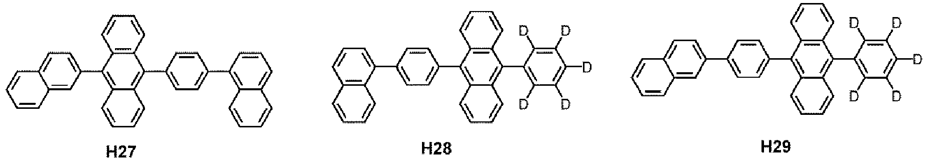

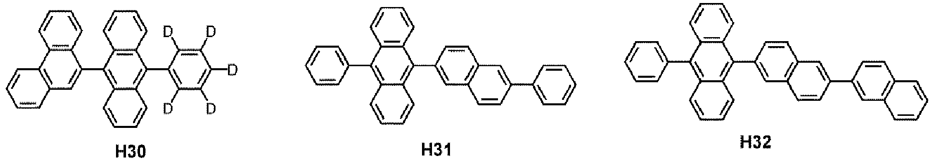

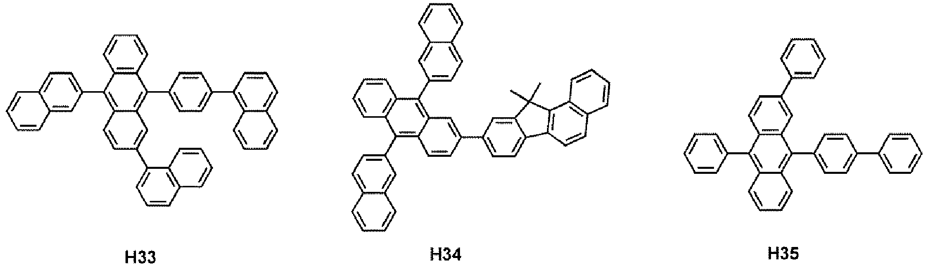

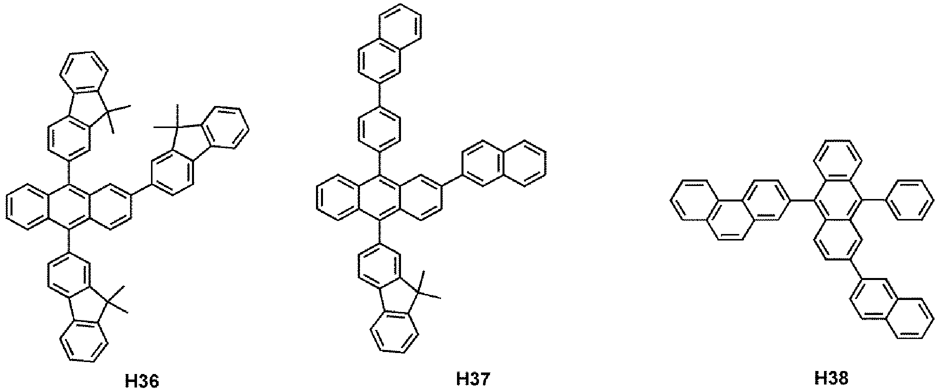

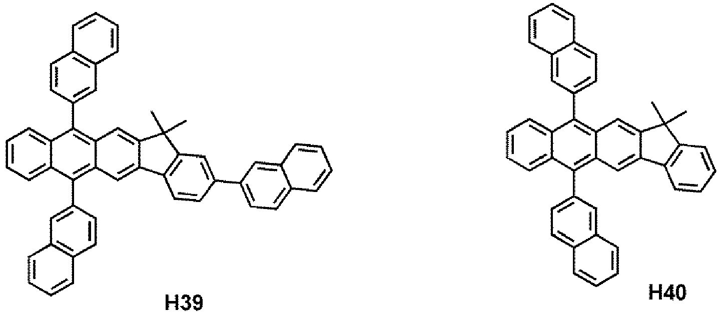

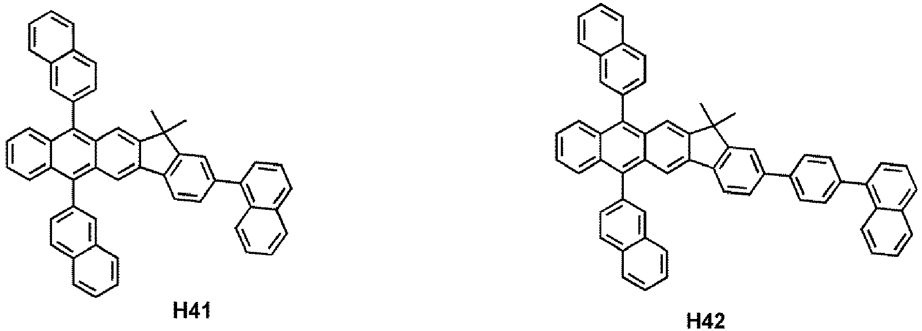

When the organic light-emitting device is a full color organic light-emitting device, the emission layer may be patterned into a red emission layer, a green emission layer, and a blue emission layer. The emission layer may have various modifications, for example, in some embodiments, the emission layer may have a structure in which a red emission layer, a green emission layer and/or a blue emission layer are stacked upon one another and thus may emit white light.

When the emission layer includes a host and a dopant, an amount of the dopant in the emission layer may be from about 0.01 parts to about 15 parts by weight based on 100 parts by weight of the host, but is not limited thereto.

A thickness of the emission layer may be from about 10 nm (100 Angstroms (Å)) to about 100 nm (1,000 Å), for example, from about 20 nm (200 Å) to about 60 nm (600 Å). While not wishing to be bound by a theory, it is understood that when the thickness of the emission layer is within this range, the emission layer may have excellent light-emitting characteristics without a substantial increase in driving voltage.

Next, the electron transport region may be disposed on the emission layer.

The electron transport region may include at least one selected from a hole blocking layer, an electron transport layer, and an electron injection layer.

For example, the electron transport region may have a structure of hole blocking layer/electron transport layer/electron injection layer or a structure of electron transport layer/electron injection layer, but a structure of the electron transport region is not limited thereto. The electron transport layer may have a single-layered structure or a multi-layer structure including two or more different materials.

Conditions for forming the hole blocking layer, the electron transport layer, and the electron injection layer of the electron transport region may be understood by referring to the conditions for forming the hole injection layer.

When the electron transport region includes a hole blocking layer, the hole blocking layer may include, for example, at least one selected from BCP, Bphen, and BAlq, but is not limited thereto.

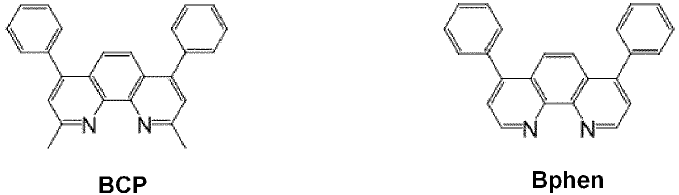

A thickness of the hole blocking layer may be from about 2 nm (20 Å) to about 100 nm (1000 Å), for example, about 3 nm (30 Å) to about 30 nm (300 Å). While not wishing to be bound by a theory, it is understood that when the thickness of the hole blocking layer is within this range, excellent hole blocking characteristics may be obtained without a substantial increase in driving voltage.

The electron transport layer may further include at least one selected from BCP, Bphen, Alq₃, Balq, TAZ, and NTAZ.

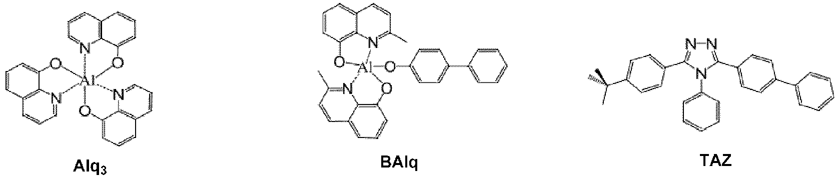

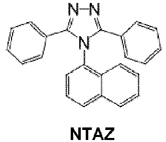

In some embodiments, the electron transport layer may include at least one selected from Compounds ET1 and ET2 below, but is not limited thereto.

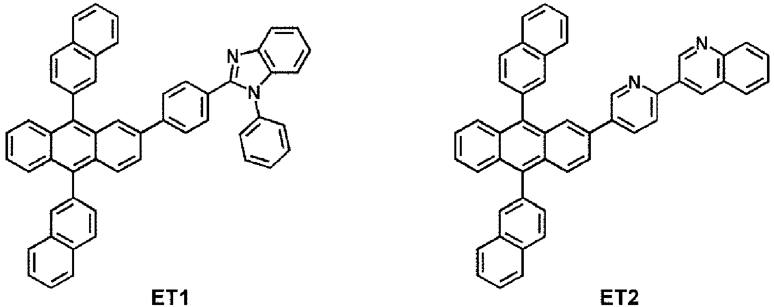

A thickness of the electron transport layer may be from about 10 nm (100 Å) to about 100 nm (1,000 Å), for example, about 15 nm (150 Å) to about 50 nm (500 Å). While not wishing to be bound by a theory, it is understood that when the thickness of the electron transport layer is within this range, satisfactory electron transporting characteristics may be obtained without a substantial increase in driving voltage.

In addition to the materials described above, the electron transport layer may further include a metal-containing material.

The metal-containing material may include a Li complex. The Li complex may include, for example, Compound ET-D1 (lithium quinolate, LiQ) or ET-D2 below.

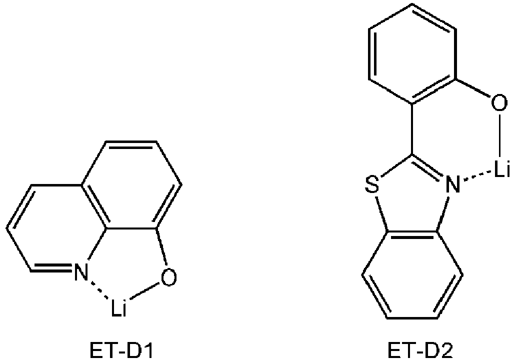

The electron transport region may include an electron injection layer that may facilitate injection of electrons from the second electrode 19.

The electron injection layer may include at least one selected from LiF, NaCl, CsF, Li₂O, and BaO.

A thickness of the electron injection layer may be from about 0.1 nm (1 Å) to about 10 nm (100 Å), for example, from about 0.3 nm (3 Å) to about 9 nm (90 Å). While not wishing to be bound by a theory, it is understood that when the thickness of the electron injection layer is within this range, satisfactory electron injection characteristics may be obtained without a substantial increase in driving voltage.

The second electrode 19 is disposed on the organic layer 15. The second electrode 19 may be a cathode. A material for forming the second electrode 19 may be a metal, an alloy, an electrically conductive compound, or a combination thereof, which have a relatively low work function. For example, lithium (Li), magnesium (Mg), aluminum (Al), aluminum-lithium (Al-Li), calcium (Ca), magnesium-indium (Mg-In), magnesium-silver (Mg-Ag), or the like may be used as the material for forming the second electrode 19. The material for forming the second electrode 19 may have various modifications, for example, in some embodiments, in order to obtain a top-emission type light-emitting device, ITO or IZO may be used to form a transmissive second electrode 19.

Although the organic light-emitting device has been described above with reference to FIG. 1, one or more embodiments are not limited thereto.

A C₁-C₆₀ alkyl group as used herein refers to a linear or branched aliphatic saturated hydrocarbon monovalent group having 1 to 60 carbon atoms. Detailed examples thereof are a methyl group, an ethyl group, a propyl group, an isobutyl group, a sec-butyl group, a tert-butyl group, a pentyl group, an iso-amyl group, and a hexyl group. A C₁-C₆₀ alkylene group as used herein refers to a divalent group having the same structure as the C₁-C₆₀ alkyl group.

A C₁-C₆₀ alkoxy group as used herein refers to a monovalent group represented by -OA₁₀₁ (wherein A₁₀₁ is the C₁-C₆₀ alkyl group). Detailed examples thereof are a methoxy group, an ethoxy group, and an isopropyloxy group.

A C₂-C₆₀ alkenyl group as used herein refers to a hydrocarbon group formed by substituting at least one carbon-carbon double bond in the middle or at the terminal of the C₂-C₆₀ alkyl group. Detailed examples thereof are an ethenyl group, a propenyl group, and a butenyl group. A C₂-C₆₀ alkenylene group as used herein refers to a divalent group having the same structure as the C₂-C₆₀ alkenyl group.

A C₂-C₆₀ alkynyl group as used herein refers to a hydrocarbon group formed by substituting at least one carbon-carbon triple bond in the middle or at the terminal of the C₂-C₆₀ alkyl group. Detailed examples thereof are an ethynyl group, and a propynyl group. A C₂-C₆₀ alkynylene group as used herein refers to a divalent group having the same structure as the C₂-C₆₀ alkynyl group.

A C₃-C₁₀ cycloalkyl group as used herein refers to a monovalent saturated hydrocarbon monocyclic group having 3 to 10 carbon atoms. Detailed examples thereof are a cyclopropyl group, a cyclobutyl group, a cyclopentyl group, a cyclohexyl group, and a cycloheptyl group. A C₃-C₁₀ cycloalkylene group as used herein refers to a divalent group having the same structure as the C₃-C₁₀ cycloalkyl group.

A C₁-C₁₀ heterocycloalkyl group as used herein refers to a monovalent monocyclic group having at least one hetero atom selected from N, O, P, and S as a ring-forming atom and 1 to 10 carbon atoms. Detailed examples thereof are a tetrahydrofuranyl group and a tetrahydrothiophenyl group. A C₁-C₁₀ heterocycloalkylene group as used herein refers to a divalent group having the same structure as the C₁-C₁₀ heterocycloalkyl group.

A C₃-C₁₀ cycloalkenyl group as used herein refers to a monovalent monocyclic group that has 3 to 10 carbon atoms and at least one double bond in the ring thereof and which is not aromatic. Detailed examples thereof are a cyclopentenyl group, a cyclohexenyl group, and a cycloheptenyl group. A C₃-C₁₀ cycloalkenylene group as used herein refers to a divalent group having the same structure as the C₃-C₁₀ cycloalkenyl group.

A C₁-C₁₀ heterocycloalkenyl group as used herein is a monovalent monocyclic group that has at least one hetero atom selected from N, O, P, and S as a ring-forming atom, 1 to 10 carbon atoms, and at least one double bond in its ring. Detailed examples of the C₁-C₁₀ heterocycloalkenyl group are a 2,3-dihydrofuranyl group and a 2,3-dihydrothiophenyl group. A C₁-C₁₀ heterocycloalkenylene group as used herein refers to a divalent group having the same structure as the C₁-C₁₀ heterocycloalkenyl group.

A C₆-C₆₀ aryl group as used herein refers to a monovalent group having a carbocyclic aromatic system having 6 to 60 carbon atoms, and a C₆-C₆₀ arylene group as used herein refers to a divalent group having a carbocyclic aromatic system having 6 to 60 carbon atoms. Detailed examples of the C₆-C₆₀ aryl group are a phenyl group, a naphthyl group, an anthracenyl group, a phenanthrenyl group, a pyrenyl group, and a chrysenyl group. When the C₆-C₆₀ aryl group and the C₆-C₆₀ arylene group each include two or more rings, the rings may be fused to each other.

A C₁-C₆₀ heteroaryl group as used herein refers to a monovalent group having a aromatic system that has at least one hetero atom selected from N, O, P, and S as a ring-forming atom, and 1 to 60 carbon atoms. A C₁-C₆₀ heteroarylene group used herein refers to a divalent group having a carbocyclic aromatic system that has at least one hetero atom selected from N, O, P, and S as a ring-forming atom, and 1 to 60 carbon atoms. Examples of the C₁-C₆₀ heteroaryl group are a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each include two or more rings, the rings may be fused to each other.

A C₆-C₆₀ aryloxy group as used herein indicates -OA₁₀₂ (wherein A₁₀₂ is the C₆-C₆₀ aryl group), a C₆-C₆₀ arylthio group as used herein indicates -SA₁₀₃ (wherein A₁₀₃ is the C₆-C₆₀ aryl group), and the C₇-C₆₀ arylalkyl indicates -A₁₀₄A₁₀₅ (wherein A₁₀₅ is the C₆-C₆₀ aryl group and A₁₀₄ is the C₁-C₆₀ alkyl group).

The C₁-C₆₀ heteroaryloxy used herein indicates -OA₁₀₆ (wherein A₁₀₆ is the C₁-C₆₀ heteroaryl group), the C₁-C₆₀ heteroarylthio indicates -SA₁₀₇ (wherein A₁₀₇ is the C₁-C₆₀ heteroaryl group), and the C₂-C₆₀ heteroarylalkyl indicates -A₁₀₈A₁₀₉ (wherein A₁₀₉ is the C₁-C₆₀ heteroaryl group and A₁₀₈ is the C₁-C₆₀ alkyl group).

A monovalent non-aromatic condensed polycyclic group as used herein refers to a monovalent group (for example, having 8 to 60 carbon atoms) that has two or more rings condensed to each other, only carbon atoms as a ring forming atom, and which is non-aromatic in the entire molecular structure. A detailed example of the monovalent non-aromatic condensed polycyclic group is a fluorenyl group. A divalent non-aromatic condensed polycyclic group as used herein refers to a divalent group having the same structure as the monovalent non-aromatic condensed polycyclic group.

A monovalent non-aromatic condensed heteropolycyclic group as used herein refers to a monovalent group (for example, having 1 to 60 carbon atoms) that has two or more rings condensed to each other, has a heteroatom selected from N, O P, and S, other than carbon atoms, as a ring forming atom, and which is non-aromatic in the entire molecular structure. An example of the monovalent non-aromatic condensed heteropolycyclic group is a carbazolyl group. A divalent non-aromatic condensed heteropolycyclic group as used herein refers to a divalent group having the same structure as the monovalent non-aromatic condensed heteropolycyclic group.

At least one of substituents of the substituted C₁-C₆₀ alkyl group, substituted C₂-C₆₀ alkenyl group, substituted C₂-C₆₀ alkynyl group, substituted C₁-C₆₀ alkoxy group, substituted C₃-C₁₀ cycloalkyl group, substituted C₁-C₁₀ heterocycloalkyl group, substituted C₃-C₁₀ cycloalkenyl group, substituted C₁-C₁₀ heterocycloalkenyl group, substituted C₆-C₆₀ aryl group, substituted C₆-C₆₀ aryloxy group, substituted C₆-C₆₀ arylthio group, substituted C₇-C₆₀ arylalkyl group, substituted C₁-C₆₀ heteroaryl group, substituted C₁-C₆₀ heteroaryloxy group, substituted C₁-C₆₀ heteroarylthio group, substituted C₂-C₆₀ heteroarylalkyl group, substituted monovalent non-aromatic condensed polycyclic group, and substituted monovalent non-aromatic condensed heteropolycyclic group may be selected from:
a deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from a deuterium, - F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, a monovalent non-aromatic condensed heteropolycyclic group, -N(Q₁₁)(Q₁₂), -B(Q₁₃)(Q₁₄), and -P(=O)(Q₁₅)(Q₁₆);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, and a monovalent non-aromatic condensed heteropolycyclic group, each substituted with at least one selected from a deuterium, -F, -CI, -Br, -I, -CD₃, -CD₂H, -CDH₂, -CF₃, - CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, a monovalent non-aromatic condensed heteropolycyclic group, -N(Q₂₁)(Q₂₂), - B(Q₂₃)(Q₂₄), and -P(=O)(Q₂₅)(Q₂₆); and
-N(Q₃₁)(Q₃₂), -B(Q₃₃)(Q₃₄) and -P(=O)(Q₃₅)(Q₃₆),
wherein Q₁ to Q₆, Q₁₁ to Q₁₆, Q₂₁ to Q₂₆, Q₃₁ to Q₃₆, and Q₅₁ to Q₅₃ may be each independently selected from a hydrogen, a deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₇-C₆₀ arylalkyl group, a substituted or unsubstituted C₁-C₆₀ heteroaryl group, a substituted or unsubstituted C₁-C₆₀ heteroaryloxy group, a substituted or unsubstituted C₁-C₆₀ heteroarylthio group, a substituted or unsubstituted C₂-C₆₀ heteroarylalkyl group, a substituted or unsubstituted monovalent non-aromatic condensed polycyclic group, and a substituted or unsubstituted monovalent non-aromatic condensed heteropolycyclic group.

When a group containing a specified number of carbon atoms is substituted with any of the substituents listed above, the number of carbon atoms in the resulting "substituted" group may be the number of atoms contained in the original (base) group plus the number of carbon atoms (if any) contained in the substituent. For example, the "substituted C₁-C₃₀ alkyl" may refer to a C₁-C₃₀ alkyl group substituted with C₆-₆₀ aryl group, in which the total number of carbon atoms may be C₇-C₉₀.

Hereinafter, a compound and an organic light-emitting device according to embodiments are described in detail with reference to Synthesis Example and Examples. However, the organic light-emitting device is not limited thereto. The wording "B was used instead of A" used in describing Synthesis Examples means that an amount of A used was identical to an amount of B used, in terms of a molar equivalent.

### Example

### Synthesis Example 1: Synthesis of Compound 1

### Synthesis of Compound A

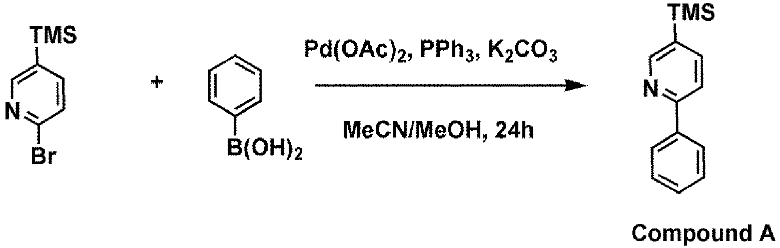

2-bromo-5-(trimethylsilyl)pyridine (10 grams (g), 43.44 millimoles (mmol)), phenylboronic acid (6.36 g, 52.13 mmol), Pd(OAc)₂ (0.49 g, 2.00 mmol), PPh₃ (1.139 g, 4.00 mmol), and K₂CO₃ (15.01 g, 109 mmol) were mixed with 100 milliliters (mL) of acetonitrile and 50 mL of methanol. The resulting mixture was stirred at a temperature of 50°C for 24 hours, cooled to room temperature (about 25°C), and filtered. Methylene chloride (MC) was used to separate the organic layer from the aqueous layer. The organic layer was subsequently dried with an anhydrous magnesium sulfate (MgSO₄) and filtered. The resultant filtrate was subjected to reduced pressure to evaporate the solvent, and the obtained residual crude product was purified by column chromatography using ethyl acetate (EA) and hexane at a ratio of 3:97 to obtain 7.21 g (73%) of Compound A.

### Synthesis of Compound B3

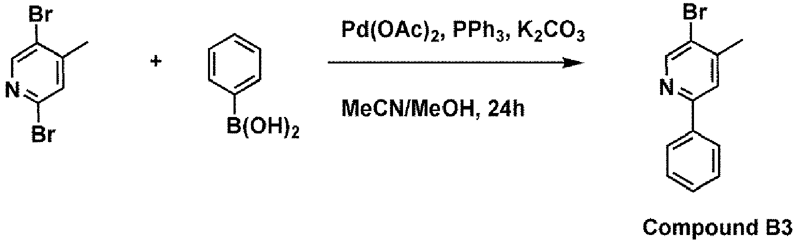

2,5-dibromo-4-methylpyridine (10 g, 39.86 mmol), phenylboronic acid (5.35 g, 43.85 mmol), Pd(OAc)₂ (0.90 g, 3.99 mmol), PPh₃ (2.09 g, 7.97 mmol), and K₂CO₃ (11.02 g, 79.72 mmol) were mixed with 100 mL of acetonitrile and 50 mL of methanol. The resulting mixture was stirred at a temperature of 50°C for 24 hours, cooled to room temperature, and filtered. Methylene chloride (MC) was used to separate an organic layer from the aqueous layer. The organic layer was subsequently dried with an anhydrous magnesium sulfate (MgSO₄) and filtered. The resultant filtrate was subjected to reduced pressure to evaporate the solvent, and the obtained residual crude product was purified by column chromatography using ethylacetate (EA) and hexane at a ratio of 3:97 to obtain 3.6 g (61%) of Compound B3.

### Synthesis of Compound B2

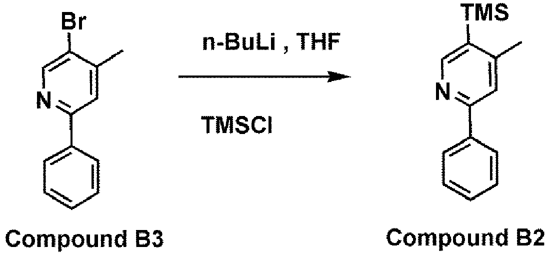

100 mL of tetrahydrofuran (THF) was added to Compound B3 (6 g, 24.18 mmol), and the mixture was cooled to a temperature of -78°C. n-BuLi (16.6 mL, 26.60 mmol) was slowly added thereto, and the resulting mixture was stirred at a temperature of -78°C for 1 hour. Then, TMSCI (3.38 mL, 26.60 mmol) was added thereto, and a reaction was carried out at a temperature of -78°C for 1 hour. The temperature was then raised to room temperature and the reaction was allowed to proceed for 12 hours. The organic layer was extracted therefrom using MC. The organic layer was subsequently dried with an anhydrous magnesium sulfate and filtered. The resulting filtrate was subjected to reduced pressure to evaporate solvent. The obtained residual crude product was purified by column chromatography using EA and hexane at a ratio of 4:96 to obtain 4.5 g (77%) of Compound B2.

### Synthesis of Compound B1

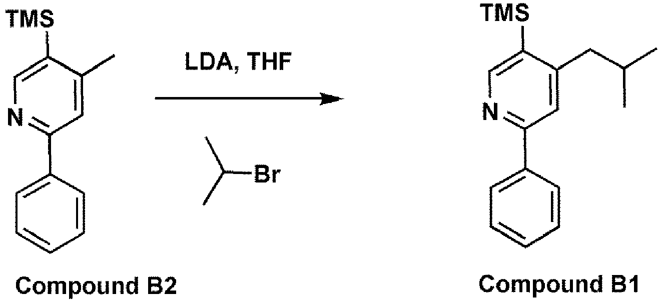

Compound B2 (4.27 g, 17.68 mmol) was mixed with 100 mL of THF, and cooled to a temperature of -78°C. Lithium diisopropylamide (LDA, 16 mL, 31.83 mmol) was slowly added thereto. Next, the result was stirred at a temperature of - 78°C for 1 hour to perform a reaction. The temperature was raised to room temperature, and the reaction was further carried out for 1.5 hours. The temperature was then reduced to -78°C, and 2-bromopropane (2.99 mL, 31.83 mmol) was slowly added to the resulting mixture. The temperature was raised to room temperature and the reaction was carried out for 12 hours. An organic layer was extracted therefrom using MC, and an anhydrous magnesium sulfate was added thereto to perform dehydration. The mixture was filtered, and the resulting filtrate was subjected to reduced pressure. The obtained residual crude product was purified by column chromatography using EA and hexane at a ratio of 4:96 to obtain 3.73 g (74%) of Compound B1.

### Synthesis of Compound M2A

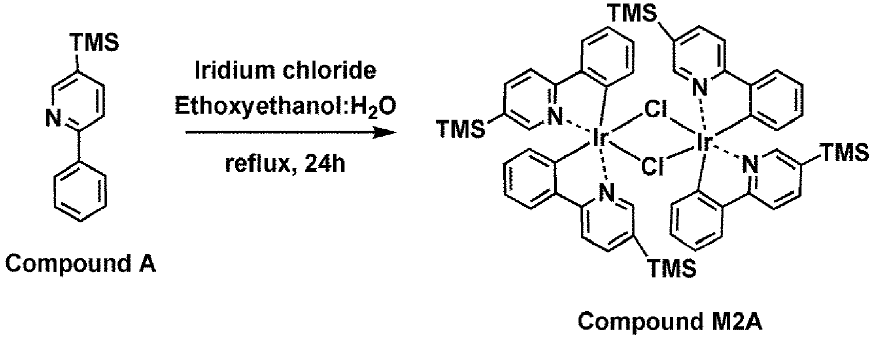

Compound A (16.54 g, 73 mmol) and iridium chloride (11.50 g, 32.6 mmol) were mixed with 210 mL of ethoxyethanol and 70 mL of distilled water. The resulting mixture was stirred under reflux for 24 hours to carry out a reaction. The temperature was then lowered to room temperature. The resultant solid was separated by filtration, and thoroughly washed with water, methanol, and hexane in the stated order. The obtained solid was dried in a vacuum oven to obtain 14.0 g (63%) of Compound M2A.

### Synthesis of Compound M1A

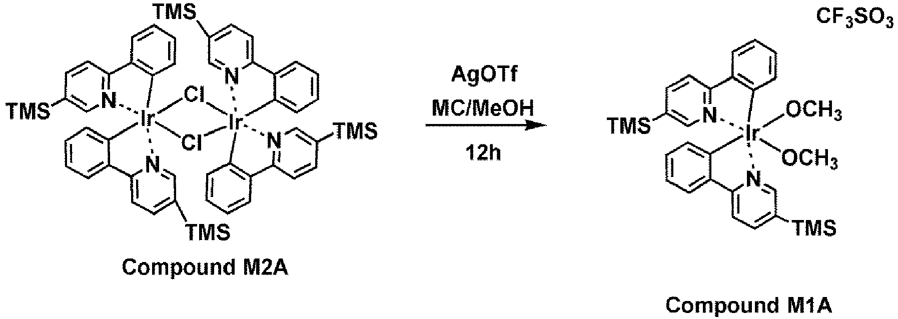

Compound M2A (6.0 g, 4.40 mmol) was mixed with 60 mL of MC. AgOTf (2.27 g, 8.8 mmol) dissolved in 20 mL of methanol was added thereto. Next, while being protected from light by using an aluminum foil, the mixture was stirred at room temperature for 12 hours to carry out a reaction, thereby generating a solid, which upon completion of the reaction, was removed therefrom by celite filtration. The resultant filtrate was subjected to reduced pressure to obtain a solid (Compound M1A), which was then used in the following reaction without any purification.

### Synthesis of Compound 1

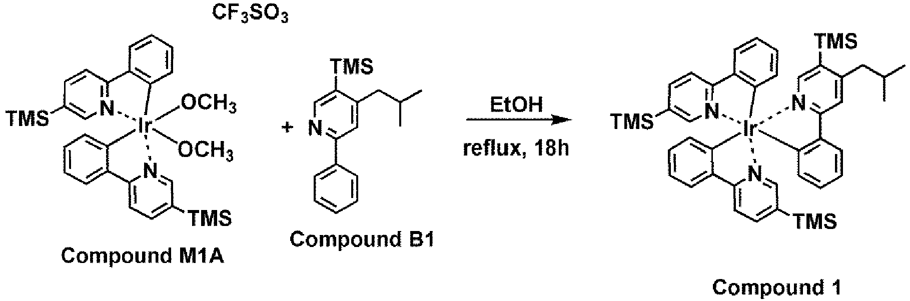

Compound M1A (7 g, 8.2 mmol) and Compound B1 (3.0798 g, 10.60 mmol) were mixed with 90 mL of ethanol, and the result was stirred under reflux for 18 hours to carry out a reaction. The temperature was then decreased, and the resulting mixture was filtered to separate a solid, which was then thoroughly washed with ethanol and hexane. the crude product was purified by column chromatography using MC and hexane at a ratio of 35:65 to obtain 2.87 g (38%) of Compound 1. The obtained product was confirmed by Mass and HPLC analysis.
HRMS (MALDI) calcd for C₄₆H₅₆IrN₃Si₃: m/z 927.3411, Found: 927.3416

### Synthesis Example 2: Synthesis of Compound 2

### Synthesis of Compound M2B

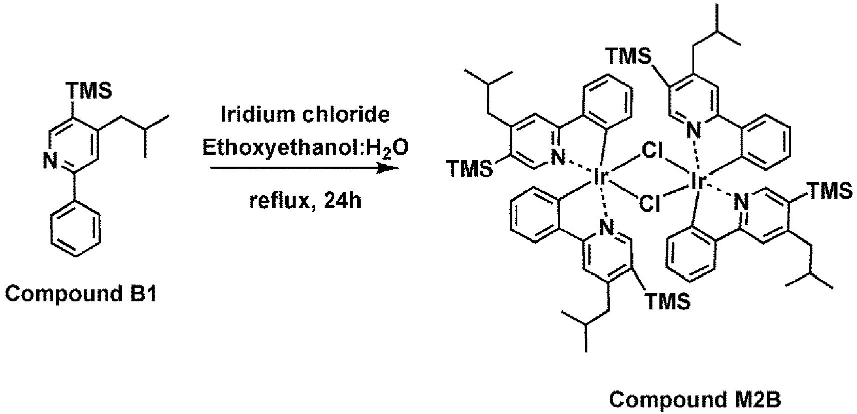

14.0 g (88%) of Compound M2B was prepared in the same manner as Compound M2A in Synthesis Example 1, except that Compound B1 (10.760 g, 38 mmol) and iridium chloride (6.0 g, 17 mmol) were used instead of Compound A and iridium chloride, and ethoxyethanol and distilled water were respectively used in amounts of 180 mL and 70 mL.

### Synthesis of Compound M1B

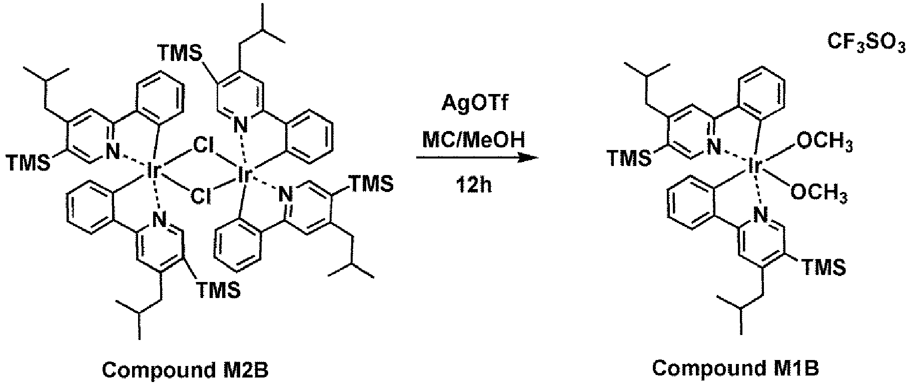

Compound M1B was prepared in the same manner as Compound M1A in Synthesis Example 1, except that Compound M2B (10.4 g, 13 mmol) was used instead of Compound M2A. Compound M1B was then used in the following reaction without any purification.

### Synthesis of Compound 2

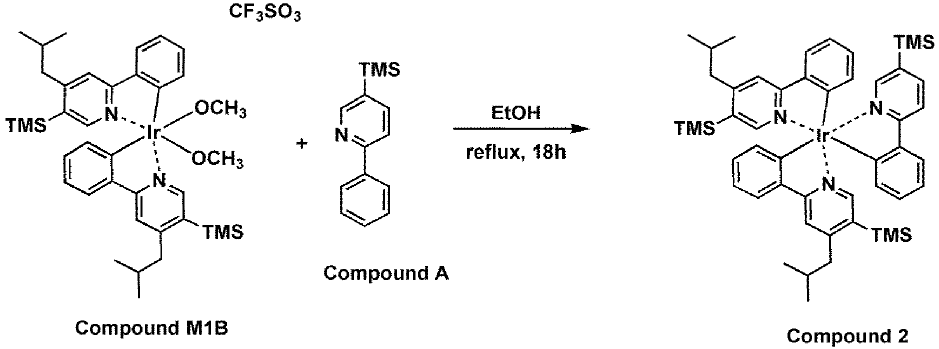

3.14 g (31%) of Compound 2 was prepared in the same manner as Compound 1 in Synthesis Example 1, except that Compound M1B (10 g, 10.34 mmol), Compound A (3.050 g, 13.4 mmol), and 60 mL of ethanol were used instead of Compound M1A, Compound B1, and 90 mL of ethanol. The obtained product was confirmed by Mass and HPLC analysis.
HRMS (MALDI) calcd for C₅₀H₆₄IrN₃Si₃: m/z 983.4037, Found: 983.4039

### Synthesis Example 3: Synthesis of Compound 3

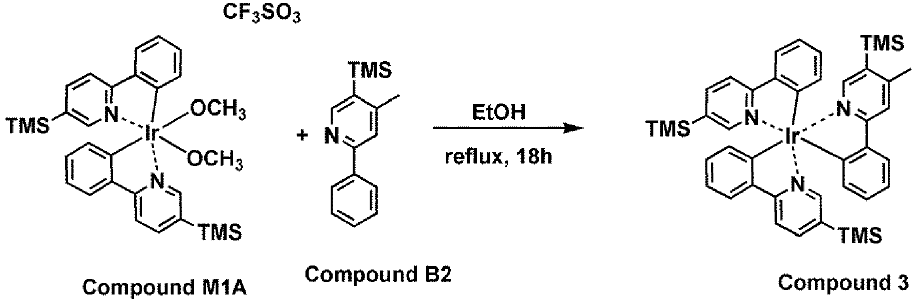

2.53 g (35%) of Compound 3 was prepared in the same manner as Compound 1 in Synthesis Example 1, except that Compound M1A (7 g, 8 mmol), Compound B2 (2.56 g, 11 mmol), and 60 mL of ethanol were used instead of Compound M1A, Compound B1, and 90 mL of ethanol. The obtained product was confirmed by Mass and HPLC analysis.
HRMS (MALDI) calcd for C₄₃H₅₀IrN₃Si₃: m/z 885.2942, Found: 885.2940

### Synthesis Example 4: Synthesis of Compound 4

### Synthesis of M2C

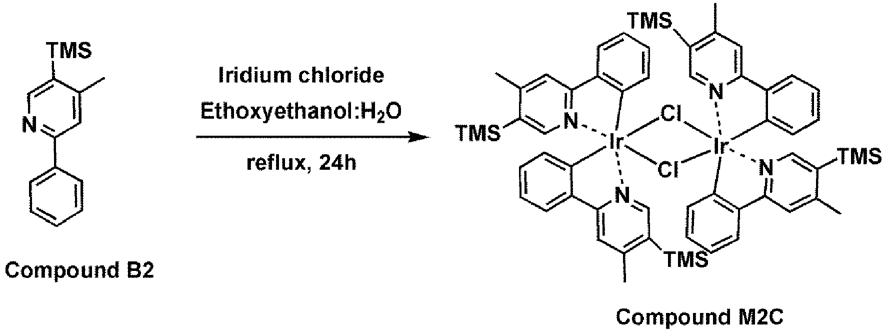

7.03 g (70%) of Compound M2C was prepared in the same manner Compound M2A in Synthesis Example 1, except that Compound B2 (7.630 g, 32 mmol) and iridium chloride (5.0 g, 14 mmol) were used instead of Compound A and iridium chloride, and ethoxyethanol and distilled water were respectively used in amounts of 180 mL and 70 mL.

### Synthesis of Compound M1C

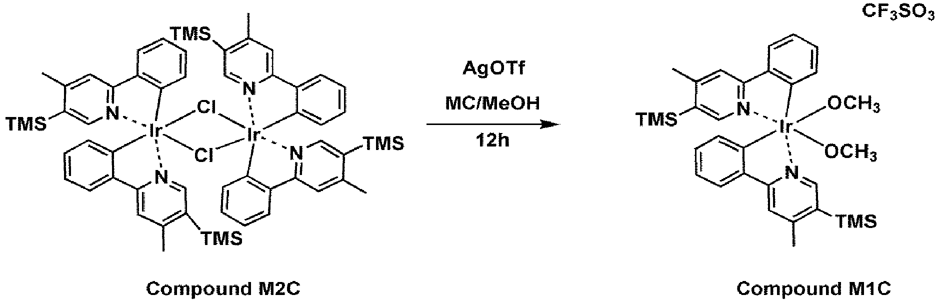

Compound M1C was prepared in the same manner as Compound M1A in Synthesis Example 1, except that Compound M2C (7 g, 5 mmol) was used instead of Compound M2A. Compound M1C was then used in the following reaction without any purification.

### Synthesis of Compound 4

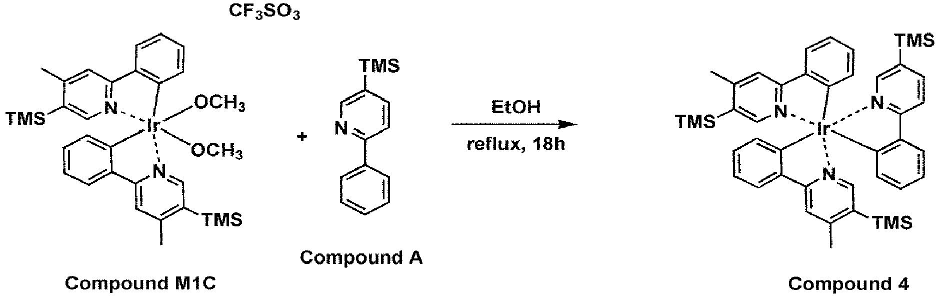

1.54 g (33%) of Compound 4 was prepared in the same manner Compound 1 in Synthesis Example 1, except that Compound M1C (5 g, 6 mmol), Compound A (1.226 g, 8 mmol), and 60 mL of ethanol were used instead of Compound M1A, Compound B1, and 90 mL of ethanol. The obtained product was confirmed by Mass and HPLC analysis.
HRMS (MALDI) calcd for C₄₄H₅₂IrN₃Si₃: m/z 899.3098, Found: 899.3100

### Synthesis Example 5: Synthesis of Compound 5

### Synthesis of Compound C

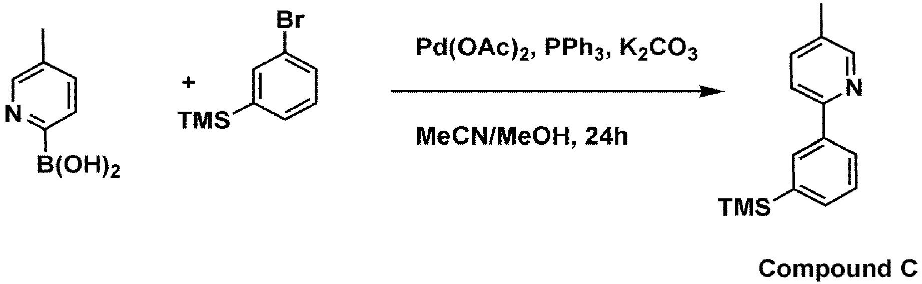

(3-bromophenyl)trimethylsilane (10 g, 44 mmol), 5-methyl-2-pyridineboronic acid (7.17 g, 52 mmol), Pd(OAc)₂ (0.49 g, 2.00 mmol), PPh₃ (1.1440 g, 4.00 mmol), and K₂CO₃ (15.08 g, 109 mmol) were mixed with 100 mL of acetonitrile and 50 mL of methanol. The mixture was then stirred at a temperature of 50°C for 24 hours, cooled to room temperature, and filtered. Methylene chloride (MC) was used to separate the organic layer from the aqueous layer. The organic layer was subsequently dried with an anhydrous magnesium sulfate (MgSO₄) and filtered. The resulting filtrate was subjected to reduced pressure, and the obtained residual crude product was purified by column chromatography using ethylacetate (EA) and hexane at a ratio of 3:97 to obtain 8.64 g (81%) of Compound C.

### Synthesis of Compound M2D

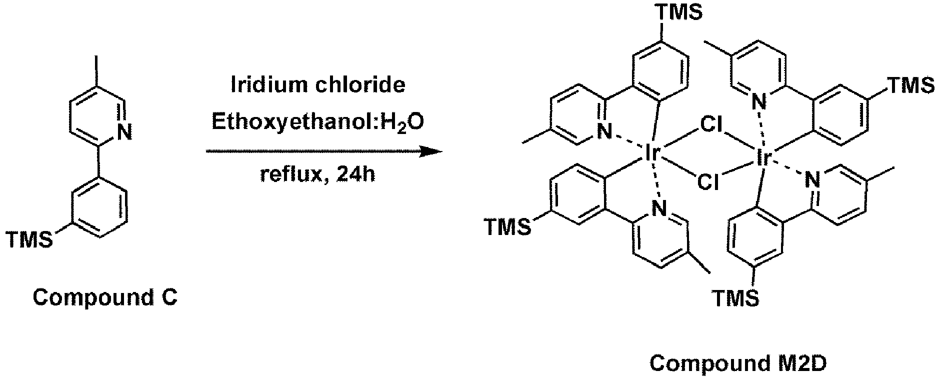

Compound C (8.397 g, 35 mmol) and iridium chloride (5.50 g, 16 mmol) were mixed with 210 mL of ethoxyethanol and 70 mL of distilled water. The mixture was stirred under reflux for 24 hours to carry out a reaction. The temperature was then reduced to room temperature. The resulting solid was separated by filtration, thoroughly washed with water, methanol, and hexane in the stated order. The obtained solid was dried in a vacuum oven to obtain 6.37 g (60%) of Compound M2D.

### Synthesis of Compound M1D

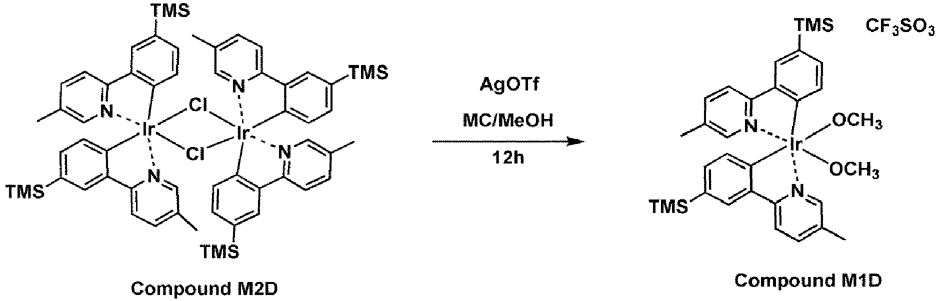

Compound M2D (6.0 g, 4.00 mmol) was mixed with 60 mL of MC, and AgOTf (2.176 g, 8.00 mmol) dissolved in 20 mL of methanol was added thereto. Next, while being protected from light by using an aluminum foil, the mixture was stirred at room temperature for 12 hours to carry out a reaction, thereby generating a solid. The solid was removed by celite filtration. The resulting filtrate was subjected to reduced pressure to evaporate the solvent to obtain a solid (Compound M1D), which was then used in the following reaction without any purification.

### Synthesis of Compound 5

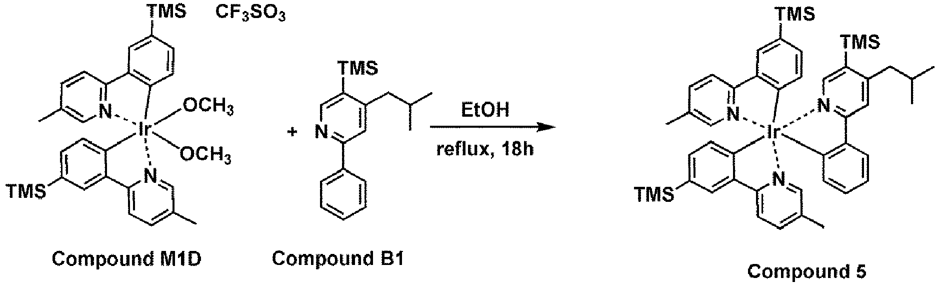

Compound M1D (6 g, 7.0 mmol) and Compound B1 (2.547 g, 9.00 mmol) were mixed with 90 mL of ethanol, and the resulting mixture was stirred under reflux for 18 hours to carry out a reaction. The temperature was then reduced to room temperature. The resultant mixture was filtered to separate a solid, which was then thoroughly washed with ethanol and hexane. The crude product was purified by column chromatography using MC and hexane at a ratio of 35:65 to obtain 2.458 g (38%) of Compound 5. The obtained product was confirmed by Mass and HPLC analysis.
HRMS (MALDI) calcd for C₄₈H₆₀IrN₃Si₃: m/z 955.3724, Found: 955.3729

### Comparative Synthesis Example 1: Synthesis of Comparative Compound 1

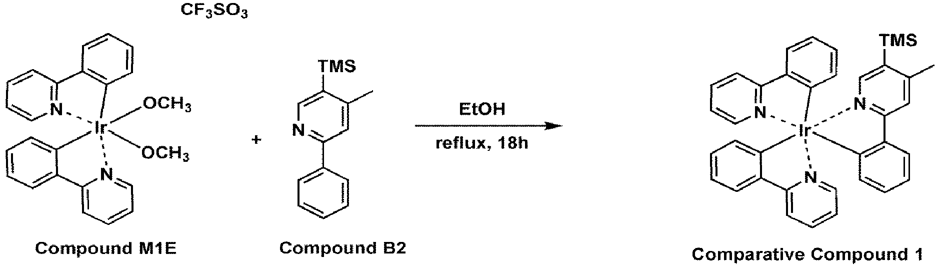

2.4 g (39%) of Comparative Compound 1 was prepared in the same manner as Compound 1 in Synthesis Example 1, except that Compound M1E (6 g, 8.41 mmol) and Compound B2 (3.0 g, 12.61 mmol) were used instead of Compound M1A and Compound B1. The obtained product was confirmed by Mass and HPLC analysis.
HRMS (MALDI) calcd for C₃₇H₃₄IrN₃Si: m/z 741.2151, Found: 741.2157

### Example 1

An ITO glass substrate was cut to a size of 50 millimeters (mm) x 50 mm x 0.5 mm, sonicated in acetone, isopropyl alcohol and pure water, each for 15 minutes, and washed by exposure to UV ozone for 30 minutes.

Then, m-MTDATA was deposited on an ITO electrode (anode) of the glass substrate at a deposition speed of 0.1 nm/sec (1 Angstroms per second (Å/sec)) to form a hole injection layer having a thickness of 60 nm (600 Å), and α-NPD was deposited on the hole injection layer at a deposition speed of 0.1 nm/sec (1 Å/sec) to form a hole transport layer having a thickness of 25 nm (250 Å).

Compound 1 (dopant) and CBP (host) were co-deposited on the hole transport layer at a deposition speed 0.01 nm/sec (0.1 Å/sec) and a deposition speed of 0.1 nm/sec (1 Å/sec), respectively, to form an emission layer having a thickness of 40 nm (400 Å).

BAlq was deposited on the emission layer at a deposition speed of 0.1 nm/sec (1 Å/sec) to form a hole blocking layer having a thickness of 5 nm (50 Å), and Alq₃ was deposited on the hole blocking layer to form an electron transport layer having a thickness of 30 nm (300 Å). Then, LiF was deposited on the electron transport layer to form an electron injection layer having a thickness of 1 nm (10 Å), and Al was vacuum deposited on the electron injection layer to form a second electrode (cathode) having a thickness of 120 nm (1,200 Å), thereby completing manufacturing of an organic light-emitting device having a structure of ITO / m-MTDATA (600 Å) / α-NPD (250 Å) / CBP + 10% (Compound 1) (400 Å) / BAlq (50 Å) / Alq₃ (300 Å) / LiF (10 Å) / Al (1,200 Å).

### Examples 2 to 5 and Comparative Example 1

Organic light-emitting devices were manufactured in the same manner as in Example 1, except that in forming an emission layer, for use as a dopant, corresponding compounds shown in Table 2 were used instead of Compound 1.

### Evaluation Example 1: Evaluation on characteristics of organic light-emitting devices

The organic light-emitting devices manufactured according to Examples 1 to 5 and Comparative Example 1 were evaluated with respect to driving voltage, efficiency, power, color purity, quantum efficiency, and lifespan (T₉₅). Results thereof are shown in Table 2. This evaluation was performed using a current-voltage meter (Keithley 2400) and a brightness meter (Minolta Cs-1000A), and the lifespan (T₉₅) (at 6,000 nit) was evaluated by measuring a time taken until brightness was reduced to 95% of the initial brightness of 100%.

**Table 2**

| | Dopant | Driving Voltage (V) | Efficiency (cd/A) | Power (Im/W) | CIEx | CIEy | Quantum Efficiency (%) | Lifespan (hr) (T₉₅) |
|---|---|---|---|---|---|---|---|---|
| Example 1 | Compound 1 | 5.1 | 53.0 | 32.6 | 0.365 | 0.600 | 19 | 355 |
| Example 2 | Compound 2 | 5.4 | 57.9 | 33.7 | 0.366 | 0.601 | 19 | 370 |
| Example 3 | Compound 3 | 5.2 | 50.2 | 30.3 | 0.362 | 0.604 | 18 | 280 |
| Example 4 | Compound 4 | 5.5 | 56.0 | 32.0 | 0.363 | 0.600 | 19 | 294 |
| Example 5 | Compound 5 | 5.3 | 49.8 | 29.5 | 0.340 | 0.602 | 18 | 140 |
| Comparative Example 1 | Comparative Compound 1 | 5.3 | 48.5 | 28.7 | 0.344 | 0.604 | 18 | 135 |

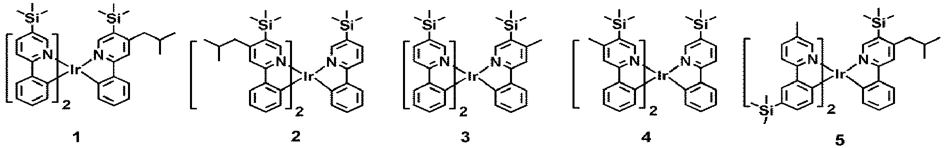

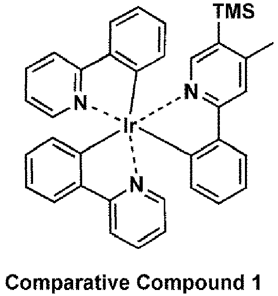

From the data in Table 2, it was confirmed that the organic light-emitting devices of Examples 1 to 5 had higher efficiency, higher power, higher color purity, and longer lifetime than the organic light-emitting device of Comparative Example 1.

According to one or more embodiments, an organometallic compound may have excellent electric characteristics and thermal stability. Accordingly, an organic light-emitting device including the organometallic compound may have excellent driving voltage, current density, efficiency, power, color purity, and lifespan characteristics.

It should be understood that exemplary embodiments described herein should be considered in a descriptive sense only and not for purposes of limitation. Descriptions of features or aspects within each exemplary embodiment should typically be considered as available for other similar features or aspects in other exemplary embodiments.

While one or more exemplary embodiments have been described with reference to the figures, it will be understood by those of ordinary skill in the art that various changes in form and details may be made therein without departing from the scope as defined by the following claims.

## Claims

1. An organometallic compound represented by Formula 1:
Formula 1 M(L₁)ₙ₁(L₂)ₙ₂ 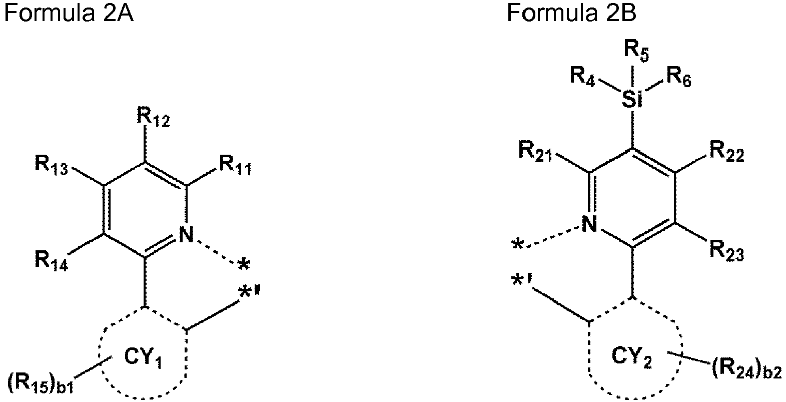
wherein M in Formula 1 is selected from iridium, platinum, osmium, titanium, zirconium, hafnium, europium, terbium, thulium, and rhodium,
in Formula 1, L₁ is selected from ligands represented by Formula 2A above, n1 is 1 or 2, provided that when n1 is 2, two groups L₁ are identical to or different from each other,
in Formula 1, L₂ is selected from ligands represented by Formula 2B above, n2 is 1 or 2, provided that when n2 is 2, two groups L₂ are identical to or different from each other,
in Formula 1, L₁ and L₂ are different from each other, and the sum of n1 and n2 is 2 or 3,
each of * and *' in Formulae 2A and 2B indicates a binding site to M in Formula 1,
CY₁ and CY₂ in Formulae 2A and 2B are each independently selected from a C₅-C₆₀ carbocyclic group and a C₁-C₆₀ heterocyclic group, provided that CY₂ is none of a dibenzofuran, a dibenzothiophene, a dibenzothiophene sulfone, a carbazole, and a dibenzosilole,
R₁₁ to R₁₅ in Formula 2A are each independently selected from a hydrogen, a deuterium, -F, -CI, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₇-C₆₀ arylalkyl group, a substituted or unsubstituted C₁-C₆₀ heteroaryl group, a substituted or unsubstituted C₁-C₆₀ heteroaryloxy group, a substituted or unsubstituted C₁-C₆₀ heteroarylthio group, a substituted or unsubstituted C₂-C₆₀ heteroarylalkyl group, a substituted or unsubstituted monovalent non-aromatic condensed polycyclic group, a substituted or unsubstituted monovalent non-aromatic condensed heteropolycyclic group, -Si(R₁)(R₂)(R₃), -N(Q₁)(Q₂), -B(Q₃)(Q₄), and -P(=O)(Q₅)(Q₆),
R₂₁ to R₂₄ in Formula 2B are each independently selected from a hydrogen, a deuterium, -F, -CI, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₇-C₆₀ arylalkyl group, a substituted or unsubstituted C₁-C₆₀ heteroaryl group, a substituted or unsubstituted C₁-C₆₀ heteroaryloxy group, a substituted or unsubstituted C₁-C₆₀ heteroarylthio group, a substituted or unsubstituted C₂-C₆₀ heteroarylalkyl group, a substituted or unsubstituted monovalent non-aromatic condensed polycyclic group, a substituted or unsubstituted monovalent non-aromatic condensed heteropolycyclic group, -N(Q₁)(Q₂), -B(Q₃)(Q₄), and -P(=O)(Q₅)(Q₆),
b1 and b2 in Formulae 2A and 2B are each independently an integer selected from 0 to 4, provided that
i) one selected from R₁₁ to R₁₄ in Formula 2A or ii) one selected from R₁₅ in the number of b1 in Formula 2A, is -Si(R₁)(R₂)(R₃),
at least one selected from R₂₁ to R₂₃ in Formula 2B is not a hydrogen,
R₁ to R₃ in -Si(R₁)(R₂)(R₃) of Formula 2A and R₄ to R₆ in Formula 2B are each independently selected from a hydrogen, a deuterium, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, and - Si(Q₅₁)(Q₅₂)(Q₅₃), and
at least one of substituents of the substituted C₁-C₆₀ alkyl group, substituted C₂-C₆₀ alkenyl group, substituted C₂-C₆₀ alkynyl group, substituted C₁-C₆₀ alkoxy group, substituted C₃-C₁₀ cycloalkyl group, substituted C₁-C₁₀ heterocycloalkyl group, substituted C₃-C₁₀ cycloalkenyl group, substituted C₁-C₁₀ heterocycloalkenyl group, substituted C₆-C₆₀ aryl group, substituted C₆-C₆₀ aryloxy group, substituted C₆-C₆₀ arylthio group, a substituted C₇-C₆₀ arylalkyl group, substituted C₁-C₆₀ heteroaryl group, a substituted C₁-C₆₀ heteroaryloxy group, a substituted C₁-C₆₀ heteroarylthio group, a substituted C₂-C₆₀ heteroarylalkyl group, substituted monovalent non-aromatic condensed polycyclic group, and substituted monovalent non-aromatic condensed heteropolycyclic group is selected from:
a deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from a deuterium, - F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, a monovalent non-aromatic condensed heteropolycyclic group, -N(Q₁₁)(Q₁₂), -B(Q₁₃)(Q₁₄), and -P(=O)(Q₁₅)(Q₁₆);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, and a monovalent non-aromatic condensed heteropolycyclic group, each substituted with at least one selected from a deuterium, -F, -CI, -Br, -I, -CD₃, -CD₂H, -CDH₂, -CF₃, - CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆- a C₆-C₆₀ arylthio group, a C₇-C₆₀ arylalkyl group, a C₁-C₆₀ heteroaryl group, a C₁-C₆₀ heteroaryloxy group, a C₁-C₆₀ heteroarylthio group, a C₂-C₆₀ heteroarylalkyl group, a monovalent non-aromatic condensed polycyclic group, a monovalent non-aromatic condensed heteropolycyclic group, -N(Q₂₁)(Q₂₂), -B(Q₂₃)(Q₂₄), and -P(=O)(Q₂₅)(Q₂₆); and
-N(Q₃₁)(Q₃₂), -B(Q₃₃)(Q₃₄), and -P(=O)(Q₃₅)(Q₃₆),
wherein Q₁ to Q₆, Q₁₁ to Q₁₆, Q₂₁ to Q₂₆, Q₃₁ to Q₃₆, and Q₅₁ to Q₅₃ are each independently selected from a hydrogen, a deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₇-C₆₀ arylalkyl group, a substituted or unsubstituted C₁-C₆₀ heteroaryl group, a substituted or unsubstituted C₁-C₆₀ heteroaryloxy group, a substituted or unsubstituted C₁-C₆₀ heteroarylthio group, a substituted or unsubstituted C₂-C₆₀ heteroarylalkyl group, a substituted or unsubstituted monovalent non-aromatic condensed polycyclic group, and a substituted or unsubstituted monovalent non-aromatic condensed heteropolycyclic group.

2. The organometallic compound of claim 1, wherein
in Formula 1, M is Ir and the sum of n1 and n2 is 3; or M is Pt and the sum of n1 and n2 is 2, and
the organometallic compound is neutral.

3. The organometallic compound of claim 1 or 2, wherein
CY₁ in Formula 2A is selected from a benzene, an indene, a naphthalene, an azulene, a heptalene, an indacene, an acenaphthylene, a fluorene, a spiro-fluorene, a benzofluorene, a dibenzofluorene, a phenalene, a phenanthrene, an anthracene, a fluoranthene, a triphenylene, a pyrene, a chrysene, a naphthacene, a picene, a perylene, a pentacene, a hexacene, a pentaphene,, a rubicene, a coronene, an ovalene, an isoindole, an indole, an indazole, a purine, a quinoline, an isoquinoline, a benzoquinoline, a phthalazine, a naphthyridine, a quinoxaline, a quinazoline, a cinnoline, a phenanthridine, an acridine, a phenanthroline, a phenazine, a benzoimidazole, a benzofuran, a benzothiophene, an isobenzothiazole, a benzoxazole, an isobenzoxazole, a benzocarbazole, a dibenzocarbazole, an imidazopyridine, an imidazopyrimidine, a dibenzofuran, a dibenzothiophene, a dibenzothiophene sulfone, a carbazole, and a dibenzosilole, and,
CY₂ in Formula 2B is selected from a benzene, an indene, a naphthalene, an azulene, a heptalene, an indacene, an acenaphthylene, a fluorene, a spiro-fluorene, a benzofluorene, a dibenzofluorene, a phenalene, a phenanthrene, an anthracene, a fluoranthene, a triphenylene, a pyrene, a chrysene, a naphthacene, a picene, a perylene, a pentacene, a hexacene, a pentaphene, a rubicene, a coronene, an ovalene, an isoindole, an indole, an indazole, a purine, a quinoline, an isoquinoline, a benzoquinoline, a phthalazine, a naphthyridine, a quinoxaline, a quinazoline, a cinnoline, a phenanthridine, an acridine, a phenanthroline, a phenazine, a benzoimidazole, a benzofuran, a benzothiophene, an isobenzothiazole, a benzoxazole, an isobenzoxazole, a benzocarbazole, a dibenzocarbazole, an imidazopyridine, and an imidazopyrimidine, preferably wherein:
CY₁ in Formula 2A is selected from a benzene, a naphthalene, a fluorene, a dibenzofuran, a dibenzothiophene, a dibenzothiophene sulfone, a carbazole, and a dibenzosilole, and
CY₂ in Formula 2B is a benzene.

4. The organometallic compound of any of claims 1-3, wherein
R₁₁ to R₁₅ in Formula 2A are each independently selected from
a hydrogen, a deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a C₁-C₂₀ alkyl group, and a C₁-C₂₀ alkoxy group;
a C₁-C₂₀ alkyl group and a C₁-C₂₀ alkoxy group, each substituted with at least one selected from a deuterium, -F, -Cl, -Br, -I, -CD₃, -CD₂H, -CDH₂, -CF₃, -CF₂H,-CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, and a pyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group, each substituted with at least one selected from a deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group; and
-Si(R₁)(R₂)(R₃), -B(Q₃)(Q₄), and -P(=O)(Q₅)(Q₆), and
R₂₁ to R₂₄ in Formula 2B are each independently selected from
a hydrogen, a deuterium, -F, -CI, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a C₁-C₂₀ alkyl group, and a C₁-C₂₀ alkoxy group;
a C₁-C₂₀ alkyl group and a C₁-C₂₀ alkoxy group, each substituted with at least one selected from a deuterium, -F, -CI, -Br, -I, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, and a pyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group, each substituted with at least one selected from a deuterium, -F, -CI, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, and an imidazopyrimidinyl group; and
-B(Q₃)(Q₄) and -P(=O)(Q₅)(Q₆),
wherein Q₃ to Q₆ are each independently selected from
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, and -CD₂CDH₂; an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₀ alkyl group, and a phenyl group, preferably wherein:
R₁₁ to R₁₅ in Formula 2A are each independently selected from a hydrogen, a deuterium, -F, a cyano group, a nitro group, -SF₅, -CH₃, -CD₃, -CD₂H, -CDH₂, -CF₃, - CF₂H, -CFH₂, groups represented by Formulae 9-1 to 9-19, groups represented by Formulae 10-1 to 10-36, and -Si(R₁)(R₂)(R₃), and
R₂₁ to R₂₄ in Formula 2B are each independently selected from a hydrogen, a deuterium, -F, a cyano group, a nitro group, -SF₅, -CH₃, -CD₃, -CD₂H, -CDH₂, -CF₃, - CF₂H, -CFH₂, groups represented by Formulae 9-1 to 9-19, and groups represented by Formulae 10-1 to 10-36: 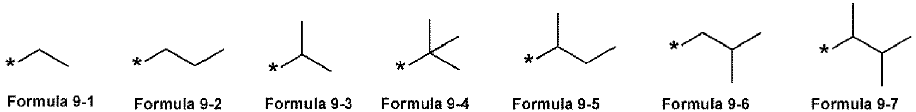 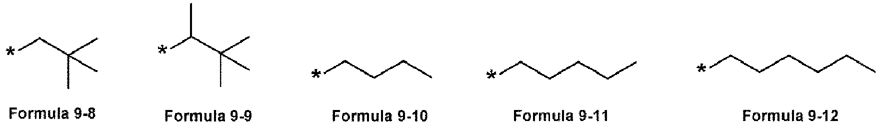 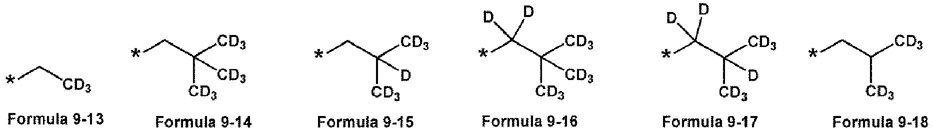 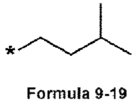 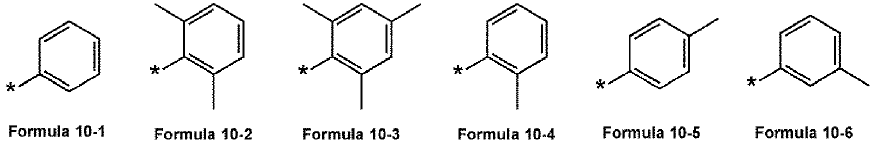 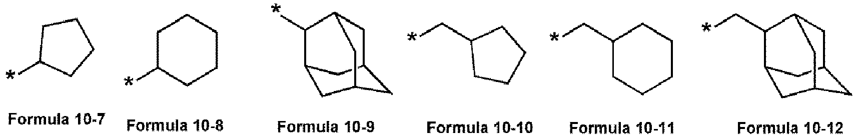 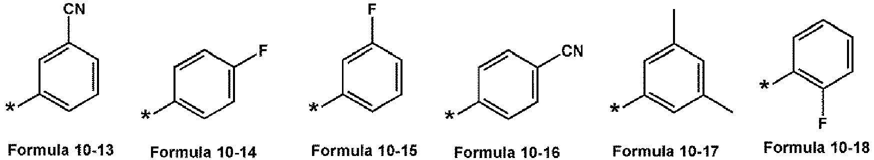 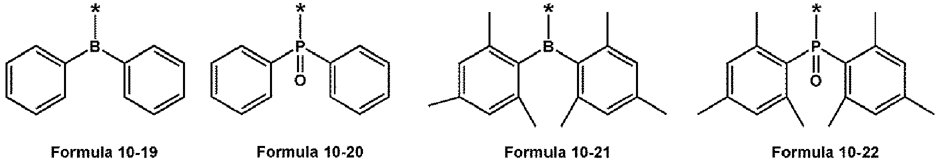 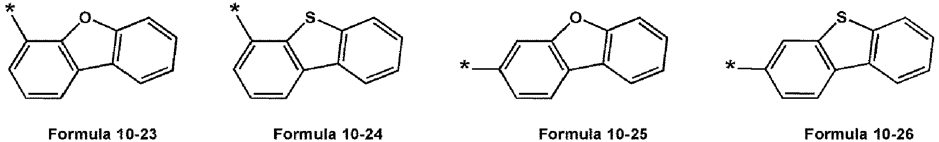 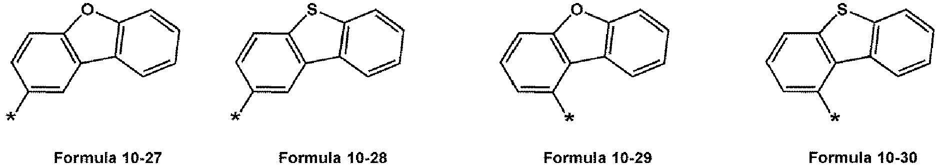 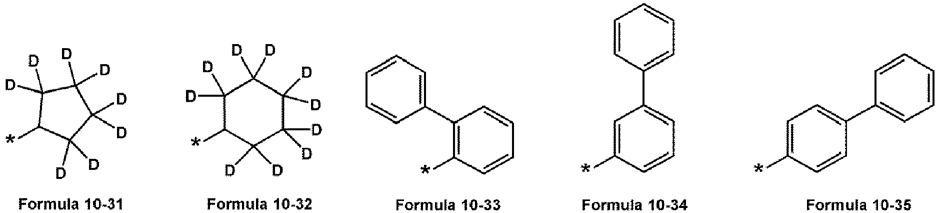 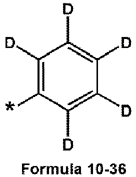 * in Formulae in 9-1 to 9-19 and 10-1 to 10-36 indicates a binding site to a neighboring atom.

5. The organometallic compound of any of claims 1-4, wherein R₂₂ in Formula 2B is not a hydrogen.

6. The organometallic compound of any of claims 1-5, wherein
R₁ to R₃ in -Si(R₁)(R₂)(R₃) of Formula 2A and R₄ to R₆ in Formula 2B are each independently selected from
a hydrogen, a deuterium, -CH₃, -CD₃, -CD₂H, -CDH₂, -CH₂CH₃, -CH₂CD₃, - CH₂CD₂H, -CH₂CDH₂, -CHDCH₃, -CHDCD₂H, -CHDCDH₂, -CHDCD₃, -CD₂CD₃, - CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, a naphthyl group, and -Si(Q₅₁)(Q₅₂)(Q₅₃); and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₀ alkyl group, and a phenyl group,
wherein Q₅₁ to Q₅₃ are each independently selected from a hydrogen, a deuterium, -CH₃, -CD₃, -CD₂H, -CDH₂, -CH₂CH₃, -CH₂CD₃, - CH₂CD₂H, -CH₂CDH₂, -CHDCH₃, -CHDCD₂H, -CHDCDH₂, -CHDCD₃, -CD₂CD₃, - CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₀ alkyl group, and a phenyl group, preferably wherein:
R₁ to R₃ in -Si(R₁)(R₂)(R₃) of Formula 2A and R₄ to R₆ in Formula 2B are each independently selected from -CH₃, -CD₃, -CD₂H, -CDH₂, a phenyl group, groups represented by Formulae 9-1 to 9-19, and groups represented by Formulae 10-1 to 10-18: 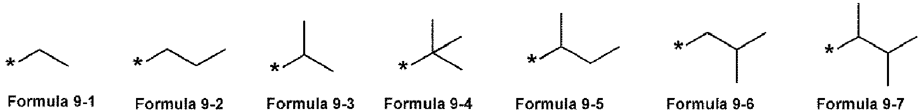 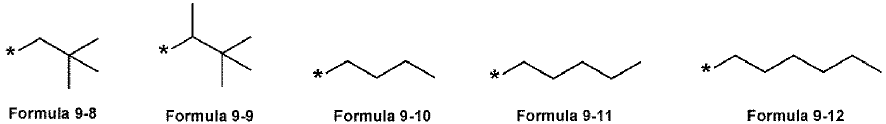 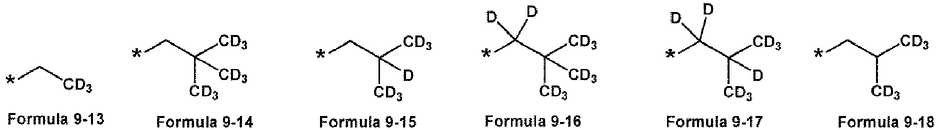 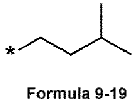 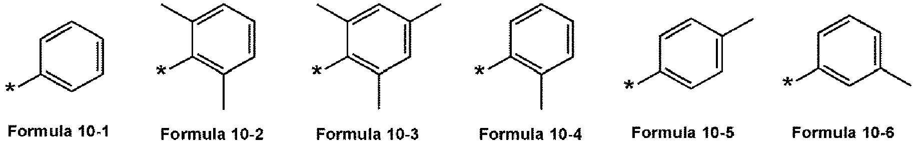 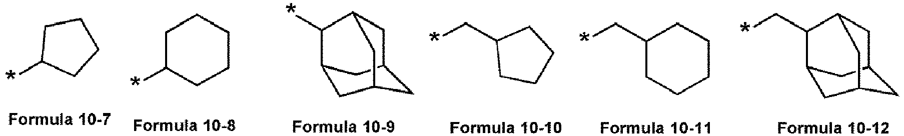 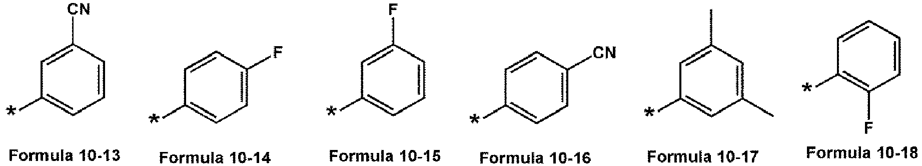 wherein * in Formulae 9-1 to 9-19 and 10-1 to 10-18 indicates a binding site to a neighboring atom,
wherein in -Si(R₁)(R₂)(R₃) of Formula 2A,
all of R₁ to R₃ are the same; or
R₁ and R₃ are identical to each other, and R₂ is different from R₁, and
wherein in Formula 2B,
all of R₄ to R₆ are the same; or
R₄ and R₆ are identical to each other, and R₅ is different from R₄.

7. The organometallic compound of any of claims 1-6, wherein L₁ is selected from ligands represented by Formulae 2A-1 to 2A-5: 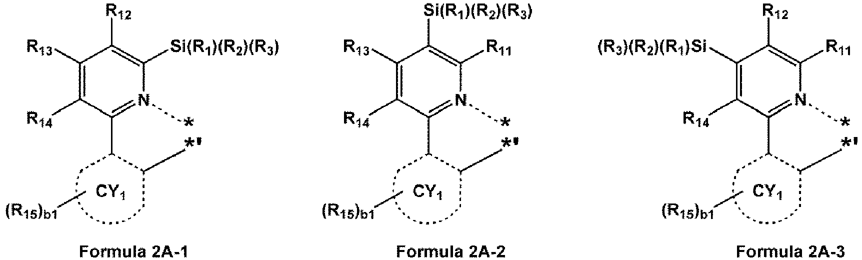 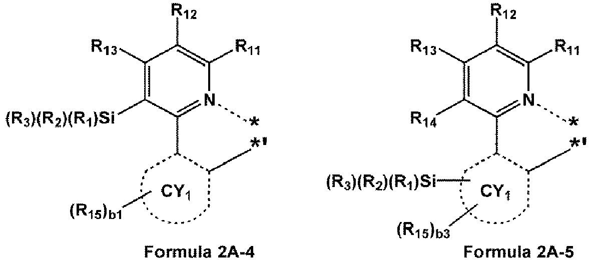 in Formulae 2A-1 to 2A-5,
CY₁, R₁₁ to R₁₅, b1, and R₁ to R₃ are the same as in claim 1,
each of * and *' indicates a binding site to M in Formula 1, and
b3 is an integer selected from 0 to 3, preferably wherein:
L₁ is selected from ligands represented by Formulae 2A(1) to 2A(192): 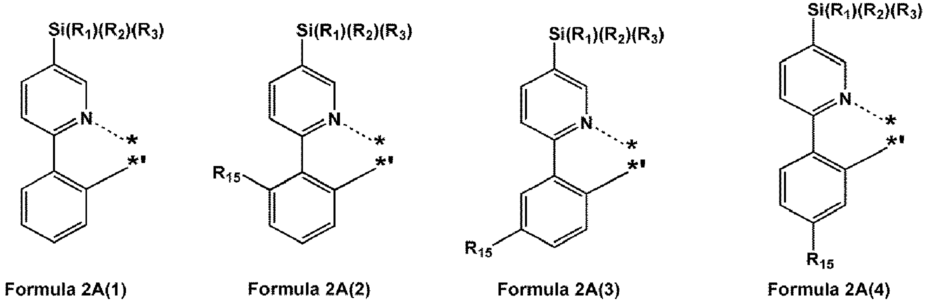 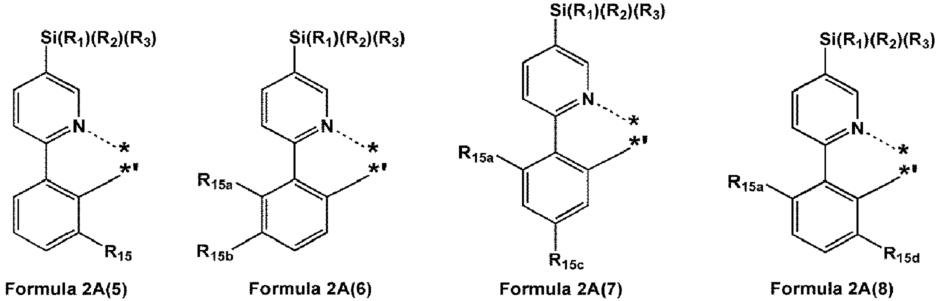 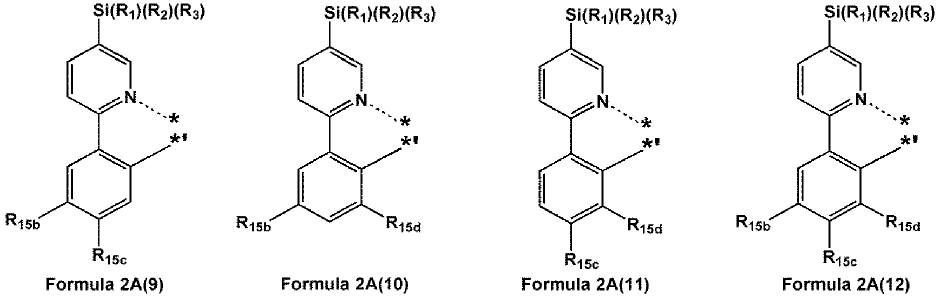 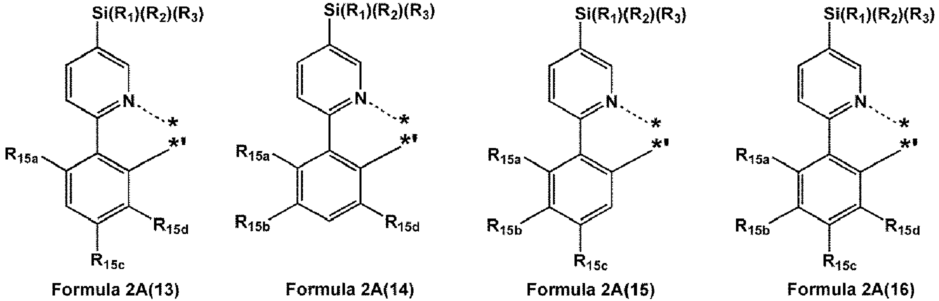 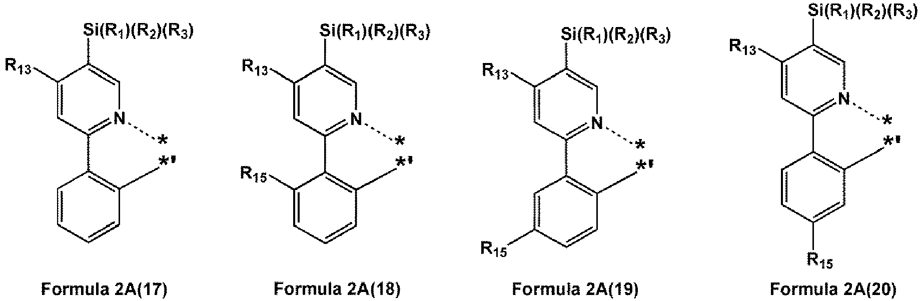 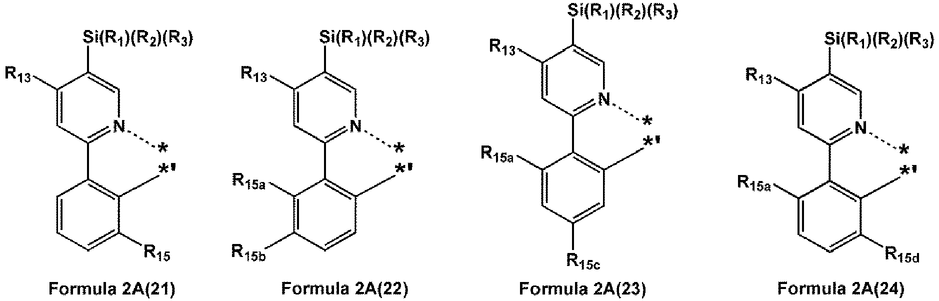 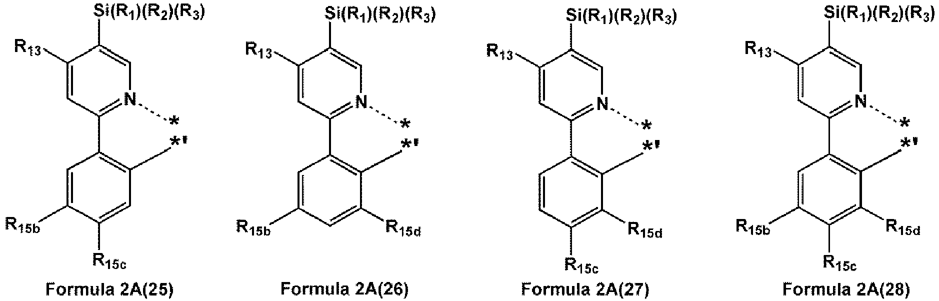 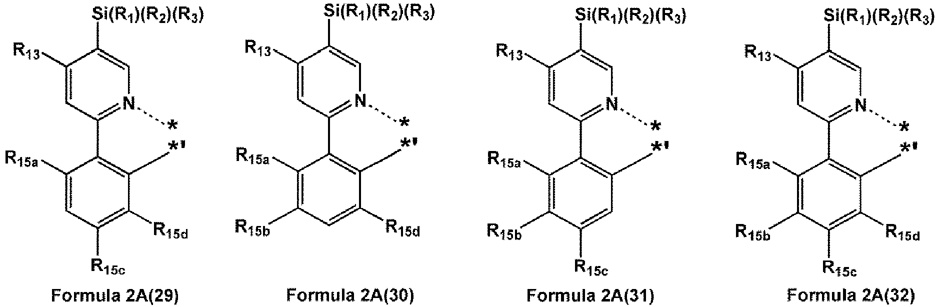 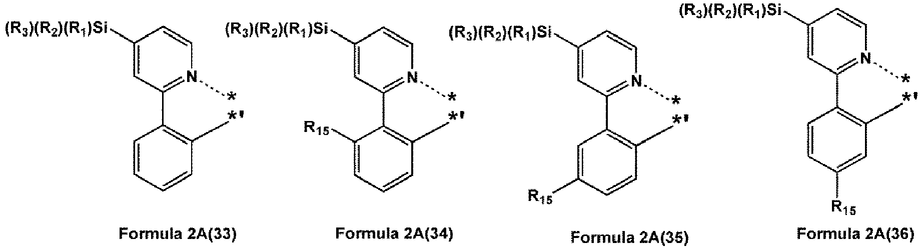 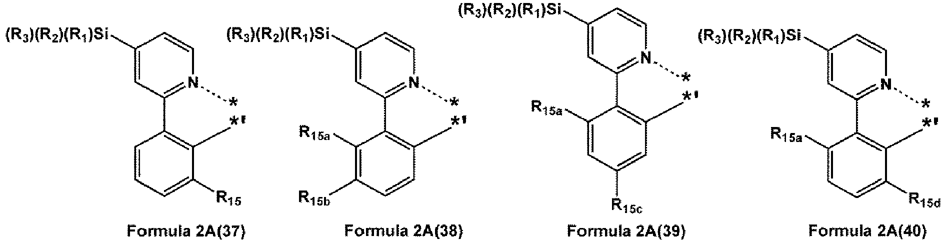 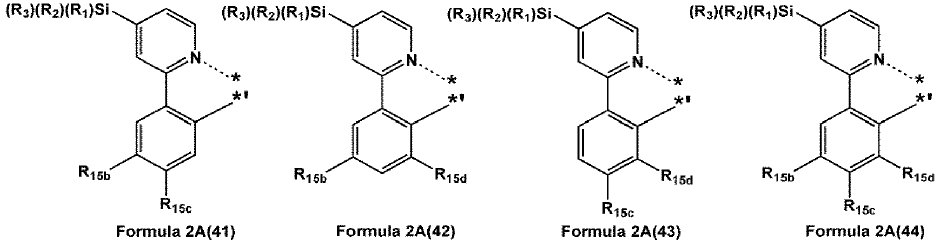 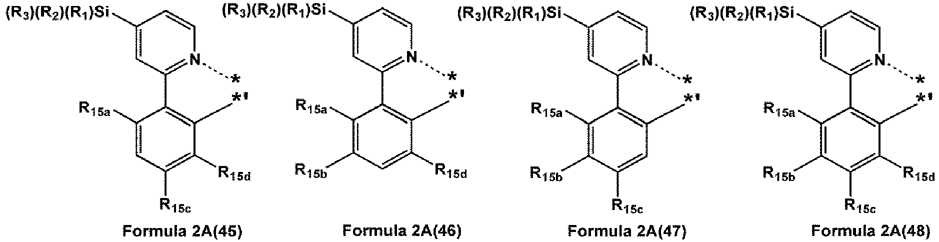 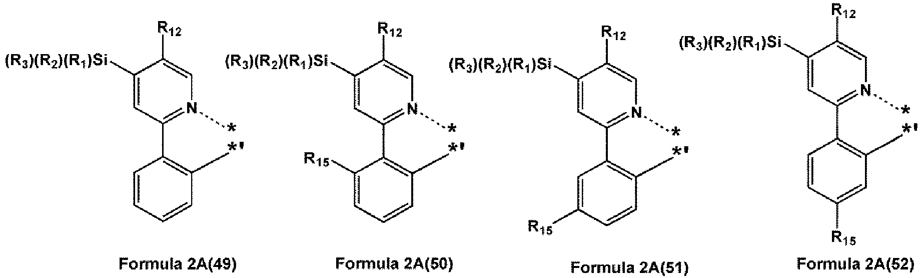 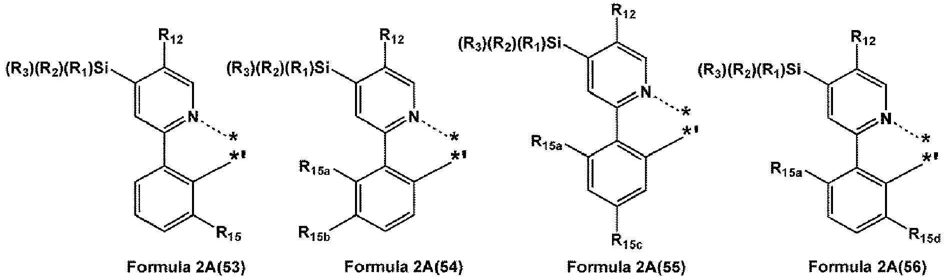 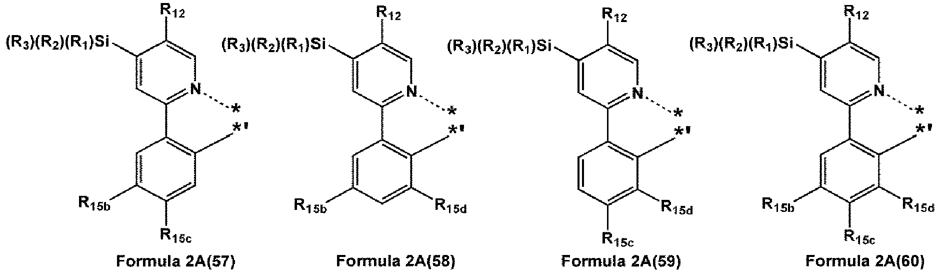 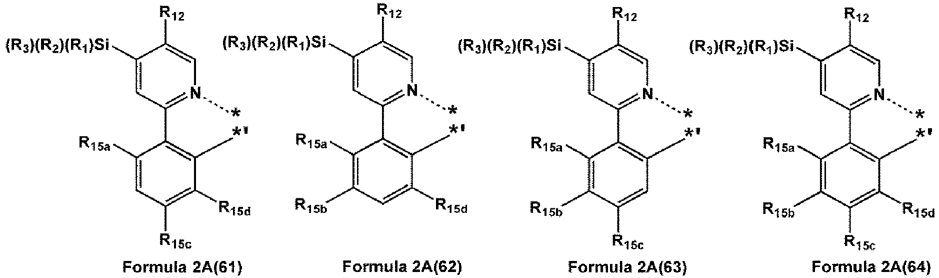 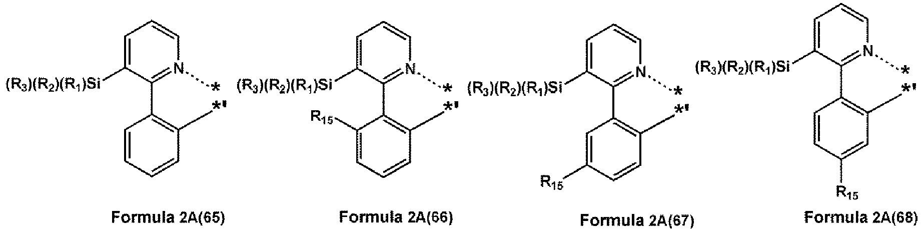 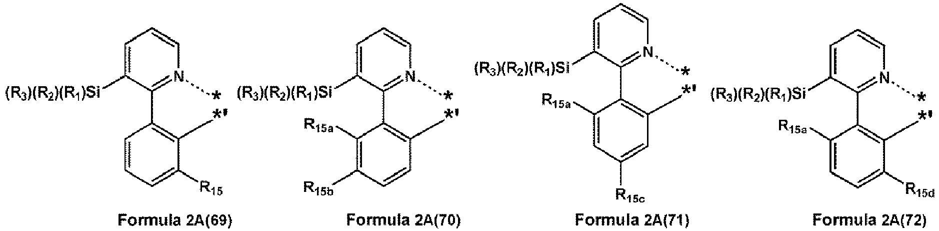 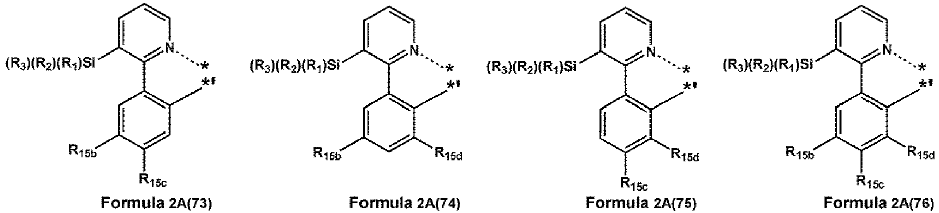 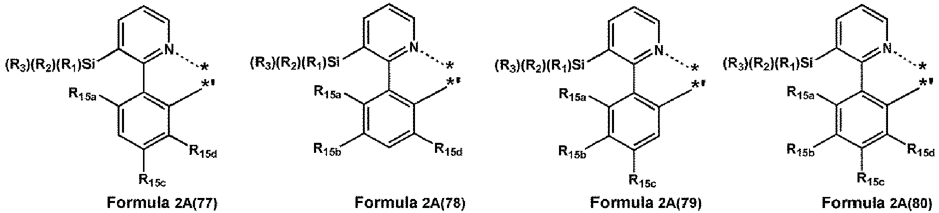 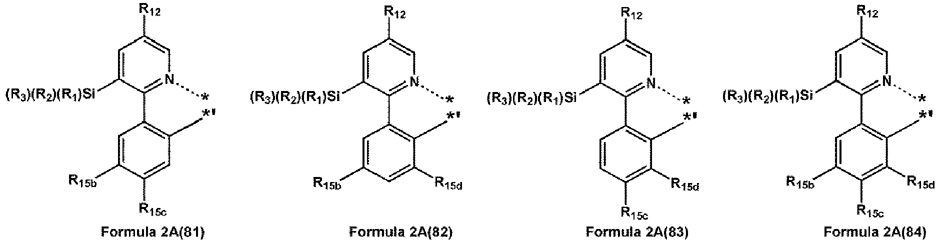 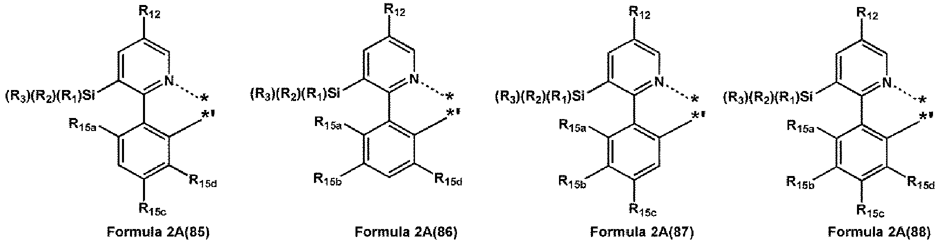 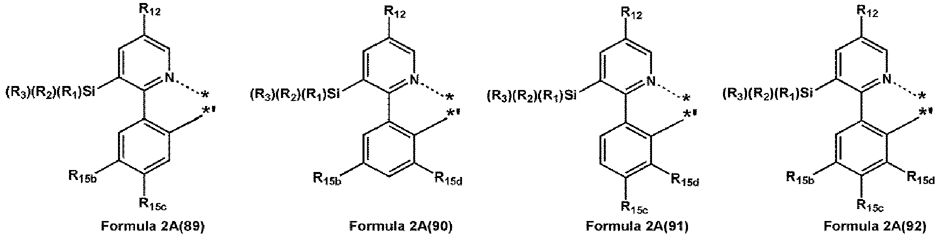 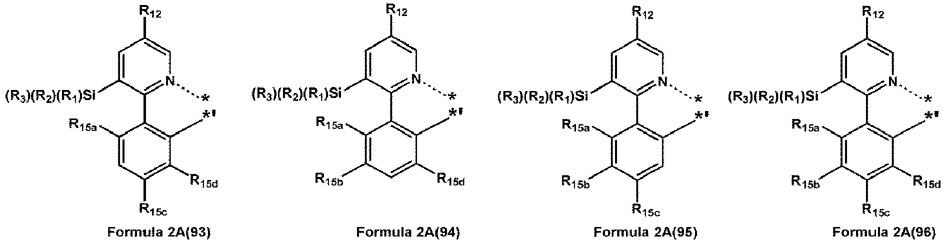 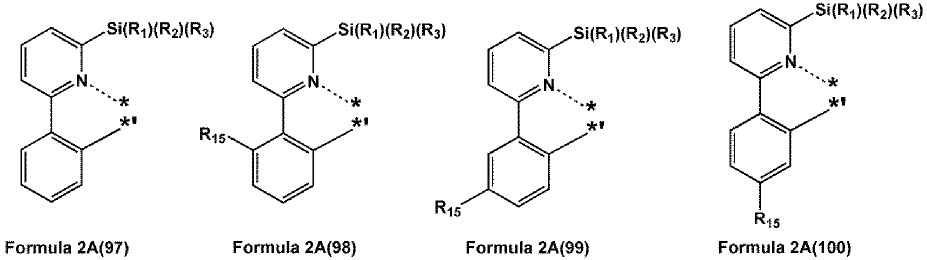 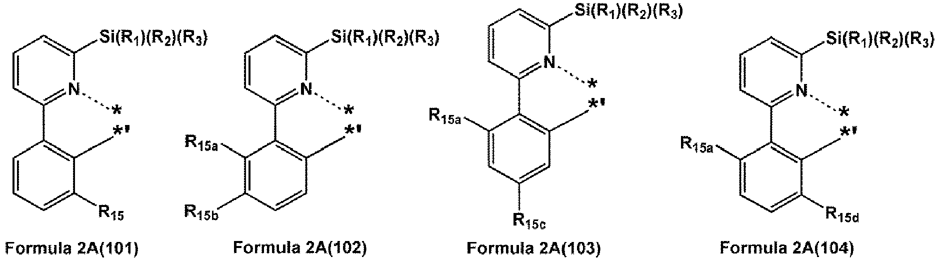 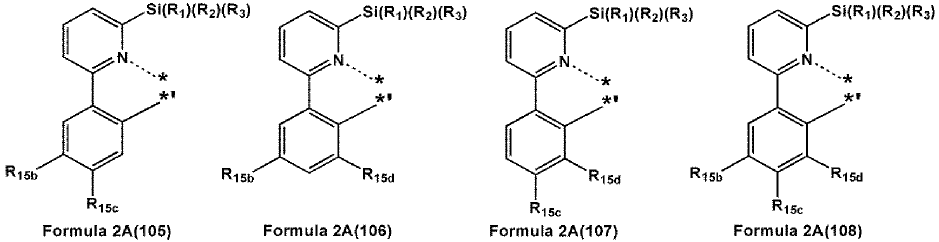 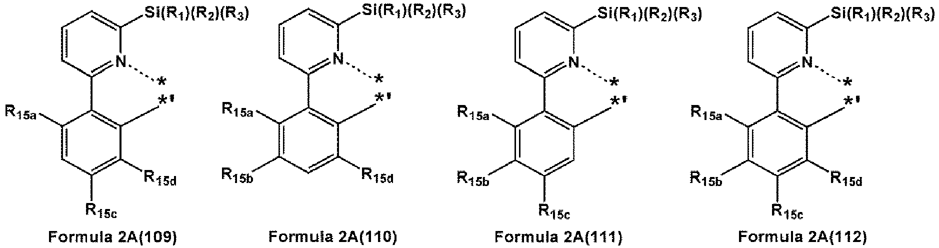 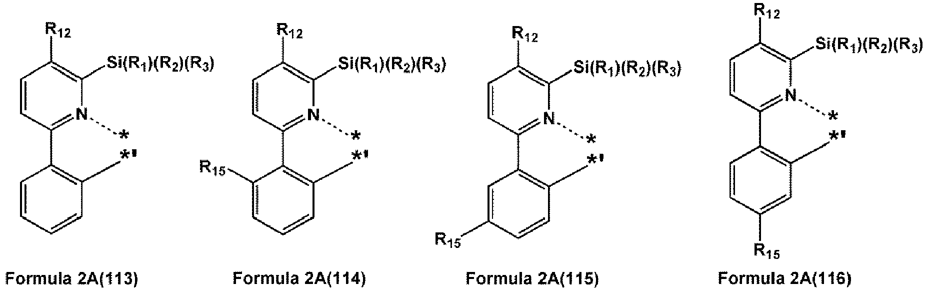 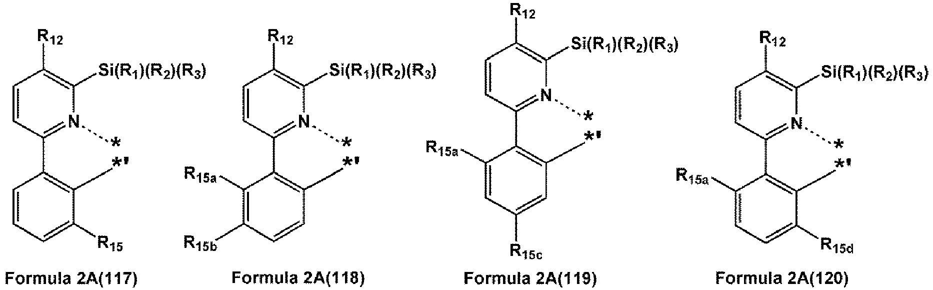 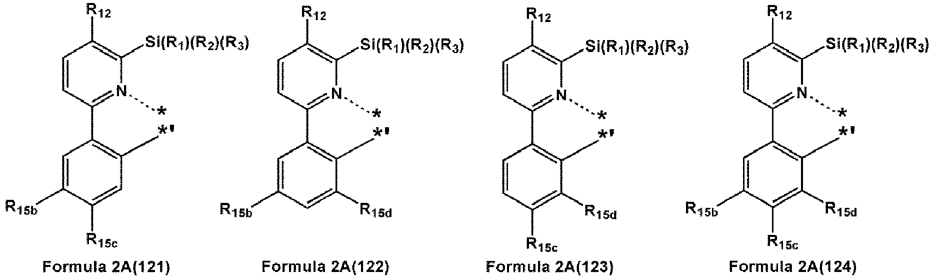 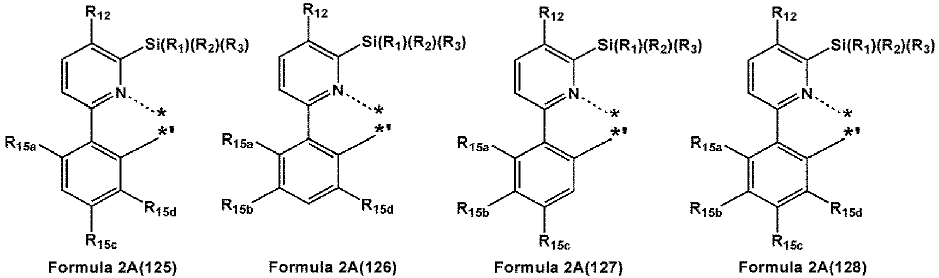 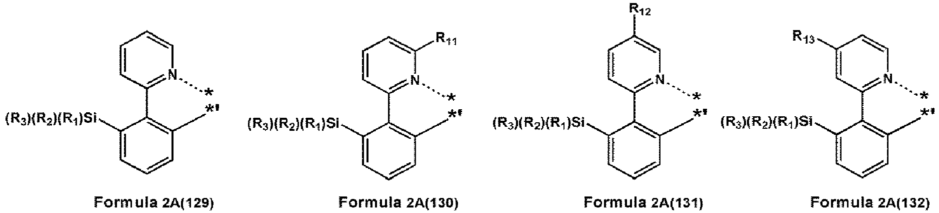 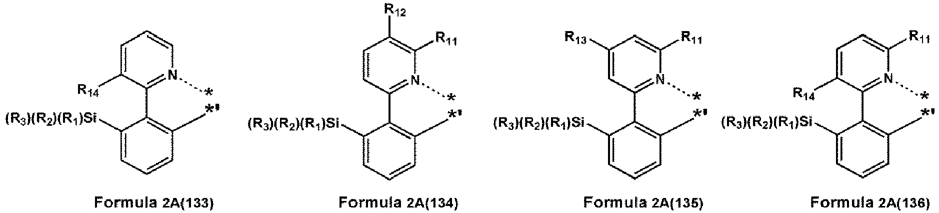 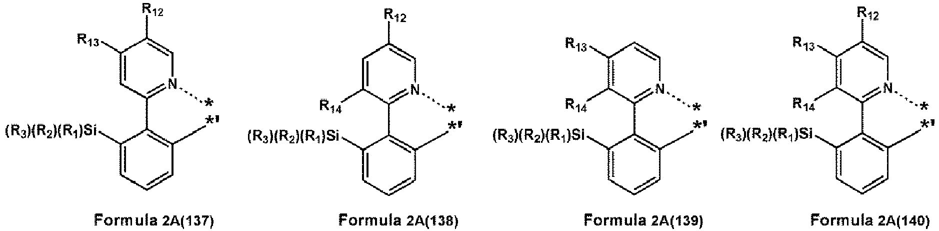 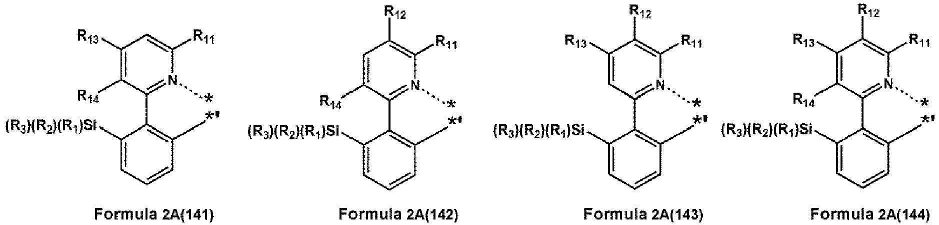 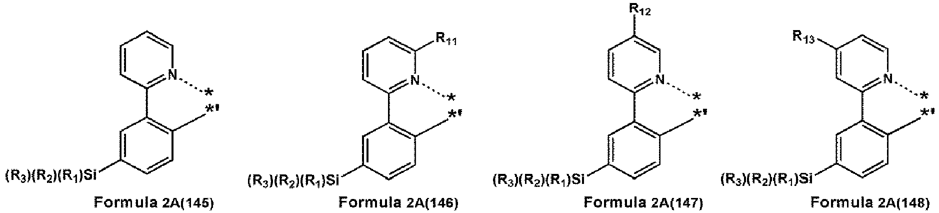 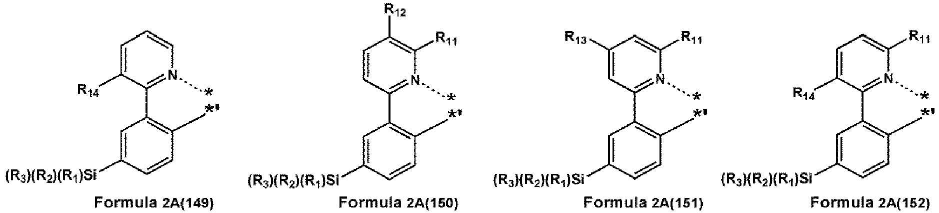 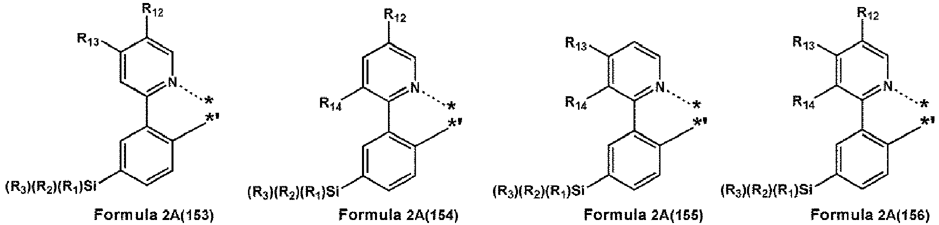 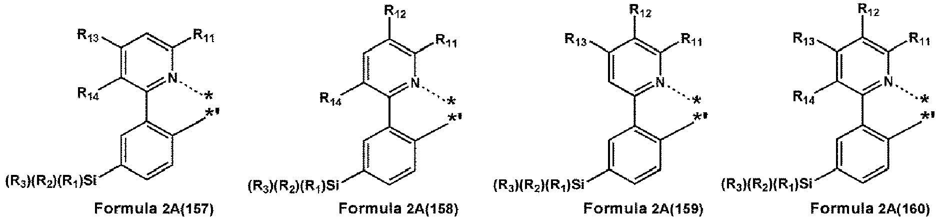 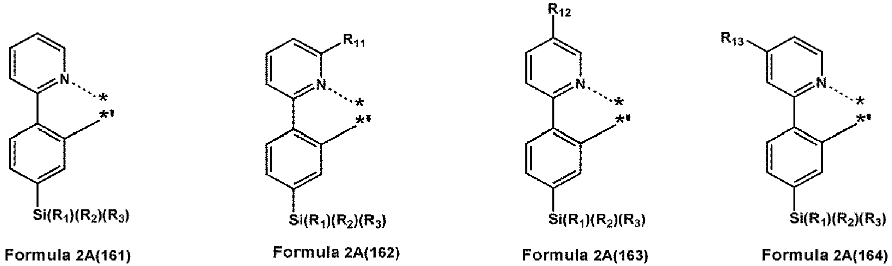 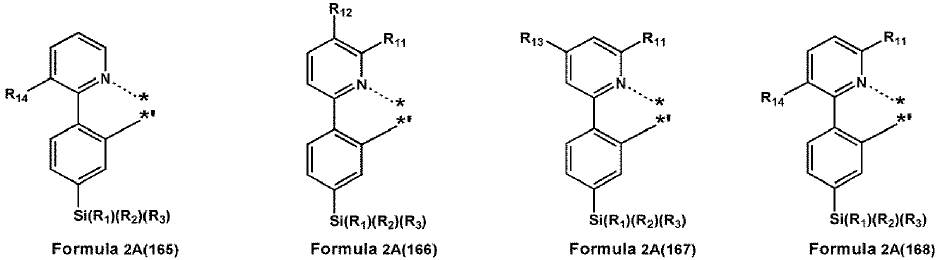 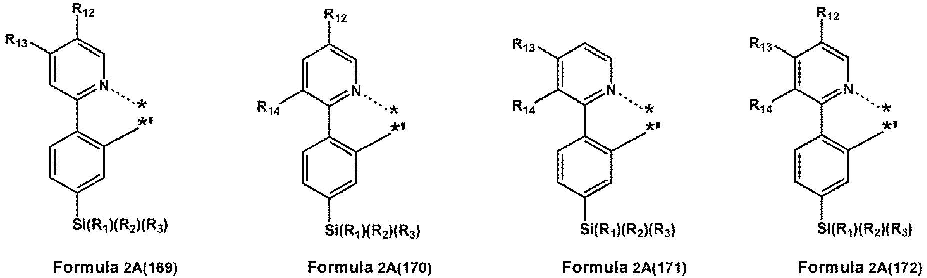 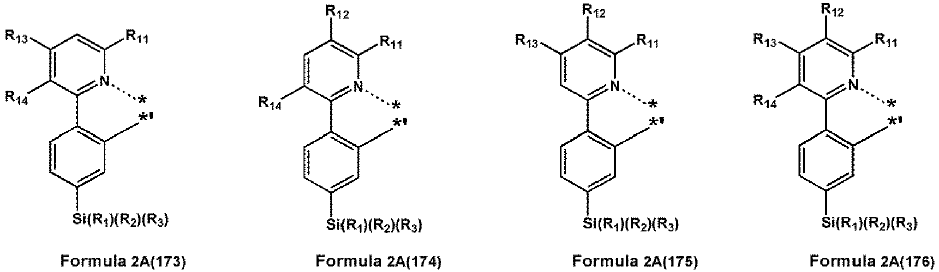 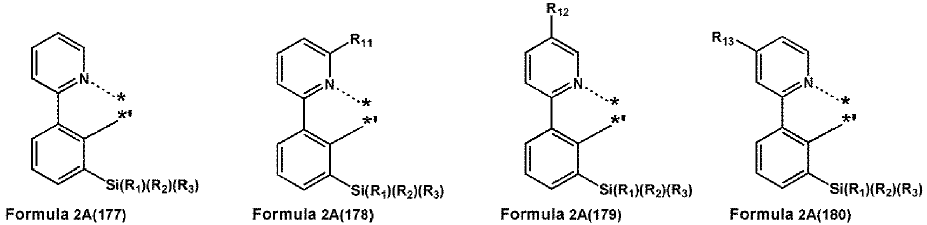 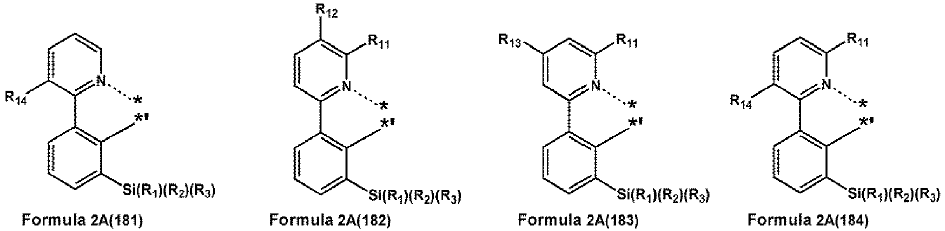 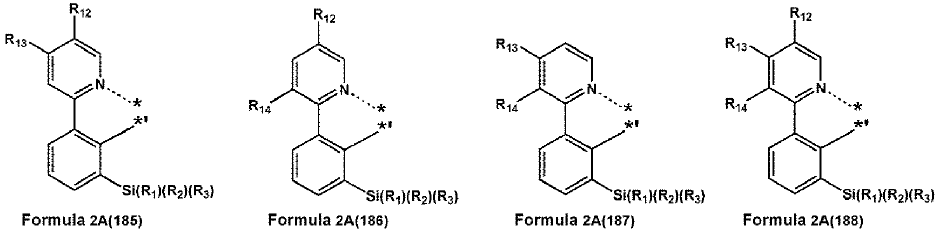 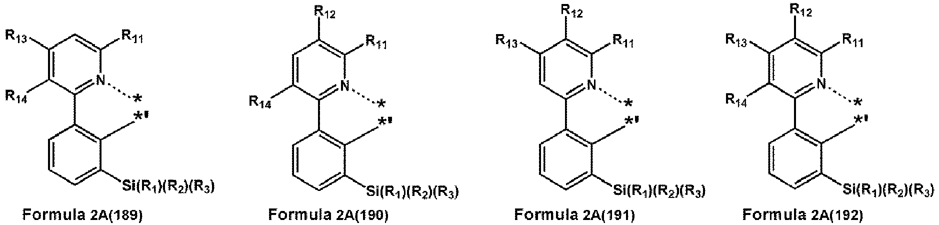 in Formulae 2A(1) to 2A(192),
R₁₁ to R₁₅ and R₁ to R₃ are the same as recited in claim 1,
R₁₅ₐ to R_{15d} are the same as the description of R₁₅ in claim 1, and
each of * and *' indicates a binding site to M in Formula 1,
provided that all of R₁₁ to R₁₅ and R₁₅ₐ to R_{15d} are not simultaneously a hydrogen.

8. The organometallic compound of claim 7, wherein
L₁ is selected from ligands represented by Formulae 2A(1) to 2A(48), 2A(65) to 2A(80), 2A(97) to 2A(112), and 2A(129) to 2A(192), and
in Formulae 2A(1) to 2A(48), 2A(65) to 2A(80), 2A(97) to 2A(112), and 2A(129) to 2A(192),
R₁ to R₃ are each independently selected from
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₀ alkyl group, and a phenyl group,
all of R₁ to R₃ are the same; or R₁ and R₃ are identical to each other, and R₂ is different from R₁, and
R₁₁ to R₁₅ and R₁₅ₐ to R_{15d} are each independently selected from a deuterium, -F, a cyano group, a nitro group, -SF₅, -CH₃, -CD₃, -CD₂H, -CDH₂, -CF₃, -CF₂H, -CFH₂, groups represented by Formulae 9-1 to 9-19, and groups represented by Formulae 10-1 to 10-36: 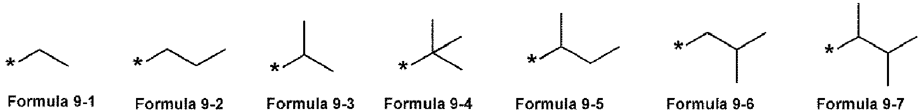 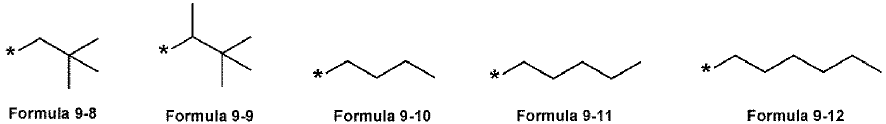 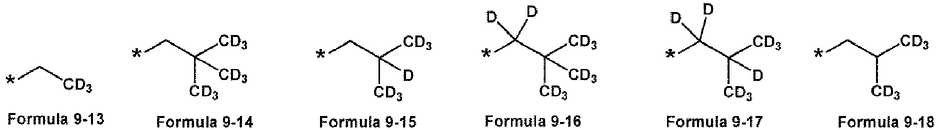 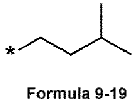 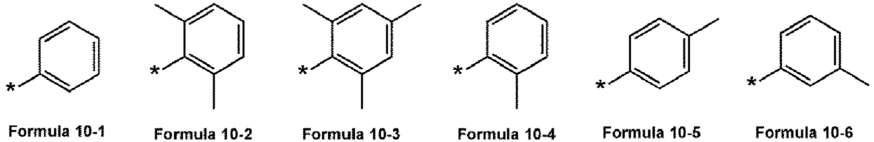 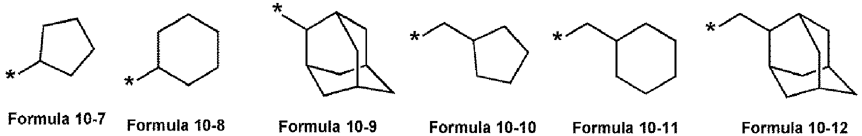 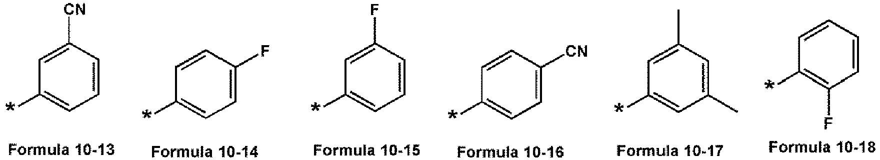 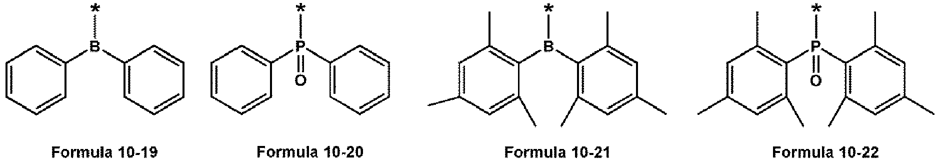 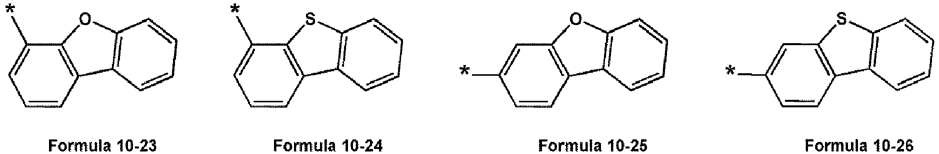 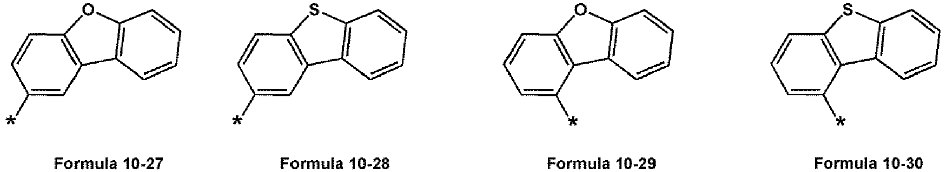 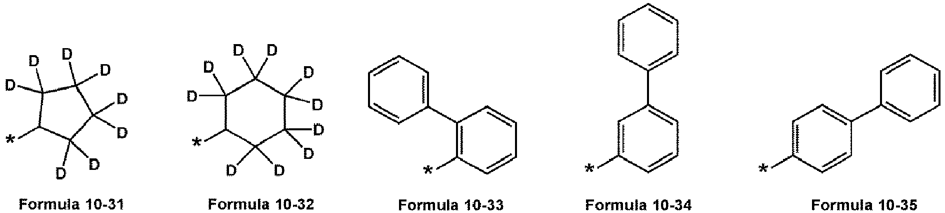 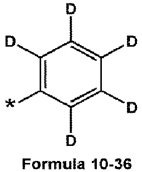 * in Formulae 9-1 to 9-19 and 10-1 to 10-36 indicates a binding site to a neighboring atom.

9. The organometallic compound of any of claims 1-8, wherein
L₂ is selected from ligands represented by Formulae 2B-1 to 2B-14: 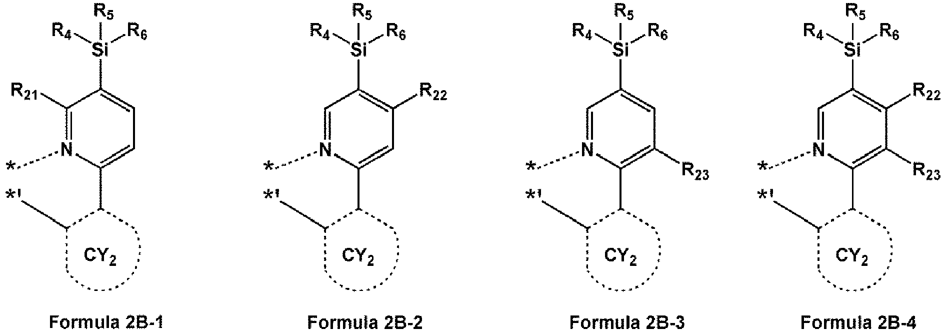 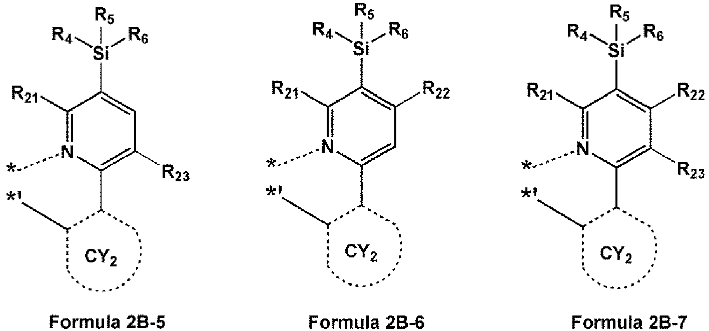 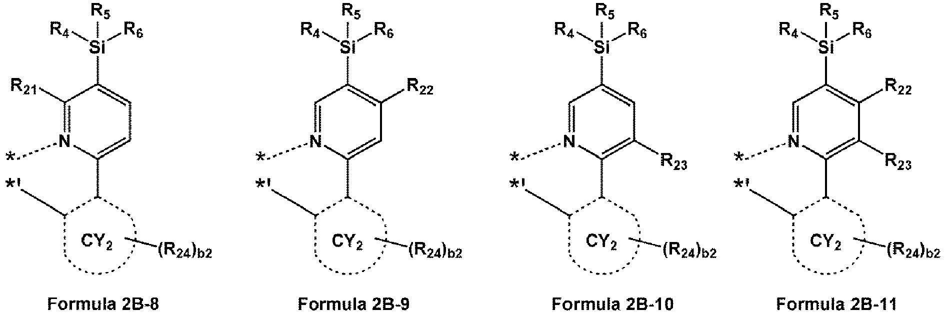 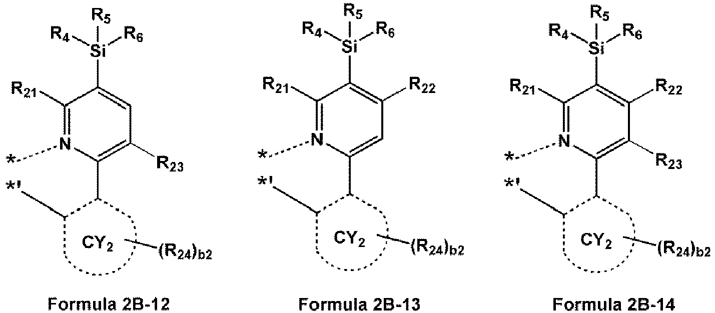 in Formulae 2B-1 to 2B-14,
CY₂, R₂₁ to R₂₄, R₄ to R₆, and b2 are the same as in claim 1, and
each of * and *' indicates a binding site to M in Formula 1,
provided that all of R₂₁ to R₂₄ are not simultaneously a hydrogen, preferably wherein:
L₂ is selected from ligands represented by Formulae 2B(1) to 2B(96): 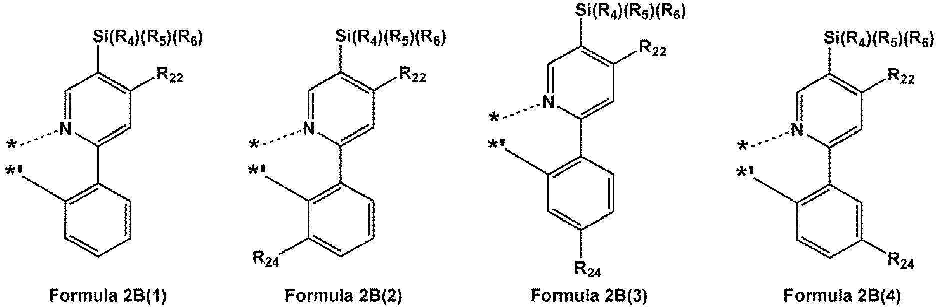 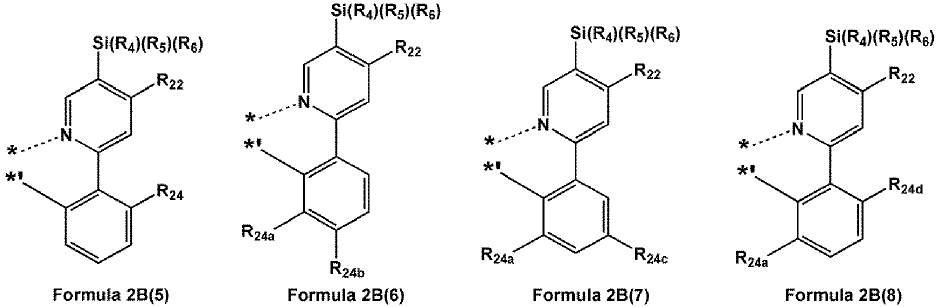 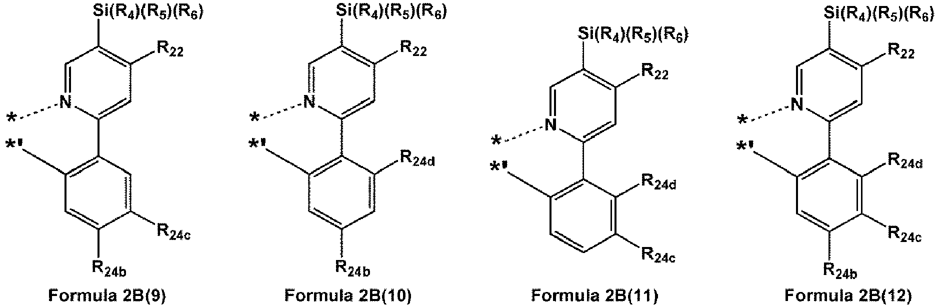 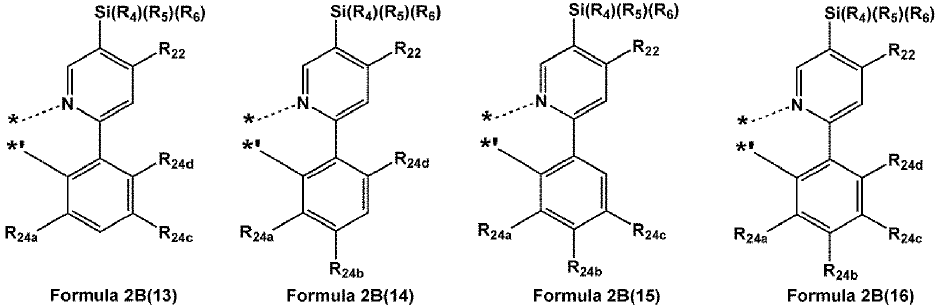 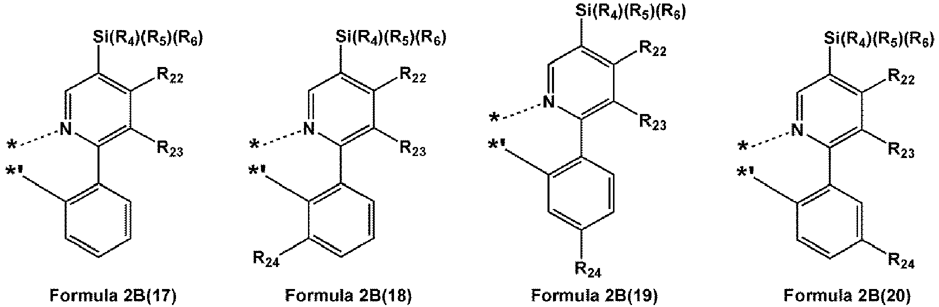 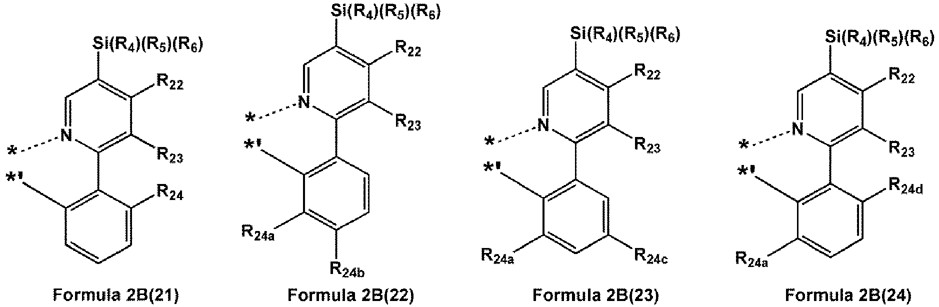 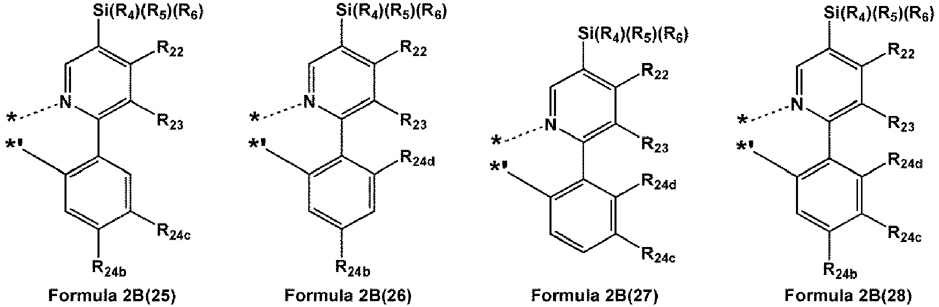 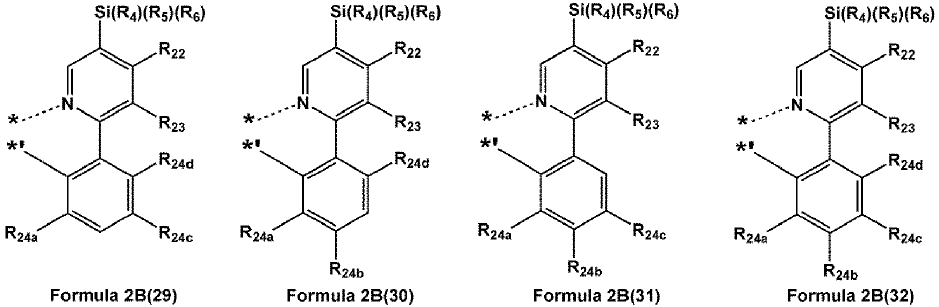 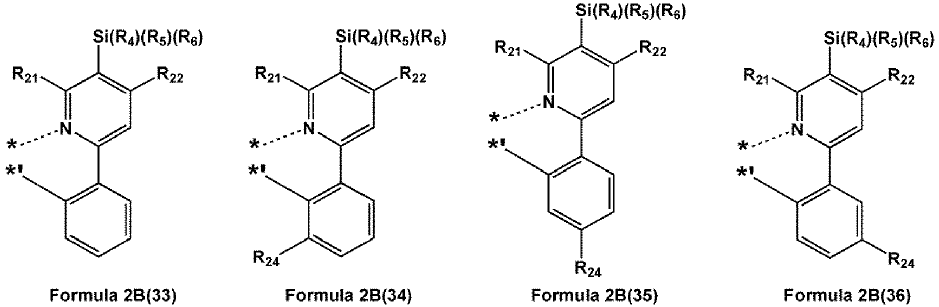 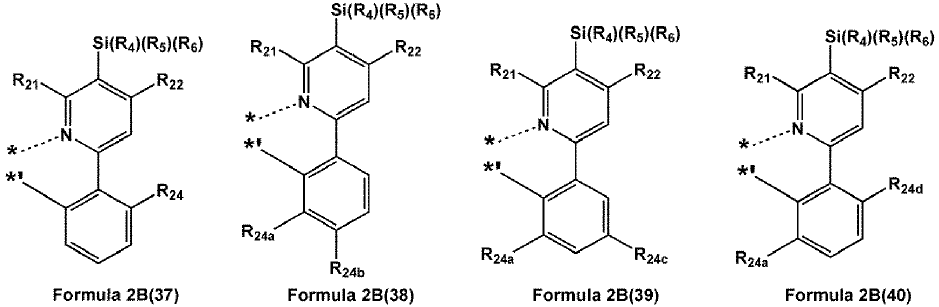 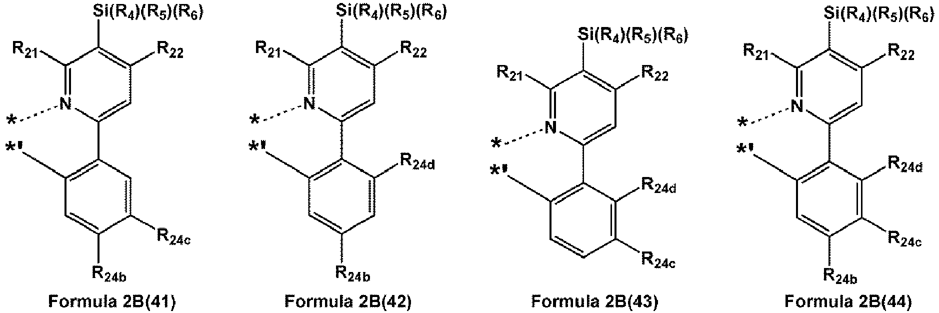 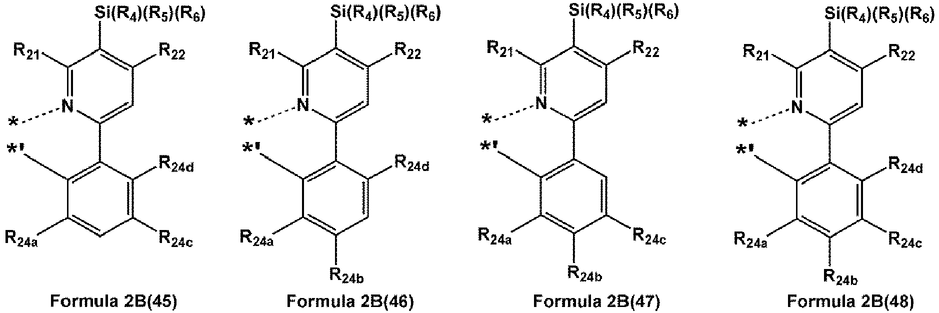 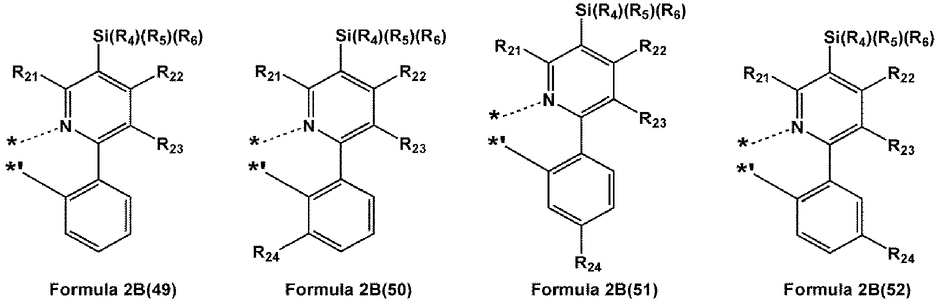 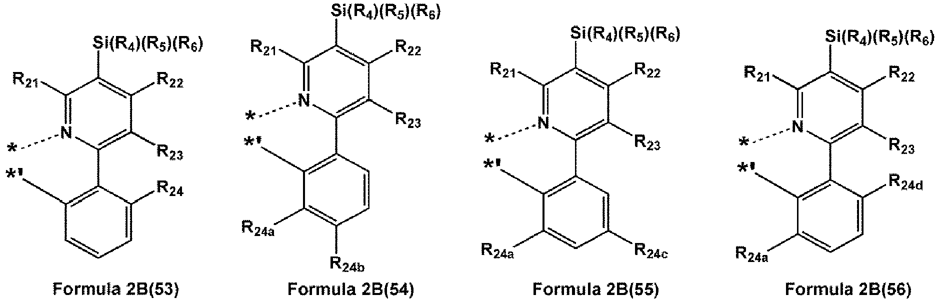 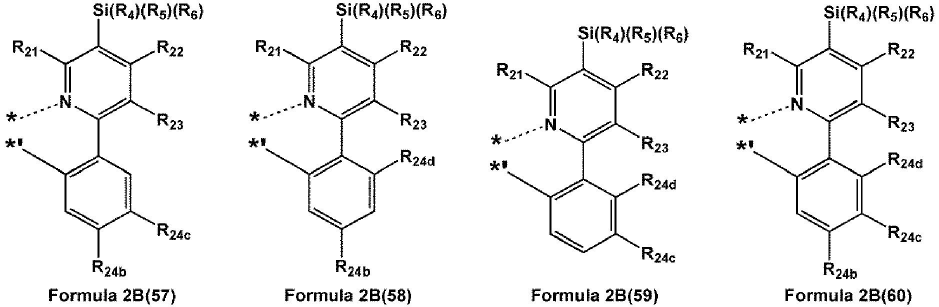 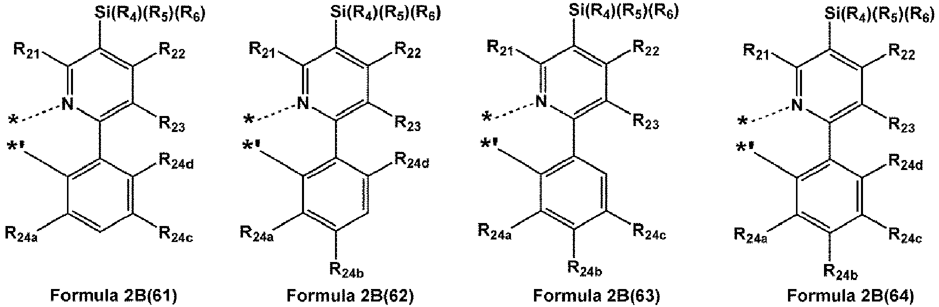 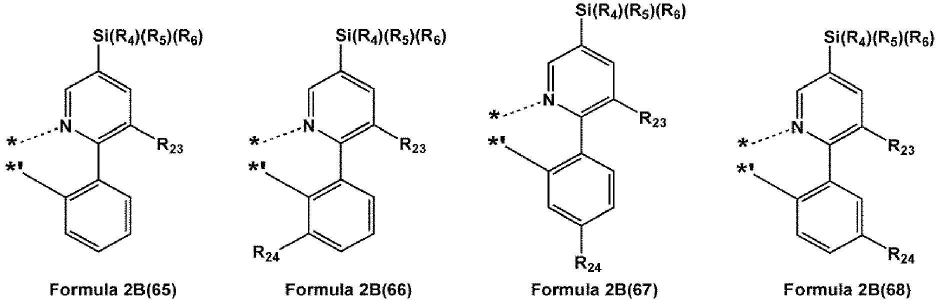 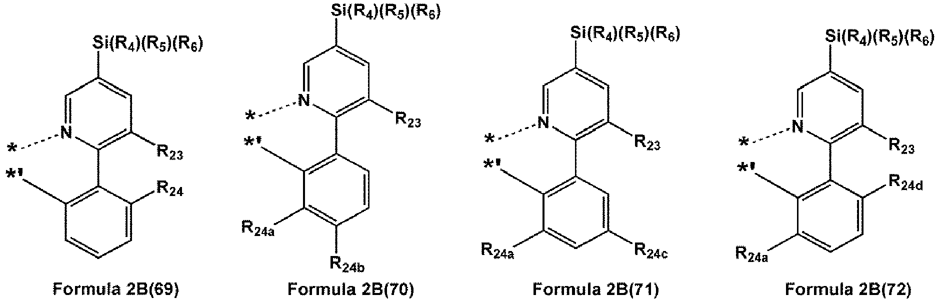 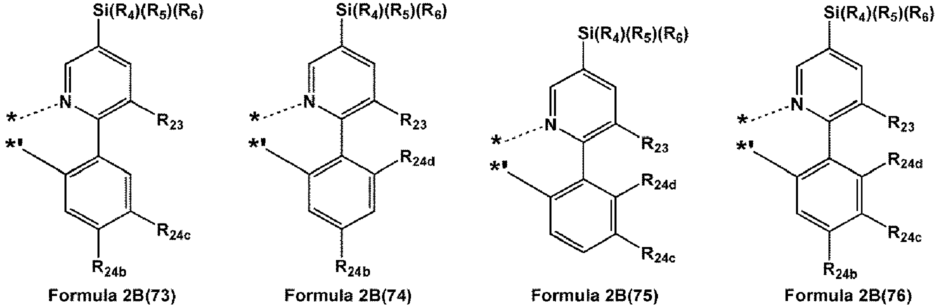 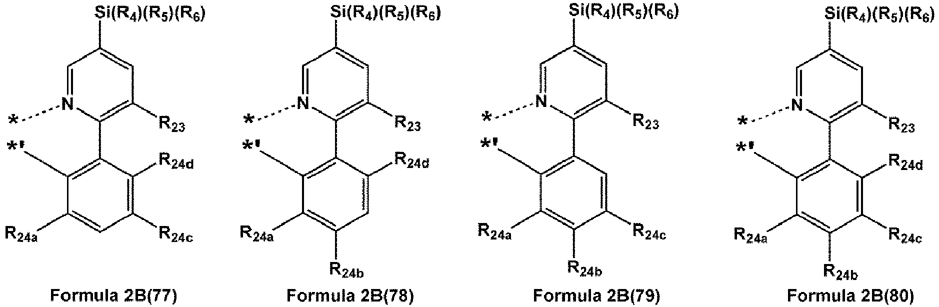 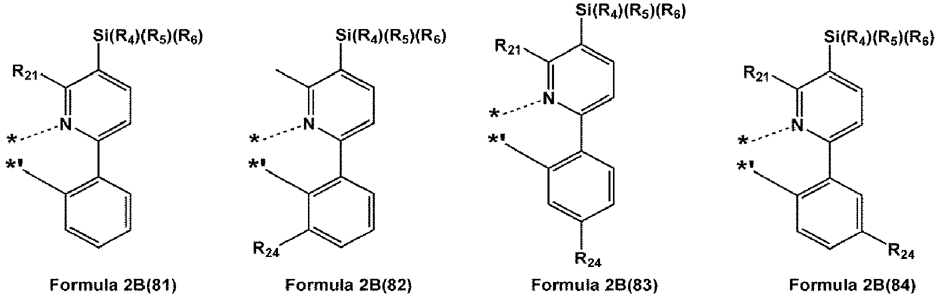 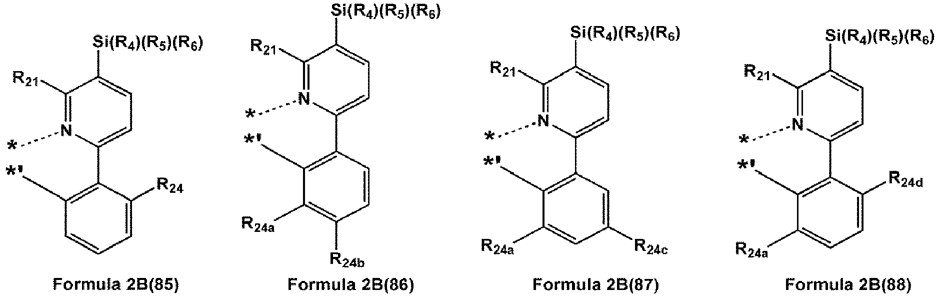 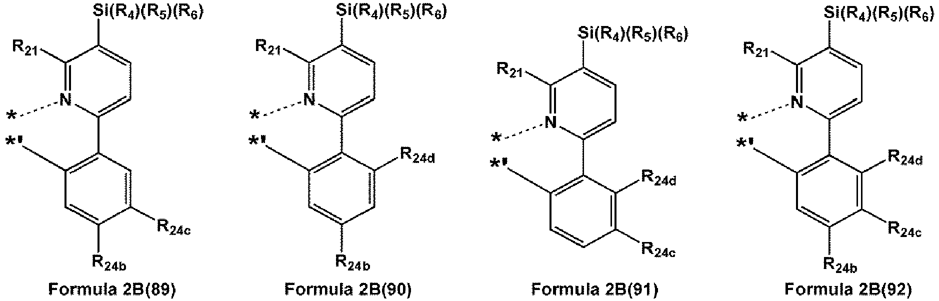 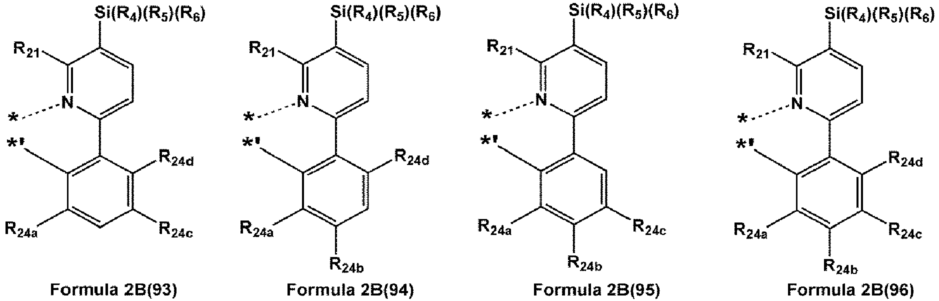 in Formulae 2B(1) to 2B(96),
R₂₁ to R₂₄ and R₄ to R₆ are the same as in claim 1,
R₂₄ₐ to R_{24d} are the same as R₂₄ in claim 1, and
each of * and *' indicates a binding site to M in Formula 1,
provided that all of R₂₁ to R₂₄ and R₂₄ₐ to R_{24d} are not simultaneously a hydrogen.

10. The organometallic compound of claim 9, wherein
L₂ is selected from ligands represented by Formulae 2B(1) to 2B(48) and 2B(65) to 2B(80), and
in Formulae 2B(1) to 2B(48) and 2B(65) to 2(80),
R₄ to R₆ are each independently selected from
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, and -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from a deuterium, a C₁-C₁₀ alkyl group, and a phenyl group,
all of R₄ to R₆ are the same; or R₄ and R₆ are identical to each other, and R₅ is different from R₄, and
R₂₁ to R₂₄ and R₂₄ₐ to R_{24d} are each independently selected from a deuterium, -F, a cyano group, a nitro group, -SF₅, -CH₃, -CD₃, -CD₂H, -CDH₂, -CF₃, -CF₂H, -CFH₂, groups represented by Formulae 9-1 to 9-19, and groups represented by Formulae 10-1 to 10-36: 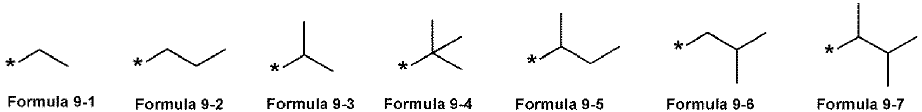 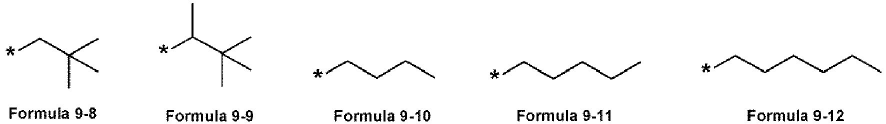 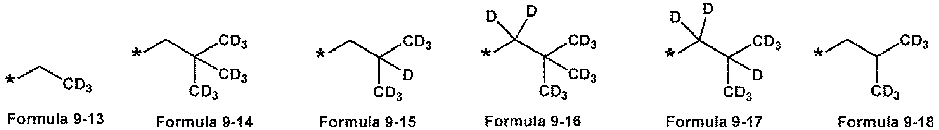 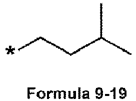 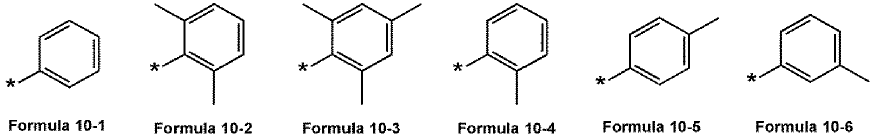 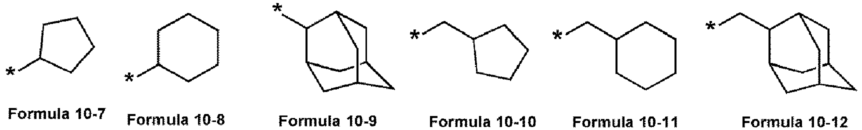 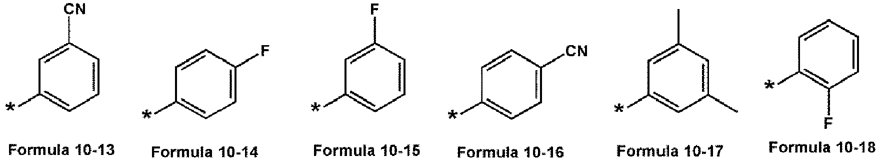 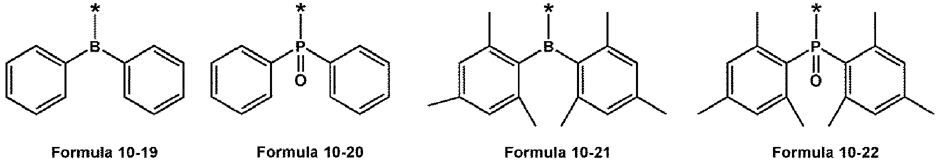 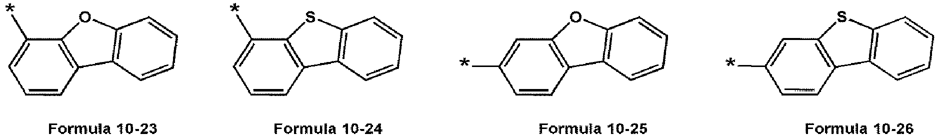 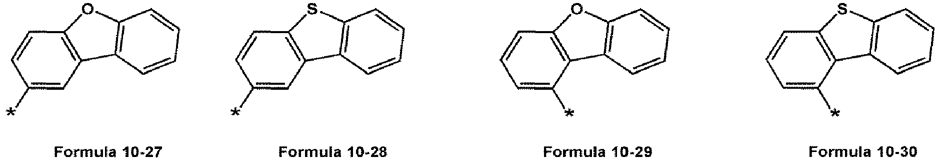 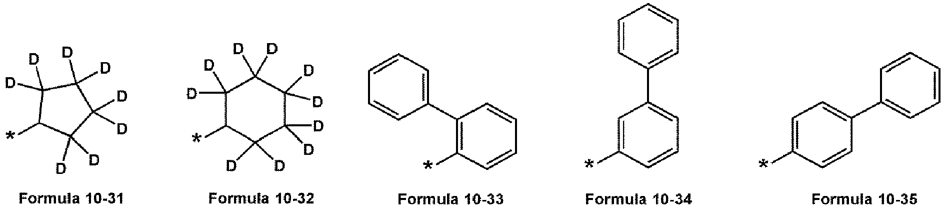 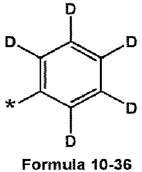 * in Formulae 9-1 to 9-19 and 10-1 to 10-36 indicates a binding site to a neighboring atom.

11. The organometallic compound of claim 1, wherein
the organometallic compound is one of Compounds 1 to 292:

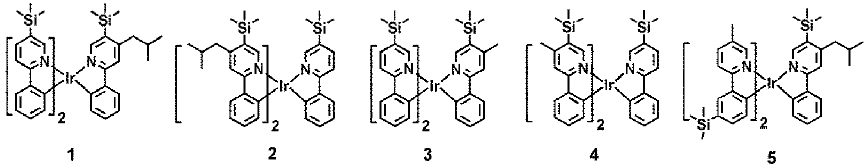

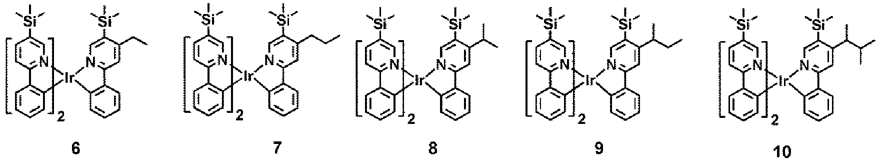

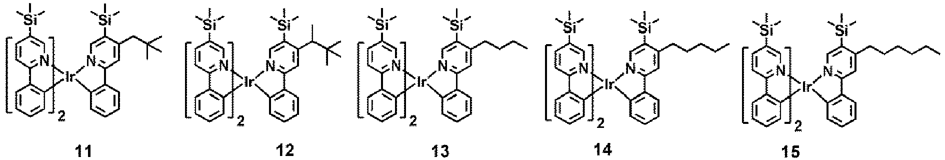

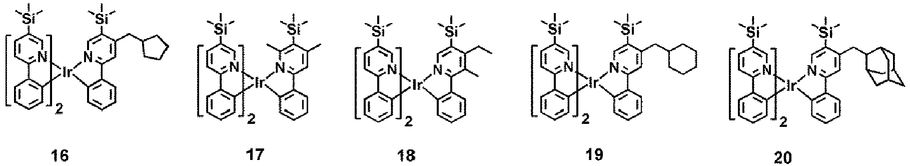

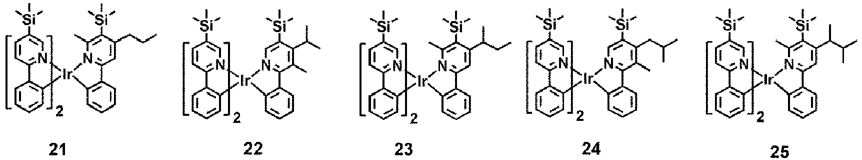

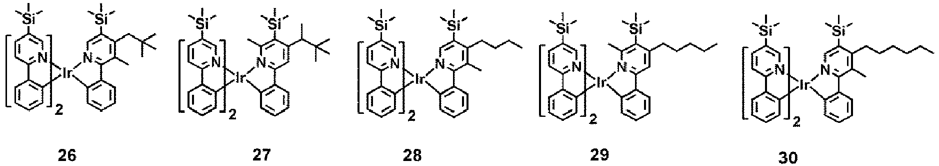

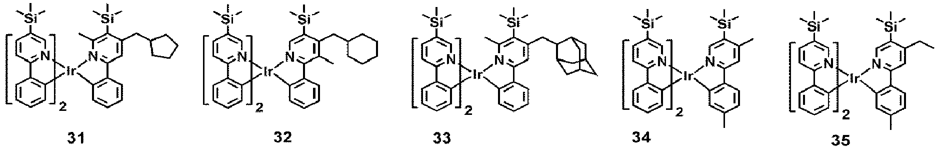

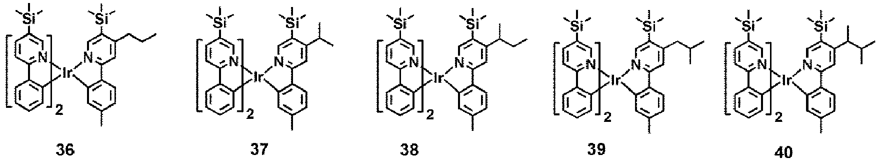

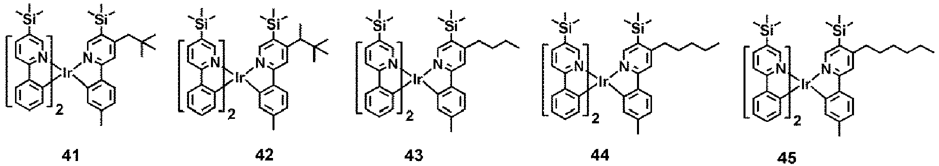

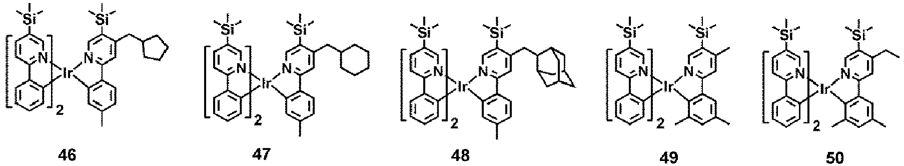

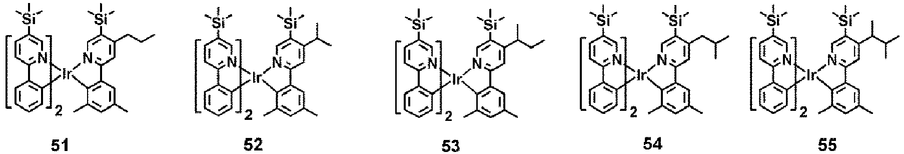

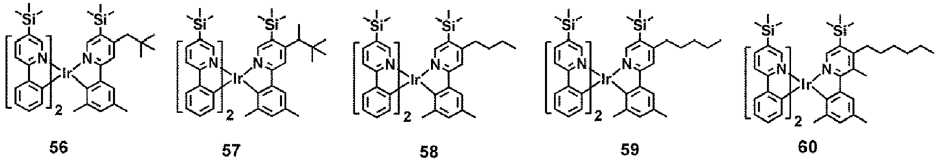

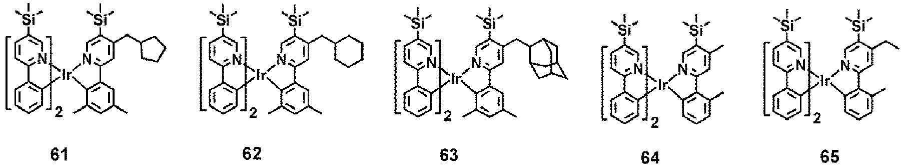

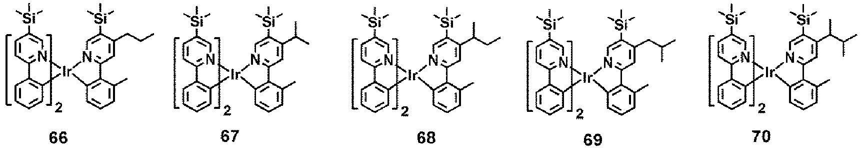

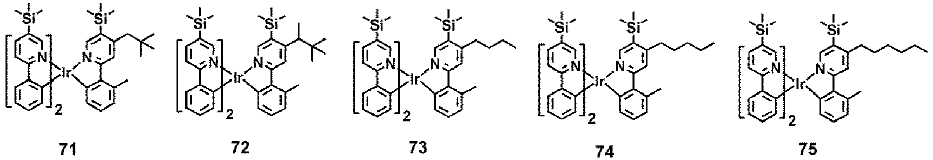

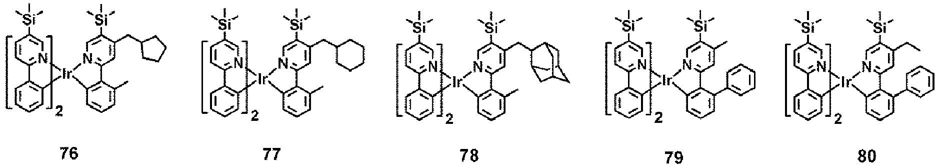

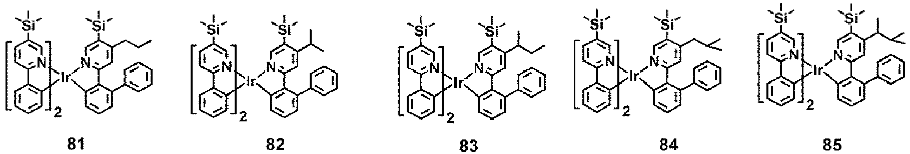

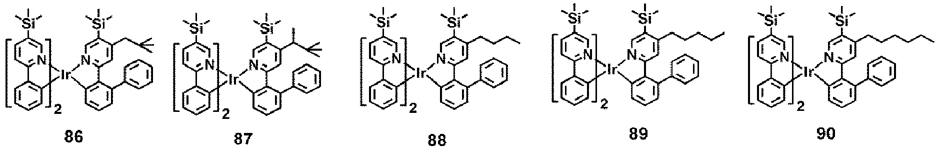

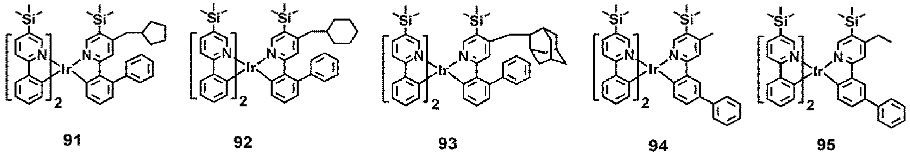

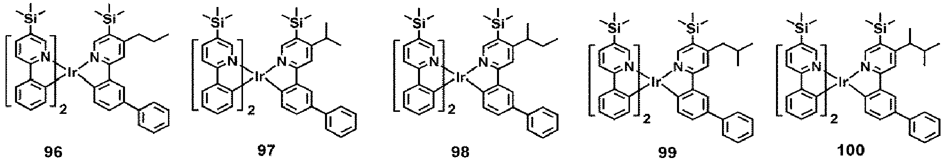

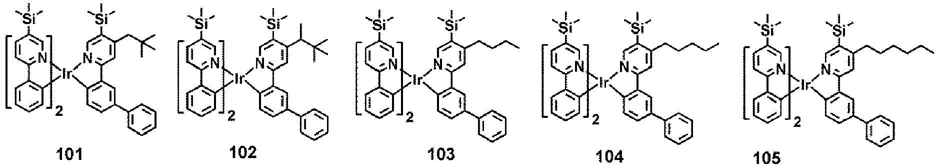

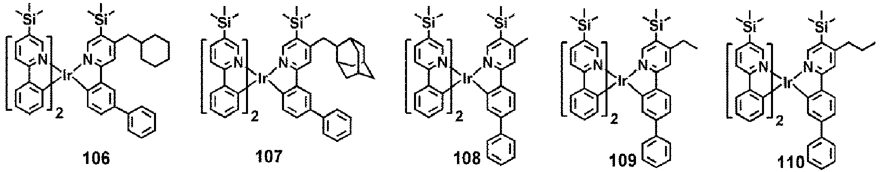

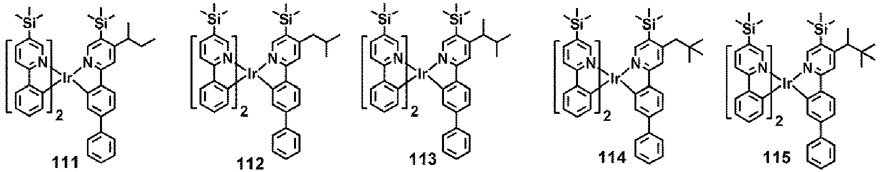

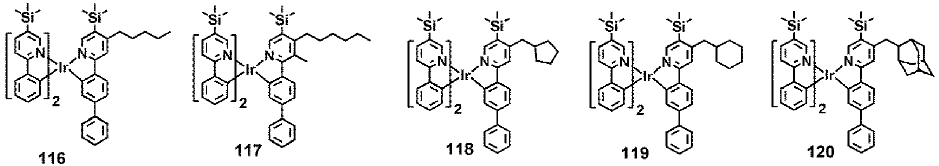

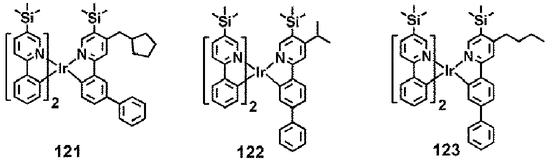

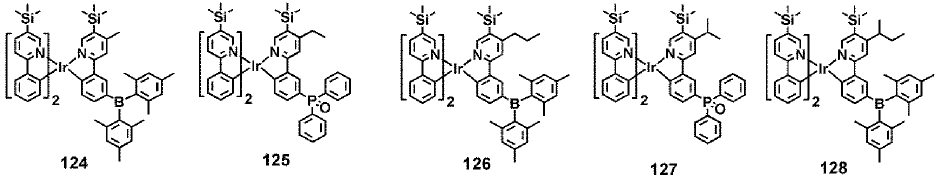

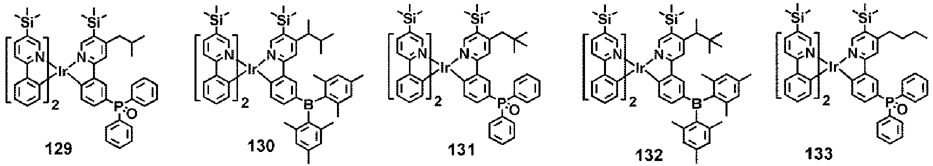

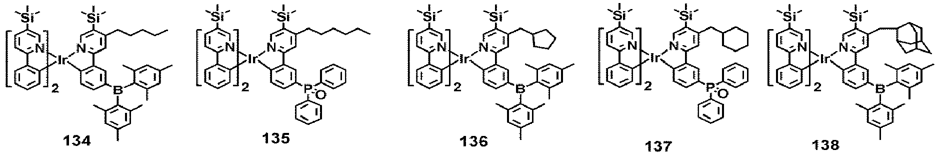

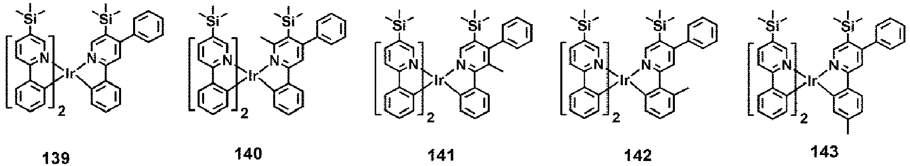

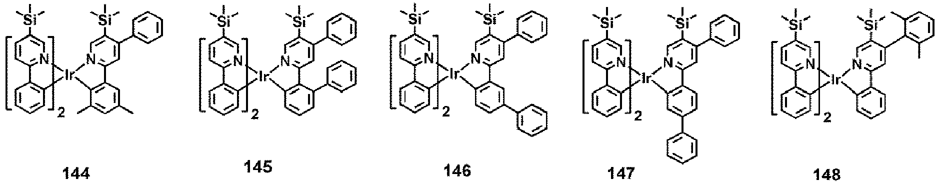

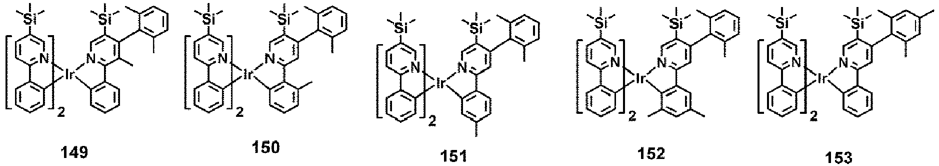

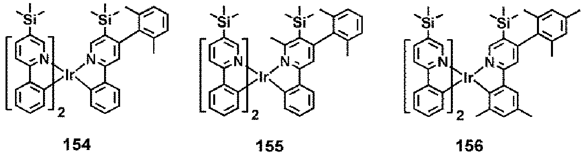

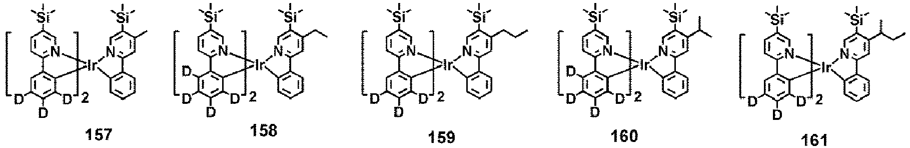

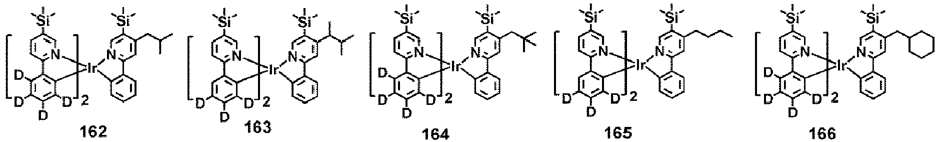

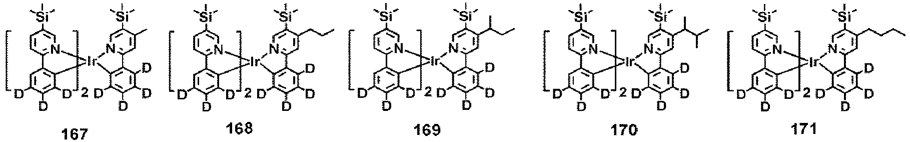

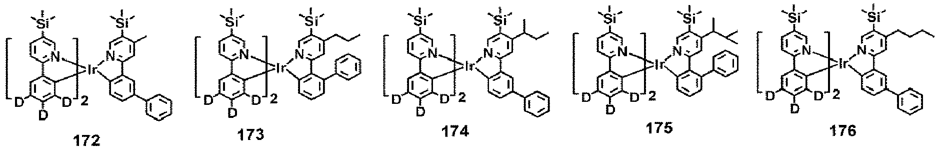

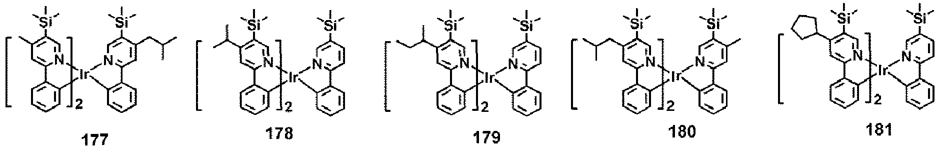

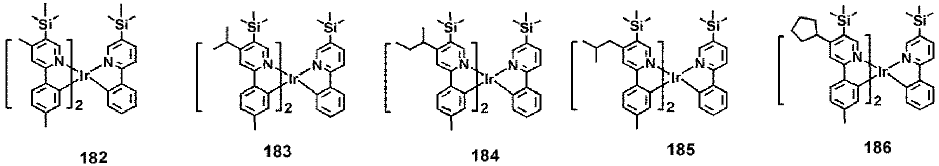

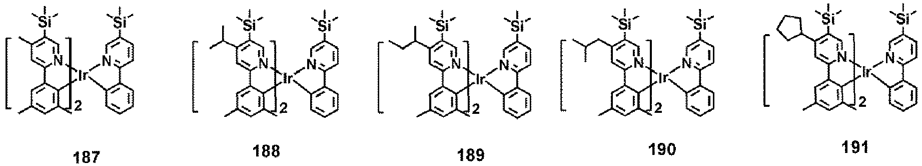

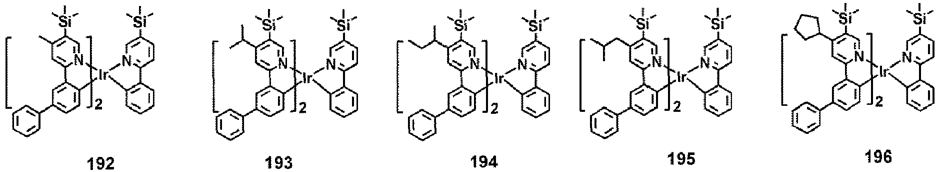

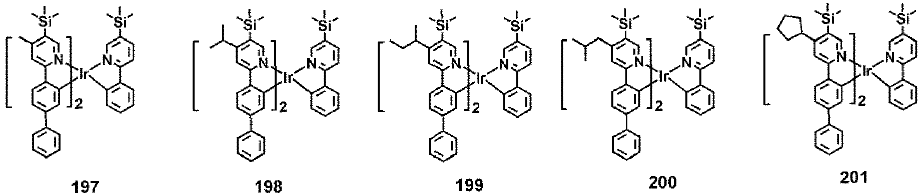

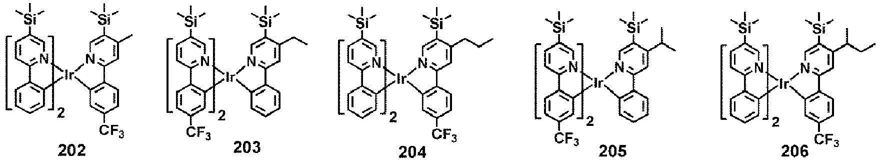

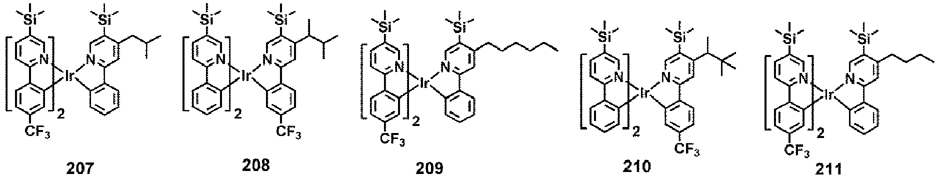

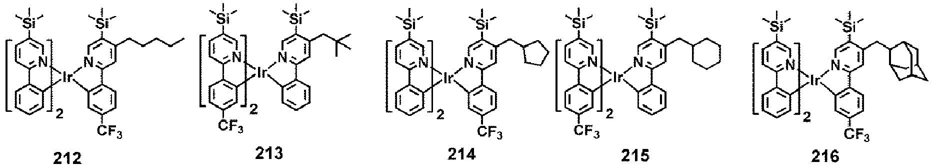

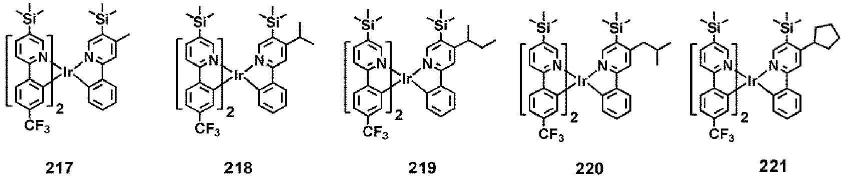

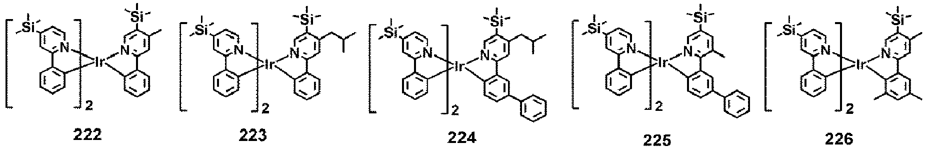

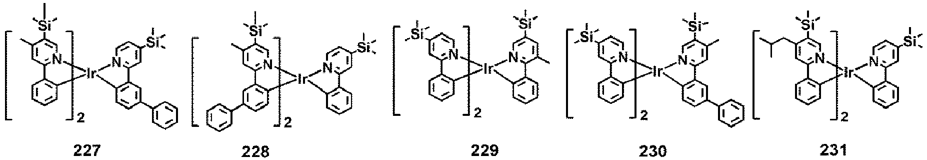

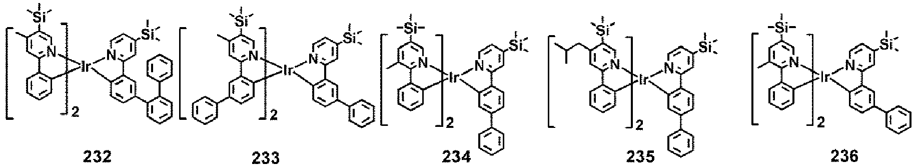

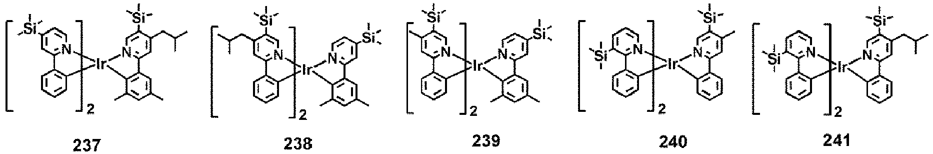

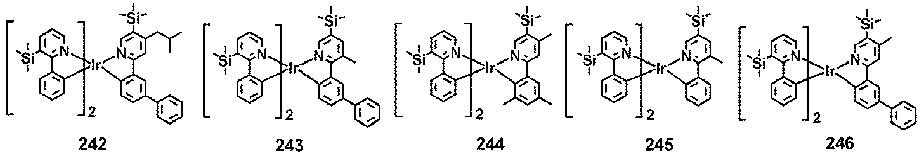

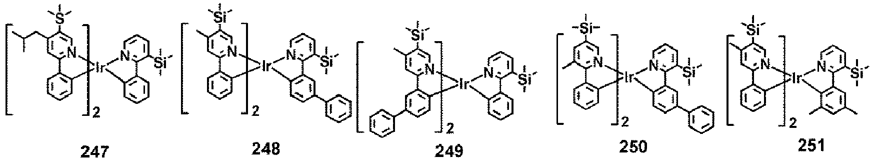

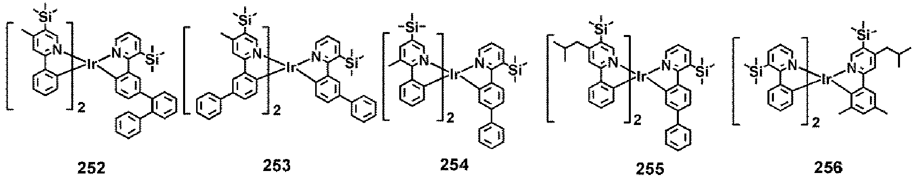

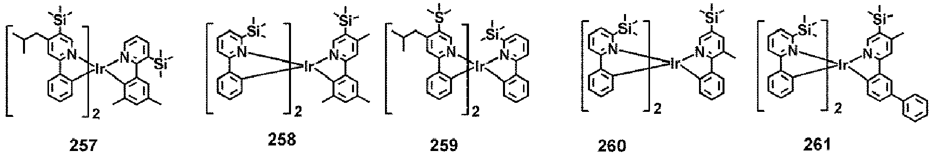

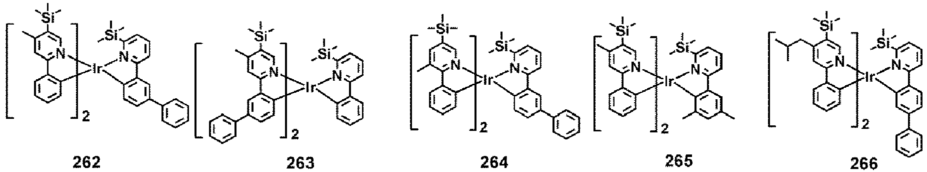

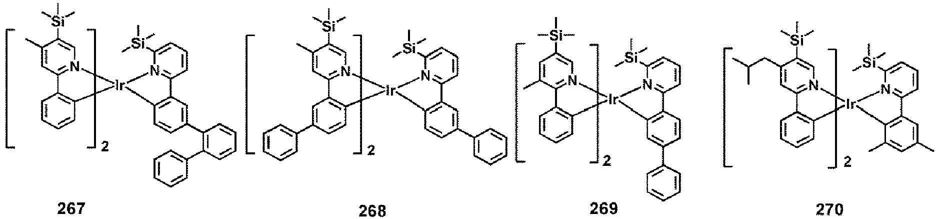

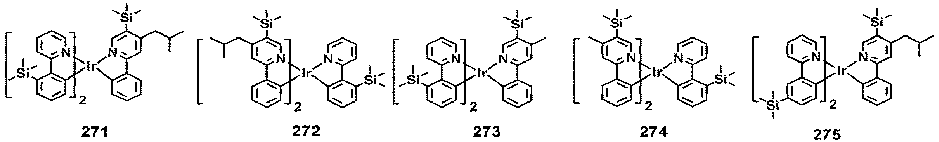

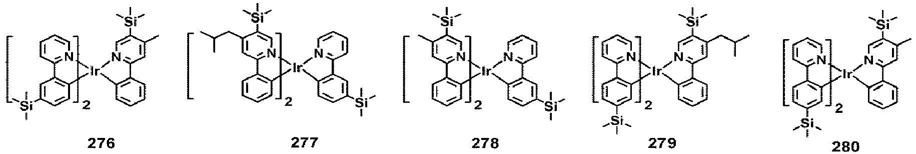

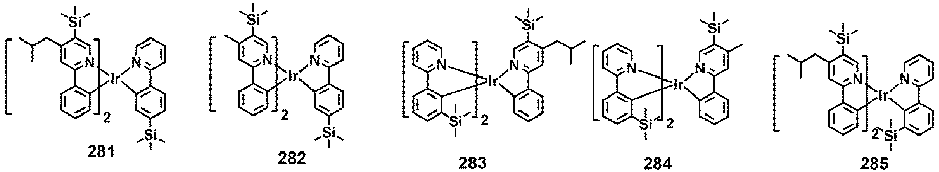

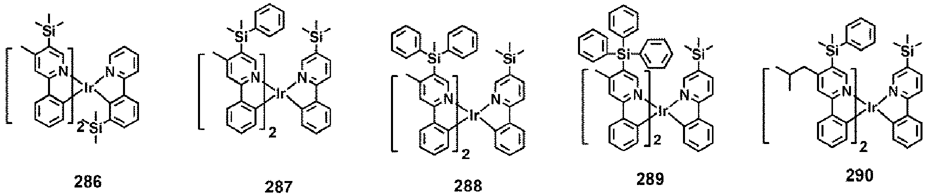

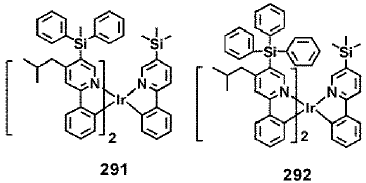

12. An organic light-emitting device comprising:
a first electrode,
a second electrode, and
an organic layer disposed between the first electrode and the second electrode,
wherein the organic layer comprises an emission layer and at least one organometallic compounds of any of claims 1-11.

13. The organic light-emitting device of claim 12, wherein
the first electrode is an anode,
the second electrode is a cathode, and
the organic layer comprises
i) a hole transport region disposed between the first electrode and the emission layer, wherein the hole transport region comprises at least one of a hole injection layer, a hole transport layer, and an electron blocking layer, and
ii) an electron transport region disposed between the emission layer and the second electrode, wherein the electron transport region comprises at least one of a hole blocking layer, an electron transport layer, and an electron injection layer.

14. The organic light-emitting device of claim 12 or 13, wherein the emission layer comprises the organometallic compound.

15. The organic light-emitting device of claim 14, wherein the organometallic compound acts as a dopant and the emission layer further comprises a host.

## Patentansprüche

1. Organometallverbindung, dargestellt durch Formel 1:
Formel 1 M(L₁)n₁(L₂)ₙ₂ 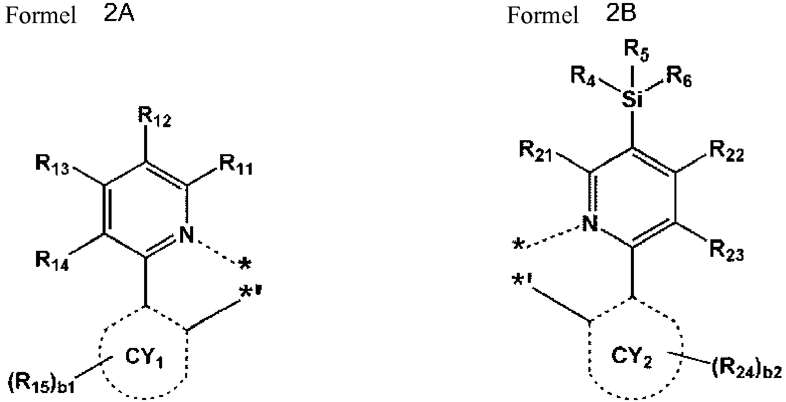
wobei M in Formel 1 ausgewählt ist aus Iridium, Platin, Osmium, Titan, Zirkonium, Hafnium, Europium, Terbium, Thulium und Rhodium, in Formel 1 ist L₁ ausgewählt aus Liganden, die durch die obige Formel 2A dargestellt werden, n1 ist 1 oder 2, mit der Maßgabe, dass, wenn n1 2 ist, zwei Gruppen L₁ identisch oder voneinander verschieden sind,
in Formel 1 L₂ ausgewählt ist aus Liganden, die durch die obige Formel 2B dargestellt werden, n2 ist 1 oder 2, mit der Maßgabe, dass, wenn n2 2 ist, zwei Gruppen L₂ identisch oder voneinander verschieden sind,
in Formel 1 L₁ und L₂ voneinander verschieden sind und die Summe von n1 und n2 2 oder 3 ist, wobei * und *' in Formeln 2A und 2B jeweils eine Bindungsstelle mit M in Formel 1 anzeigen,
CY₁ und CY₂ in Formeln 2A und 2B jeweils unabhängig voneinander ausgewählt sind aus einer carbocyclischen C₅-C₆₀ Gruppe und einer heterocyclischen C₁-C₆₀ Gruppe, vorausgesetzt, dass CY₂ keines von einem Dibenzofuran, einem Dibenzothiophen, einem Dibenzothiophensulfon, einem Carbazol und einem Dibenzosilol ist,
R₁₁ bis R₁₅ in Formel 2 jeweils unabhängig ausgewählt sind aus einem Wasserstoff, einem Deuterium, aus -F, -Cl, -Br, -I, -SF₅, aus einer Hydroxygruppe, einer Cyangruppe, einer Nitrogruppe, einer Aminogruppe, einer Amidingruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer substituierten oder unsubstituierten C₁-C₆₀ Alkylgruppe, einer substituierten oder unsubstituierten C₂-C₆₀ Alkenylgruppe, einer substituierten oder unsubstituierten C₂-C₆₀ Alkynylgruppe, einer substituierten oder unsubstituierten C₁-C₆₀ Alkoxygruppe, einer substituierten oder unsubstituierten C₃-C₁₀ Cycloalkylgruppe, einer substituierten oder unsubstituierten C₁-C₁₀ Heterocycloalkylgruppe, einer substituierten oder unsubstituierten C₃-C₁₀ Cycloalkenylgruppe, einer substituierten oder unsubstituierten C₁-C₁₀ Heterocycloalkenylgruppe, einer substituierten oder unsubstituierten C₆-C₆₀ Arylgruppe, einer substituierten oder unsubstituierten C₆-C₆₀ Aryloxygruppe, einer substituierten oder unsubstituierten C₆-C₆₀ Arylthiogruppe, einer substituierten oder unsubstituierten C₇-C₆₀ Arylalkylgruppe, einer substituierten oder unsubstituierten C₁-C₆₀ Heteroarylgruppe, einer substituierten oder unsubstituierten C₁-C₆₀ Heteroaryloxygruppe, einer substituierten oder unsubstituierten C₁-C₆₀ Heteroarylthiogruppe, einer substituierten oder unsubstituierten C₂-C₆₀ Heteroarylalkylgruppe, einer substituierten oder unsubstituierten einwertigen, nicht-aromatischen, kondensierten, polycyclischen Gruppe und einer substituierten oder unsubstituierten einwertigen, nicht-aromatischen, kondensierten, heteropolycyclischen Gruppe, -Si(R₁)(R₂)(R₃), -N(Q₁)(Q₂), -B(Q₃)(Q₄) und -P(=O)(Q₅)(Q₆),
R₂₁ bis R₂₄ in Formel 2B jeweils unabhängig ausgewählt sind aus einem Wasserstoff, einem Deuterium, aus -F, -Cl, -Br, -I, -SF₅, aus einer Hydroxygruppe, einer Cyangruppe, einer Nitrogruppe, einer Aminogruppe, einer Amidingruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer substituierten oder unsubstituierten C₁-C₆₀ Alkylgruppe, einer substituierten oder unsubstituierten C₂-C₆₀ Alkenylgruppe, einer substituierten oder unsubstituierten C₂-C₆₀ Alkynylgruppe, einer substituierten oder unsubstituierten C₁-C₆₀ Alkoxygruppe, einer substituierten oder unsubstituierten C₃-C₁₀ Cycloalkylgruppe, einer substituierten oder unsubstituierten C₁-C₁₀ Heterocycloalkylgruppe, einer substituierten oder unsubstituierten C₃-C₁₀ Cycloalkenylgruppe, einer substituierten oder unsubstituierten C₁-C₁₀ Heterocycloalkenylgruppe, einer substituierten oder unsubstituierten C₆-C₆₀ Arylgruppe, einer substituierten oder unsubstituierten C₆-C₆₀ Aryloxygruppe, einer substituierten oder unsubstituierten C₆-C₆₀ Arylthiogruppe, einer substituierten oder unsubstituierten C₇-C₆₀ Arylalkylgruppe, einer substituierten oder unsubstituierten C₁-C₆₀ Heteroarylgruppe, einer substituierten oder unsubstituierten C₁-C₆₀ Heteroaryloxygruppe, einer substituierten oder unsubstituierten C₁-C₆₀ Heteroarylthiogruppe, einer substituierten oder unsubstituierten C₂-C₆₀ Heteroarylalkylgruppe, einer substituierten oder unsubstituierten einwertigen, nicht-aromatischen, kondensierten, polycyclischen Gruppe und einer substituierten oder unsubstituierten einwertigen, nicht-aromatischen, kondensierten, heteropolycyclischen Gruppe, -N(Q₁)(Q₂), -B(Q₃)(Q₄), und -P(=O)(Q₅)(Q₆),
b1 und b2 in Formeln 2A und 2B jeweils unabhängig voneinander eine ganze Zahl sind, ausgewählt aus 0 bis 4, mit der Maßgabe, dass
i) eines, ausgewählt aus R₁₁ bis R₁₄ in Formel 2A oder ii) eines, ausgewählt aus R₁₅ in der Zahl von b1 in Formel 2A -Si(R₁)(R₂)(R₃) ist,
mindestens eines, ausgewählt aus R₂₁ zu R₂₃ in Formel 2B, kein Wasserstoff ist,
R₁ bis R₃ in -Si(R₁)(R₂)(R₃) von Formel 2A und R₄ bis R₆ in Formel 2B jeweils unabhängig ausgewählt sind aus einem Wasserstoff, einem Deuterium, einer substituierten oder unsubstituierten C₁-C₆₀ Alkylgruppe, einer substituierten oder unsubstituierten C₂-C₆₀ Alkenylgruppe, einer substituierten oder unsubstituierten C₂-C₆₀ Alkynylgruppe, einer substituierten oder unsubstituierten C₁-C₆₀ Alkoxygruppe, einer substituierten oder unsubstituierten C₃-C₁₀ Cycloalkylgruppe, einer substituierten oder unsubstituierten C₁-C₁₀ Heterocycloalkylgruppe, einer substituierten oder unsubstituierten C₃-C₁₀ Cycloalkenylgruppe, einer substituierten oder unsubstituierten C₁-C₁₀ Heterocycloalkenylgruppe, einer substituierten oder unsubstituierten C₆-C₆₀ Arylgruppe, einer substituierten oder unsubstituierten C₆-C₆₀ Aryloxygruppe, einer substituierten oder unsubstituierten C₁-C₆₀ Heteroarylgruppe, einer substituierten oder unsubstituierten einwertigen, nicht-aromatischen, kondensierten, polyzyklischen Gruppe, einer substituierten oder unsubstituierten einwertigen, nicht-aromatischen, kondensierten heteropolyzyklischen Gruppe, und - Si(Q₅₁)(Q₅₂)(Q₅₃), und
mindestens einer der Substituenten der substituierten C₁-C₆₀ Alkylgruppe, substituierten C₂-C₆₀ Alkenylgruppe, substituierten C₂-C₆₀ Alkynylgruppe, substituierten C₁-C₆₀ Alkoxygruppe, substituierten C₃-C₁₀ Cycloalkylgruppe, substituierten C₁-C₁₀ Heterocycloalkylgruppe, substituierten C₃-C₁₀ Cycloalkenylgruppe, substituierten C₁-C₁₀ Heterocycloalkenylgruppe, substituierten C₆-C₆₀ Arylgruppe, substituierten C₆-C₆₀ Aryloxygruppe, substituierten C₆-C₆₀ Arylthiogruppe, einer substituierten C₇-C₆₀ Arylalkylgruppe, substituierten C₁-C₆₀ Heteroarylgruppe, einer substituierten C₁-C₆₀ Heteroaryloxygruppe, einer substituierten C₁-C₆₀ Heteroarylthiogruppe, einer substituierten C₂-C₆₀ Heteroarylalkylgruppe, substituierten einwertigen nicht-aromatischen, kondensierten polyzyklische, Gruppe und einer substituierten, einwertigen, nicht-aromatischen, kondensierten, heteropolyzyklischen Gruppe ausgewählt ist aus:
einem Deuterium, -F, -Cl, -Br, -I, -CD₃, -CD₂H, -CDH₂, -CF₃, -CF₂H, -CFH₂, einer Hydroxygruppe, einer Cyangruppe, einer Nitrogruppe, einer Aminogruppe, einer Amidingruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₆₀ Alkylgruppe, einer C₂-C₆₀ Alkenylgruppe, einer C₂-C₆₀ Alkinylgruppe und einer C₁-C₆₀ Alkoxygruppe,
einer C₁-C₆₀ Alkylgruppe, einer C₂-C₆₀ Alkenylgruppe, einer C₂-C₆₀ Alkynylgruppe und einer C₁- C₆₀ Alkoxygruppe, jeweils substituiert mit mindestens einem ausgewählt aus einem Deuterium, -F, - Cl, -Br, -I, -CD₃, -CD₂H, -CDH₂, -CF₃, -CF₂H, -CFH₂, einer Hydroxygruppe, einer Cyangruppe, einer Nitrogruppe, einer Aminogruppe, einer Amidingruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₃-C₁₀ Cycloalkylgruppe, einer C₁-C₁₀ Heterocycloalkylgruppe, einer C₃-C₁₀ Cycloalkenylgruppe, einer C₁-C₁₀ Heterocycloalkenylgruppe, einer C₆-C₆₀ Arylgruppe, einer C₆-C₆₀ Aryloxygruppe, einer C₆-C₆₀ Arylthiogruppe, einer C₇-C₆₀ Arylalkylgruppe, einer C₁-C₆₀ Heteroarylgruppe, einer C₁-C₆₀ Heteroaryloxygruppe, einer C₁-C₆₀ Heteroarylthiogruppe, einer C₂-C₆₀ Heteroarylalkylgruppe, einer einwertigen, nicht-aromatischen, kondensierten, polyzyklischen Gruppe, einer einwertigen, nicht-aromatischen, kondensierten heteropolyzyklischen Gruppe, -N(Q₁₁)(Q₁₂), -B(Q₁₃)(Q₁₄) und -P(=O)(Q₁₅)(Q₁₆);
einer C₃-C₁₀ Cycloalkylgruppe, einer C₁-C₁₀ Heterocycloalkylgruppe, einer C₃-C₁₀ Cycloalkenylgruppe, einer C₁-C₁₀ Heterocycloalkenylgruppe, einer C₆-C₆₀ Arylgruppe, einer C₆-C₆₀ Aryloxygruppe, einer C₆-C₆₀ Arylthiogruppe, einer C₇-C₆₀ Arylalkylgruppe, einer C₁-C₆₀ Heteroarylgruppe, einer C₁-C₆₀ Heteroaryloxygruppe, einer C₁-C₆₀ Heteroarylthiogruppe, einer C₂-C₆₀ Heteroarylalkylgruppe, einer einwertigen, nicht-aromatischen, kondensierten, polyzyklischen Gruppe und einer einwertigen, nicht-aromatischen, kondensierten, heteropolyzyklischen Gruppe;
einer C₃-C₁₀ Cycloalkylgruppe, einer C₁-C₁₀ Heterocycloalkylgruppe, einer C₃-C₁₀ Cycloalkenylgruppe, einer C₁-C₁₀ Heterocycloalkenylgruppe, einer C₆-C₆₀ Arylgruppe, einer C₆-C₆₀ Aryloxygruppe, einer C₆-C₆₀ Arylthiogruppe, einer C₇-C₆₀ Arylalkylgruppe, einer C₁-C₆₀ Heteroarylgruppe, einer C₁-C₆₀ Heteroaryloxygruppe, einer C₁-C₆₀ Heteroarylthiogruppe, einer C₂-C₆₀ Heteroarylalkylgruppe, einer einwertigen, nicht-aromatischen, kondensierten, polyzyklischen Gruppe und einer einwertigen, nicht-aromatischen, kondensierten, heteropolyzyklischen Gruppe, jeweils substituiert mit mindestens einem ausgewählt aus einem Deuterium, -F, - Cl, -Br, -I, -CD₃, -CD₂H, -CDH₂, -CF₃, -CF₂H, -CFH₂, einer Hydroxygruppe, einer Cyangruppe, einer Nitrogruppe, einer Aminogruppe, einer Amidingruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₆₀ Alkylgruppe, C₂-C₆₀ Alkenylgruppe, einer C₂-C₆₀ Alkynylgruppe, einer C₁-C₆₀ Alkoxygruppe, einer C₃-C₁₀ Cycloalkylgruppe, einer C₁-C₁₀ Heterocycloalkylgruppe, einer C₃-C₁₀ Cycloalkenylgruppe, einer C₁-C₁₀ Heterocycloalkenylgruppe, einer C₆-C₆₀ Arylgruppe, einer C₆-C₆₀ Aryloxygruppe, einer C₆-C₆₀ Arylthiogruppe, einer C₇-C₆₀ Arylalkylgruppe, einer C₁-C₆₀ Heteroarylgruppe, einer C₁-C₆₀ Heteroaryloxygruppe, einer C₁-C₆₀ Heteroarylthiogruppe, einer C₂-C₆₀ Heteroarylalkylgruppe, einer einwertigen, nicht-aromatischen, kondensierten, polyzyklischen Gruppe, einer einwertigen, nicht-aromatischen, kondensierten heteropolyzyklischen Gruppe, -N(Q₂₁)(Q₂₂), -B(Q₂₃)(Q₂₄) und -P(=O)(Q₂₅)(Q₂₆),
und -N(Q₃₁)(Q₃₂), -B(Q₃₃)(Q₃₄), und -P(=O)(Q₃₅)(Q₃₆),
wobei Q₁ bis Q₆, Q₁₁ bis Q₁₆, Q₂₁ bis Q₂₆, Q₃₁ bis Q₃₆ und Q₅₁ bis Q₅₃ jeweils unabhängig voneinander ausgewählt sind aus einem Wasserstoff, einem Deuterium, -F, -Cl, -Br, -I, einer Hydroxygruppe, einer Cyangruppe, einer Nitrogruppe, einer Aminogruppe, einer Amidingruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer substituierten oder unsubstituierten C₁-C₆₀ Alkylgruppe, einer substituierten oder unsubstituierten C₂-C₆₀ Alkenylgruppe, einer substituierten oder unsubstituierten C₂-C₆₀ Alkynylgruppe, einer substituierten oder unsubstituierten C₁-C₆₀ Alkoxygruppe, einer substituierten oder unsubstituierten C₃-C₁₀ Cycloalkylgruppe, einer substituierten oder unsubstituierten C₁-C₁₀ Heterocycloalkylgruppe, einer substituierten oder unsubstituierten C₃-C₁₀ Cycloalkenylgruppe, einer substituierten oder unsubstituierten C₁-C₁₀ Heterocycloalkenylgruppe, einer substituierten oder unsubstituierten C₆-C₆₀ Arylgruppe, einer substituierten oder unsubstituierten C₆-C₆₀ Aryloxygruppe, einer substituierten oder unsubstituierten C₆-C₆₀ Arylthiogruppe, einer substituierten oder unsubstituierten C₇-C₆₀ Arylalkylgruppe, einer substituierten oder unsubstituierten C₁-C₆₀ Heteroarylgruppe, einer substituierten oder unsubstituierten C₁-C₆₀ Heteroaryloxygruppe, einer substituierten oder unsubstituierten C₁-C₆₀ Heteroarylthiogruppe, einer substituierten oder unsubstituierten C₂-C₆₀ Heteroarylalkylgruppe, einer substituierten oder unsubstituierten einwertigen, nicht-aromatischen, kondensierten, polyzyklischen Gruppe, und einer substituierten oder unsubstituierten einwertigen, nicht-aromatischen, kondensierten heteropolyzyklischen Gruppe.

2. Organometallverbindung von Anspruch 1, wobei
in Formel 1 M gleich Ir ist und die Summe von n1 und n2 gleich 3 ist, oder M gleich Pt ist und die Summe von n1 und n2 gleich 2 ist und
die Organometallverbindung neutral ist.

3. Organometallverbindung nach Anspruch 1 oder 2, wobei CY₁ in Formel 2A ausgewählt ist aus einem Benzol, einem Inden, einem Naphthalin, einem Azulen, einem Heptalen, einem Indacen, einem Acenaphthylen, einem Fluoren, einem Spirofluoren, einem Benzofluoren, einem Dibenzofluoren, einem Phenalen, ein Phenanthren, einem Anthracen, einem Fluoranthen, einem Triphenylen, einem Pyren, einem Chrysen, einem Naphthacen, einem Picen, einem Perylen, einem Pentacen, einem Hexacen, einem Pentapen, einem Rubicen, einem Coronen, einem Ovalen, einem Isoindol, einem Indol, einem Indazol, einem Purin, einem Chinolin, einem Isochinolin, einem Benzochinolin, einem Phthalazin, einem Naphthyridine, einem Chinoxalin, einem Chinazolin, einem Cinnolin, einem Phenanthridin, einem Acridin, einem Phenanthrolin, einem Phenazin, einem Benzoimidazol, einem Benzofuran, einem Benzothiophen, einem Isobenzothiazol, einem Benzoxazol, einem Isobenzoxazol, einem Benzocarbazol, einem Dibenzocarbazol, einem Imidazopyridin, einem Imidazopyrimidin, einem Dibenzofuran, einem Dibenzothiophen, einem Dibenzothiophensulfon, einem Carbazol und einem Dibenzosilol, und
CY₂ in Formel 2B ausgewählt ist aus einem Benzol, einem Inden, einem Naphthalin, einem Azulen, einem Heptalen, einem Indacen, einem Acenaphthylen, einem Fluoren, einem Spirofluoren, einem Benzofluoren, einem Dibenzofluoren, einem Phenalen, einem Phenanthren, einem Anthracen, einem Fluoranthen, einem Triphenylen, einem Pyren, einem Chrysen, einem Naphthacen, einem Piken, einem Perylen, einem Pentacen, einem Hexacen, einem Pentapen, einem Rubicen, einem Koronen, einem Ovalin, einem Isoindol, einem Indol, einem Indazol, einem Purin, einem Chinolin, einem Isochinolin, einem Benzochinolin, einem Phthalazin, einem Naphthyridin, einem Chinoxalin, einem Chinazolin, einem Cinnolin, einem Phenanthridin, einem Acridin, einem Phenanthrolin, einem Phenazin, einem Benzoimidazol, einem Benzofuran, einem Benzothiophen, einem Isobenzothiazol, einem Benzoxazol, einem Isobenzoxazol, einem Benzocarbazol, einem Dibenzocarbazol, einem Imidazopyridin und einem Imidazopyrimidin, wobei vorzugsweise:
CY₁ in Formel 2A ausgewählt ist aus einem Benzol, einem Naphthalin, einem Fluoren, einem Dibenzofuran, einem Dibenzothiophen, einem Dibenzothiophensulfon, einem Carbazol und einem Dibenzosilol, und
CY₂ in Formel 2B ein Benzol ist.

4. Organometallverbindung nach einem der Ansprüche 1 bis 3,
wobei R₁ bis R₁₅ in Formel 2A jeweils unabhängig ausgewählt sind aus
einem Wasserstoff, einem Deuterium, -F, -Cl, -Br, -I, einer Hydroxygruppe, einer Cyangruppe, einer Nitrogruppe, einer Aminogruppe, einer Amidingruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, -SF₅, einer C₁-C₂₀ Alkylgruppe und einer C₁-C₂₀ Alkoxygruppe;
einer C₁-C₂₀ Alkylgruppe und einer C₁-C₂₀ Alkoxygruppe, jeweils substituiert mit mindestens einem ausgewählt aus einem Deuterium, -F, -Cl, -Br, -I, -CD₃, -CD₂H, -CDH₂, -CF₃, -CF₂H, -CFH₂, einer Hydroxygruppe, einer Cyangruppe, einer Nitrogruppe, einer Aminogruppe, einer Amidingruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₁₀ Alkylgruppe, einer Cyclopentylgruppe, einer Cyclohexylgruppe, einer Cycloheptylgruppe, einer Cyclooctylgruppe, einer Adamantylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Pyridinylgruppe und einer Pyrimidinylgruppe;
einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Quinolinylgruppe, einer Isoquinolinylgruppe, einer Benzoquinolinylgruppe, einer Quinoxalinylgruppe, einer Quinazolinylgruppe, einer Cinnolinylgruppe, einer Carbazolylgruppe, einer Phenanthrolinylgruppe, einer Benzoimidazolylgruppe, einer Benzofuranylgruppe, einer Benzothiophenylgruppe, einer Isobenzothiazolylgruppe, einer Benzoxazolylgruppe, einer Isobenzooxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe und einer Imidazopyrimidinylgruppe;
einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Quinolinylgruppe, einer Isoquinolinylgruppe, einer Benzoquinolinylgruppe, einer Quinoxalinylgruppe, einer Quinazolinylgruppe, einer Cinnolinylgruppe, einer Carbazolylgruppe, einer Phenanthrolinylgruppe, einer Benzoimidazolylgruppe, einer Benzofuranylgruppe, einer Benzothiophenylgruppe, einer Isobenzothiazolylgruppe, einer Benzoxazolylgruppe, einer Isobenzooxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe und einer Imidazopyrimidinylgruppe; jeweils substituiert mit mindestens einem ausgewählt aus einem Deuterium, -F, -Cl, -Br, -I, -CD₃, -CD₂H, -CDH₂, -CF₃, -CF₂H, -CFH₂, einer Hydroxygruppe, einer Cyangruppe, einer Nitrogruppe, einer Aminogruppe, einer Amidingruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₂₀ Alkylgruppe, einer C₁-C₂₀ Alkoxygruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Quinolinylgruppe, einer Isoquinolinylgruppe, einer Benzoquinolinylgruppe, einer Quinoxalinylgruppe, einer Quinazolinylgruppe, einer Cinnolinylgruppe, einer Carbazolylgruppe, einer Phenanthrolinylgruppe, einer Benzoimidazolylgruppe, einer Benzofuranylgruppe, einer Benzothiophenylgruppe, einer Isobenzothiazolylgruppe, einer Benzoxazolylgruppe, einer Isobenzooxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe und einer Imidazopyrimidinylgruppe;
und -Si(R₁)(R₂)(R₃), -B(Q₃)(Q₄) und -P(=O)(Q₅)(Q₆), und
R₂₁ bis R₂₄ in Formel 2B jeweils unabhängig ausgewählt sind aus
einem Wasserstoff, einem Deuterium, -F, -Cl, -Br, -I, einer Hydroxygruppe, einer Cyangruppe, einer Nitrogruppe, einer Aminogruppe, einer Amidingruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, -SF₅, einer C₁-C₂₀ Alkylgruppe und einer C₁-C₂₀ Alkoxygruppe;
einer C₁-C₂₀ Alkylgruppe und einer C₁-C₂₀ Alkoxygruppe, jeweils substituiert mit mindestens einem ausgewählt aus einem Deuterium, -F, -Cl, -Br, -I, -CD₃, -CD₂H, -CDH₂, -CF₃, -CF₂H, -CFH₂, einer Hydroxygruppe, einer Cyangruppe, einer Nitrogruppe, einer Aminogruppe, einer Amidingruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₁₀ Alkylgruppe, einer Cyclopentylgruppe, einer Cyclohexylgruppe, einer Cycloheptylgruppe, einer Cyclooctylgruppe, einer Adamantylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Pyridinylgruppe und einer Pyrimidinylgruppe;
einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Quinolinylgruppe, einer Isoquinolinylgruppe, einer Benzoquinolinylgruppe, einer Quinoxalinylgruppe, einer Quinazolinylgruppe, einer Cinnolinylgruppe, einer Carbazolylgruppe, einer Phenanthrolinylgruppe, einer Benzoimidazolylgruppe, einer Benzofuranylgruppe, einer Benzothiophenylgruppe, einer Isobenzothiazolylgruppe, einer Benzoxazolylgruppe, einer Isobenzooxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe und einer Imidazopyrimidinylgruppe;
einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Quinolinylgruppe, einer Isoquinolinylgruppe, einer Benzoquinolinylgruppe, einer Quinoxalinylgruppe, einer Quinazolinylgruppe, einer Cinnolinylgruppe, einer Carbazolylgruppe, einer Phenanthrolinylgruppe, einer Benzoimidazolylgruppe, einer Benzofuranylgruppe, einer Benzothiophenylgruppe, einer Isobenzothiazolylgruppe, einer Benzoxazolylgruppe, einer Isobenzooxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe und einer Imidazopyrimidinylgruppe; jeweils substituiert mit mindestens einem ausgewählt aus einem Deuterium, -F, -Cl, -Br, -I, -CD₃, -CD₂H, -CDH₂, -CF₃, -CF₂H, -CFH₂, einer Hydroxygruppe, einer Cyangruppe, einer Nitrogruppe, einer Aminogruppe, einer Amidingruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₂₀ Alkylgruppe, einer C₁-C₂₀ Alkoxygruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Quinolinylgruppe, einer Isoquinolinylgruppe, einer Benzoquinolinylgruppe, einer Quinoxalinylgruppe, einer Quinazolinylgruppe, einer Cinnolinylgruppe, einer Carbazolylgruppe, einer Phenanthrolinylgruppe, einer Benzoimidazolylgruppe, einer Benzofuranylgruppe, einer Benzothiophenylgruppe, einer Isobenzothiazolylgruppe, einer Benzoxazolylgruppe, einer Isobenzooxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe und einer Imidazopyrimidinylgruppe;
und -B(Q₃)(Q₄) und -P(=O)(Q₅)(Q₆),
wobei Q₃ bis Q₆ jeweils unabhängig ausgewählt sind aus
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, und -CD₂CDH₂;
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe,
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, ein tert-Pentylgruppe, einer Phenylgruppe und einer Naphthylgruppe, die jeweils mit mindestens einem ausgewählt aus einem Deuterium, einer C₁-C₁₀ Alkylgruppe und einer Phenylgruppe substituiert sind, wobei vorzugsweise:
R₁₁ bis R₁₅ in Formel 2A jeweils unabhängig ausgewählt sind aus einem Wasserstoff, einem Deuterium, -F, einer Cyangruppe, einer Nitrogruppe, -SF₅, -CH₃, -CD₃, -CD₂H, -CDH₂, -CF₃, - CF₂H, -CFH₂, aus durch Formeln 9-1 bis 9-19 dargestellten Gruppen, durch Formeln 10-1 bis 10-36 dargestellten Gruppen, und -Si(R₁)(R₂)(R₃), und
R₂₁ bis R₂₄ in Formel 2B jeweils unabhängig ausgewählt sind aus einem Wasserstoff, einem Deuterium, -F, einer Cyangruppe, einer Nitrogruppe, -SF₅, -CH₃, -CD₃, -CD₂H, -CDH₂, -CF₃, - CF₂H, -CFH₂, aus durch Formeln 9-1 bis 9-19 dargestellten Gruppen und durch Formeln 10-1 bis 10-36 dargestellten Gruppen: 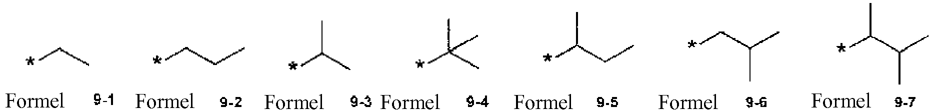 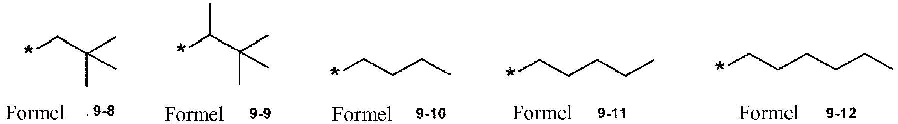 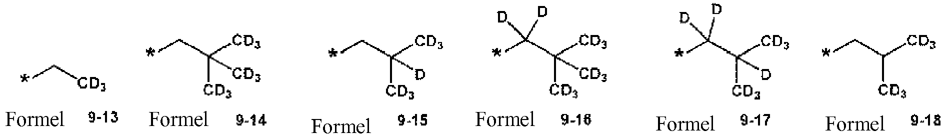 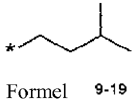 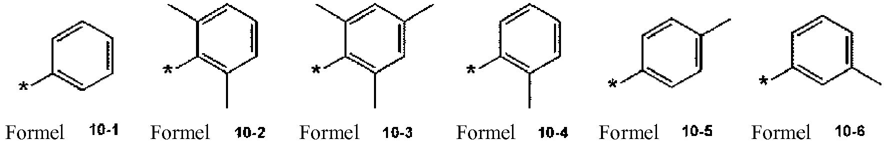 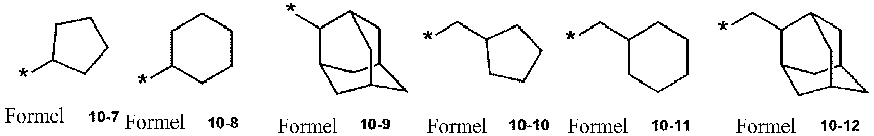 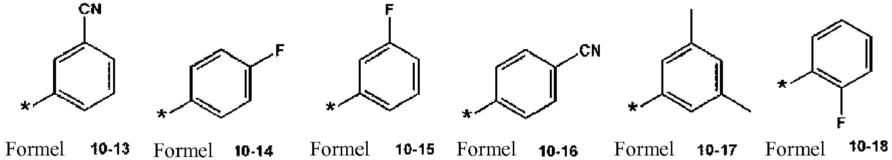 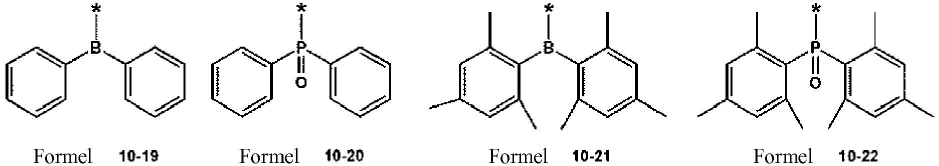 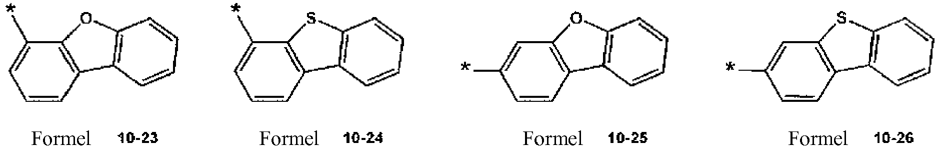 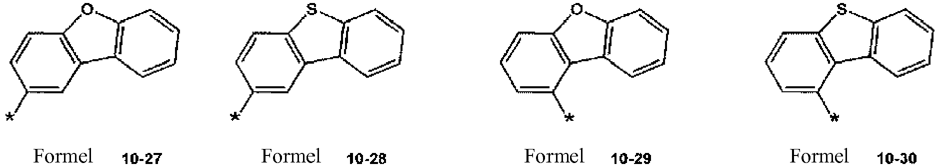 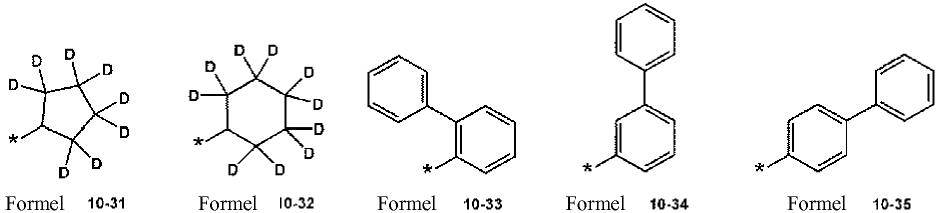 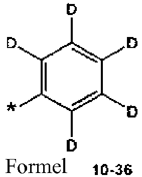 * zeigt in Formeln in 9-1 bis 9-19 und 10-1 bis 10-36 eine Bindungsstelle mit einem benachbarten Atom an.

5. Organometallverbindung nach einem der Ansprüche 1 bis 4, wobei R₂₂ in Formel 2B kein Wasserstoff ist.

6. Organometallverbindung nach einem der Ansprüche 1 bis 5, wobei R₁ bis R₃ in -Si(R₁)(R₂)(R₃) von Formel 2A und R₄ bis R₆ in Formel 2B jeweils unabhängig ausgewählt sind aus einem Wasserstoff, einem Deuterium, -CH₃, -CD₃, -CD₂H, -CDH₂, -CH₂CH₃, -CH₂CD₃, - CH₂CD₂H, -CH₂CDH₂, -CHDCH₃, -CHDCD₂H, -CHDCDH₂, -CHDCD₃, -CD₂CD₃, - CD₂CD₂H und -CD₂CDH₂;
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe, einer Naphthylgruppe und -Si(Q₅₁)(Q₅₂)(Q₅₃),
und einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, ein tert-Pentylgruppe, einer Phenylgruppe und einer Naphthylgruppe, die jeweils mit mindestens einem ausgewählt aus einem Deuterium, einer C₁-C₁₀ Alkylgruppe und einer Phenylgruppe substituiert sind,
wobei Q₅₁ bis Q₅₃ jeweils unabhängig ausgewählt sind aus
einem Wasserstoff, einem Deuterium, -CH₃, -CD₃, -CD₂H, -CDH₂, -CH₂CH₃, -CH₂CD₃, - CH₂CD₂H, -CH₂CDH₂, -CHDCH₃, -CHDCD₂H, -CHDCDH₂, -CHDCD₃, -CD₂CD₃, - CD₂CD₂H und -CD₂CDH₂;
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe, und einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe, die jeweils mit mindestens einem ausgewählt aus einem Deuterium, einer C₁-C₁₀ Alkylgruppe und einer Phenylgruppe substituiert sind, wobei vorzugsweise:
R₁ bis R₃ in -Si(R₁)(R₂)(R₃) von Formel 2A und R₄ bis R₆ in Formel 2B jeweils unabhängig ausgewählt sind aus -CH₃, -CD₃, -CD₂H, -CDH₂, einer Phenylgruppe, aus durch Formeln 9-1 bis 9-19 dargestellten Gruppen und durch Formeln 10-1 bis 10-18 dargestellten Gruppen: 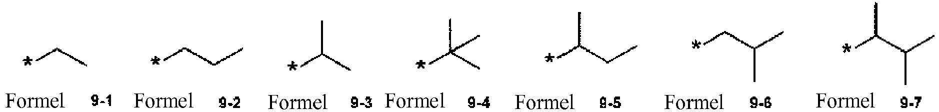 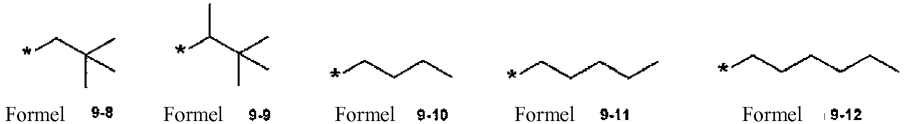 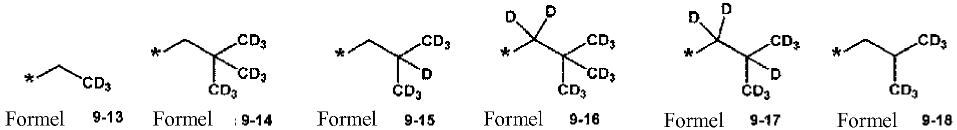 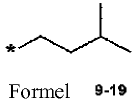 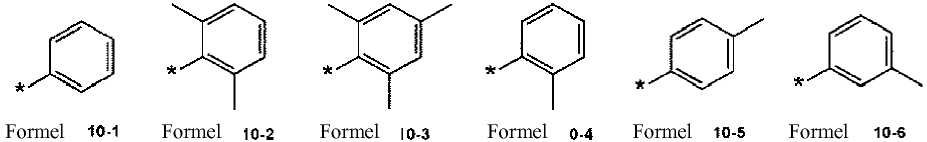 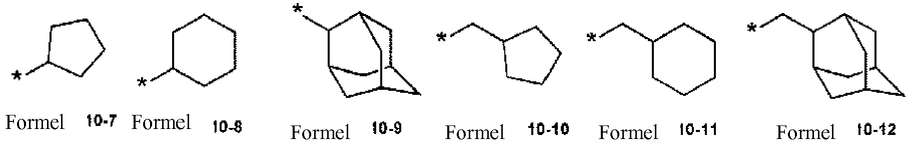 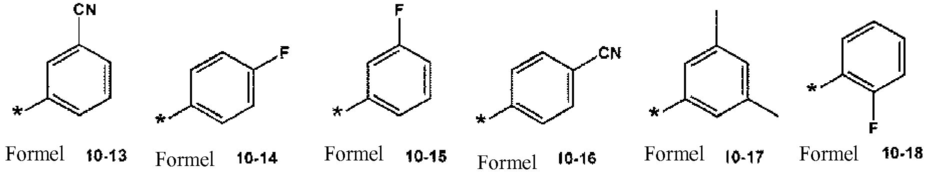 wobei * in Formeln 9-1 bis 9-19 und 10-1 bis 10-18 eine Bindungsstelle mit einem benachbarten Atom anzeigt,
wobei in -Si(R₁)(R₂)(R₃) von Formel 2A,
alle von R₁ bis R₃ dieselben sind;
oder R₁ und R₃ identisch miteinander sind, und R₂ zu R₁ unterschiedlich ist,
und wobei in Formel 2B
alle R₄ dieselben wie R₆ sind;
oder R₄ und R₆ identisch sind und R₅ zu R₄ unterschiedlich ist.

7. Organometallverbindung nach einem der Ansprüche 1 bis 6, wobei L₁ ausgewählt ist aus Liganden, die durch Formeln 2A-1 bis 2A-5 dargestellt sind: 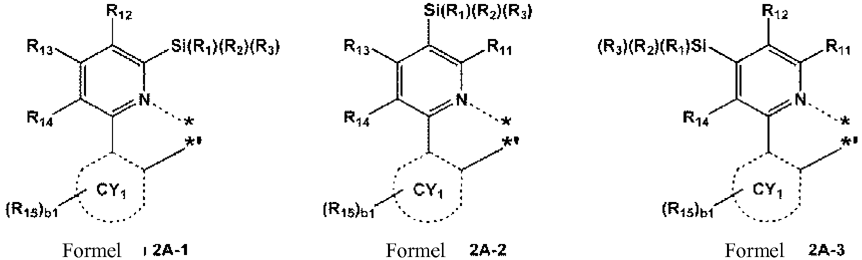 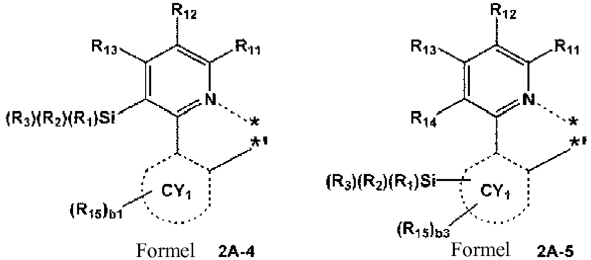 In Formeln 2A-1 bis 2A-5,
CY₁ sind R₁₁ bis R₁₅, b1 und R₁ bis R₃ dieselben wie in Anspruch 1,
* und *' zeigen jeweils eine Bindungsstelle mit M in Formel 1 an,
und b3 ist eine aus 0 bis 3 ausgewählte ganze Zahl, wobei vorzugsweise:
L₁ ausgewählt ist aus Liganden der Formeln 2A(1) bis 2A(192): 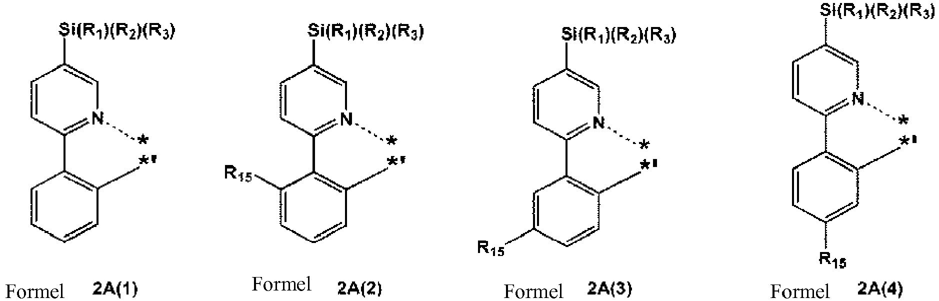 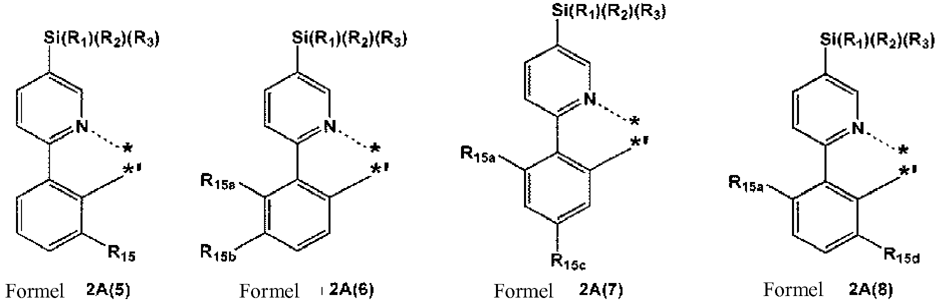 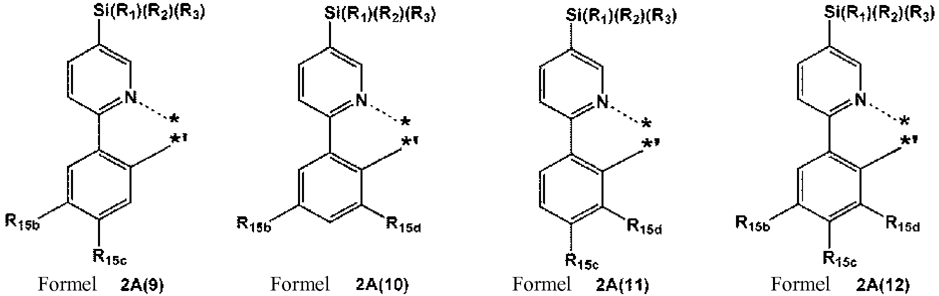 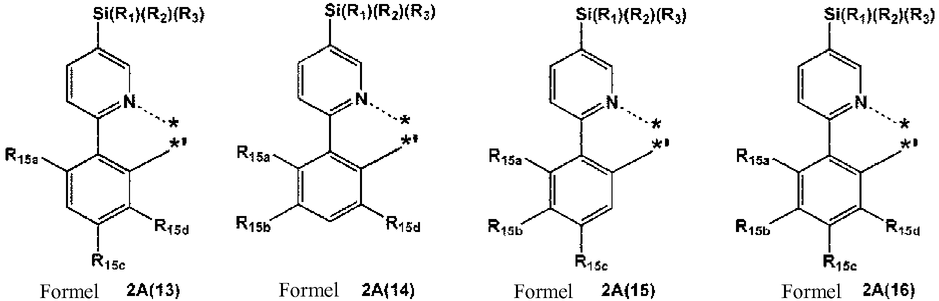 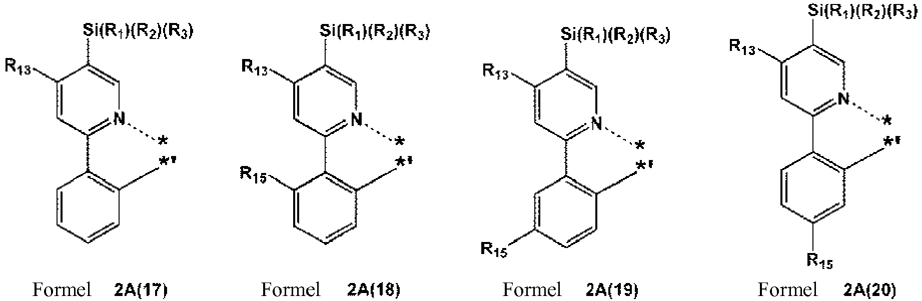 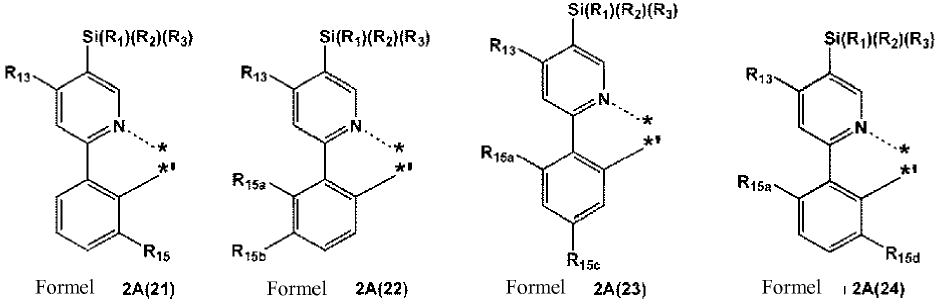 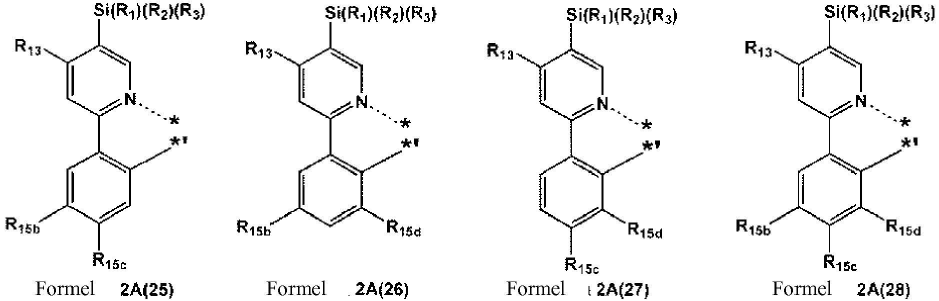 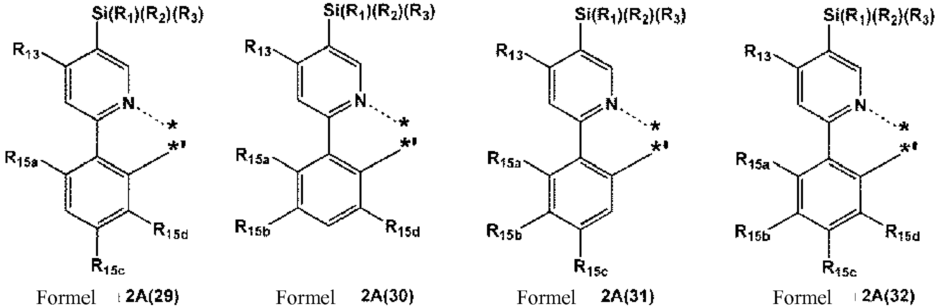 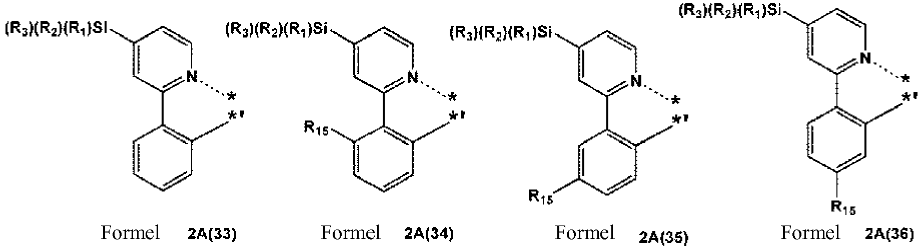 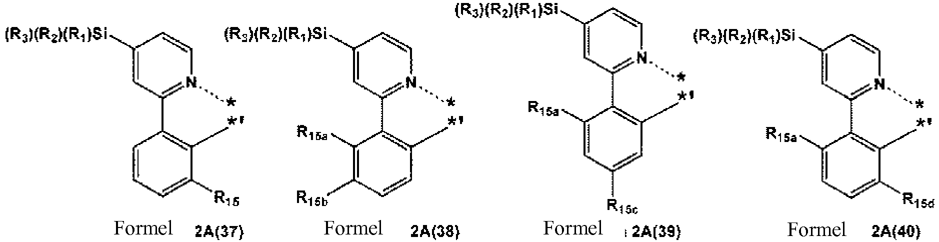 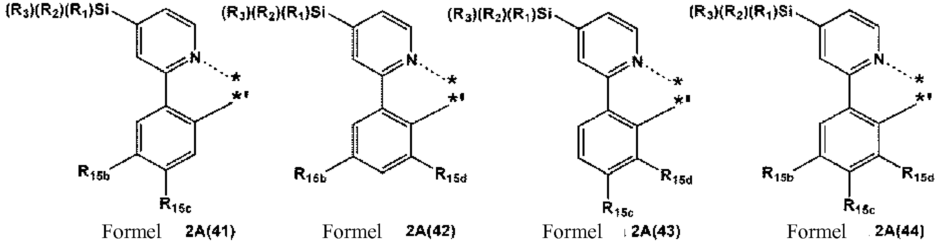 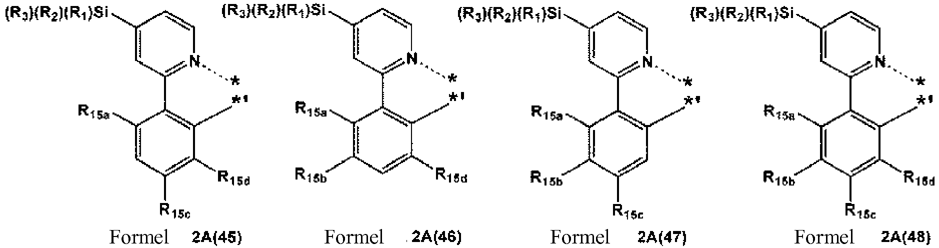 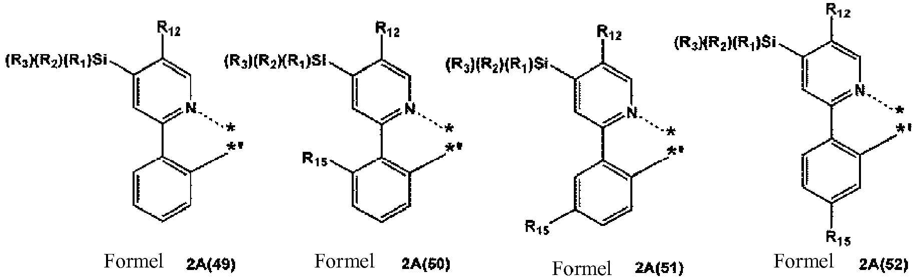 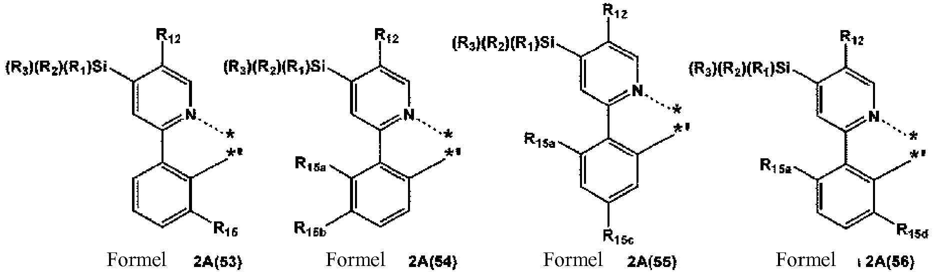 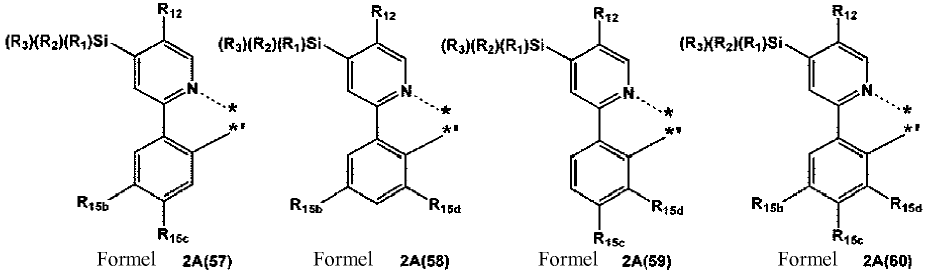 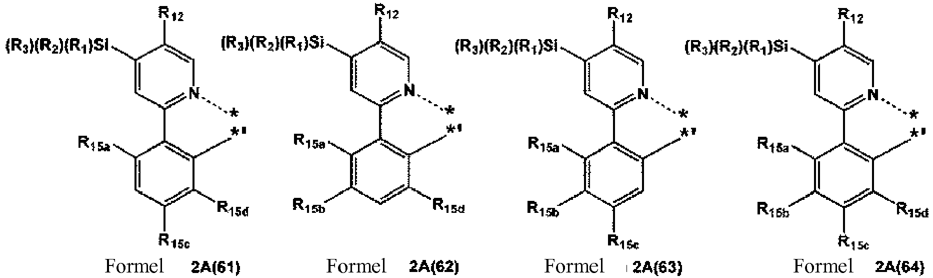 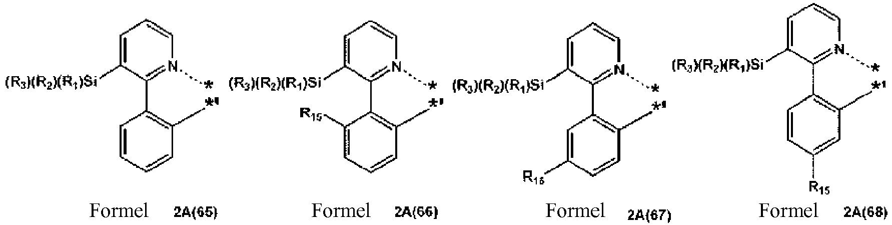 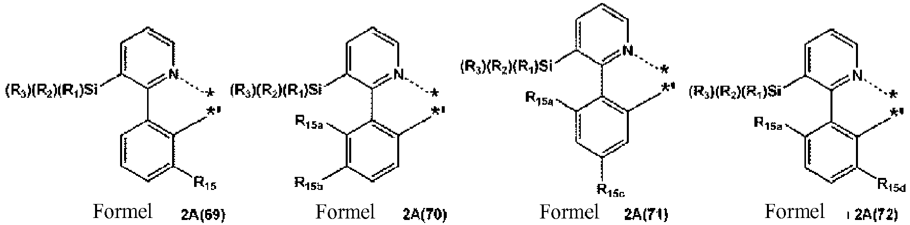 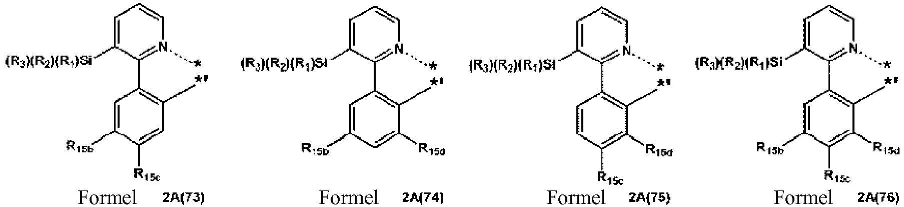 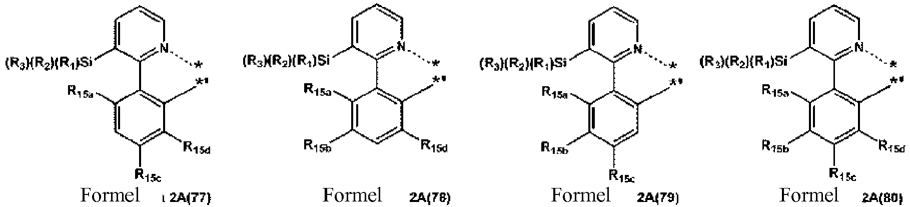 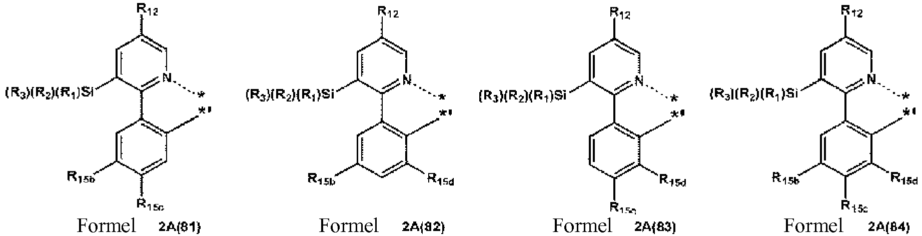 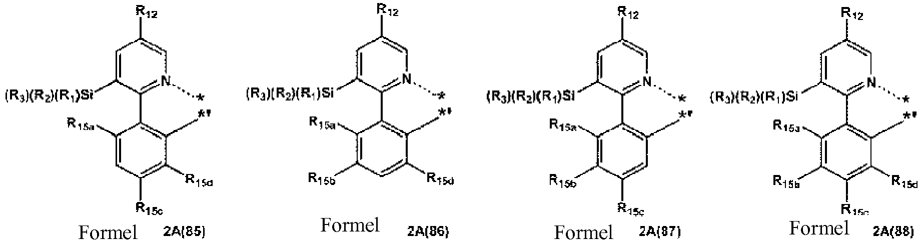 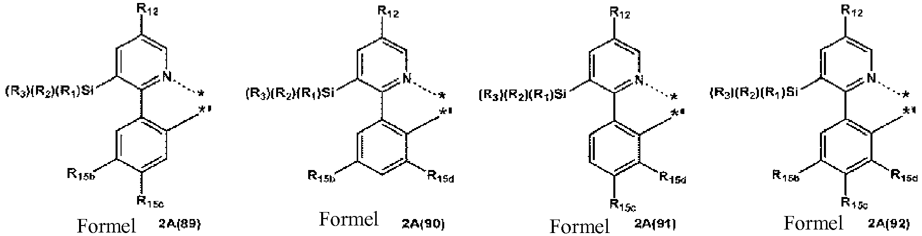 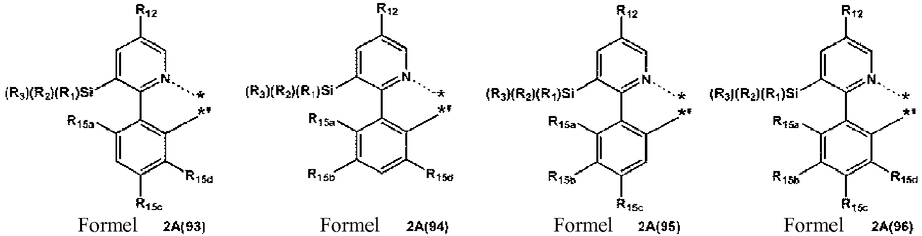 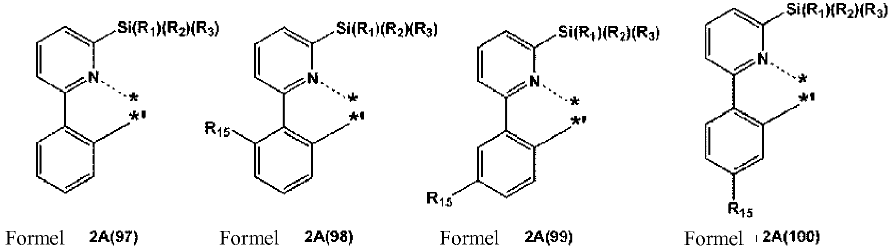 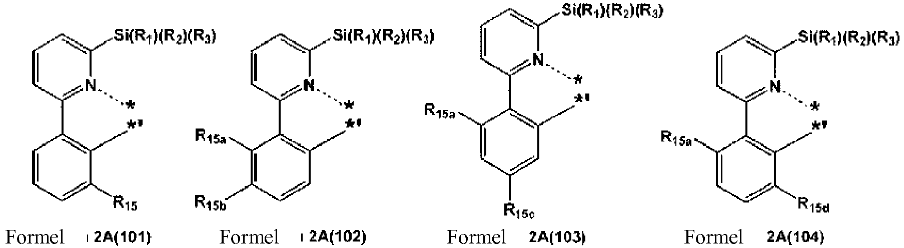 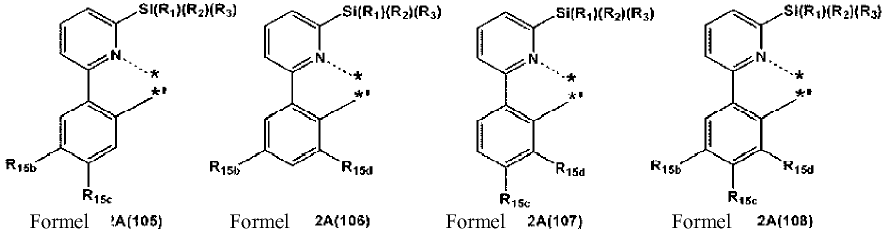 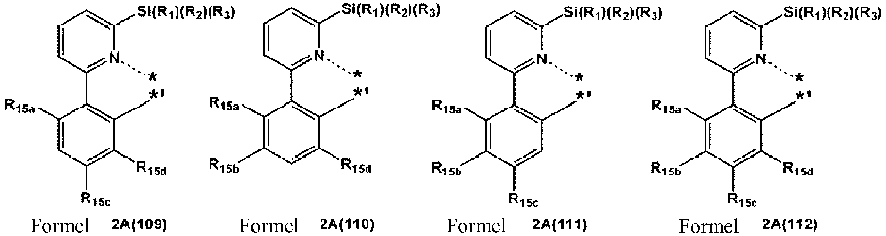 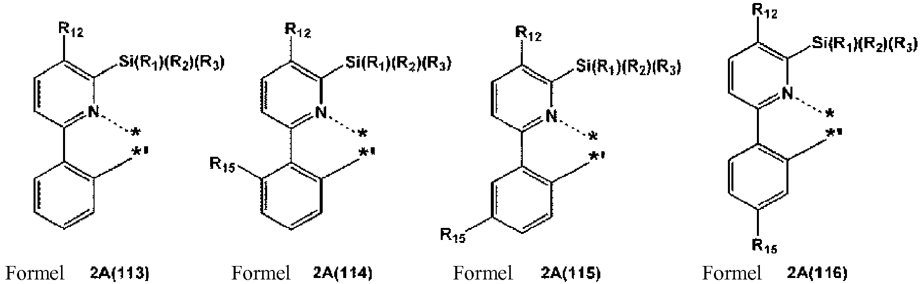 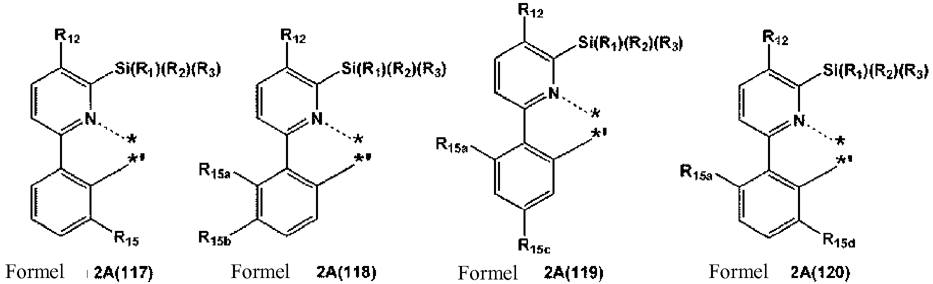 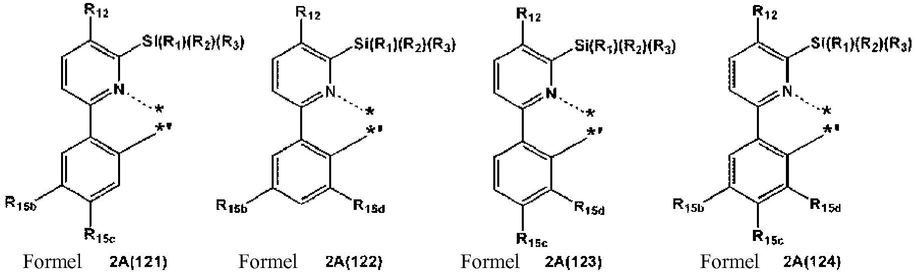 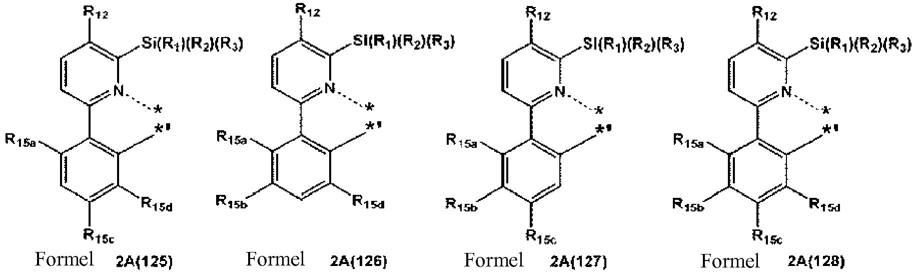 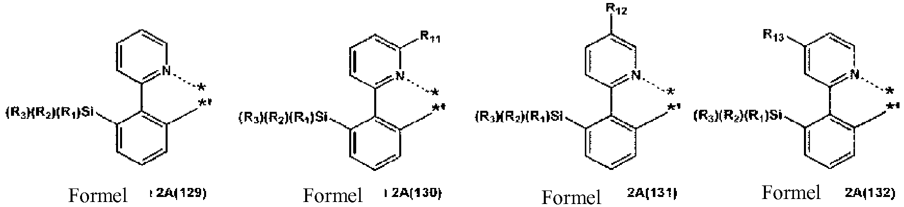 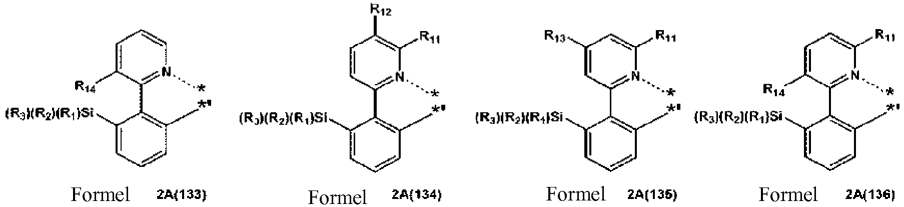 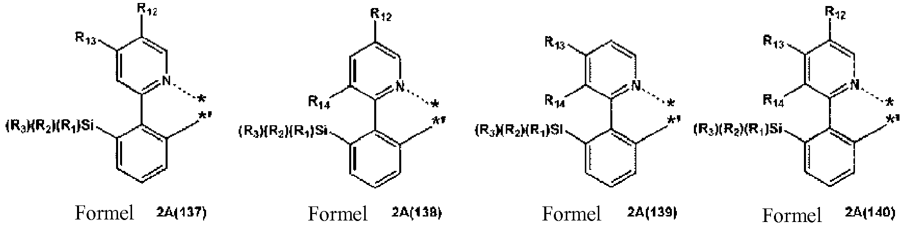 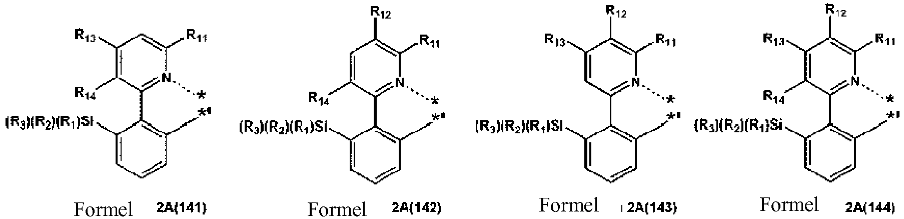 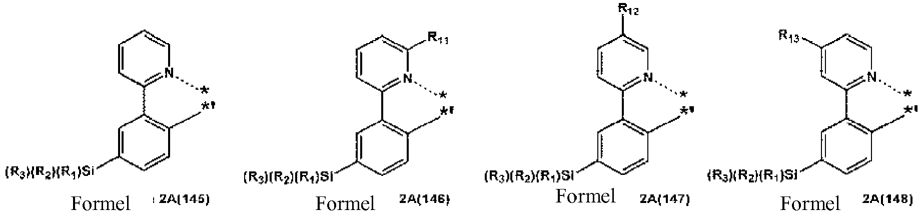 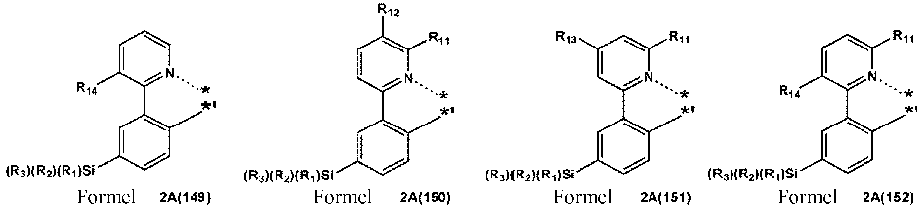 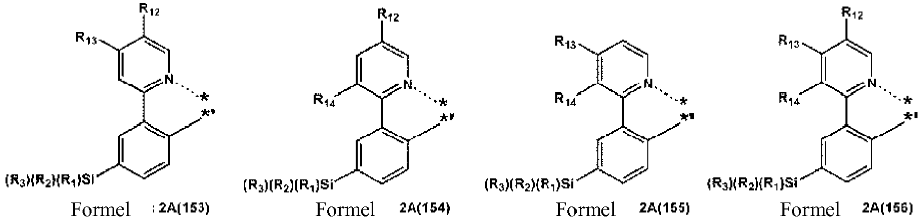 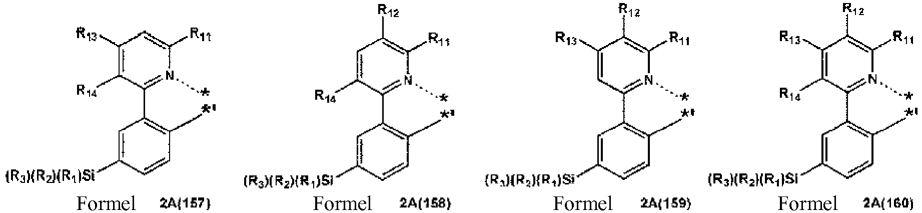 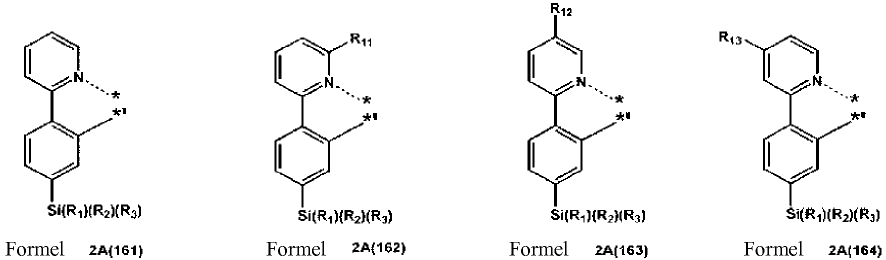 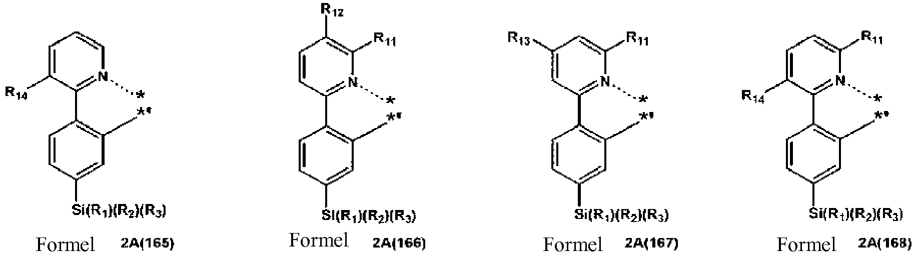 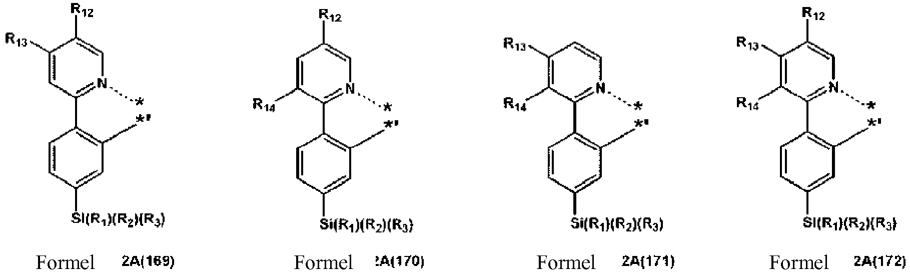 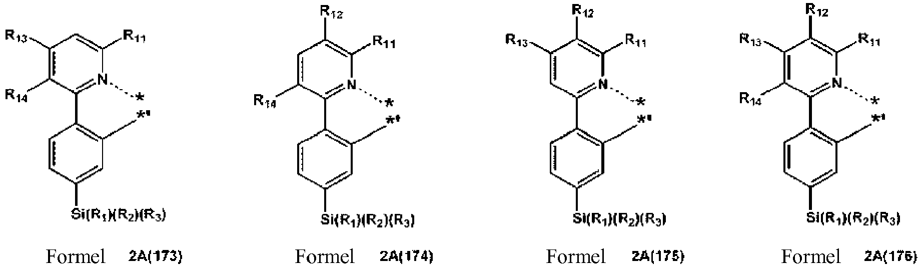 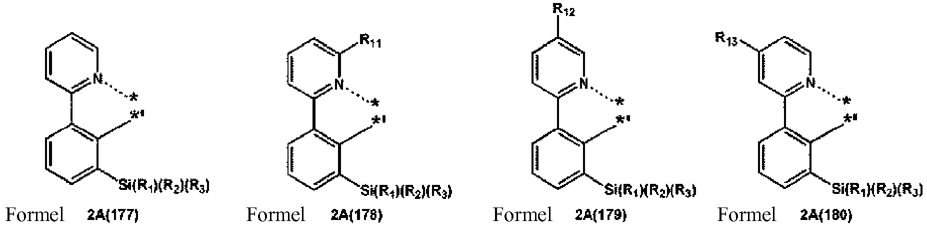 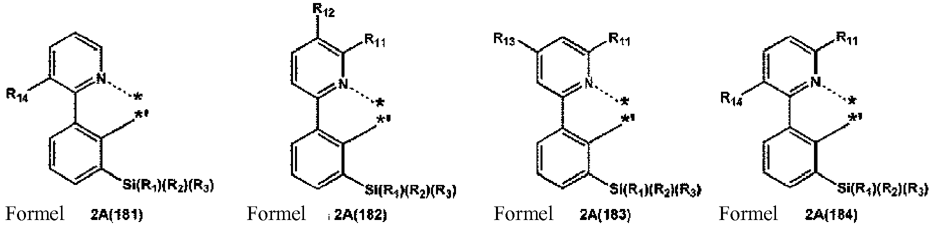 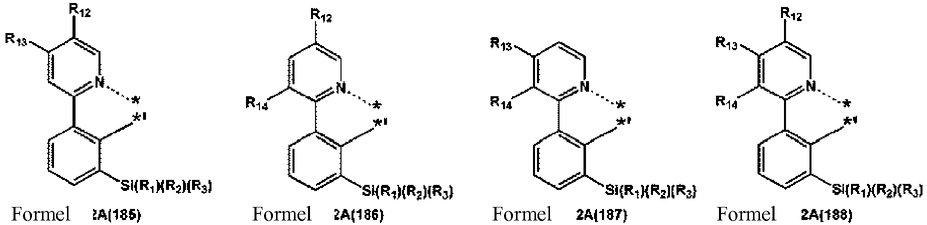 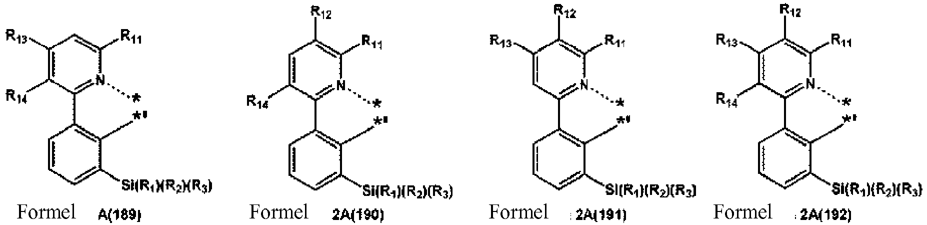 In Formeln 2A(1) bis 2A(192)
sind R₁₁ bis R₁₅ und R₁ bis R₃ dieselben wie die in Anspruch 1 aufgeführten,
R₁₅ₐ bis R_{15d} sind dieselben wie die Beschreibung von R₁₅ in Anspruch 1, und
* und *' zeigen jeweils eine Bindungsstelle mit M in Formel 1 an,
sofern alle von R₁₁ bis R₁₅ und R₁₅ₐ bis R_{15d} nicht gleichzeitig ein Wasserstoff sind.

8. Organometallverbindung von Anspruch 7,
wobei L₁ ausgewählt ist aus den durch Formeln 2A(1) bis 2A(48), 2A(65) bis 2A(80), 2A(97) bis 2A(112) und 2A(129) bis 2A(192) dargestellten Liganden,
und in Formeln 2A(1) bis 2A(48), 2A(65) bis 2A(80), 2A(97) bis 2A(112) und 2A(129) bis 2A(192)
R₁ bis R₃ jeweils unabhängig ausgewählt sind aus
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H und -CD₂CDH₂;
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe,
und einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, ein tert-Pentylgruppe, einer Phenylgruppe und einer Naphthylgruppe, jeweils substituiert mit mindestens einem ausgewählt aus einem Deuterium, einer C₁-C₁₀ Alkylgruppe, und einer Phenylgruppe,
alle von R₁ bis R₃ sind dieselben, oder R₁ und R₃ sind identisch und R₂ ist zu R₁ unterschiedlich
und R₁₁ bis R₁₅ und R₁₅ₐ bis R_{15d} sind jeweils unabhängig ausgewählt aus einem Deuterium, -F, einer Cyangruppe, einer Nitrogruppe, -SF₅, -CH₃, -CD₃, -CD₂H, -CDH₂, -CF₃, -CF₂H, -CFH₂, aus durch Formeln 9-1 bis 9-19 dargestellten Gruppen und aus durch Formeln 10-1 bis 10-36 dargestellten Gruppen: 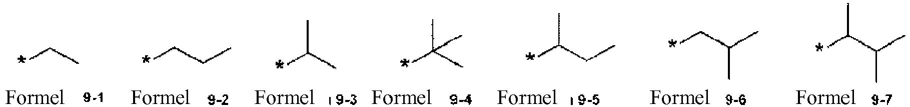 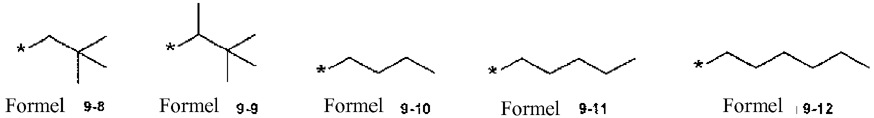 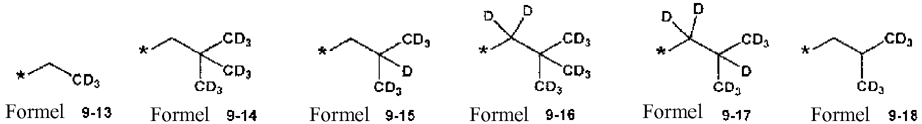 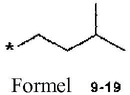 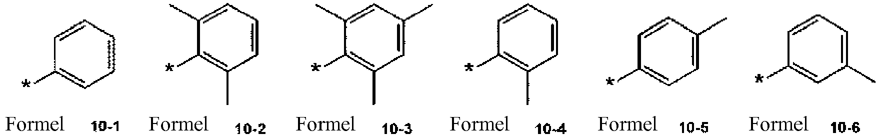 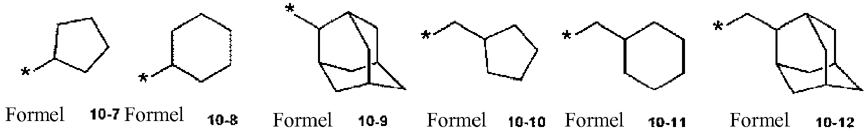 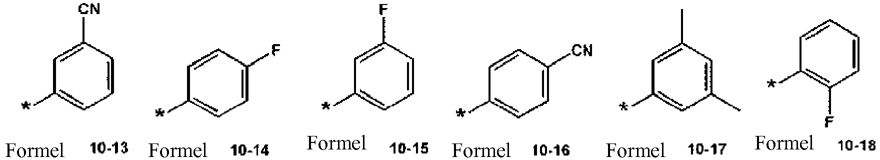 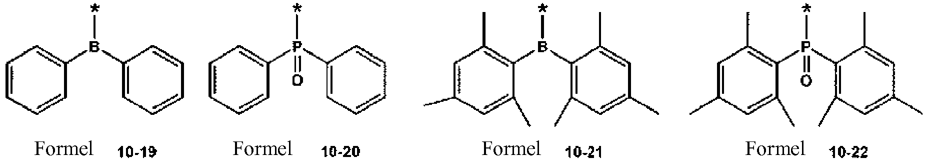 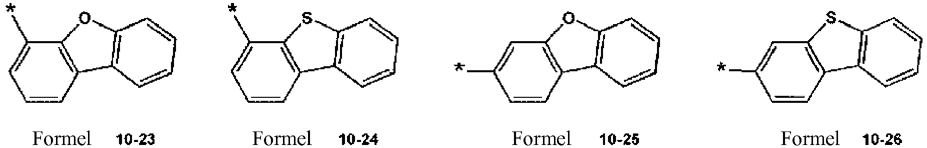 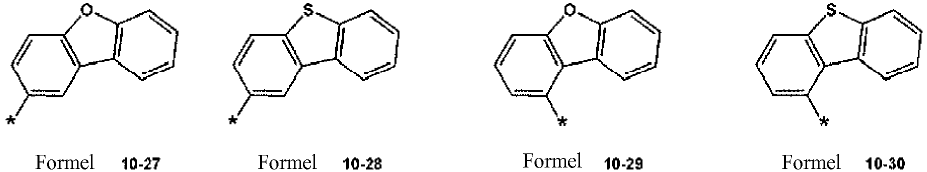 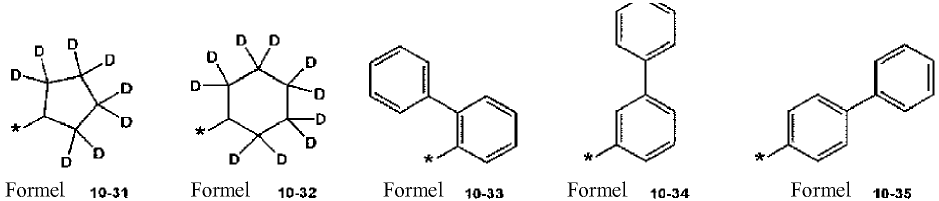 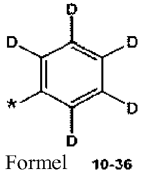 In Formeln 9-1 bis 9-19 und 10-1 bis 10-36 zeigt * eine Bindungsstelle mit einem benachbarten Atom an.

9. Organometallverbindung nach einem der Ansprüche 1 bis 8, wobei L₂ ausgewählt ist aus Liganden, die durch Formeln 2B-1 bis 2B-14 dargestellt sind: 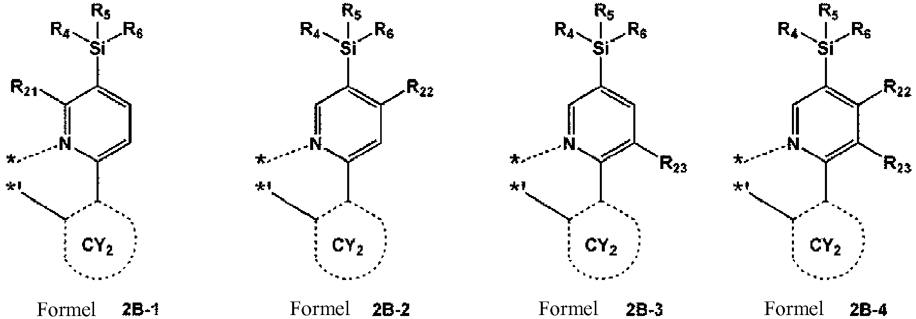 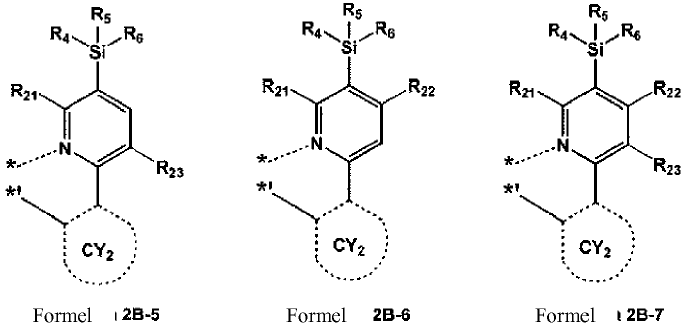 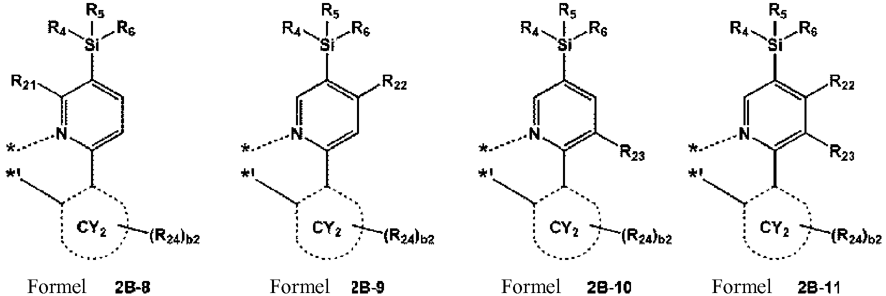 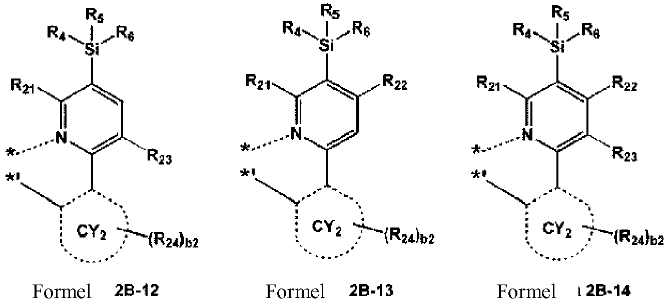 In Formeln 2B-1 bis 2B-14
sind CY₂, R₂₁ bis R₂₄, R₄ bis R₆ und b2 dieselben wie in Anspruch 1, und
* und *' zeigen jeweils eine Bindungsstelle mit M in Formel 1 an,
sofern alle von R₂₁ bis R₂₄ nicht gleichzeitig ein Wasserstoff sind, wobei vorzugsweise: L₂ ausgewählt ist aus durch Formeln 2B(1) bis 2B(96) dargestellten Liganden: 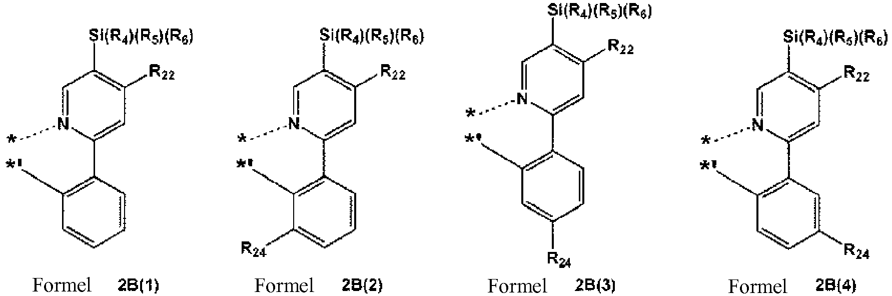 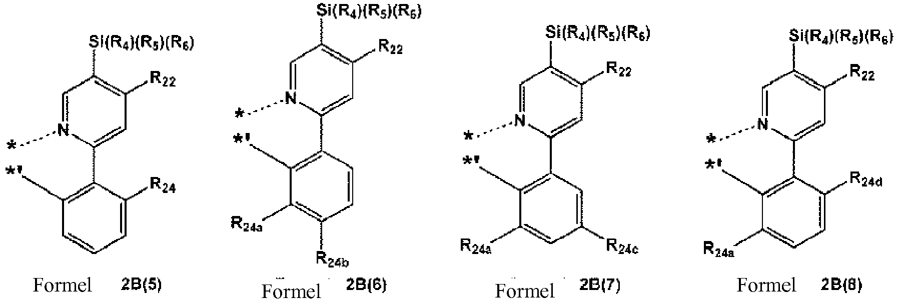 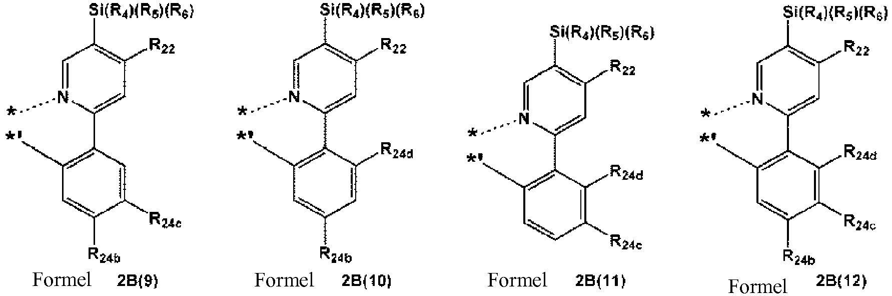 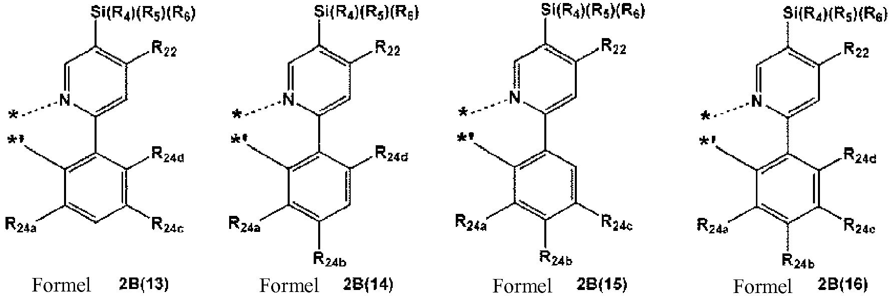 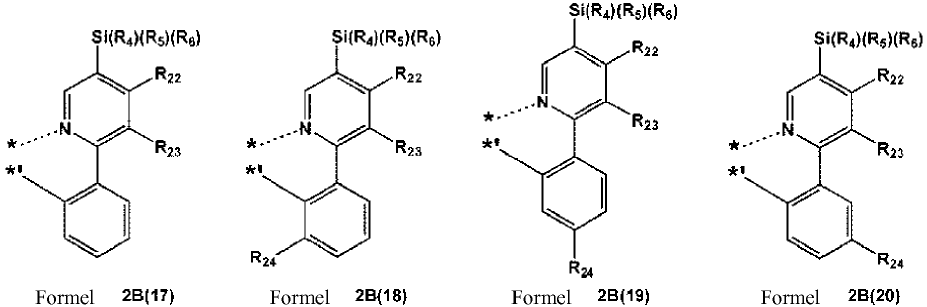 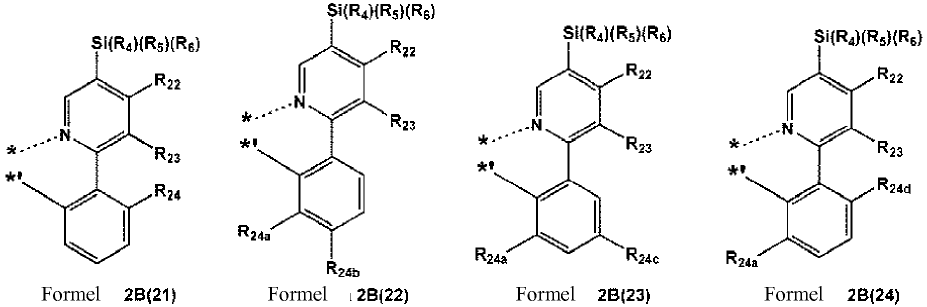 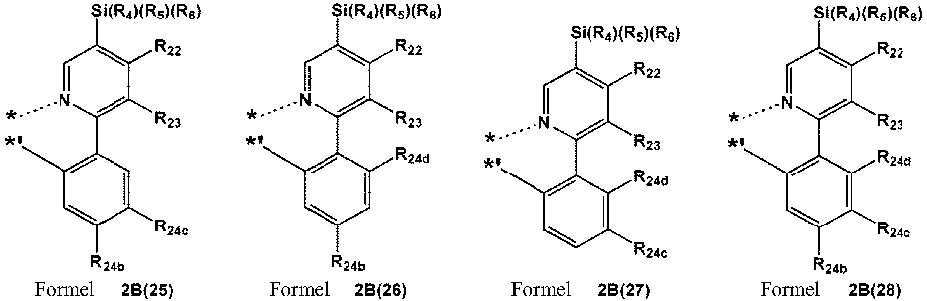 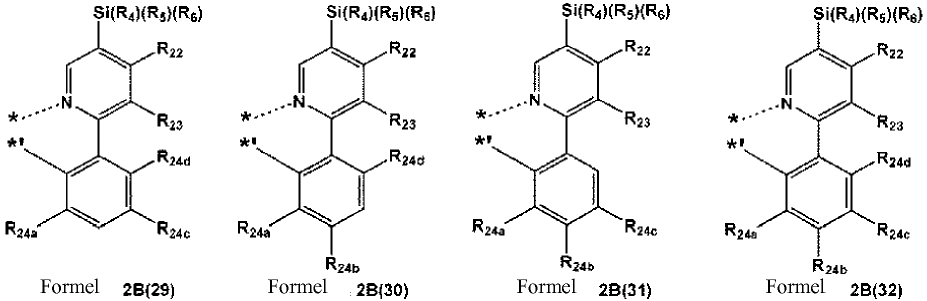 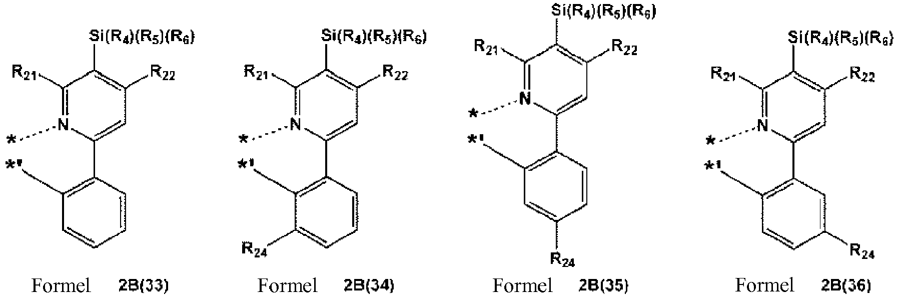 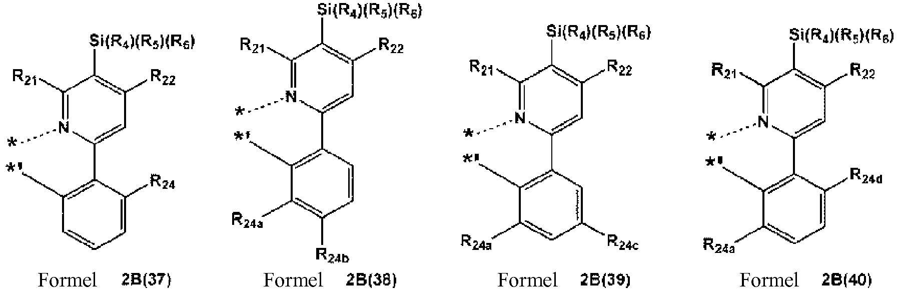 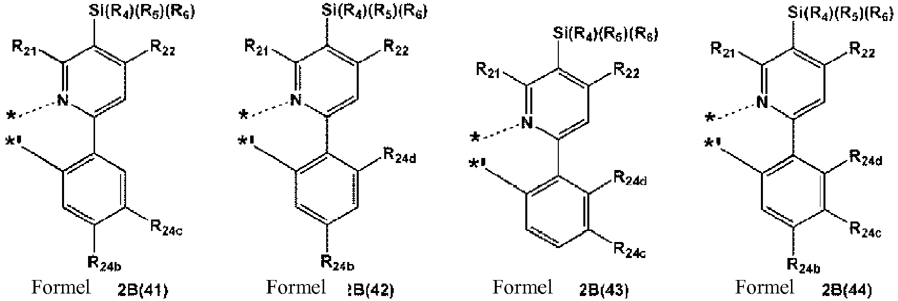 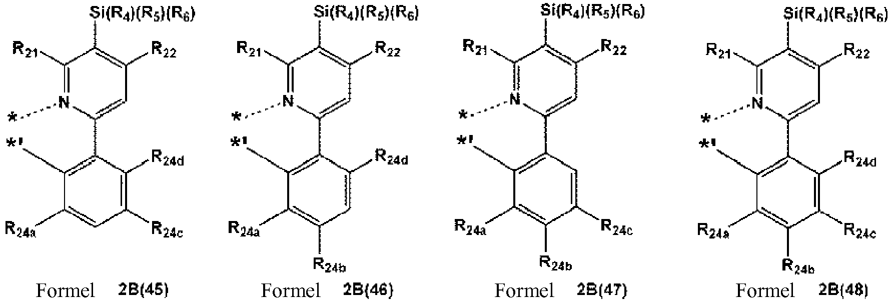 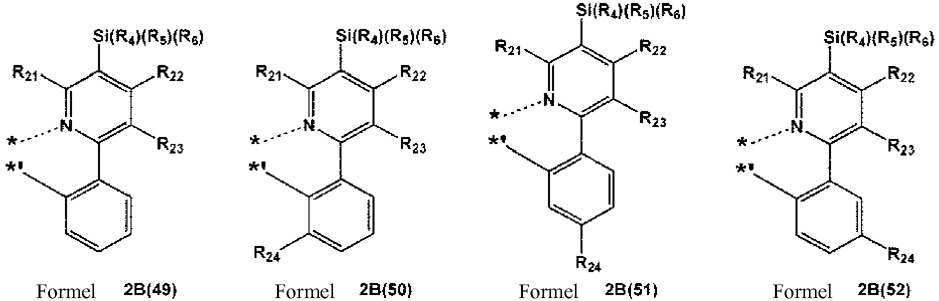 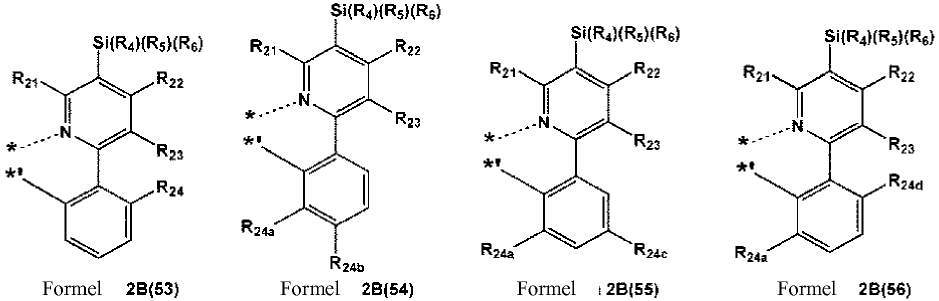 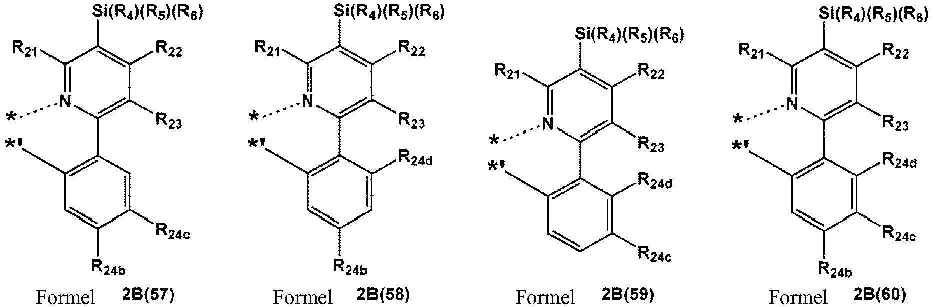 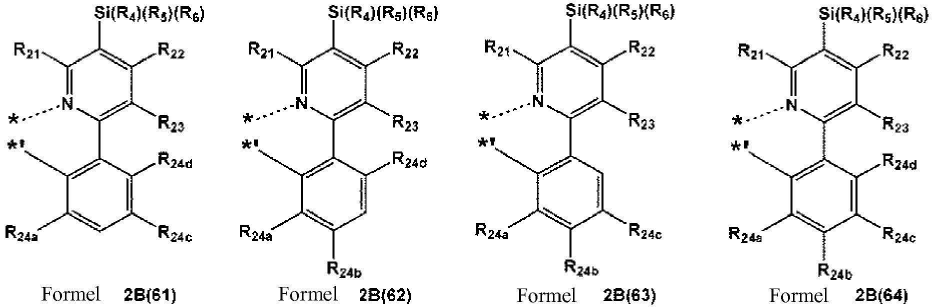 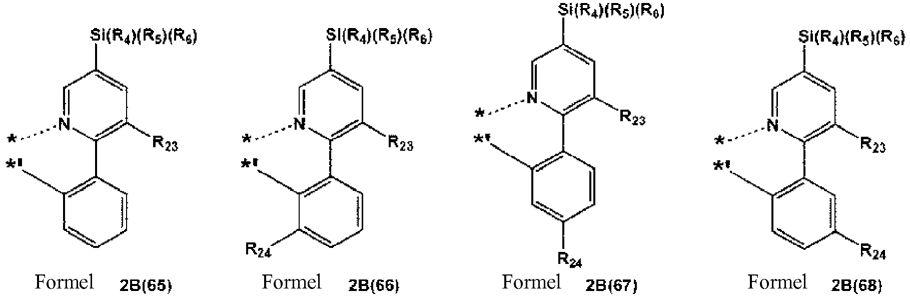 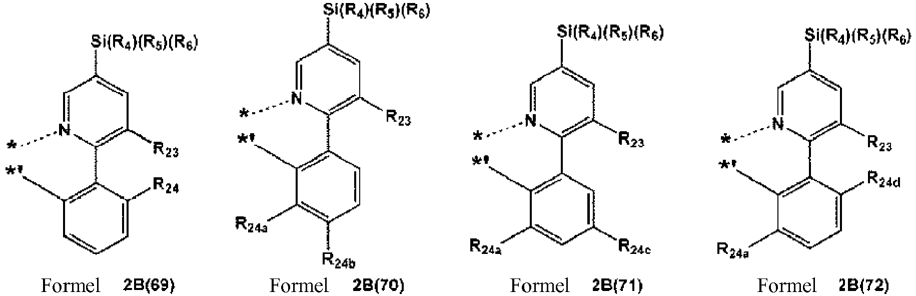 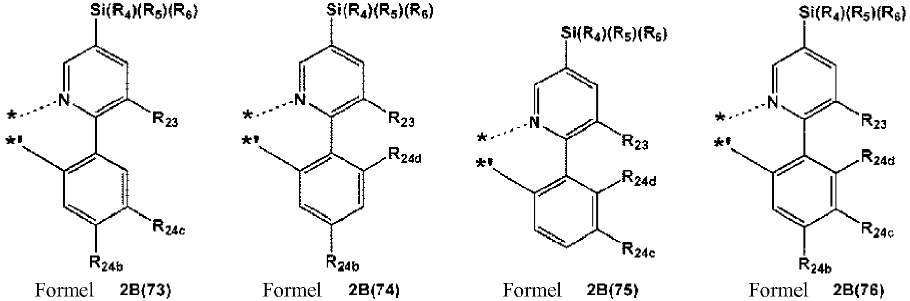 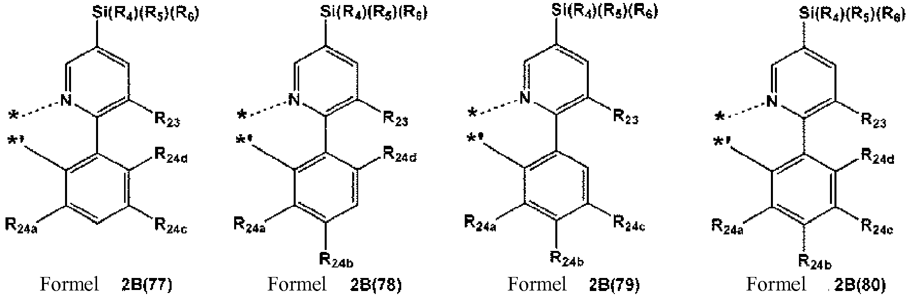 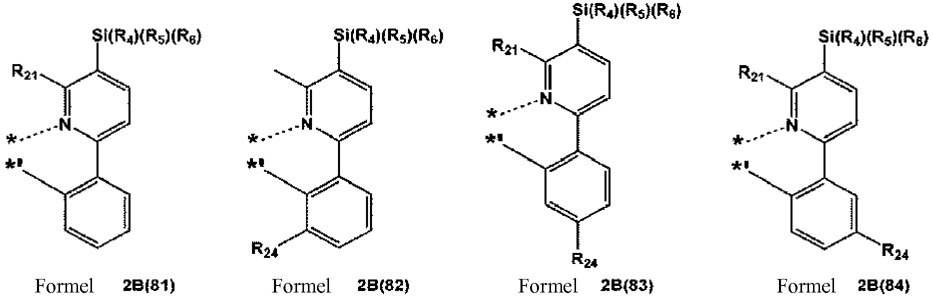 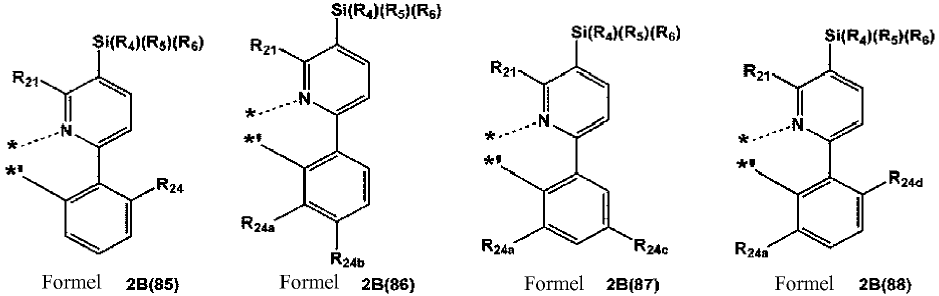 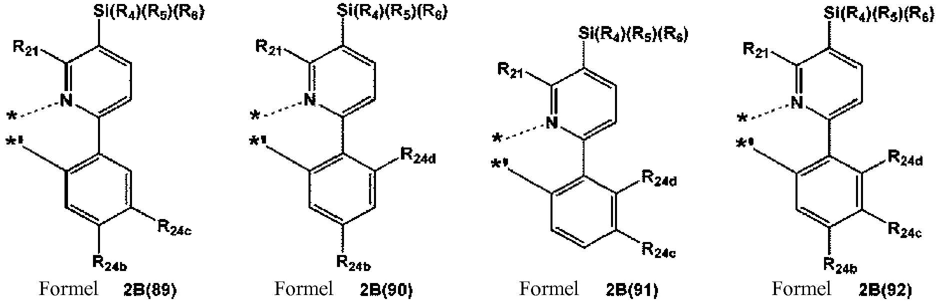 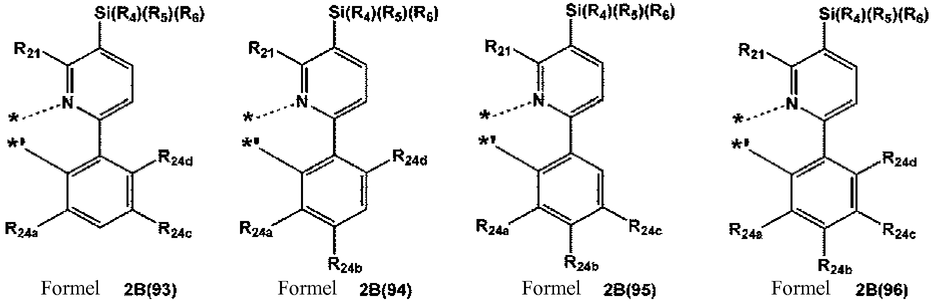 In Formeln 2B(1) bis 2B(96) sind R₂₁ bis R₂₄ und R₄ bis R₆ dieselben wie in Anspruch 1, R₂₄ₐ bis R_{24d} sind dieselben wie R₂₄ in Anspruch 1, und * und *' zeigen jeweils eine Bindungsstelle mit M in Formel 1 an, sofern alle von R₂₁ bis R₂₄ und R₂₄ₐ bis R_{24d} nicht gleichzeitig ein Wasserstoff sind.

10. Organometallverbindung von Anspruch 9,
wobei L₂ ausgewählt ist aus den durch Formeln 2B(1) bis 2B(48) und 2B(65) bis 2B(80) dargestellten Liganden,
und in Formeln 2B(1) bis 2B(48) und 2B(65) bis 2(80)
R₄ bis R₆ jeweils unabhängig ausgewählt sind aus
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, und -CD₂CDH₂;
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe,
und einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, ein tert-Pentylgruppe, einer Phenylgruppe und einer Naphthylgruppe, jeweils substituiert mit mindestens einem ausgewählt aus einem Deuterium, einer C₁-C₁₀ Alkylgruppe, und einer Phenylgruppe,
alle von R₄ bis R₆ sind dieselben, oder R₄ und R₆ sind identisch und R₅ ist zu R₄ unterschiedlich,
und R₂₁ bis R₂₄ und R₂₄ₐ bis R_{24d} sind jeweils unabhängig ausgewählt aus einem Deuterium, -F, einer Cyangruppe, einer Nitrogruppe, -SF₅, -CH₃, -CD₃, -CD₂H, -CDH₂, -CF₃, -CF₂H, -CFH₂, aus durch Formeln 9-1 bis 9-19 dargestellten Gruppen und aus durch Formeln 10-1 bis 10-36 dargestellten Gruppen: 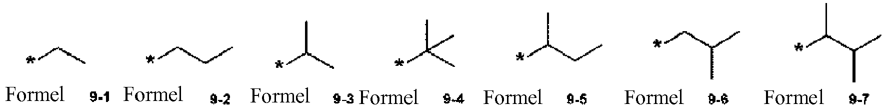 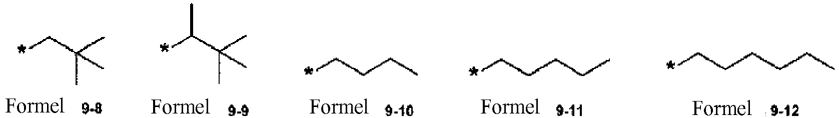 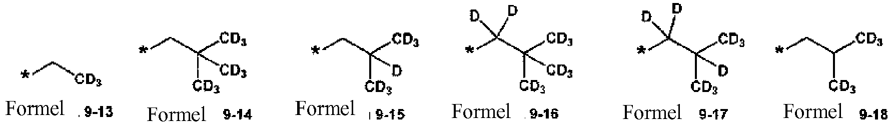 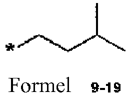 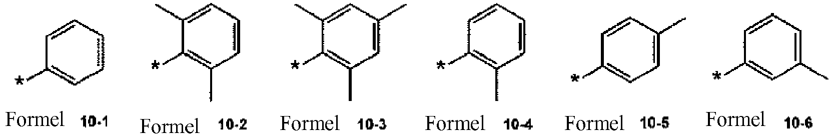 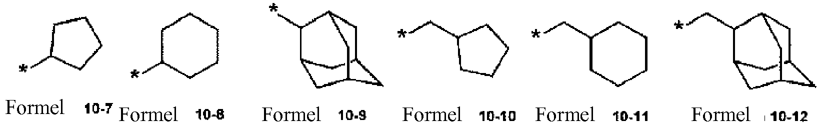 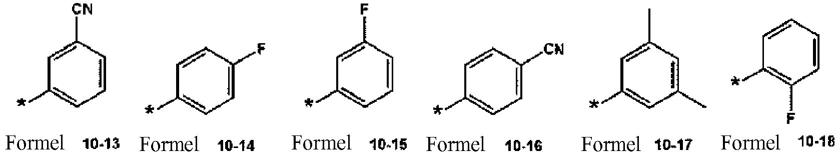 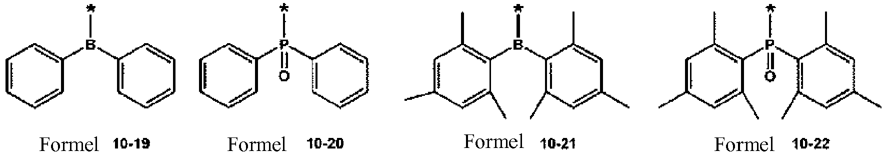 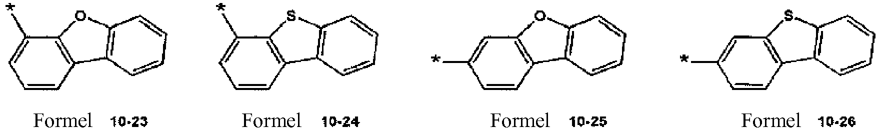 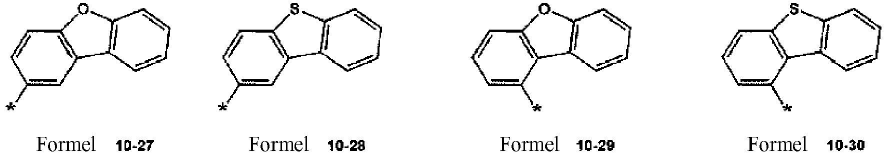 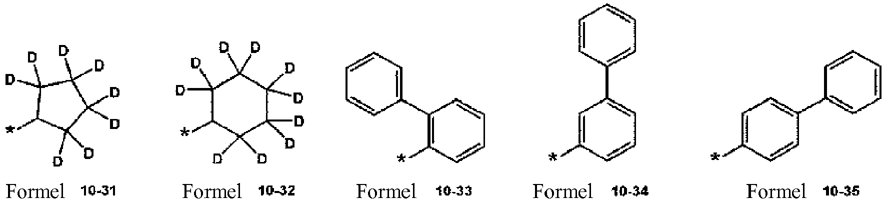 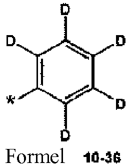 In Formeln 9-1 bis 9-19 und 10-1 bis 10-36 zeigt * eine Bindungsstelle mit einem benachbarten Atom an.

11. Organometallverbindung von Anspruch 1, wobei die Organometallverbindung eine von Verbindungen 1 bis 292 ist:

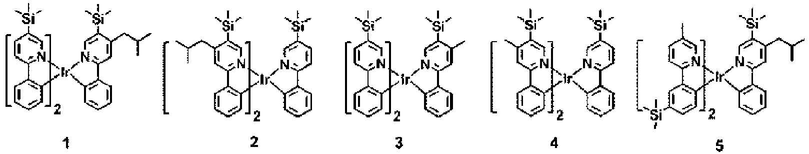

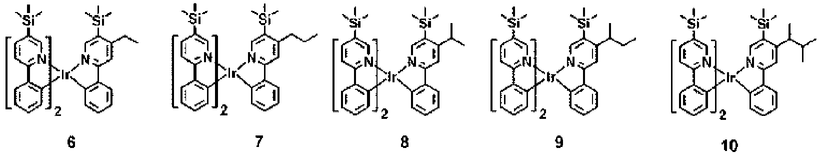

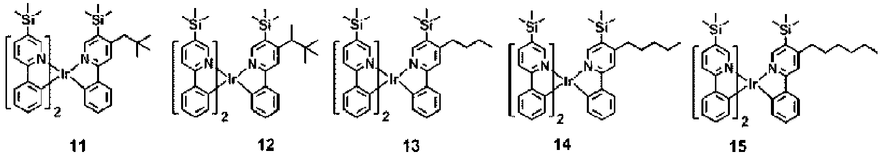

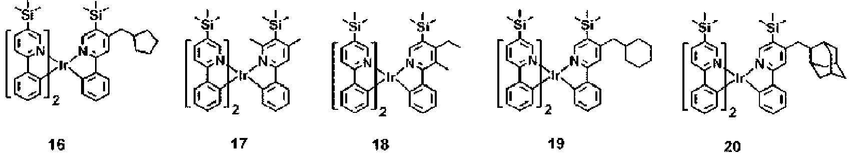

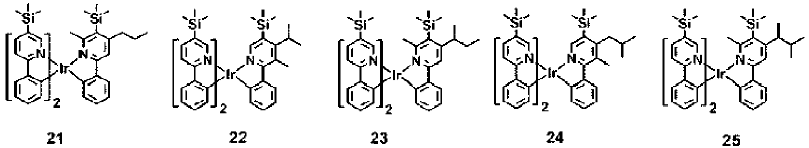

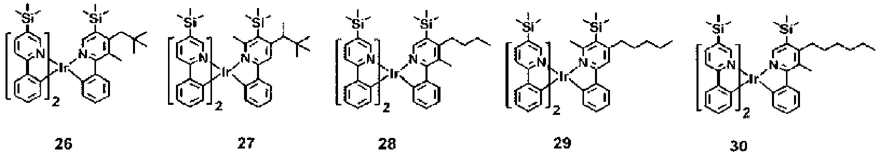

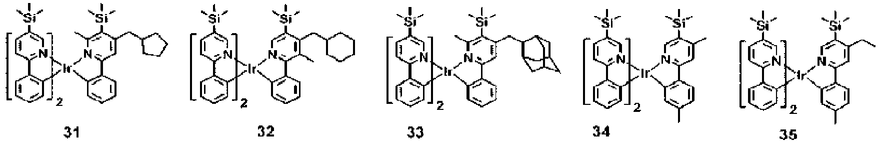

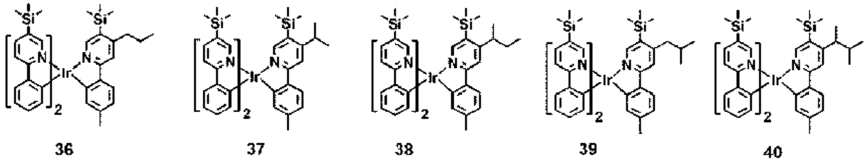

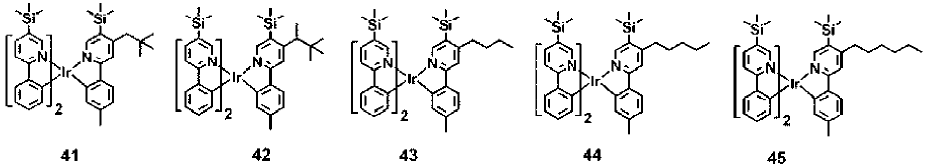

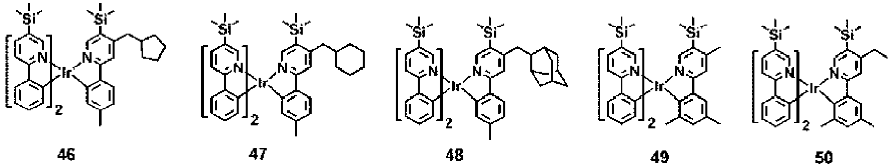

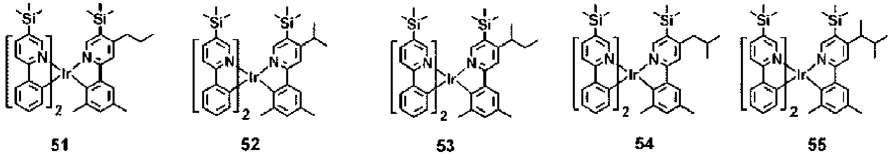

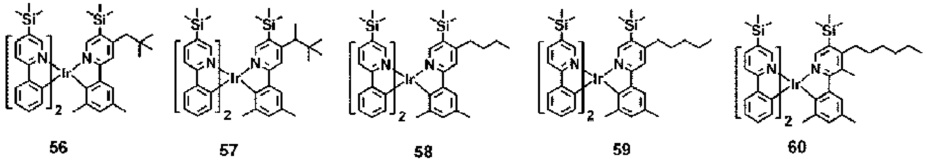

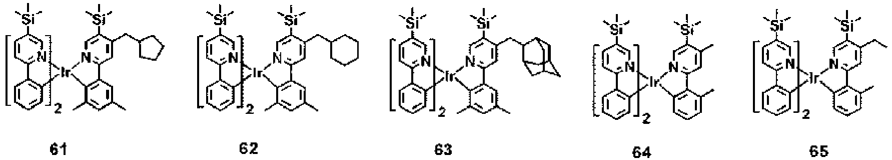

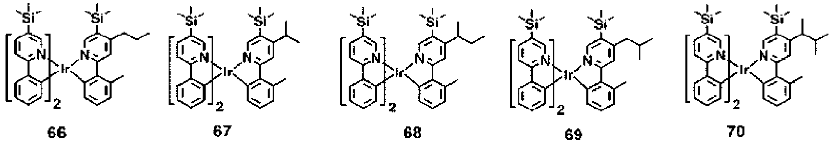

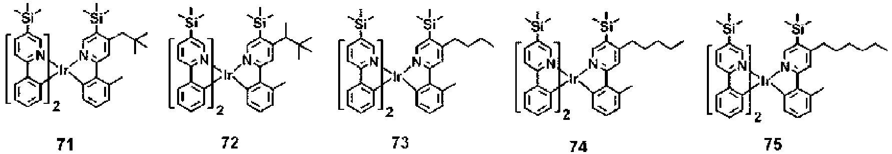

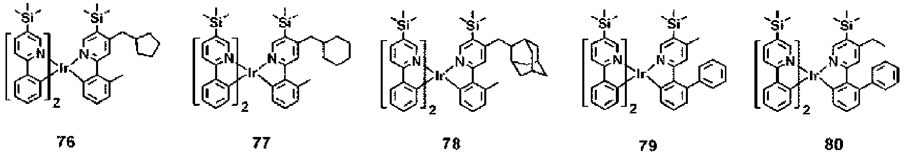

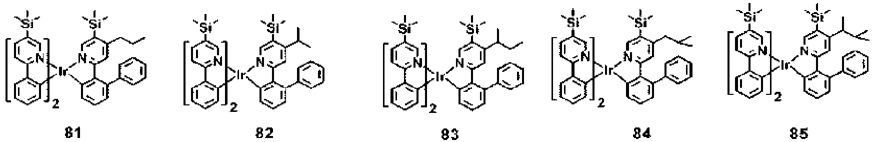

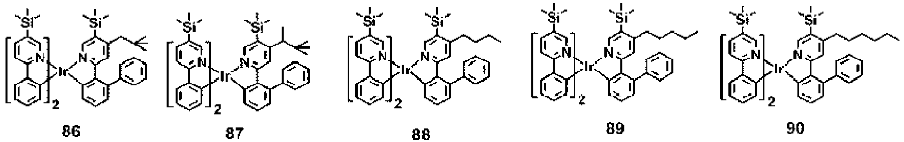

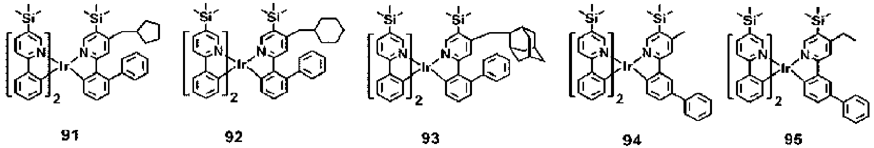

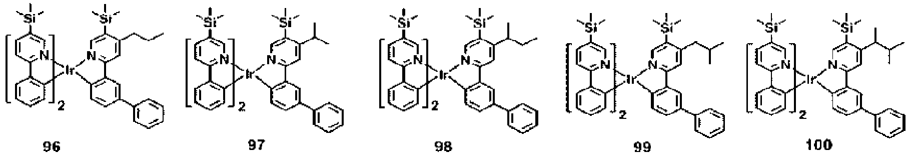

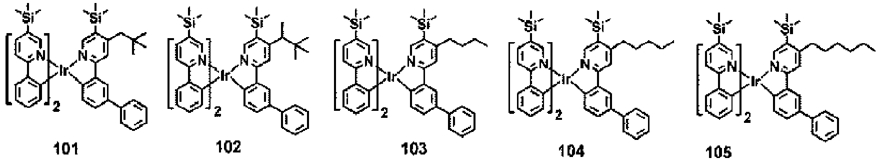

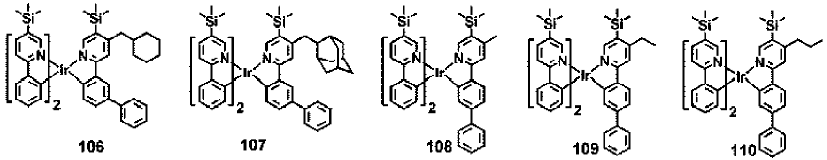

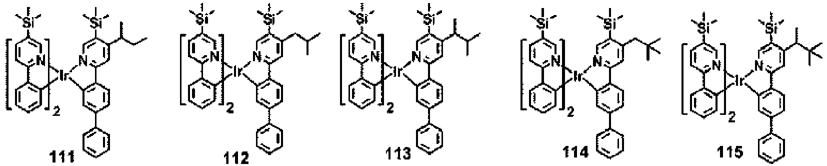

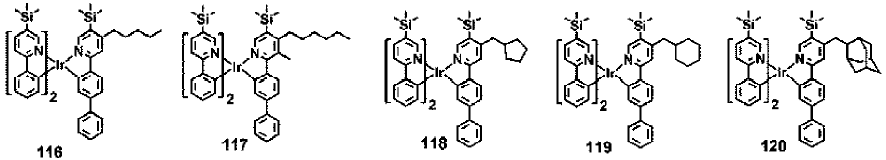

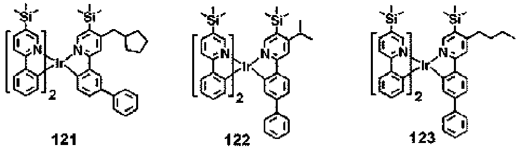

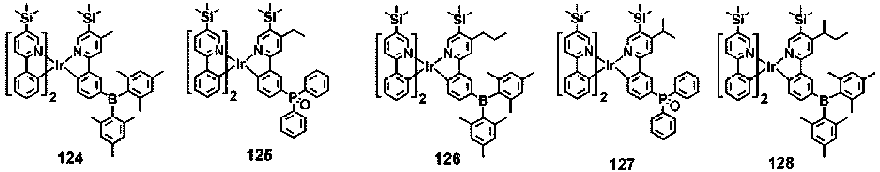

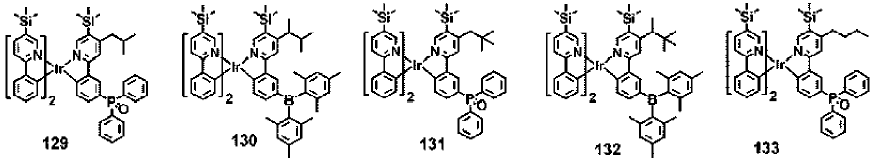

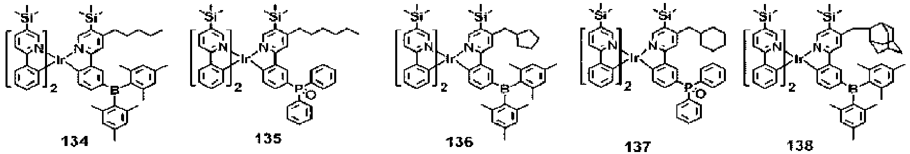

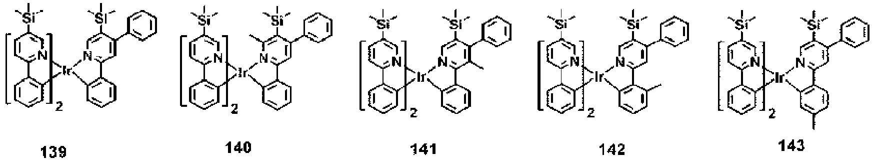

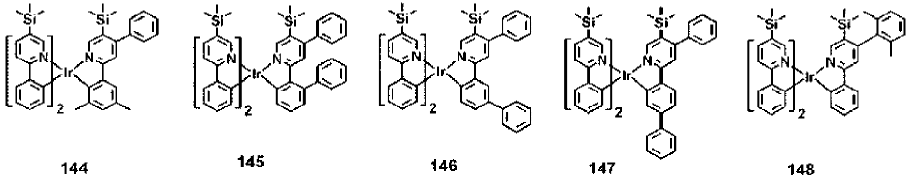

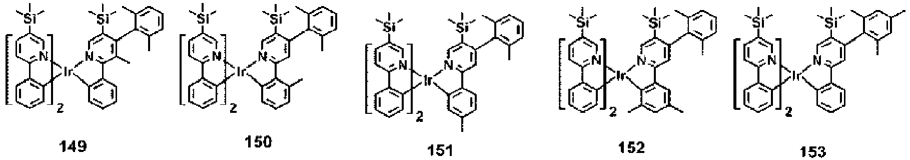

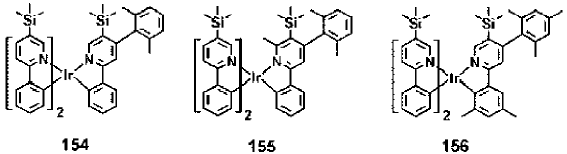

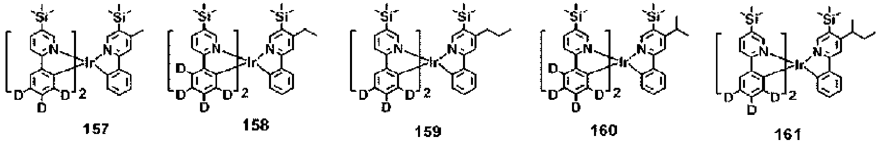

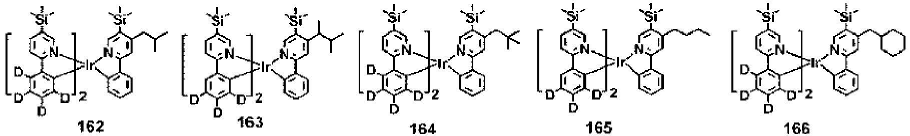

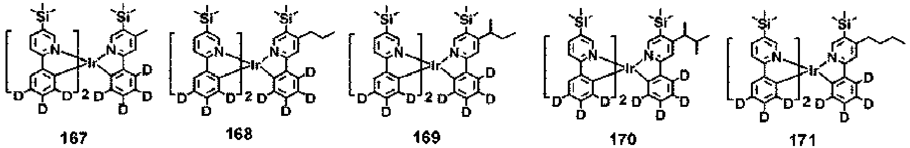

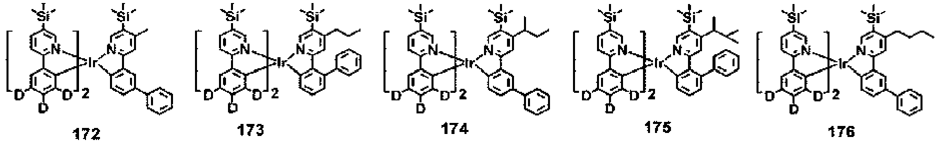

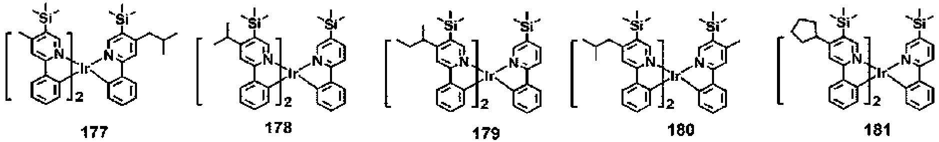

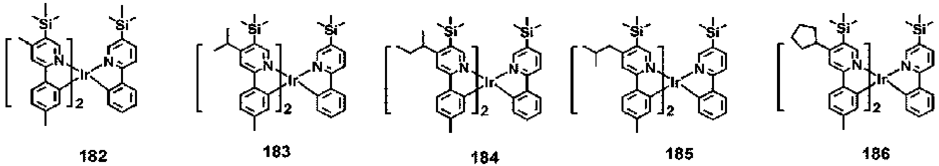

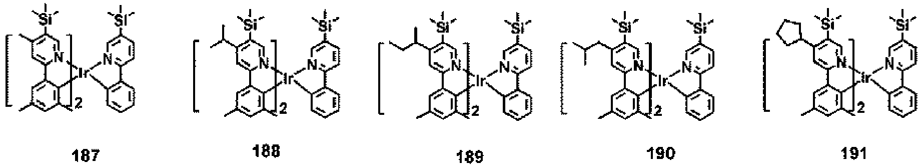

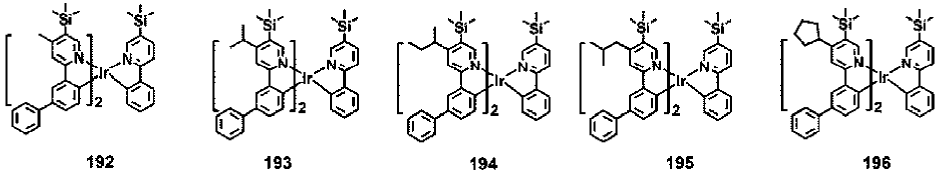

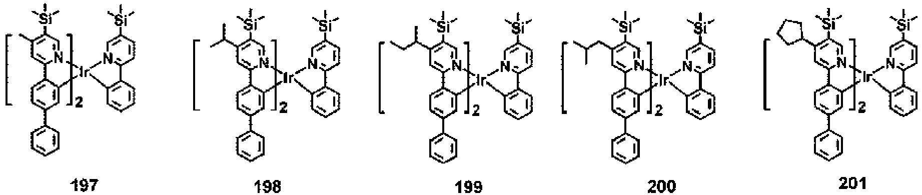

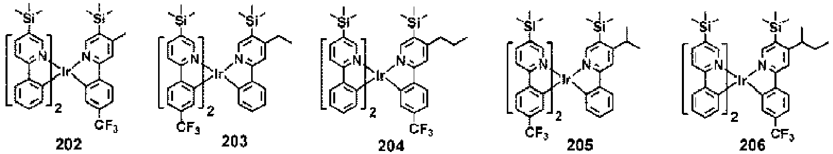

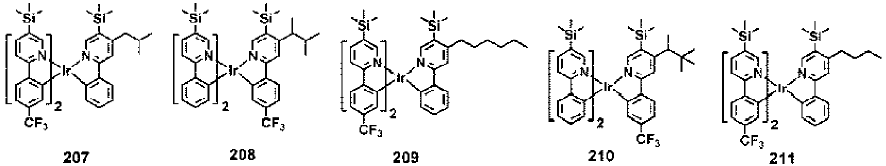

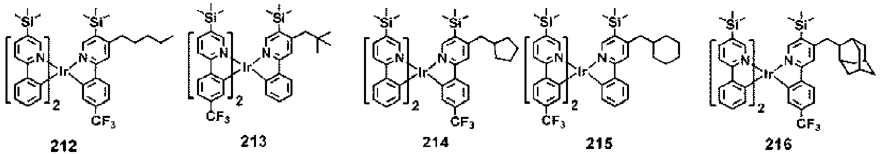

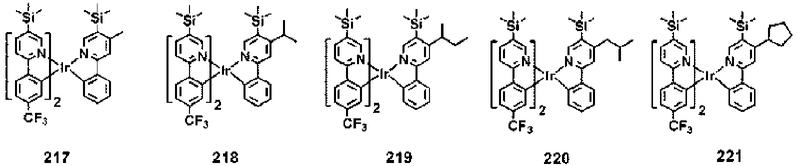

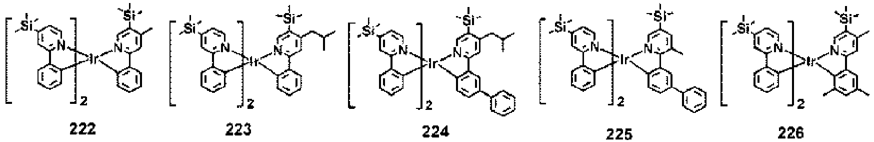

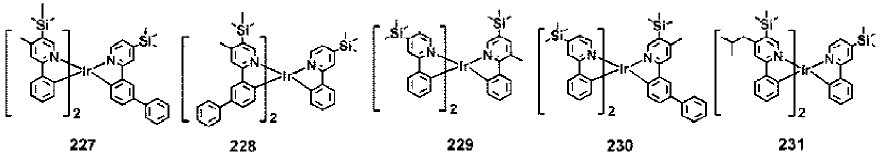

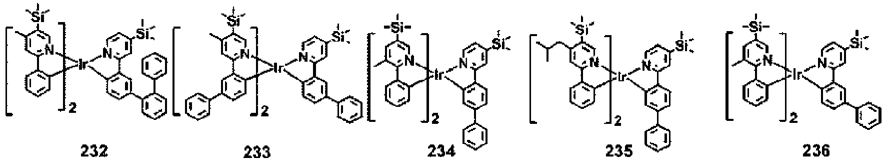

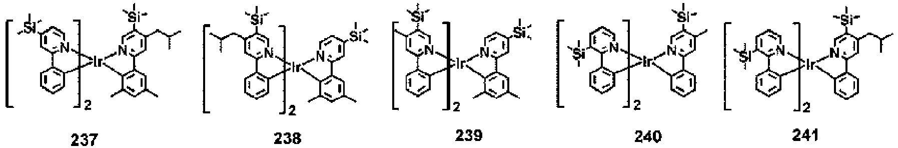

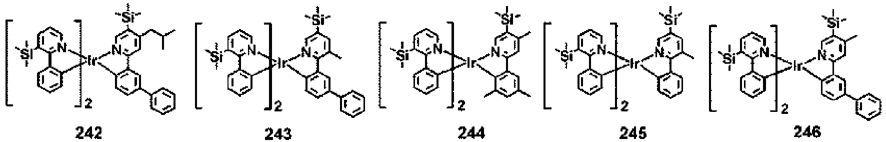

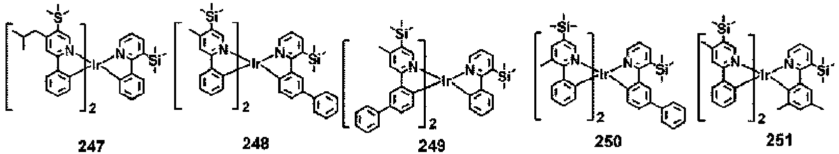

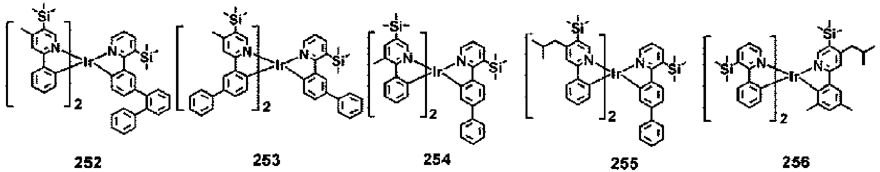

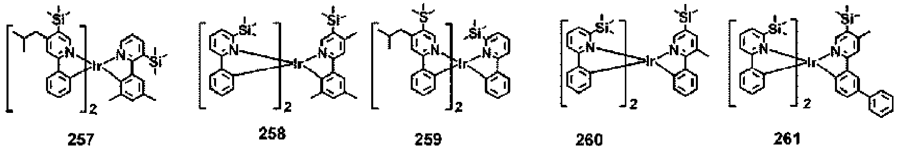

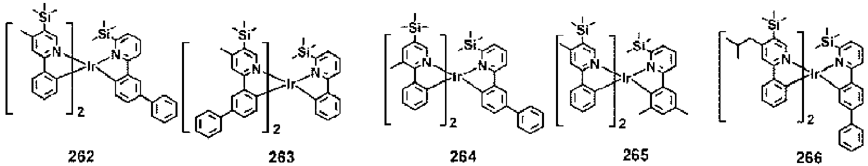

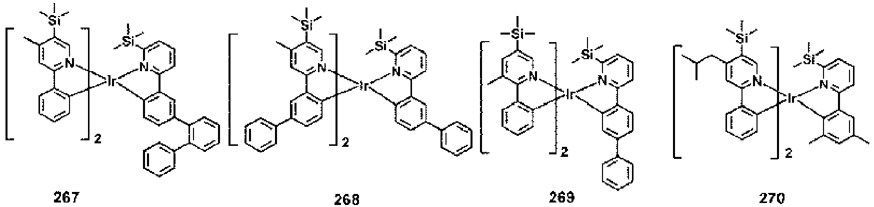

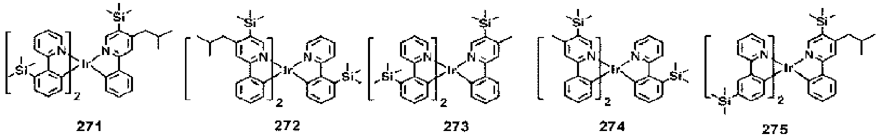

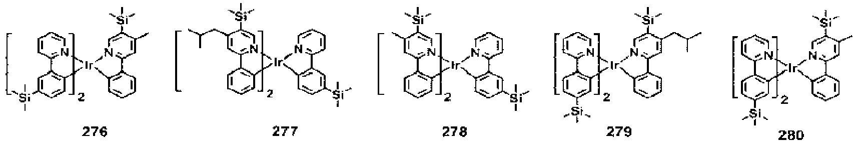

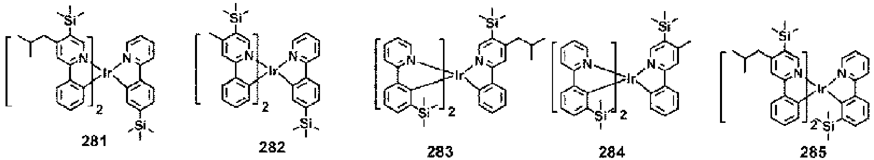

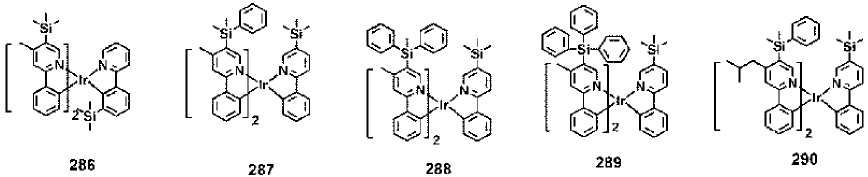

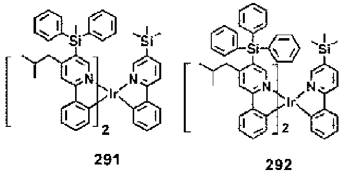

12. Organische lichtemittierende Vorrichtung, umfassend:
eine erste Elektrode,
eine zweite Elektrode
und eine zwischen der ersten Elektrode und der zweiten Elektrode angeordnete organische Schicht, wobei die organische Schicht eine Emissionsschicht und mindestens eine der Organometallverbindungen eines beliebigen der Ansprüche 1 bis 11 umfasst.

13. Organische lichtemittierende Vorrichtung nach Anspruch 12, wobei die erste Elektrode ein Anode ist,
die zweite Elektrode eine Kathode ist
und die organische Schicht Folgendes umfasst:
i) einen zwischen der ersten Elektrode und der Emissionsschicht angeordneten Lochtransportbereich, wobei der Lochtransportbereich mindestens eine von einer Lochinjektionsschicht, einer Lochtransportschicht und einer Elektronenblockierungsschicht umfasst, und
ii) einen zwischen der Emissionsschicht und der zweiten Elektrode angeordneten Elektronentransportbereich, wobei der Elektronentransportbereich mindestens eine von einer Lochblockierungsschicht, einer Elektronentransportschicht und einer Elektroneninjektionsschicht umfasst.

14. Organische lichtemittierende Vorrichtung nach Anspruch 12 oder 13, wobei die Emissionsschicht aus der Organometallverbindung besteht.

15. Organische lichtemittierende Vorrichtung nach Anspruch 14, wobei die Organometallverbindung als Dotierstoff wirkt und die Emissionsschicht ferner einen Wirt umfasst.

## Revendications

1. Composé organométallique représenté par la Formule 1 :
Formule 1 M(L₁)ₙ₁(L₂)ₙ₂ 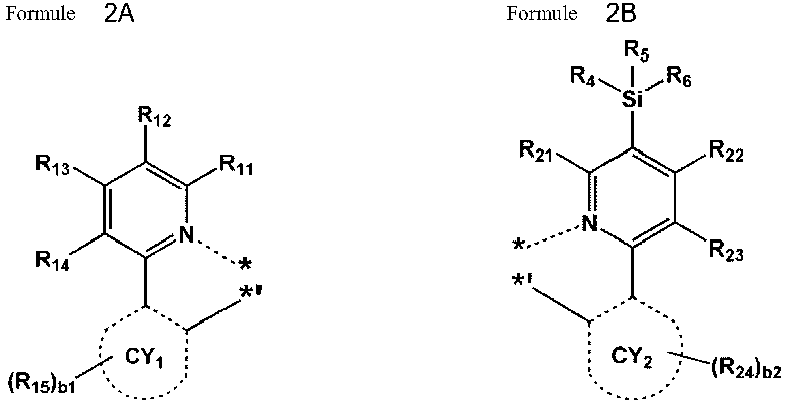
dans lequel M dans la Formule 1 est sélectionné parmi l'iridium, le platine, l'osmium, le titane, le zirconium, le hafnium, l'europium, le terbium, le thulium, et le rhodium, dans la Formule 1, L₁ est sélectionné parmi des ligands représentés par la Formule 2A ci-dessus, n1 est 1 ou 2, à condition que quand n1 est 2, deux groupes L₁ soient identiques l'un avec l'autre ou différents l'un de l'autre, dans la Formule 1, L₂ est sélectionné parmi des ligands représentés par la Formule 2B ci-dessus, n2 est 1 ou 2, à condition que quand n2 est 2, deux groupes L₂ soient identiques ou différents l'un de l'autre, dans la Formule 1, L₁ et L₂ sont différents l'un de l'autre et la somme de n1 et n2 est 2 ou 3, chacun de * et *' dans les Formules 2A et 2B indique un site de liaison à M dans la Formule 1, CY₁ et CY₂ dans les Formules 2A et 2B sont chacun indépendamment sélectionnés parmi un groupe carbocyclique en C₅ à C₆₀ et un groupe hétérocyclique en C₁ à C₆₀, à condition que CY₂ ne soit pas un dibenzofurane, un dibenzothiophène, une dibenzothiophène sulfone, un carbazole, et un dibenzosilole, R₁₁ à R₁₅ dans la Formule 2A sont chacun indépendamment sélectionnés parmi un hydrogène, un deutérium, -F, -Cl, -Br, -I, -SF₅, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁ à C₆₀ substitué ou non substitué, un groupe alcényle en C₂ à C₆₀ substitué ou non substitué, un groupe alcynyle en C₂ à C₆₀ substitué ou non substitué, un groupe alcoxy en C₁ à C₆₀ substitué ou non substitué, un groupe cycloalkyle en C₃ à C₁₀ substitué ou non substitué, un groupe hétérocycloalkyle en C₁ à C₁₀ substitué ou non substitué, un groupe cycloalcényle en C₃ à C₁₀ substitué ou non substitué, un groupe hétérocycloalcényle en C₁ à C₁₀ substitué ou non substitué, un groupe aryle en C₆ à C₆₀ substitué ou non substitué, un groupe aryloxy en C₆ à C₆₀ substitué ou non substitué, un groupe arylthio en C₆ à C₆₀ substitué ou non substitué, un groupe arylalkyle en C₇ à C₆₀ substitué ou non substitué, un groupe hétéroaryle en C₁ à C₆₀ substitué ou non substitué, un groupe hétéroaryloxy en C₁ à C₆₀ substitué ou non substitué, un groupe hétéroarylthio en C₁ à C₆₀ substitué ou non substitué, un groupe hétéroarylalkyle en C₂ à C₆₀ substitué ou non substitué, un groupe polycyclique condensé non aromatique monovalent substitué ou non substitué, un groupe hétéropolycyclique condensé non aromatique monovalent substitué ou non substitué, -Si(R₁)(R₂)(R₃), -N(Q₁)(Q₂), -B(Q₃)(Q₄), et -P(=Q)(Q₅)(Q₆), R₂₁ à R₂₄ dans la Formule 2B sont chacun indépendamment sélectionnés parmi un hydrogène, un deutérium, -F, -Cl, -Br, -I, -SF₅, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁ à C₆₀ substitué ou non substitué, un groupe alcényle en C₂ à C₆₀ substitué ou non substitué, un groupe alcynyle en C₂ à C₆₀ substitué ou non substitué, un groupe alcoxy en C₁ à C₆₀ substitué ou non substitué, un groupe cycloalkyle en C₃ à C₁₀ substitué ou non substitué, un groupe hétérocycloalkyle en C₁ à C₁₀ substitué ou non substitué, un groupe cycloalcényle en C₃ à C₁₀ substitué ou non substitué, un groupe hétérocycloalcényle en C₁ à C₁₀ substitué ou non substitué, un groupe aryle en C₆ à C₆₀ substitué ou non substitué, un groupe aryloxy en C₆ à C₆₀ substitué ou non substitué, un groupe arylthio en C₆ à C₆₀ substitué ou non substitué, un groupe arylalkyle en C₇ à C₆₀ substitué ou non substitué, un groupe hétéroaryle en C₁ à C₆₀ substitué ou non substitué, un groupe hétéroaryloxy en C₁ à C₆₀ substitué ou non substitué, un groupe hétéroarylthio en C₁ à C₆₀ substitué ou non substitué, un groupe hétéroarylalkyle en C₂ à C₆₀ substitué ou non substitué, un groupe polycyclique condensé non aromatique monovalent substitué ou non substitué, un groupe hétéropolycyclique condensé non aromatique monovalent substitué ou non substitué, -N(Q₁)(Q₂), -B(Q₃)(Q₄), et -P(=Q)(Q₅)(Q₆), b1 et b2 dans les Formules 2A et 2B sont chacun indépendamment un nombre entier sélectionné parmi 0 à 4, à condition que i) un sélectionné parmi R₁₁ à R₁₄ dans la Formule 2A ou ii) un sélectionné parmi R₁₅ dans le nombre de b1 dans la Formule 2A, soit -Si(R₁)(R₂)(R₃),
au moins un sélectionné parmi R₂₁ à R₂₃ dans la Formule 2B n'est pas un hydrogène,
R₁ à R₃ dans -Si(R₁)(R₂)(R₃) de la Formule 2A et R₄ à R₆ dans la Formule 2B sont chacun indépendamment sélectionnés parmi un hydrogène, un deutérium, un groupe alkyle en C₁ à C₆₀ substitué ou non substitué, un groupe alcényle en C₂ à C₆₀ substitué ou non substitué, un groupe alcynyle en C₂ à C₆₀ substitué ou non substitué, un groupe alcoxy en C₁ à C₆₀ substitué ou non substitué, un groupe cycloalkyle en C₃ à C₁₀ substitué ou non substitué, un groupe hétérocycloalkyle en C₁ à C₁₀ substitué ou non substitué, un groupe cycloalcényle en C₃ à C₁₀ substitué ou non substitué, un groupe hétérocycloalcényle en C₁ à C₁₀ substitué ou non substitué, un groupe aryle en C₆ à C₆₀ substitué ou non substitué, un groupe aryloxy en C₆ à C₆₀ substitué ou non substitué, un groupe hétéroaryle en C₁ à C₆₀ substitué ou non substitué, un groupe polycyclique condensé non aromatique monovalent substitué ou non substitué, un groupe hétéropolycyclique condensé non aromatique monovalent substitué ou non substitué, et -Si(Q₅₁)(Q₅₂)(Q₅₃), et au moins un des substituants du groupe alkyle en C₁ à C₆₀ substitué, du groupe alcényle en C₂ à C₆₀ substitué, du groupe alcynyle en C₂ à C₆₀ substitué, du groupe alcoxy en C₁ à C₆₀ substitué, du groupe cycloalkyle en C₃ à C₁₀ substitué, du groupe hétérocycloalkyle en C₁ à C₁₀ substitué, du groupe cycloalcényle en C₃ à C₁₀ substitué, du groupe hétérocycloalcényle en C₁ à C₁₀ substitué, du groupe aryle en C₆ à C₆₀ substitué, du groupe aryloxy en C₆ à C₆₀ substitué, du groupe arylthio en C₆ à C₆₀ substitué, du groupe arylalkyle en C₇ à C₆₀ substitué, du groupe hétéroaryle en C₁ à C₆₀ substitué, du groupe hétéroaryloxy en C₁ à C₆₀ substitué, du groupe hétéroarylthio en C₁ à C₆₀ substitué, du groupe hétéroarylalkyle en C₂ à C₆₀ substitué, du groupe polycyclique condensé non aromatique monovalent substitué, et du groupe hétéropolycyclique condensé non aromatique monovalent substitué est sélectionné parmi :
un deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁ à C₆₀, un groupe alcényle en C₂ à C₆₀, un groupe alcynyle en C₂ à C₆₀, et un groupe alcoxy en C₁ à C₆₀ ;
un groupe alkyle en C₁ à C₆₀, un groupe alcényle en C₂ à C₆₀, un groupe alcynyle en C₂ à C₆₀, et un groupe alcoxy en C₁ à C₆₀, chacun substitué avec au moins un sélectionné parmi un deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en en C₆ à C₆₀, un groupe aryloxy en C₆ à C₆₀, un groupe arylthio en C₆ à C₆₀, un groupe arylalkyle en C₇ à C₆₀, un groupe hétéroaryle en C₁ à C₆₀, un groupe hétéroaryloxy en C₁ à C₆₀, un groupe hétéroarylthio en C₁ à C₆₀, un groupe hétéroarylalkyle en C₂ à C₆₀, un groupe polycyclique condensé non aromatique monovalent, un groupe hétéropolycyclique condensé non aromatique monovalent, -N(Q₁₁)(Q₁₂), -B(Q₁₃)(Q₁₄), et -P(=O)(Q₁₅)(Q₁₆) ;
un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe arylalkyle en C₇ à C₆₀, un groupe hétéroaryle en C₁ à C₆₀, un groupe hétéroaryloxy en C₁ à C₆₀, un groupe hétéroarylthio en C₁ à C₆₀, un groupe hétéroarylalkyle en C₂ à C₆₀, un groupe polycyclique condensé non aromatique monovalent, et un groupe hétéropolycyclique condensé non aromatique monovalent ;
un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe arylalkyle en C₇ à C₆₀, un groupe hétéroaryle en C₁ à C₆₀, un groupe hétéroaryloxy en C₁ à C₆₀, un groupe hétéroarylthio en C₁ à C₆₀, un groupe hétéroarylalkyle en C₂ à C₆₀, un groupe polycyclique condensé non aromatique monovalent, et un groupe hétéropolycyclique condensé non aromatique monovalent, chacun substitué avec au moins un sélectionné parmi un deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁ à C₆₀, un groupe alcényle en C₂ à C₆₀, un groupe alcynyle en C₂ à C₆₀, un groupe alcoxy en C₁ à C₆₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe aryloxy en C₆ à C₆₀, un groupe arylthio en C₆ à C₆₀, un groupe arylalkyle en C₇ à C₆₀, un groupe hétéroaryle en C₁ à C₆₀, un groupe hétéroaryloxy en C₁ à C₆₀, un groupe hétéroarylthio en C₁ à C₆₀, un groupe hétéroarylalkyle en C₂ à C₆₀, un groupe polycyclique condensé non aromatique monovalent, un groupe hétéropolycyclique condensé non aromatique monovalent, -N(Q₂₁)(Q₂₂), -B(Q₂₃)(Q₂₄), et -P(=Q)(Q₂₅)(Q₂₆) ;
et -N(Q₃₁)(Q₃₂), -B(Q₃₃)(Q₃₄), et -P(=O)(Q₃₅)(Q₃₆), dans lequel Q₁ à Q₆, Q₁₁ à Q₁₆, Q₂₁ à Q₂₆, Q₃₁ à Q₃₆, et Q₅₁ à Q₅₃ sont chacun indépendamment sélectionnés parmi un hydrogène, un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁ à C₆₀ substitué ou non substitué, un groupe alcényle en C₂ à C₆₀ substitué ou non substitué, un groupe alcynyle en C₂ à C₆₀ substitué ou non substitué, un groupe alcoxy en C₁ à C₆₀ substitué ou non substitué, un groupe cycloalkyle en C₃ à C₁₀ substitué ou non substitué, un groupe hétérocycloalkyle en C₁ à C₁₀ substitué ou non substitué, un groupe cycloalcényle en C₃ à C₁₀ substitué ou non substitué, un groupe hétérocycloalcényle en C₁ à C₁₀ substitué ou non substitué, un groupe aryle en C₆ à C₆₀ substitué ou non substitué, un groupe aryloxy en C₆ à C₆₀ substitué ou non substitué, un groupe arylthio en C₆ à C₆₀ substitué ou non substitué, un groupe arylalkyle en C₇ à C₆₀ substitué ou non substitué, un groupe hétéroaryle en C₁ à C₆₀ substitué ou non substitué, un groupe hétéroaryloxy en C₁ à C₆₀ substitué ou non substitué, un groupe hétéroarylthio en C₁ à C₆₀ substitué ou non substitué, un groupe hétéroarylalkyle en C₂ à C₆₀ substitué ou non substitué, un groupe polycyclique condensé non aromatique monovalent substitué ou non substitué, et un groupe hétéropolycylique condensé non aromatique monovalent substitué ou non substitué.

2. Composé organométallique selon la revendication 1, dans lequel dans la Formule 1, M est Ir et la somme de n1 et n2 est 3 ; ou M est Pt et la somme de n1 et n2 est 2, et le composé organométallique est neutre.

3. Composé organométallique selon la revendication 1 ou 2, dans lequel CY₁ dans la Formule 2A est sélectionné parmi un benzène, un indène, un naphtalène, un azulène, un heptalène, un indacène, un acénaphtylène, un fluorène, un spirofluorène, un benzofluorène, un dibenzofluorène, un phénalène, un phénanthrène, un anthracène, un fluoranthène, un triphénylène, un pyrène, un chrysène, un naphtacène, un picène, un pérylène, un pentacène, un hexacène, un pentaphène, un rubicène, un coronène, un ovalène, un isoindole, un indole, un indazole, une purine, une quinoline, une isoquinoline, une benzoquinoline, une phtalazine, une naphtyridine, une quinoxaline, une quinazoline, une cinnoline, une phénanthridine, une acridine, une phénanthroline, une phénazine, un benzoimidazole, un benzofurane, un benzothiophène, un isobenzothiazole, un benzoxazole, un isobenzoxazole, un benzocarbazole, un dibenzocarbazole, une imidazopyridine, une imidazopyrimidine, un dibenzofurane, un dibenzothiophène, une dibenzothiophène sulfone, un carbazole, et un dibenzosilole, et, CY₂ dans la Formule 2B est sélectionné parmi un benzène, un indène, un naphtalène, un azulène, un heptalène, un indacène, un acénaphtylène, un fluorène, un spirofluorène, un benzofluorène, un dibenzofluorène, un phénalène, un phénanthrène, un anthracène, un fluoranthène, un triphénylène, un pyrène, un chrysène, un naphtacène, un picène, un pérylène, un pentacène, un hexacène, un pentaphène, un rubicène, un coronène, un ovalène, un isoindole, un indole, un indazole, une purine, une quinoline, une isoquinoline, une benzoquinoline, une phtalazine, une naphtyridine, une quinoxaline, une quinazoline, une cinnoline, une phénanthridine, une acridine, une phénanthroline, une phénazine, un benzoimidazole, un benzofurane, un benzothiophène, un isobenzothiazole, un benzoxazole, un isobenzoxazole, un benzocarbazole, un dibenzocarbazole, une imidazopyridine, et une imidazopyrimidine, préférablement, dans lequel :
CY₁ dans la Formule 2A est sélectionné parmi un benzène, un naphtalène, un fluorène, un dibenzofurane, un dibenzothiophène, une dibenzothiophène sulfone, un carbazole, et un dibenzosilole, et CY₂ dans la Formule 2B est un benzène.

4. Composé organométallique selon l'une quelconque des revendications 1 à 3, dans lequel R₁₁ à R₁₅ dans la Formule 2A sont chacun indépendamment sélectionnés parmi un hydrogène, un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, -SF₅, un groupe alkyle en C₁ à C₂₀, et un groupe alcoxy en C₁ à C₂₀;
un groupe alkyle en C₁ à C₂₀ et un groupe alcoxy en C₁ à C₂₀, chacun substitué avec au moins un sélectionné parmi un deutérium, -F, -Cl, -Br, -I, -CD₃, -CD₂H, -CDH₂, -CF₃, -CF₂H,-CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁ à C₁₀, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe pyridinyle, et un groupe pyrimidinyle ;
un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzoimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle, et un groupe imidazopyrimidinyle ;
un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzoimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle, et un groupe imidazopyrimidinyle, chacun substitué avec au moins un sélectionné parmi un deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁ à C₂₀, un groupe alcoxy en C₁ à C₂₀, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzoimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle, et un groupe imidazopyrimidinyle ;
et -Si(R₁)(R₂)(R₃), -B(Q₃)(Q₄), et -P(=Q)(Q₅)(Q₆), et R₂₁ à R₂₄ dans la Formule 2B sont chacun indépendamment sélectionnés parmi un hydrogène, un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, -SF₅, un groupe alkyle en C₁ à C₂₀, et un groupe alcoxy en C₁ à C₂₀;
un groupe alkyle en C₁ à C₂₀, et un groupe alcoxy en C₁ à C₂₀, chacun substitué avec au moins un sélectionné parmi un deutérium, -F, -Cl, -Br, -I, -CD₃, -CD₂H, -CDH₂, -CF₃, -CF₂H,-CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁ à C₁₀, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe pyridinyle, et un groupe pyrimidinyle ;
un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzoimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle, et un groupe imidazopyrimidinyle ;
un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzoimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle, et un groupe imidazopyrimidinyle, chacun substitué avec au moins un sélectionné parmi un deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁ à C₂₀, et un groupe alcoxy en C₁ à C₂₀, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzoimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle, et un groupe imidazopyrimidinyle ;
et -B(Q₃)(Q₄) et -P(=O)(Q₅)(Q₆), dans lequel Q₃ à Q₆ sont chacun indépendamment sélectionnés parmi -CH₃, -CD₃, -CD₂H, -CDH₂, -CH₂CH₃, -CH₂CD₃, -CH₂CD₂H, -CH₂CDH₂,-CHDCH₃, -CHDCD₂H, -CHDCDH₂, -CHDCD₃, -CD₂CD₃, -CD₂CD₂H, et -CD₂CDH₂ ; un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle, et un groupe naphtyle ;
et un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle, et un groupe naphtyle, chacun substitué avec au moins un sélectionné parmi un deutérium, un groupe alkyle en C₁ à C₁₀, et un groupe phényle, préférablement dans lequel :
R₁₁ à R₁₅ dans la Formule 2A sont chacun indépendamment sélectionnés parmi un hydrogène, un deutérium, -F, un groupe cyano, un groupe nitro, -SF₅, -CH₃, -CD₃, -CD₂H, -CDH₂, -CF₃, - CF₂H, -CFH₂, des groupes représentés par les Formules 9-1 à 9-19, des groupes représentés par les Formules 10-1 à 10-36, et -Si(R₁)(R₂)(R₃), et
R₂₁ à R₂₄ dans la Formule 2B sont chacun indépendamment sélectionnés parmi un hydrogène, un deutérium, -F, un groupe cyano, un groupe nitro, -SF₅, -CH₃, -CD₃, -CD₂H, -CDH₂, -CF₃, - CF₂H, -CFH₂, des groupes représentés par les Formules 9-1 à 9-19, et des groupes représentés par les Formules 10-1 à 10-36 : 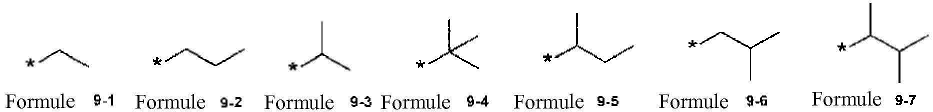 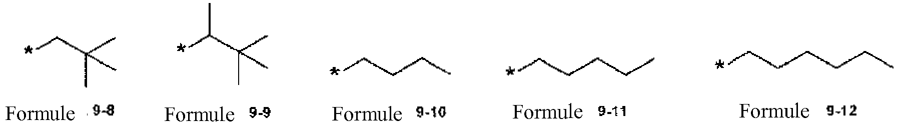 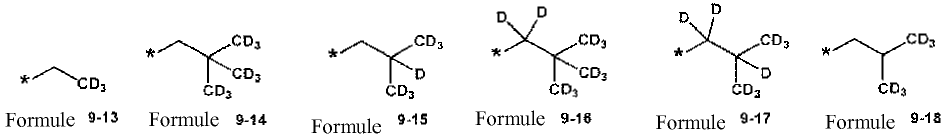 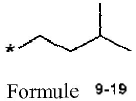 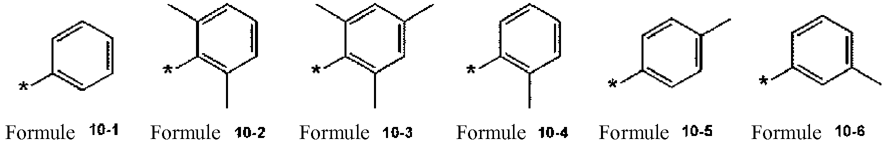 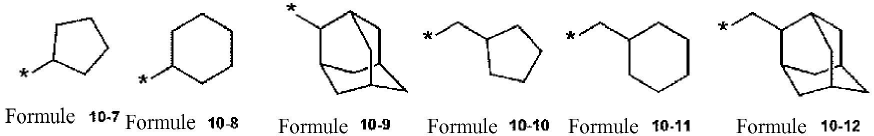 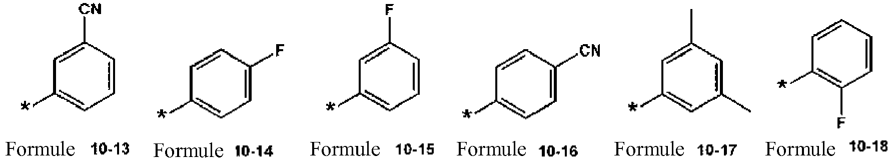 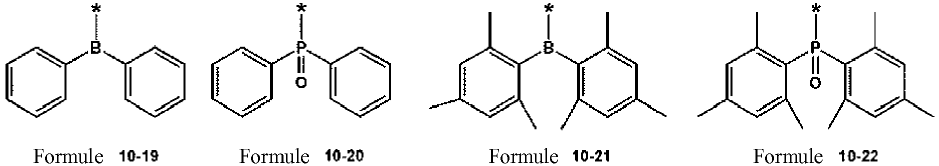 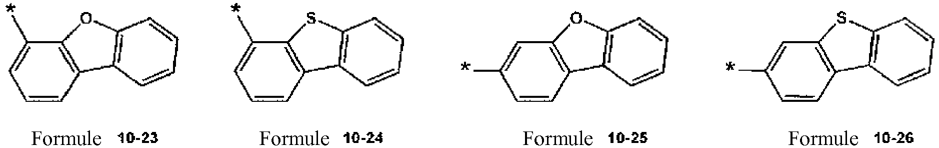 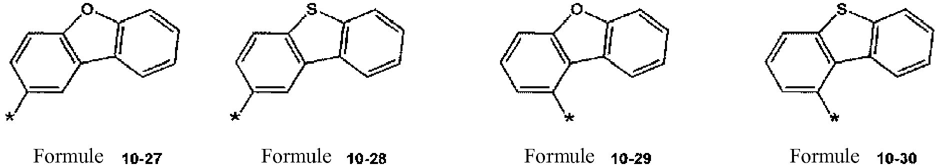 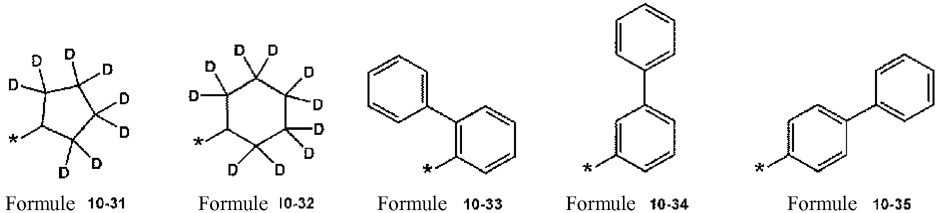 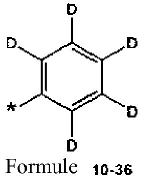 * dans les Formules 9-1 à 9-19 et 10-1 à 10-36 indique un site de liaison à un atome voisin.

5. Composé organométallique selon l'une quelconque des revendications 1 à 4, dans lequel R₂₂ dans la Formule 2B n'est pas un hydrogène.

6. Composé organométallique selon l'une quelconque des revendications 1 à 5, dans lequel R₁ à R₃ dans -Si(R₁)(R₂)(R₃) de la Formule 2A et R₄ à R₆ dans la Formule 2B sont chacun indépendamment sélectionnés parmi un hydrogène, un deutérium, -CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, - CD₂CD₂H, et -CD₂CDH₂ ;
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle, un groupe naphtyle, et -Si(Q₅₁)(Q₅₂)(Q₅₃) ;
et un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle, et un groupe naphtyle, chacun substitué avec au moins un sélectionné parmi un deutérium, un groupe alkyle en C₁ à C₁₀, et un groupe phényle,
dans lequel Q₅₁ à Q₅₃ sont chacun indépendamment sélectionnés parmi un hydrogène, un deutérium, -CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, - CD₂CD₂H, et -CD₂CDH₂ ;
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle, et un groupe naphtyle ; et un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle, et un groupe naphtyle, chacun substitué avec au moins un sélectionné parmi un deutérium, un groupe alkyle en C₁ à C₁₀, et un groupe phényle, préférablement dans lequel :
R₁ à R₃ dans -Si(R₁)(R₂)(R₃) de Formule 2A et R₄ à R₆ dans la Formule 2B sont chacun indépendamment sélectionnés parmi -CH₃, -CD₃, -CD₂H, -CDH₂, un groupe phényle, des groupes représentés par les Formules 9-1 à 9-19, et des groupes représentés par les Formules 10-1 à 10-18 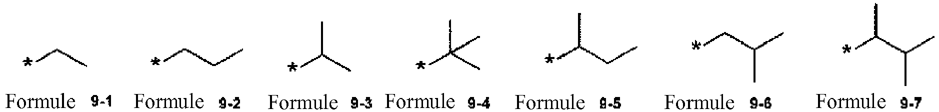 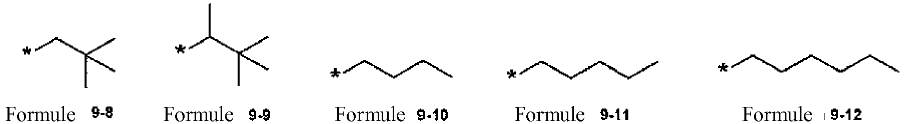 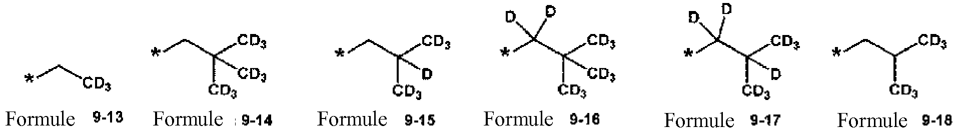 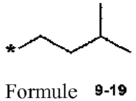 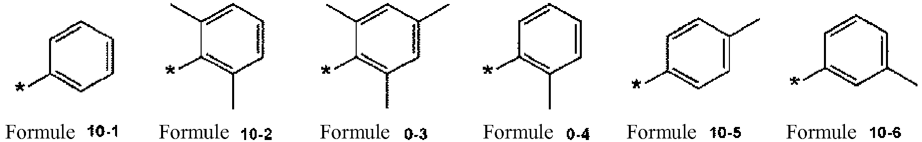 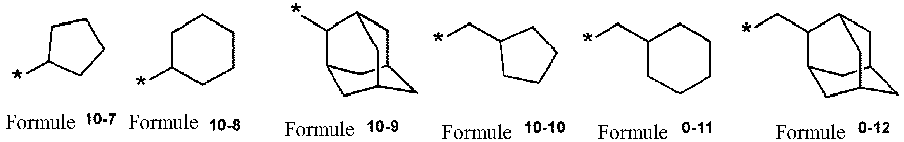 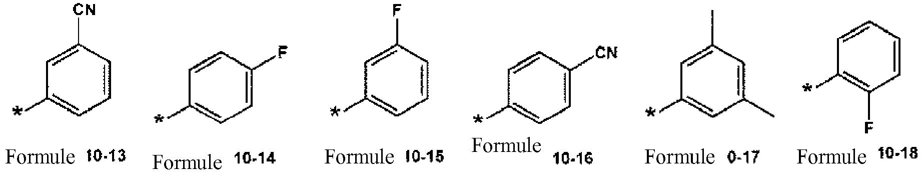
dans lequel * dans les Formules 9-1 à 9-19 et 10-1 à 10-18 indique un site de liaison à un atome voisin,
dans lequel dans -Si(R₁)(R₂)(R₃) de Formule 2A, tous les R₁ à R₃ sont les mêmes ;
ou R₁ et R₃ sont identiques l'un à l'autre, et R₂ est différent de R₁, et dans lequel dans la Formule 2B, tous les R₄ à R₆ sont les mêmes ;
ou R₄ et R₆ sont identiques l'un à l'autre, et R₅ est différent de R₄.

7. Composé organométallique selon l'une quelconque des revendications 1 à 6, dans lequel L₁ est sélectionné parmi des ligands représentés par les Formules 2A-1 à 2A-5 : 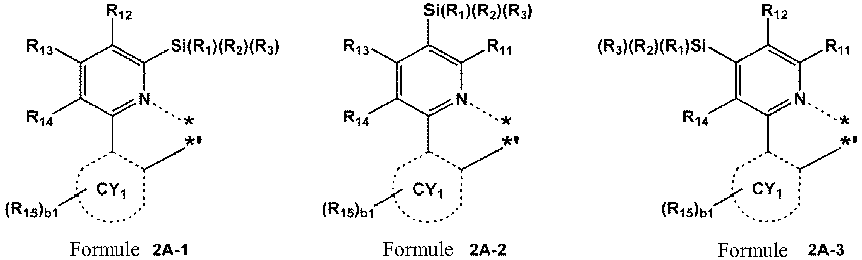 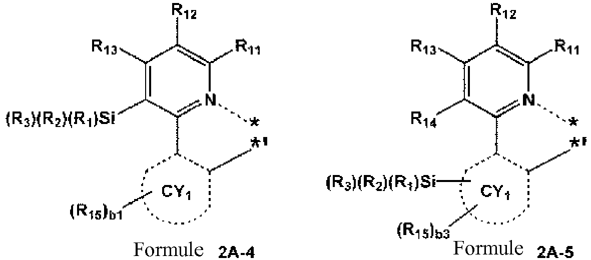 dans les Formules 2A-1 à 2A-5, CY₁, R₁₁ à R₁₅, b1, et R₁ à R₃ sont les mêmes que dans la revendication 1, chacun de * et *' indique un site de liaison à M dans la Formule 1, et b3 est un nombre entier sélectionné parmi 0 à 3, préférablement dans lequel :
L₁ est sélectionné parmi des ligands représentés par les Formules 2A(1) à 2A(192) : 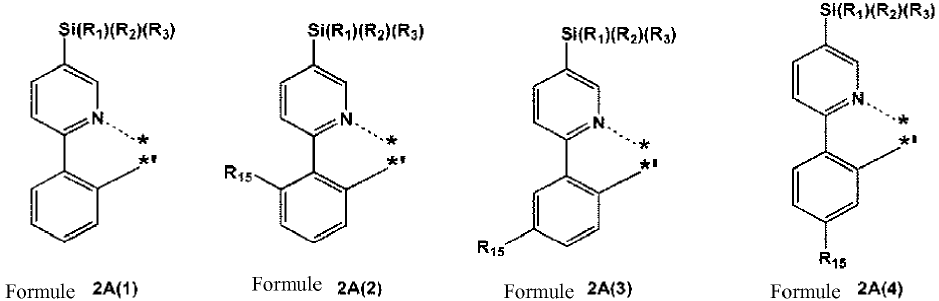 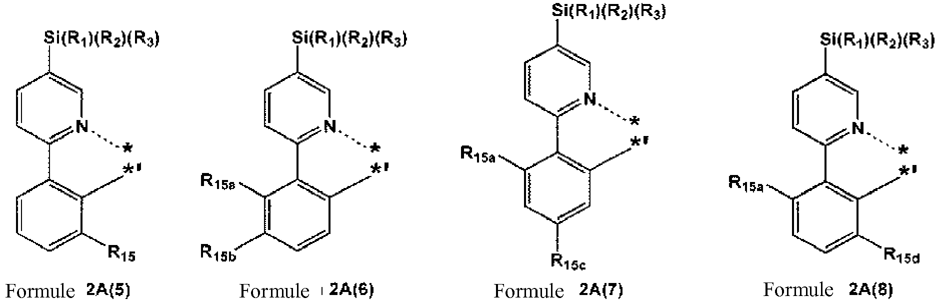 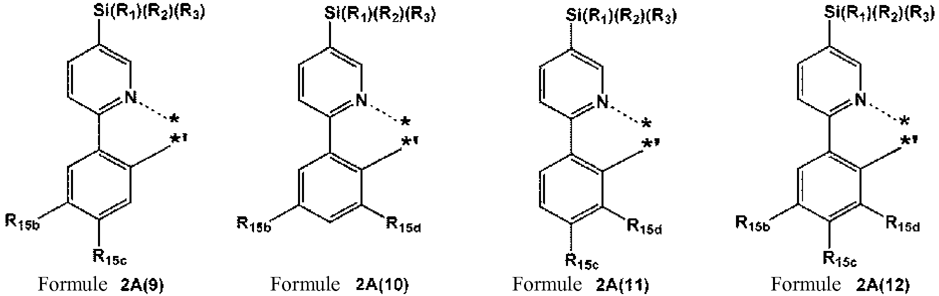 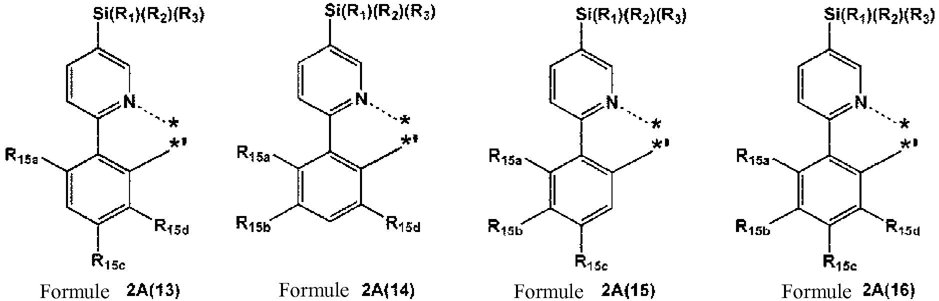 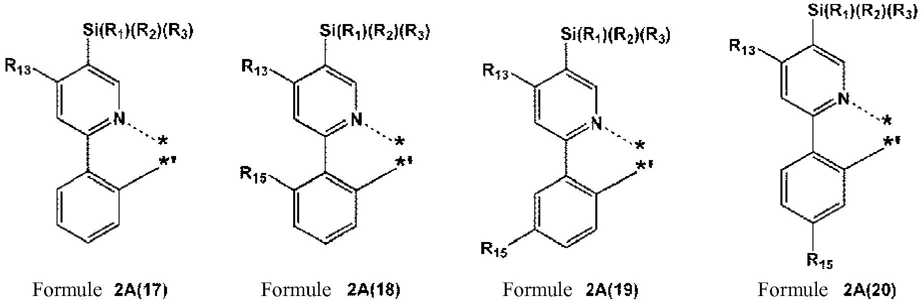 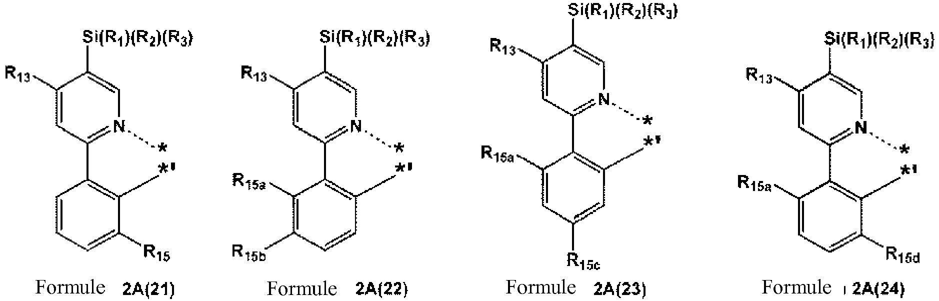 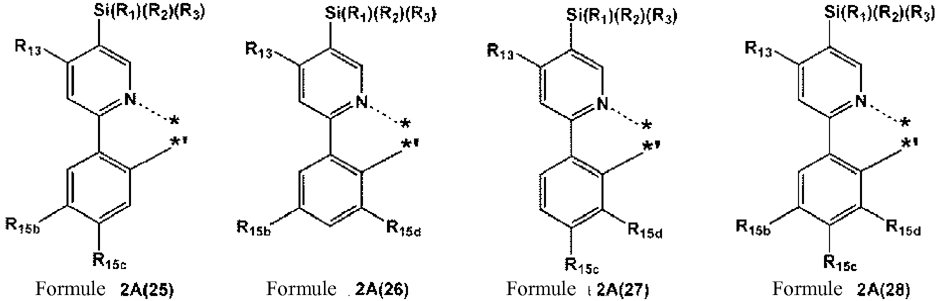 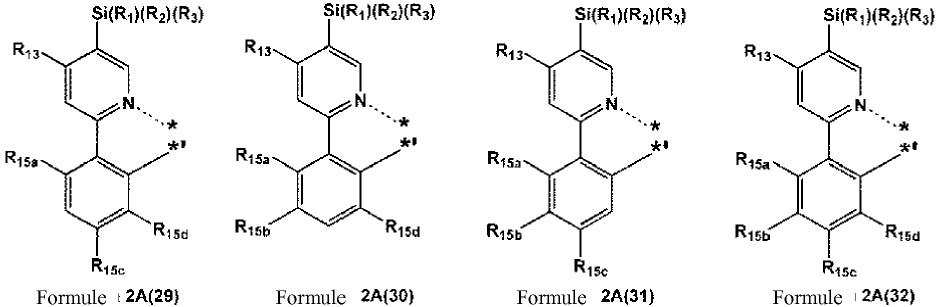 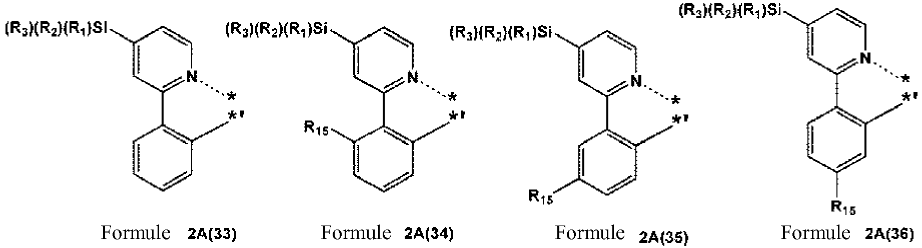 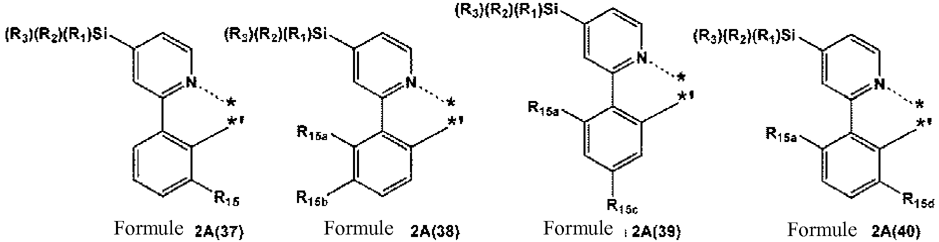 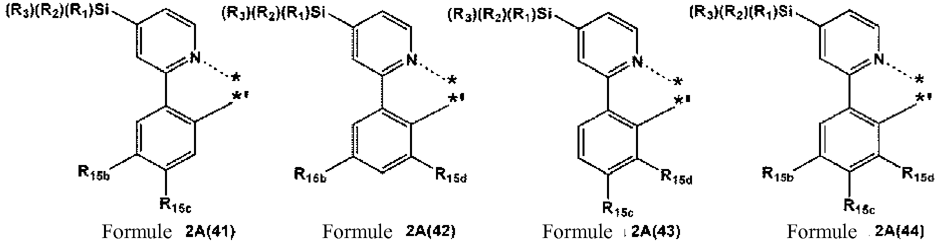 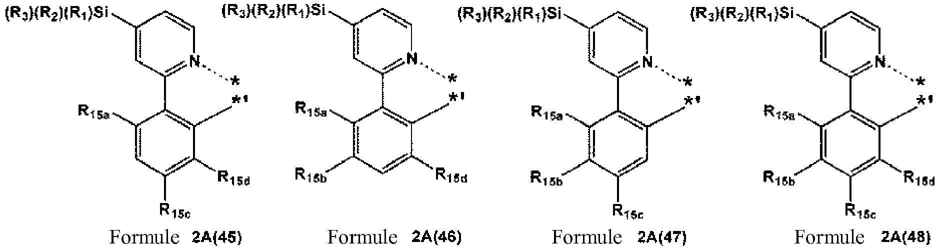 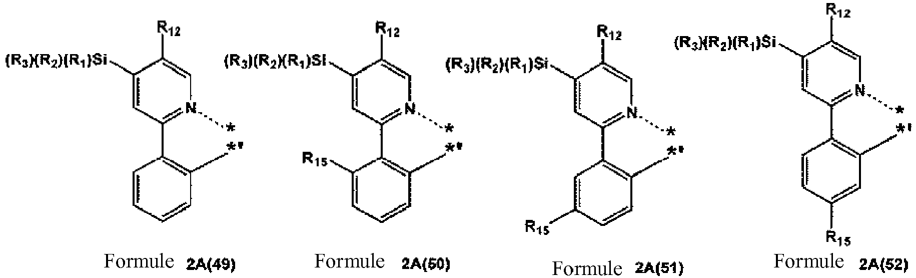 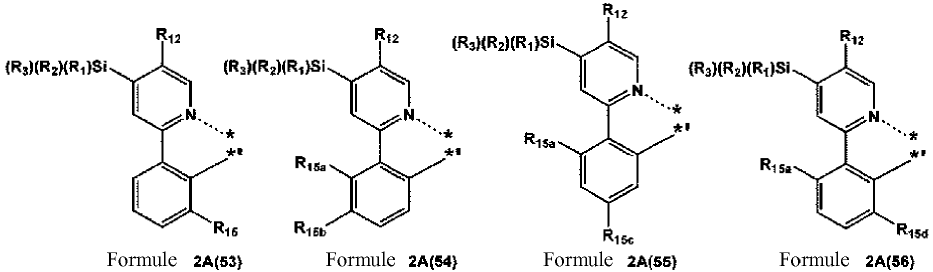 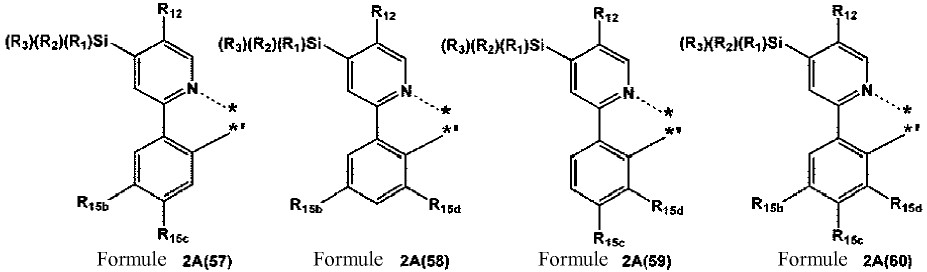 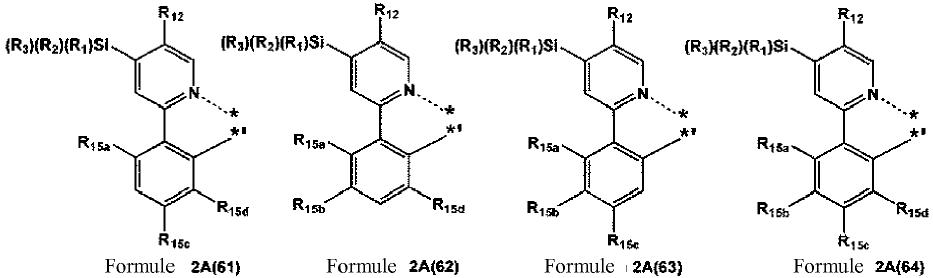 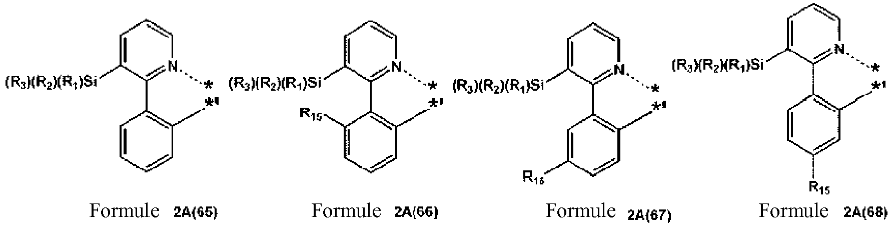 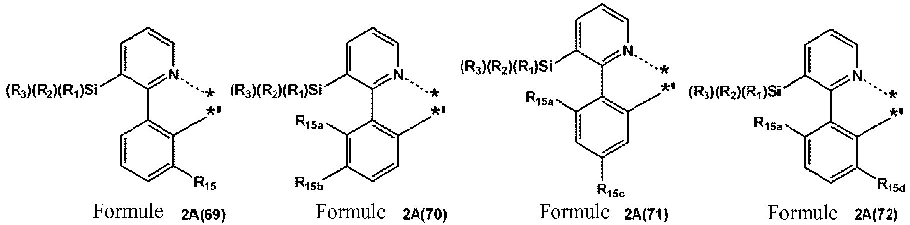 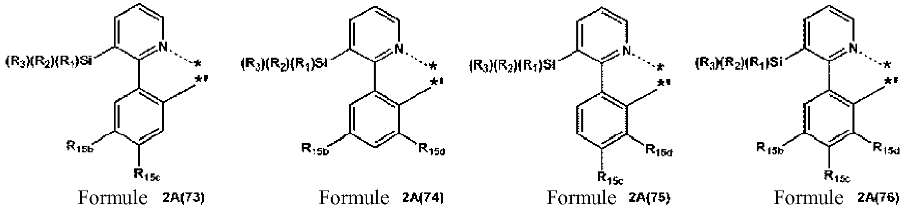 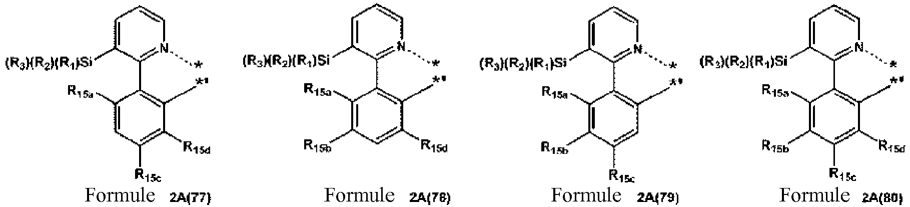 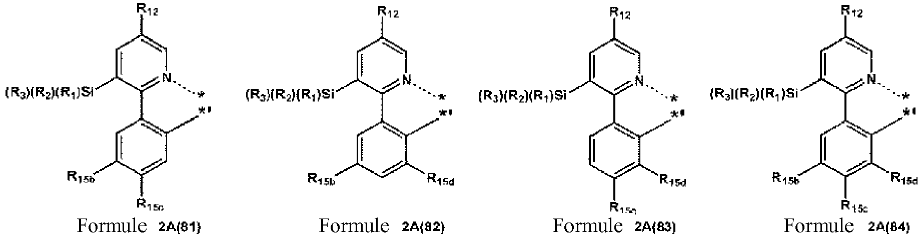 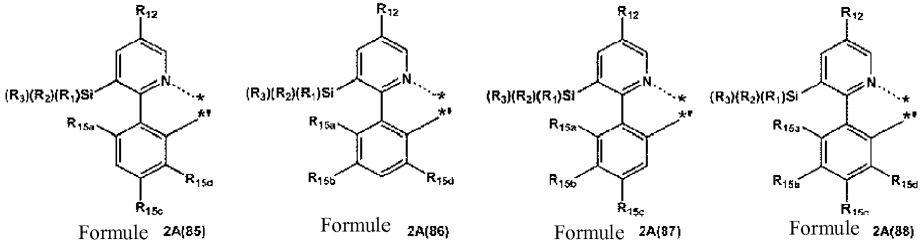 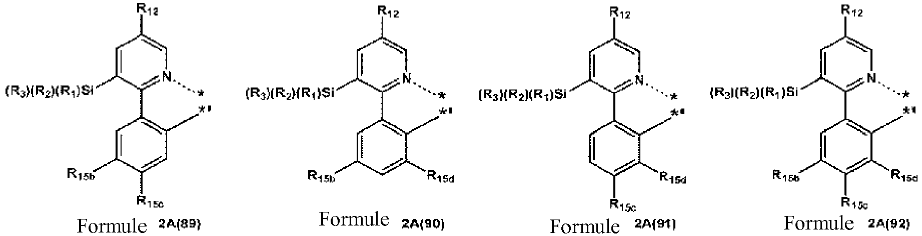 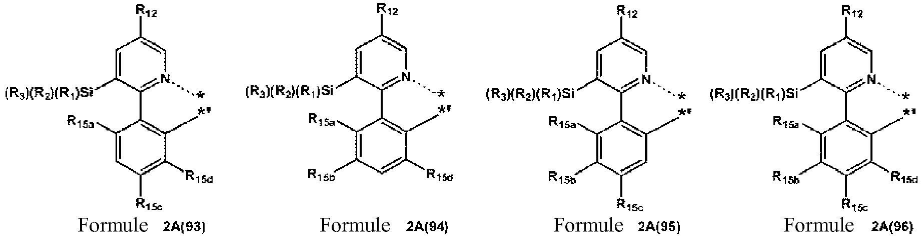 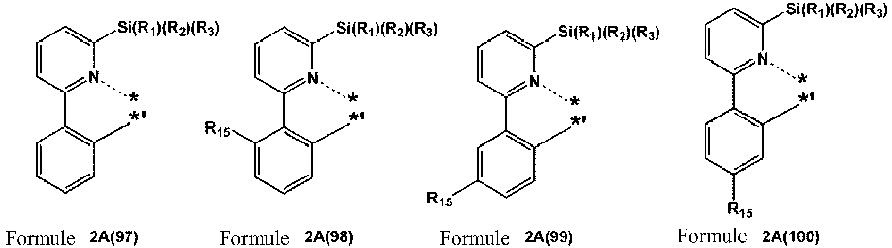 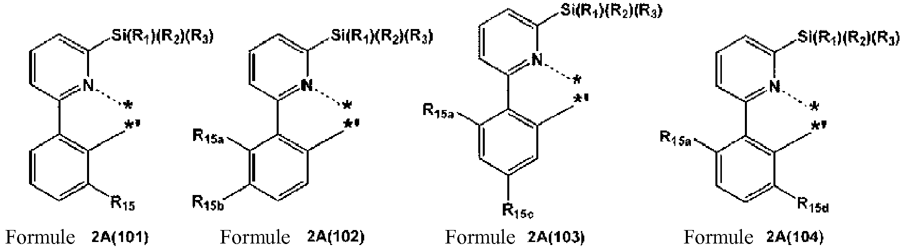 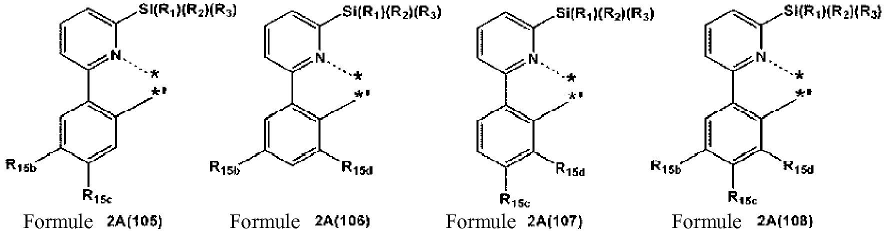 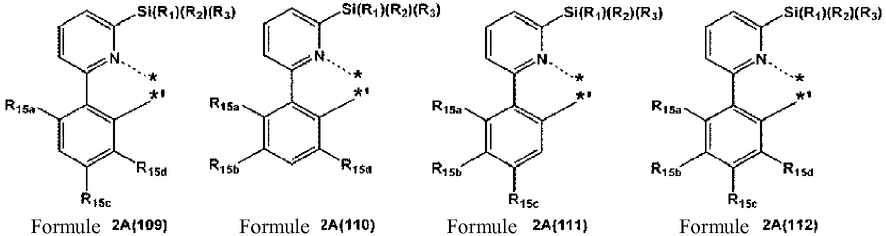 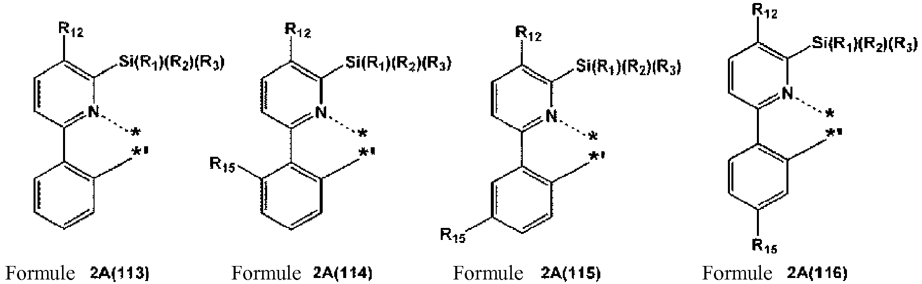 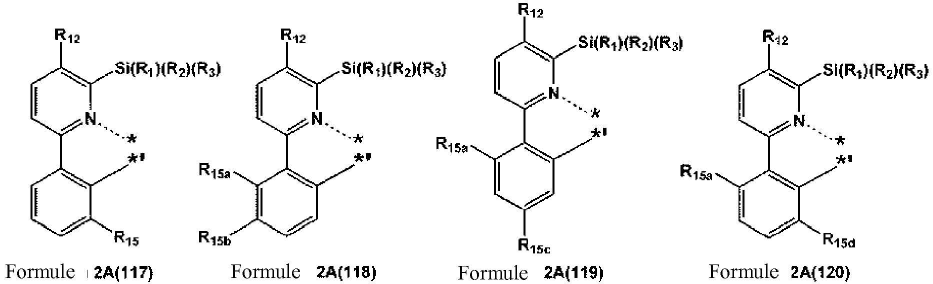 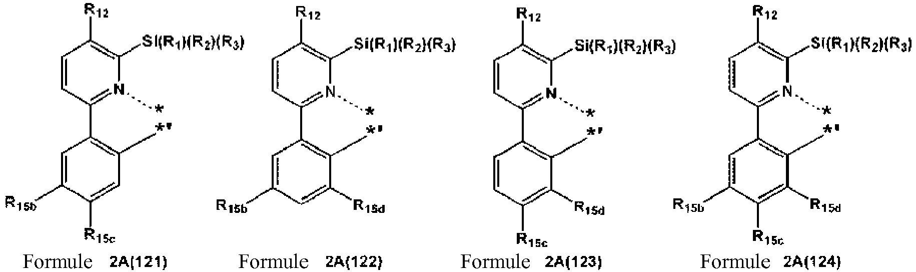 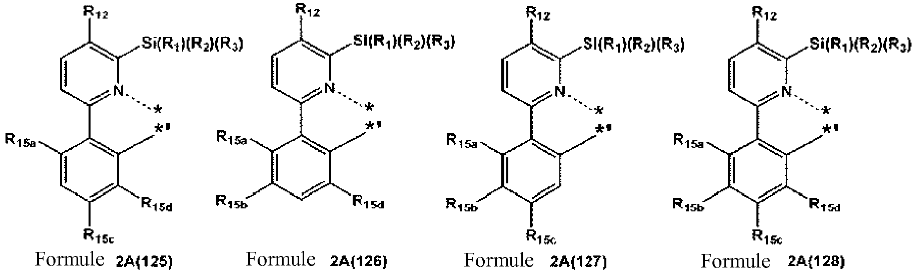 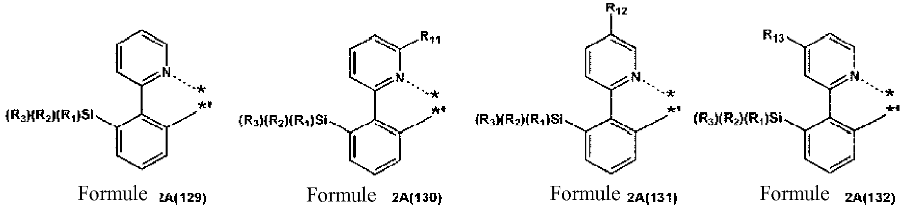 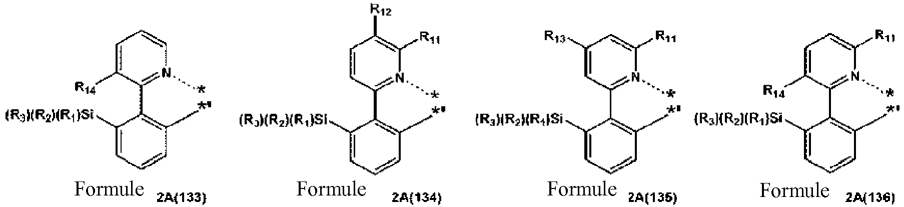 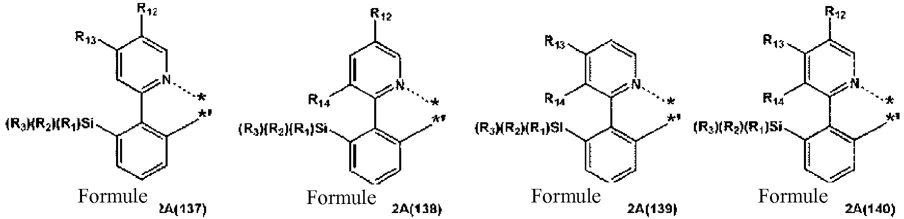 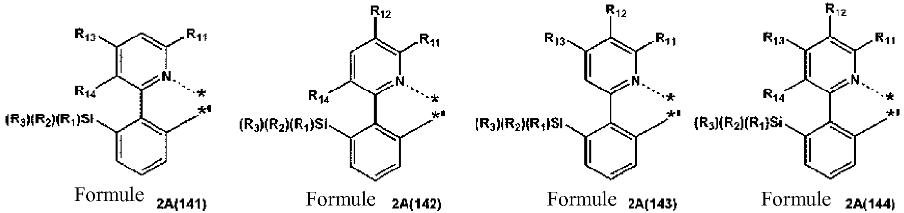 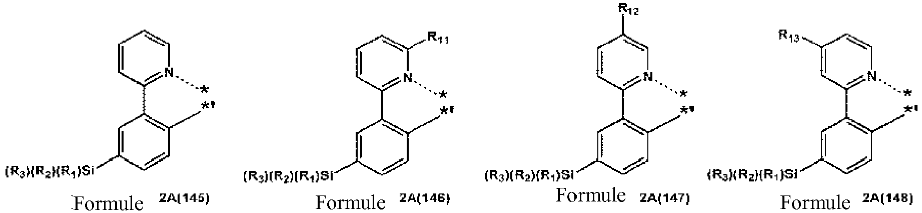 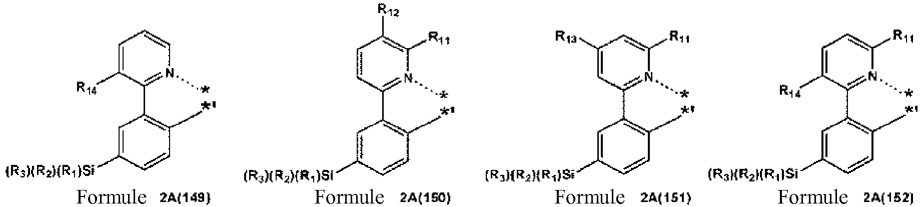 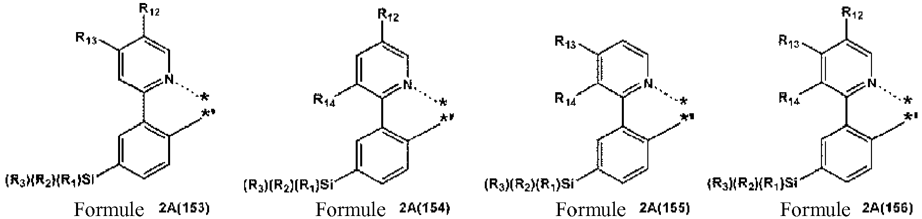 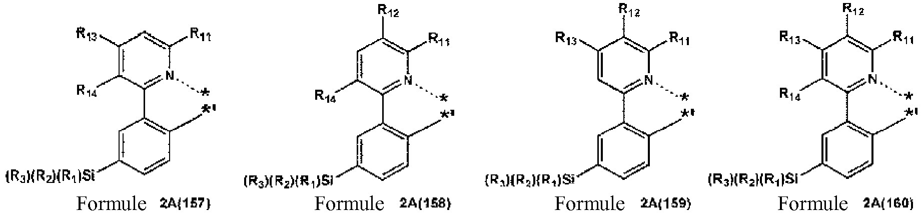 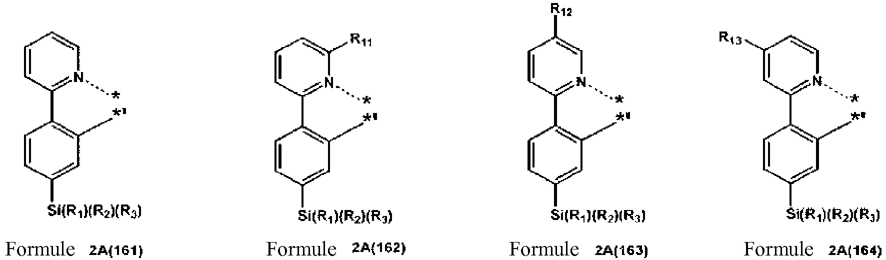 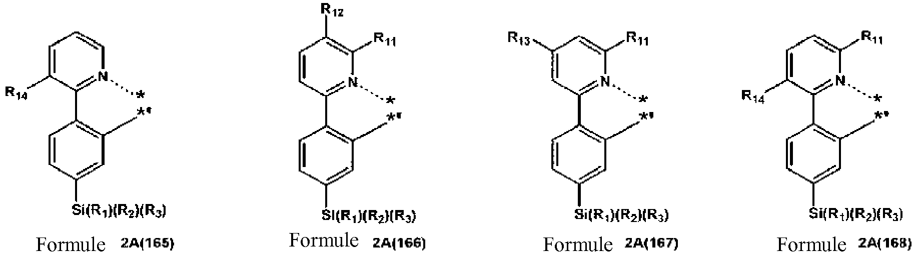 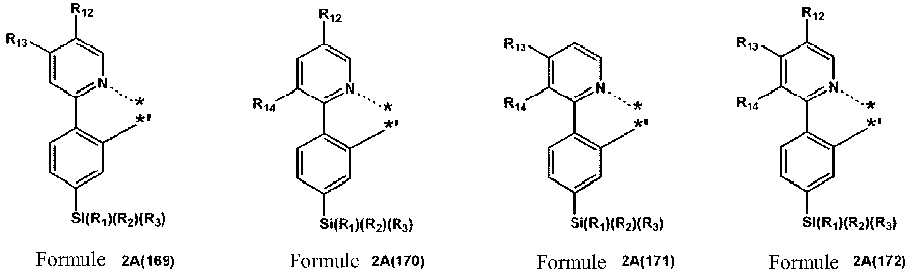 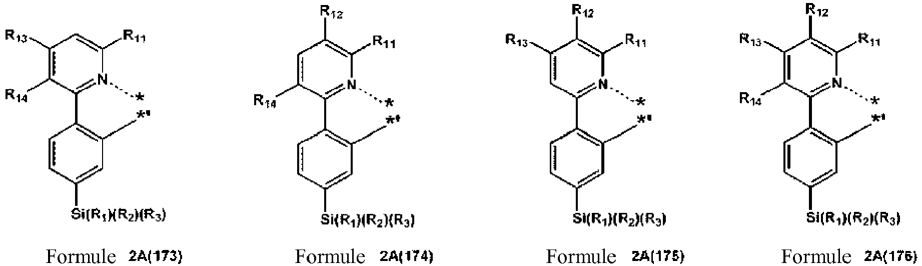 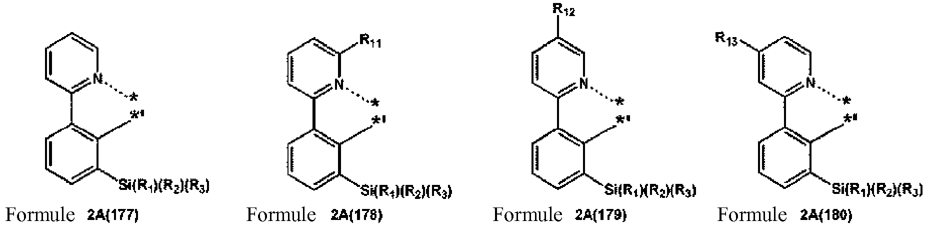 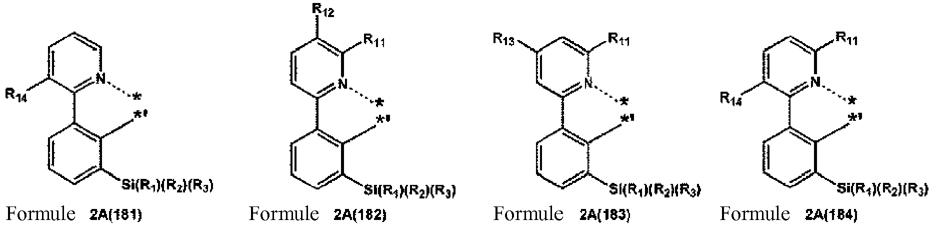 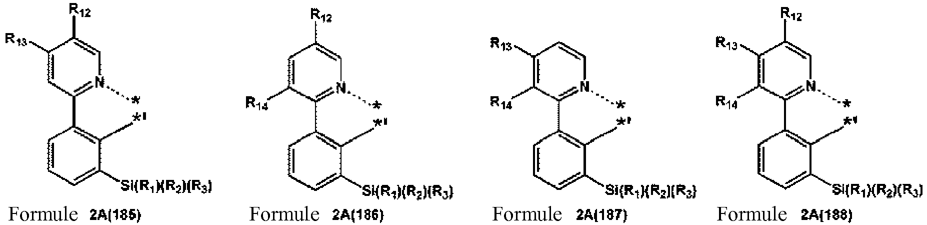 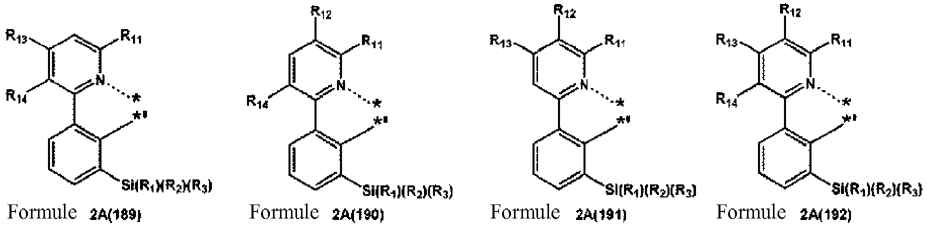 dans les Formules 2A(1) à 2A(192), R₁₁ à R₁₅ et R₁ à R₃ sont les mêmes que ceux énoncés dans la revendication 1, R₁₅ₐ à R_{15d} sont les mêmes que dans la description de R₁₅ dans la revendication 1, et chacun de * et *' indique un site de liaison à M dans la Formule 1, à condition que tous les R₁₁ à R₁₅ et R₁₅ₐ à R_{15d} ne soient pas simultanément un hydrogène.

8. Composé organométallique selon la revendication 7, dans lequel L₁ est sélectionné parmi des ligands représentés par les Formules 2A(1) à 2A(48), 2A(65) à 2A(80), 2A(97) à 2A(112), et 2A(129) à 2A(192), et dans les Formules 2A(1) à 2A(48), 2A(65) à 2A(80), 2A(97) à 2A(112), et 2A(129) à 2A(192), R₁ à R₃ sont chacun indépendamment sélectionnés parmi -CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, et -CD₂CDH₂ ;
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle, et un groupe naphtyle ;
et un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle, et un groupe naphtyle, chacun substitué avec au moins un sélectionné parmi un deutérium, un groupe alkyle en C₁ à C₁₀, et un groupe phényle, tous les R₁ à R₃ sont les mêmes ; ou R₁ et R₃ sont identiques l'un à l'autre, et R₂ est différent de R₁, et R₁₁ à R₁₅ et R₁₅ₐ à R_{15d} sont chacun indépendamment sélectionnés parmi un deutérium, -F, un groupe cyano, un groupe nitro, -SF₅, -CH₃, -CD₃, -CD₂H, -CDH₂, -CF₃, -CF₂H, -CFH₂, des groupes représentés par les Formules 9-1 à 9-19, et des groupes représentés par les Formules 10-1 à 10-36 : 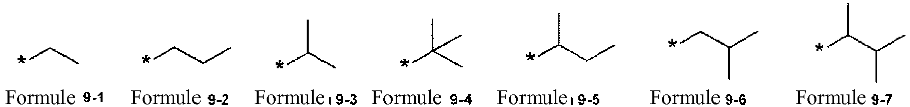 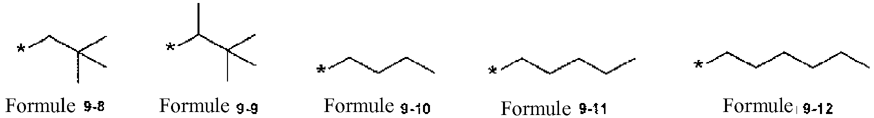 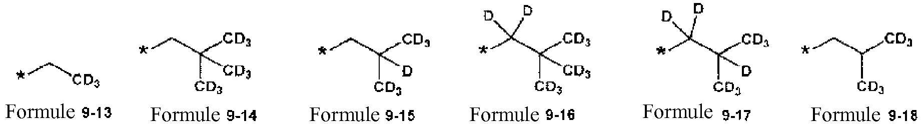 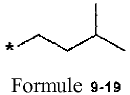 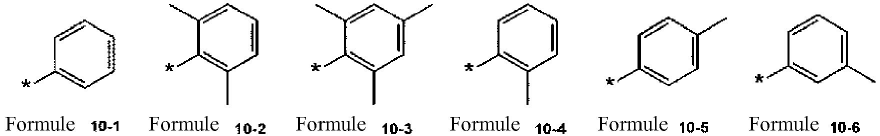 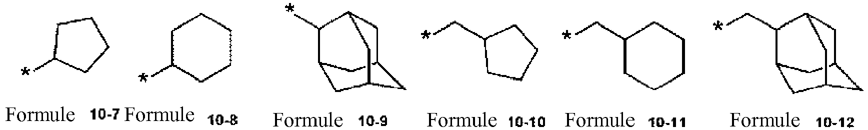 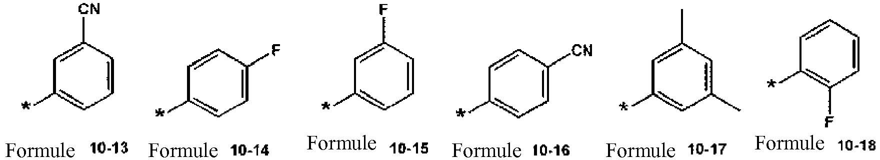 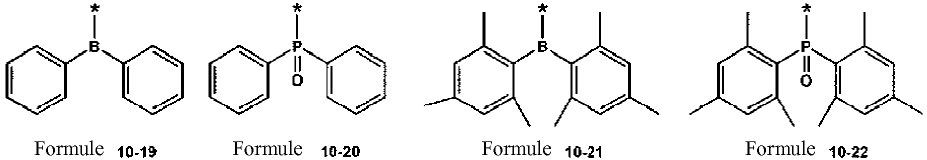 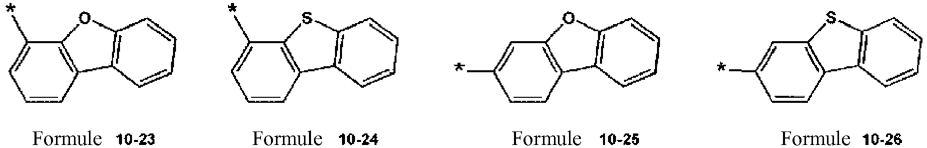 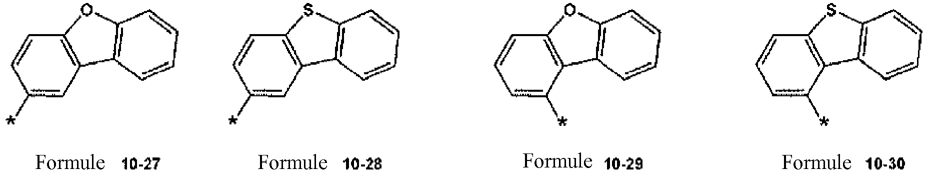 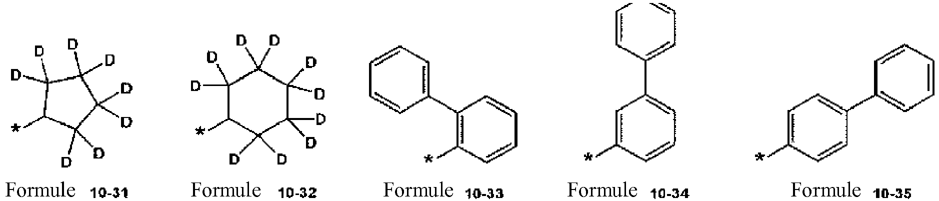 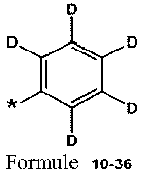 * dans les Formules 9-1 à 9-19 et 10-1 à 10-36 indique un site de liaison à un atome voisin.

9. Composé organométallique selon l'une quelconque des revendications 1 à 8, dans lequel L₂ est sélectionné parmi des ligands représentés par les Formules 2B-1 à 2B-14 : 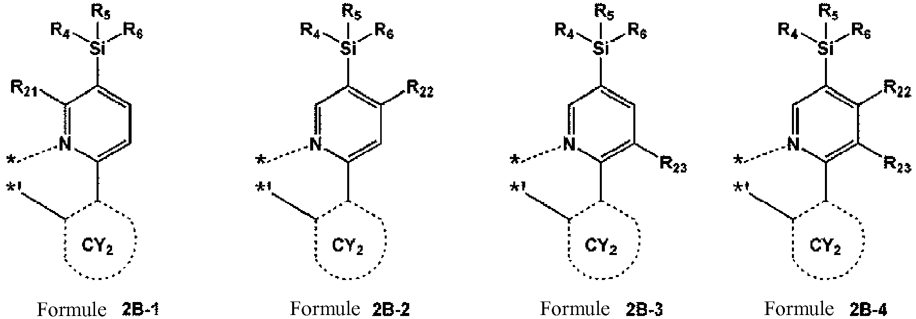 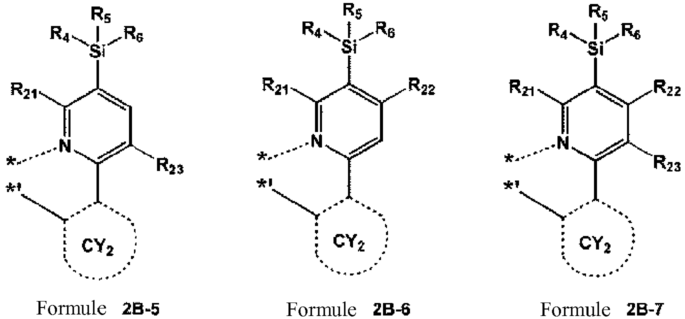 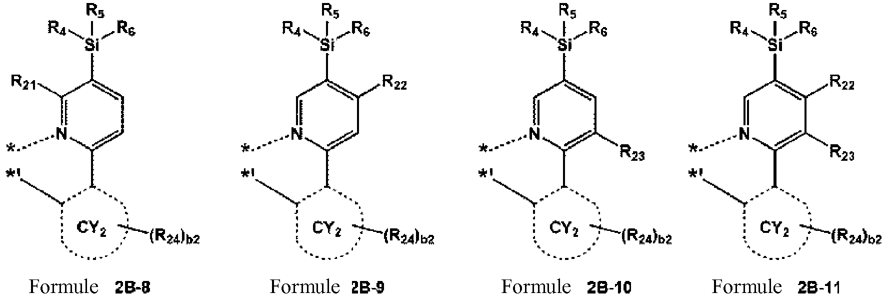 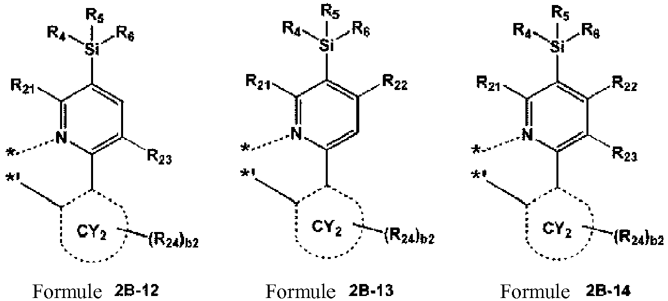 dans les Formules 2B-1 à 2B-14, CY₂, R₂₁ à R₂₄, R₄ à R₆, et b2 sont les mêmes que dans la revendication 1, et chacun de * et *' indique un site de liaison à M dans la Formule 1, à condition que tous les R₂₁ à R₂₄ ne soient pas simultanément un hydrogène, préférablement dans lequel :
L₂ est sélectionné parmi des ligands représentés par les Formules 2B(1) à 2B(96) : 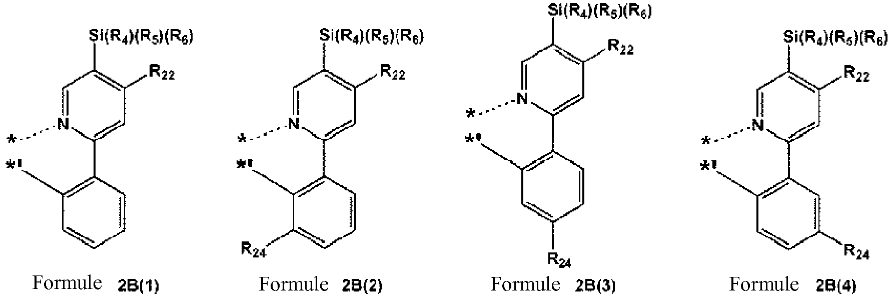 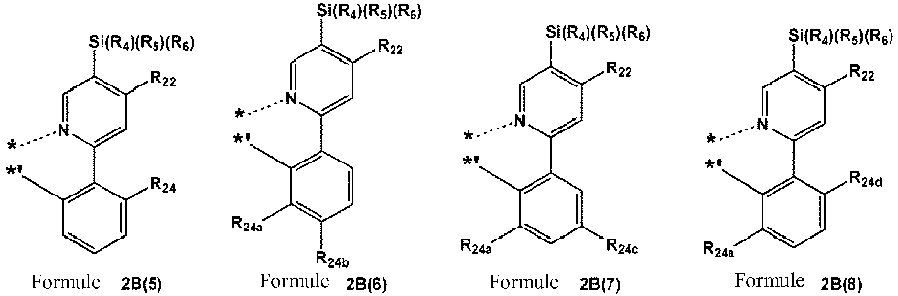 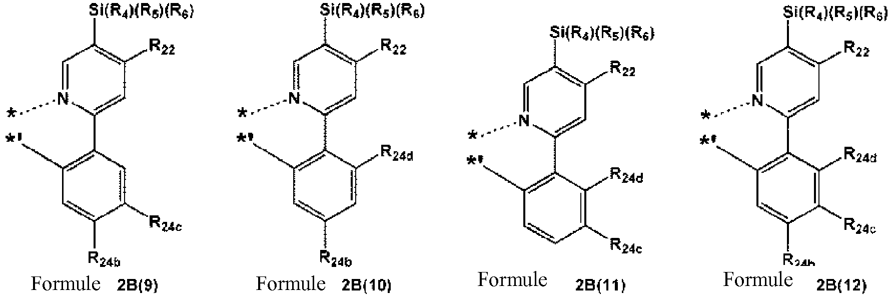 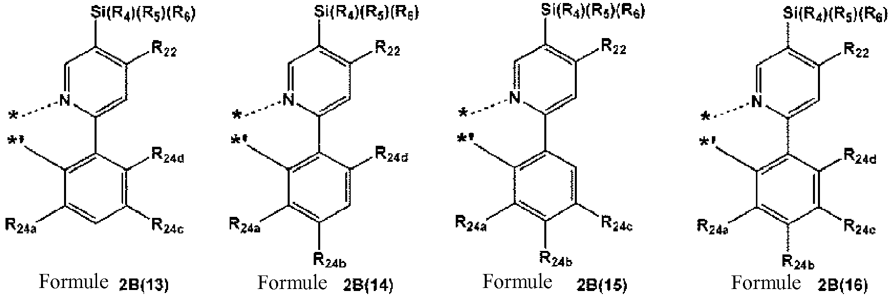 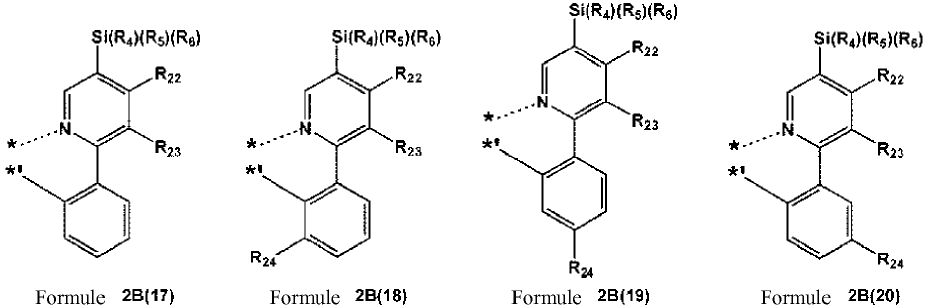 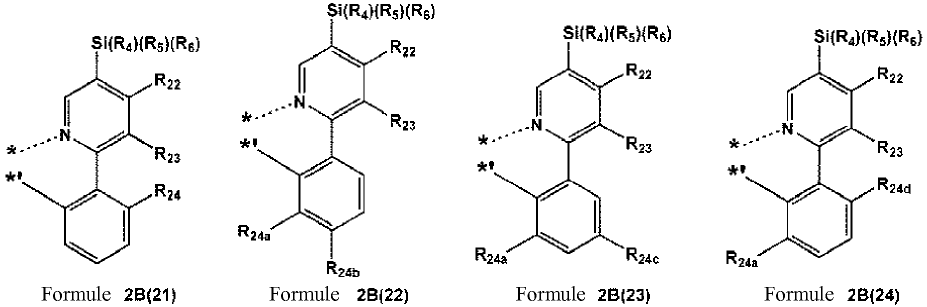 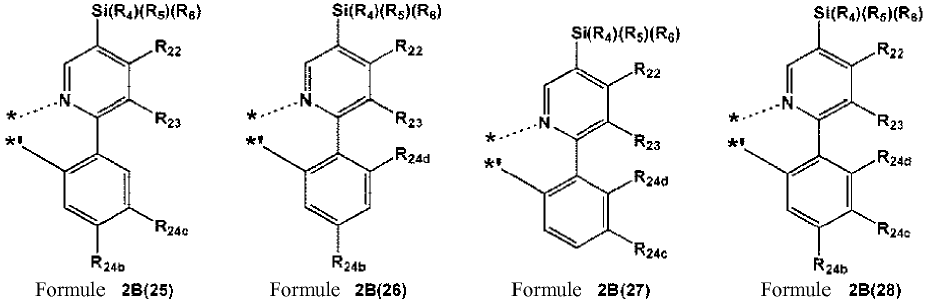 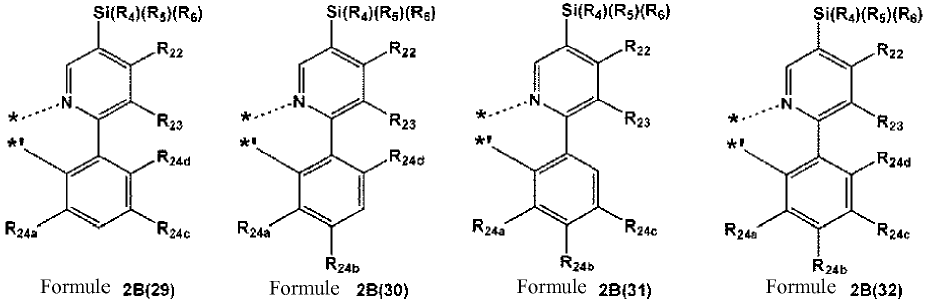 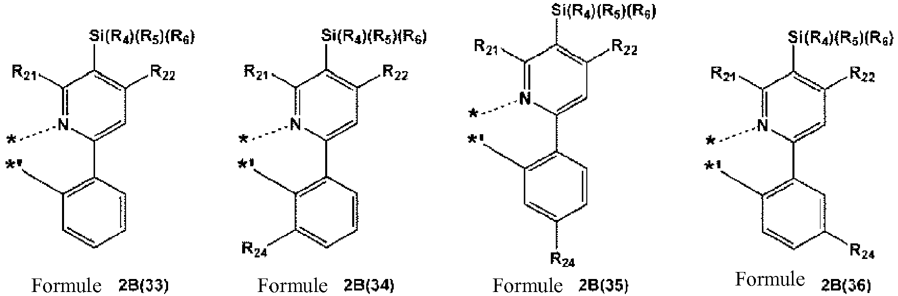 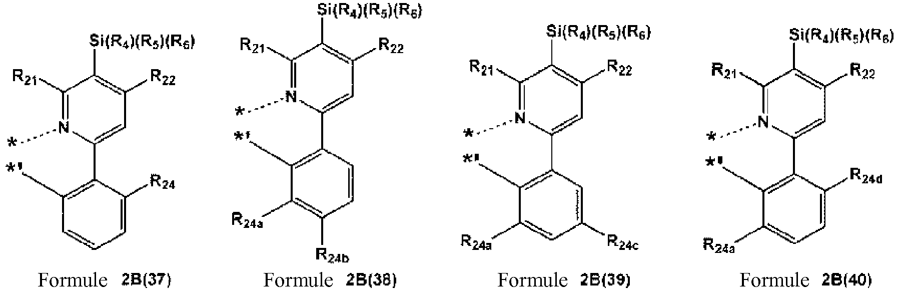 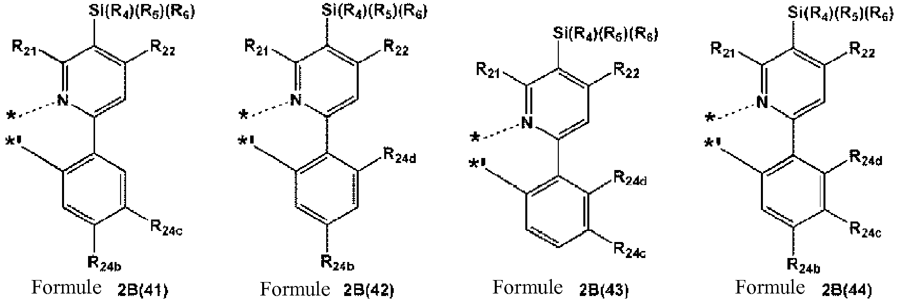 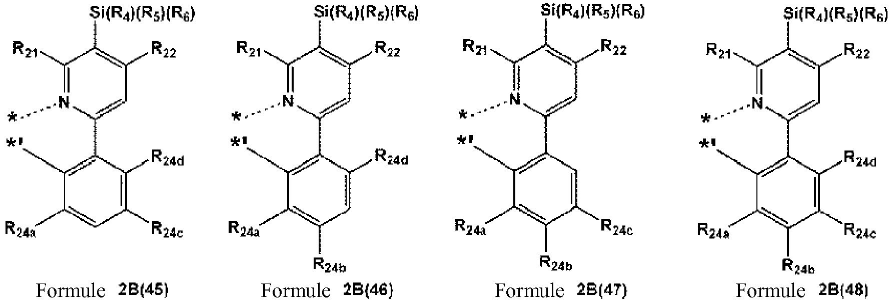 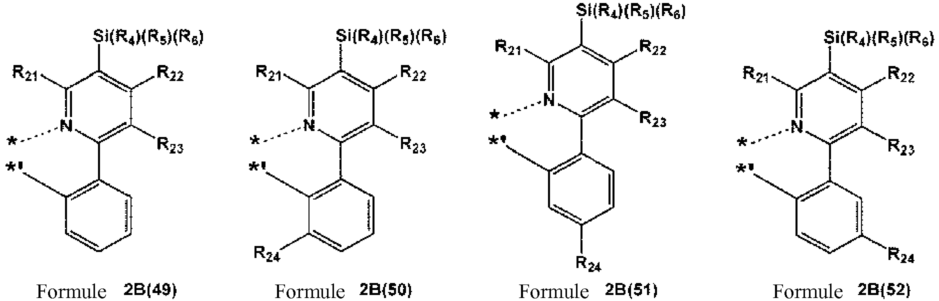 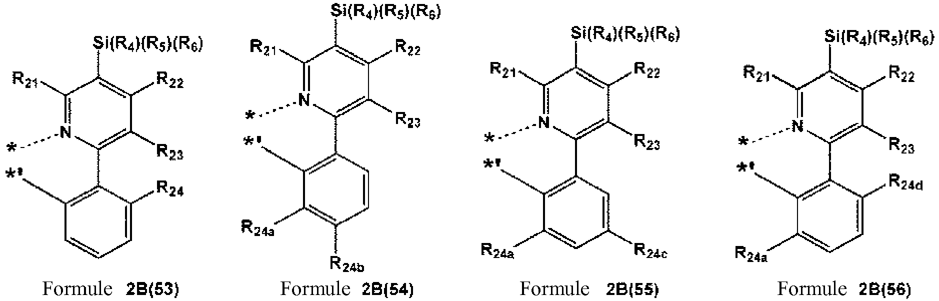 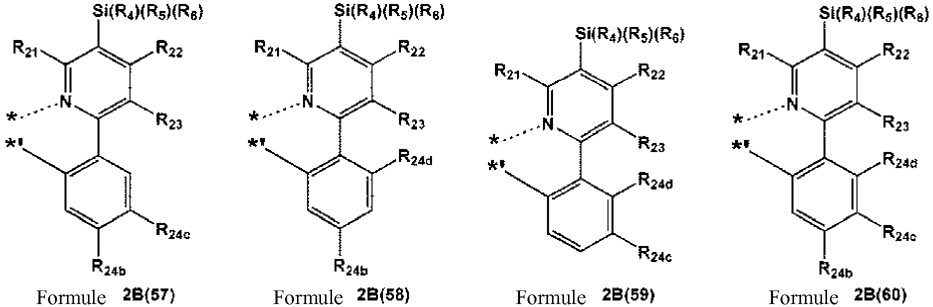 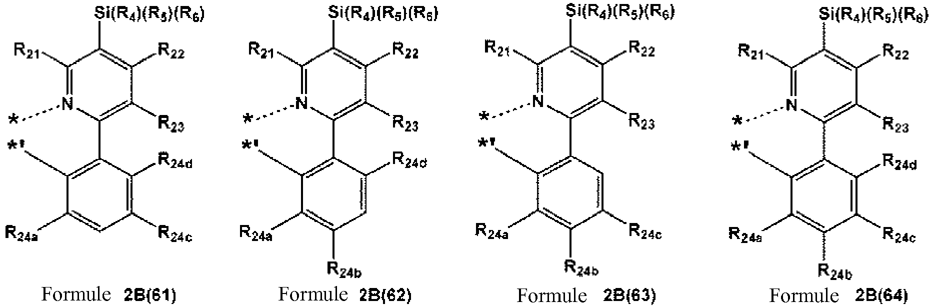 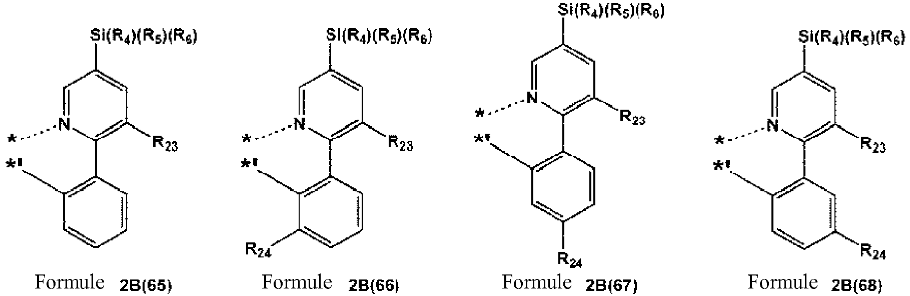 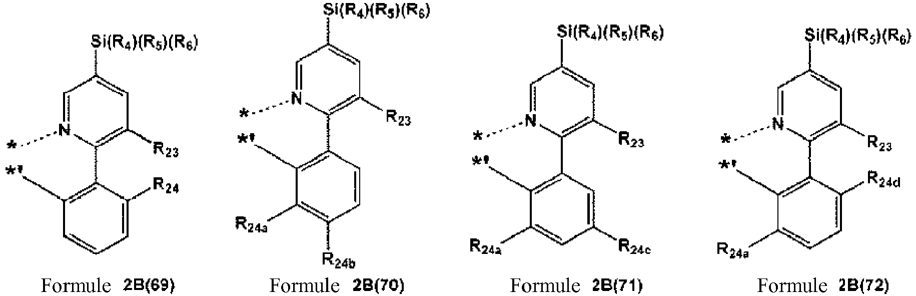 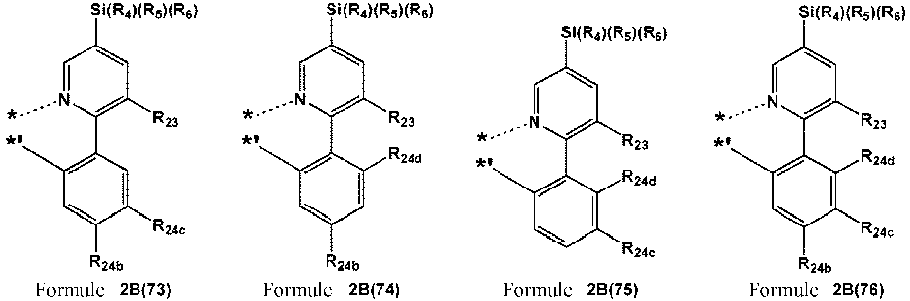 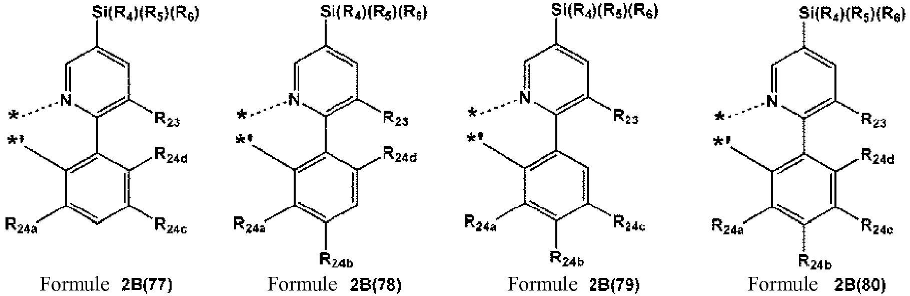 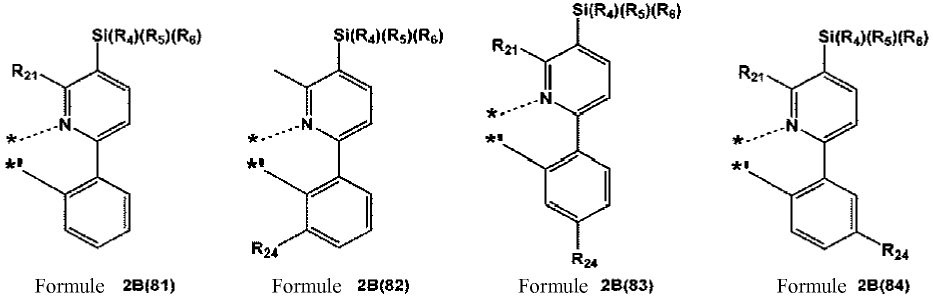 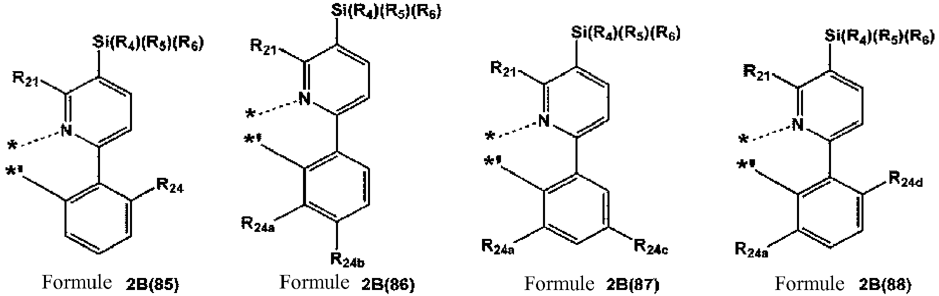 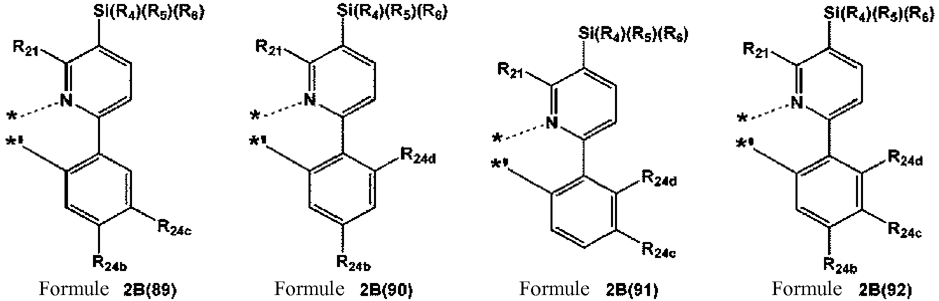 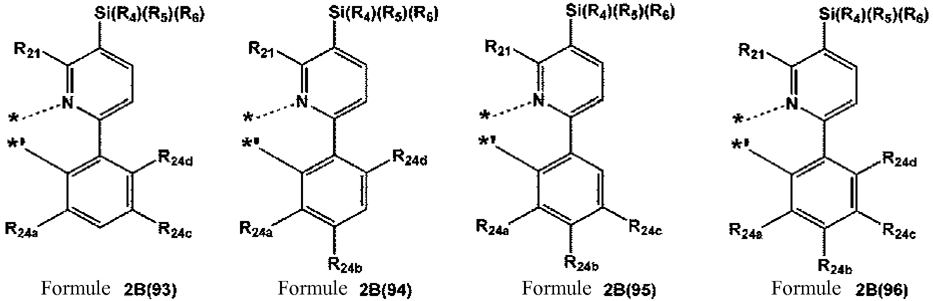 dans les Formules 2B(1) à 2B(96), R₂₁ à R₂₄ et R₄ à R₆ sont les mêmes que dans la revendication 1, R₂₄ₐ à R_{24d} sont les mêmes que R₂₄ dans la revendication 1, et chacun de * et *' indique un site de liaison à M dans la Formule 1, à condition que tous les R₂₁ à R₂₄ et R₂₄ₐ à R_{24d} ne soient pas simultanément un hydrogène.

10. Composé organométallique selon la revendication 9, dans lequel L₂ est sélectionné parmi des ligands représentés par les Formules 2B(1) à 2B(48) et 2B(65) à 2B(80), et dans les Formules 2B(1) à 2B(48) et 2B(65) à 2(80), R₄ à R₆ sont chacun indépendamment sélectionnés parmi -CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, et -CD₂CDH₂ ;
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle, et un groupe naphtyle ;
et un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle, et un groupe naphtyle, chacun substitué avec au moins un sélectionné parmi un deutérium, un groupe alkyle en C₁ à C₁₀, et un phényle, tous les R₄ à R₆ sont les mêmes ; ou R₄ et R₆ sont identiques l'un à l'autre, et R₅ est différent de R₄, et R₂₁ à R₂₄ et R₂₄ₐ à R_{24d} sont chacun indépendamment sélectionnés parmi un deutérium, -F, un groupe cyano, un groupe nitro, -SF₅, -CH₃, -CD₃, -CD₂H, -CDH₂, -CF₃, -CF₂H, -CFH₂, des groupes représentés par les Formules 9-1 à 9-19, et des groupes représentés par les Formules 10-1 à 10-36 : 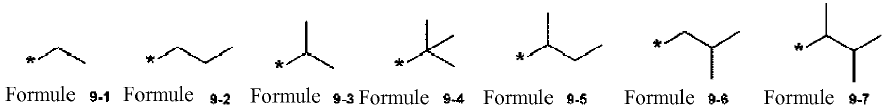 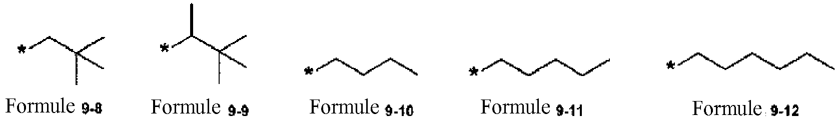 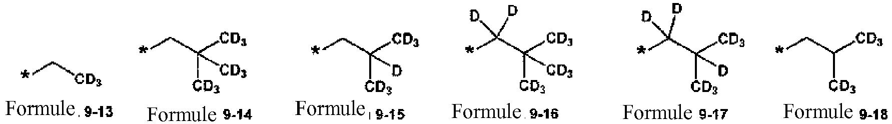 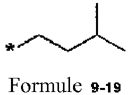 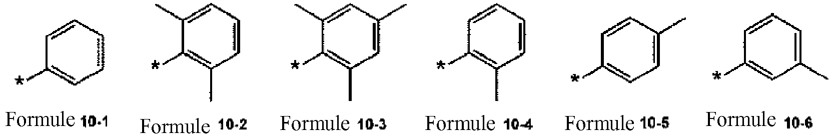 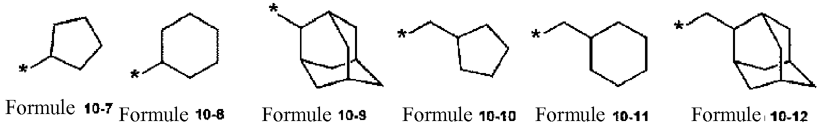 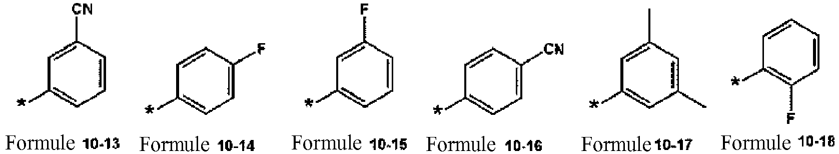 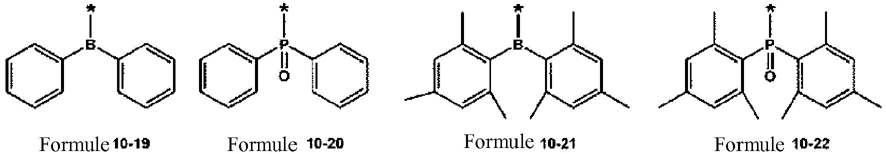 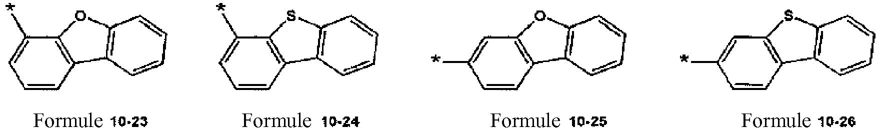 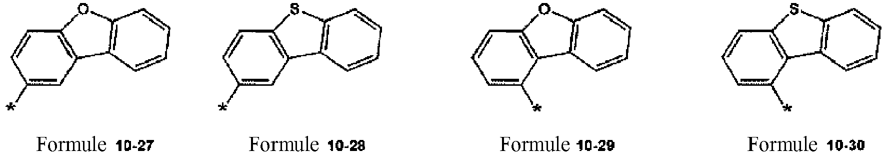 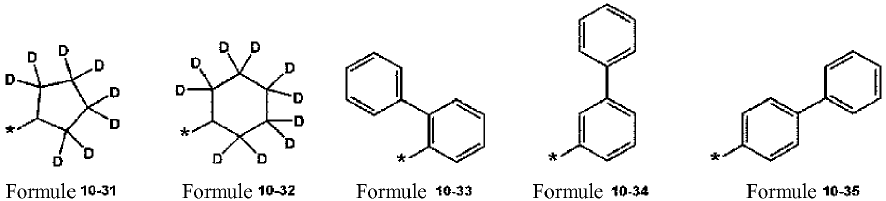 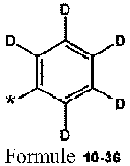 * dans les Formules 9-1 à 9-19 et 10-1 à 10-36 indique un site de liaison à un atome voisin.

11. Composé organométallique selon la revendication 1, dans lequel le composé organométallique est l'un des Composés 1 à 292 :

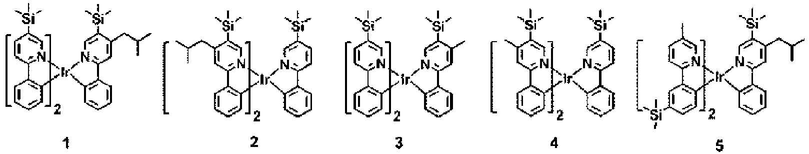

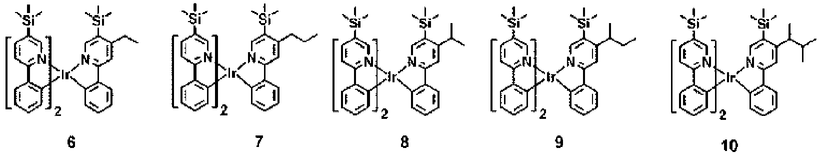

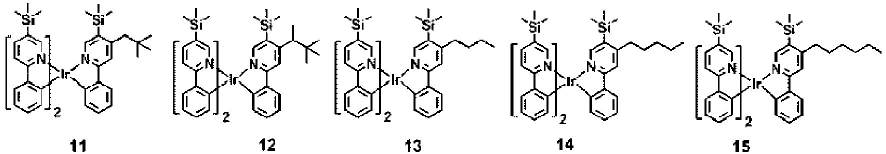

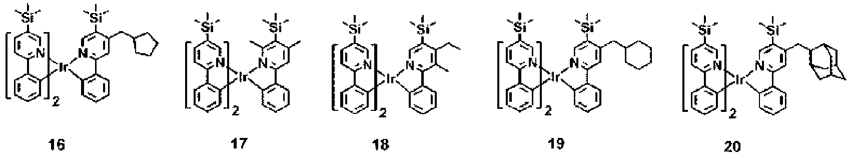

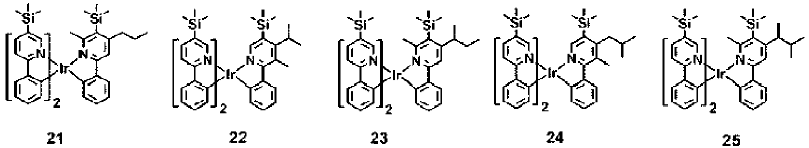

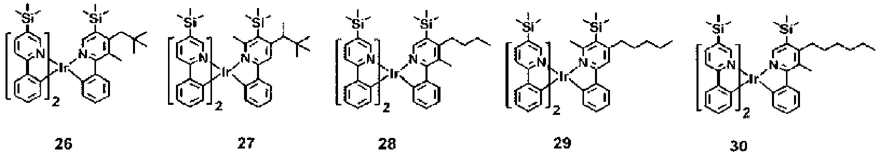

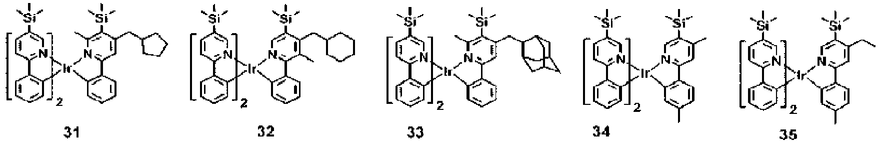

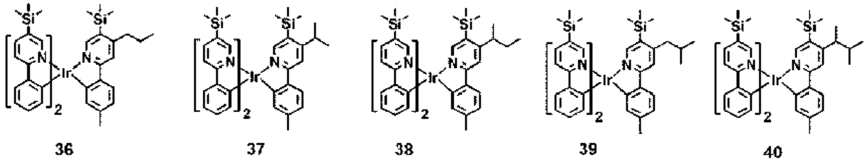

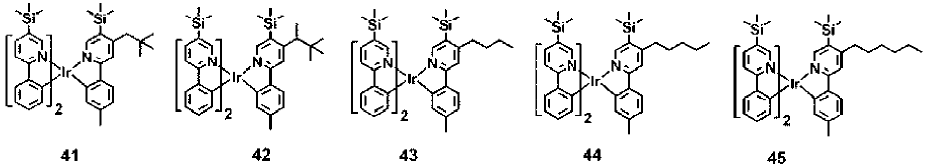

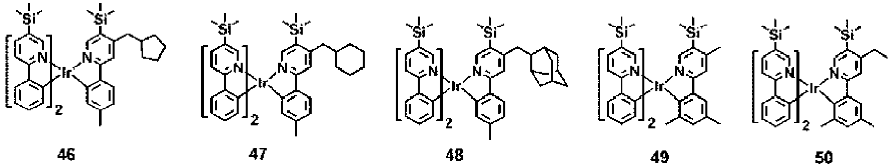

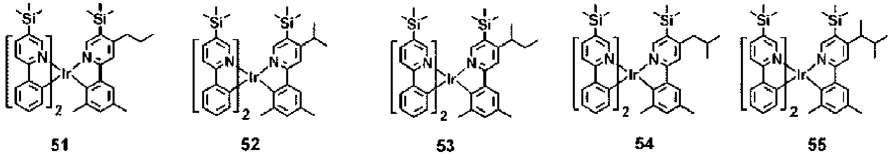

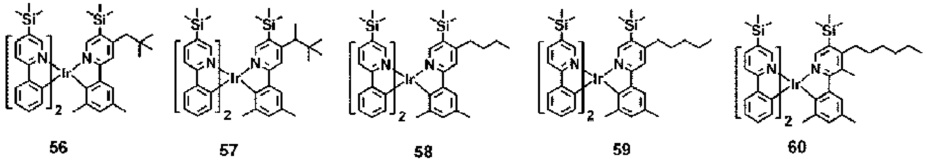

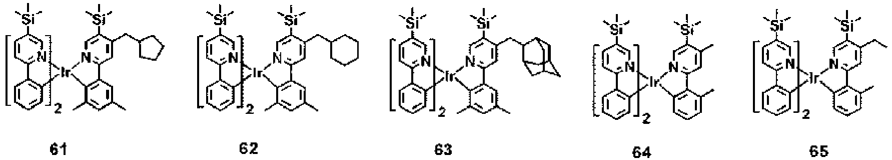

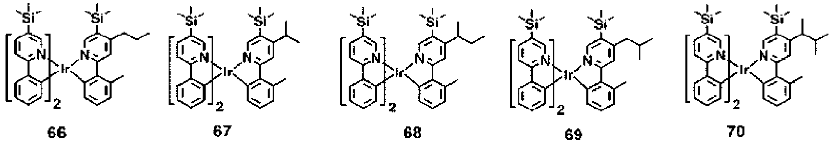

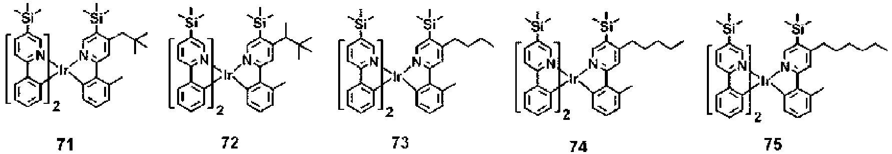

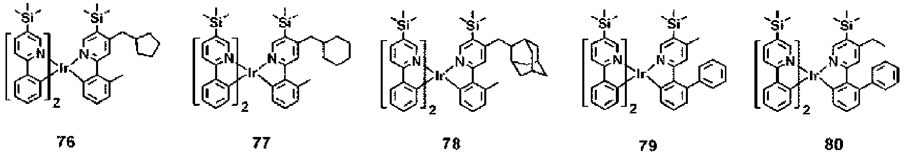

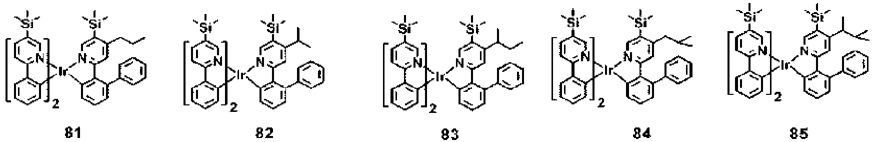

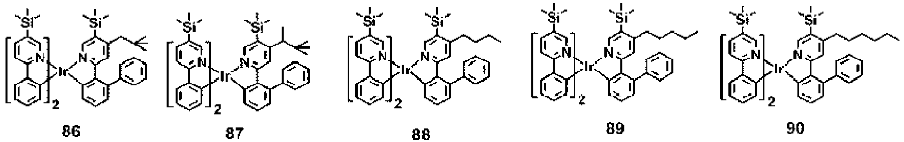

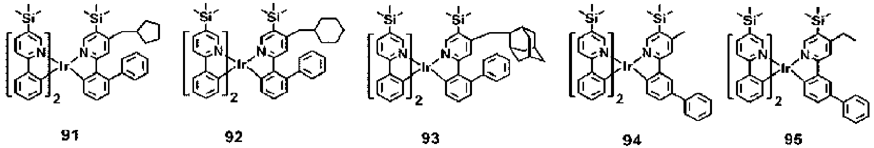

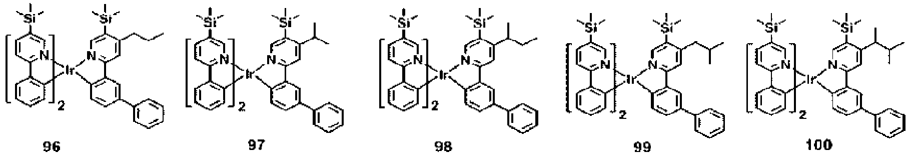

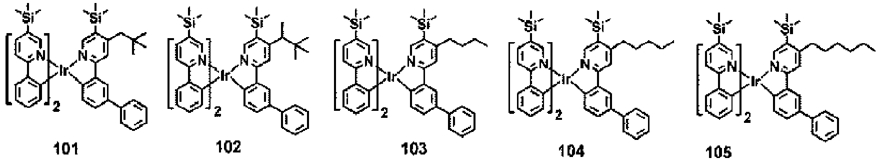

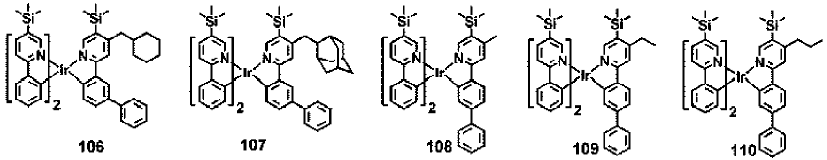

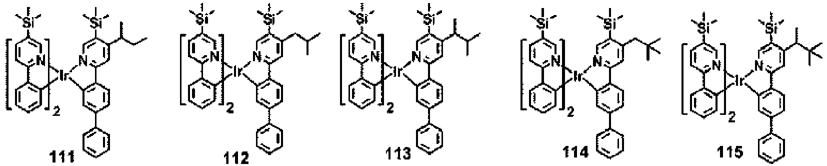

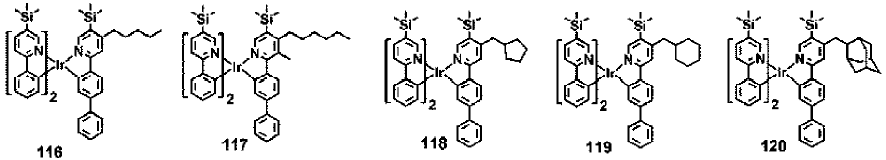

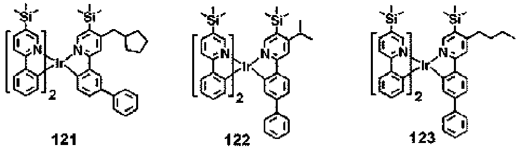

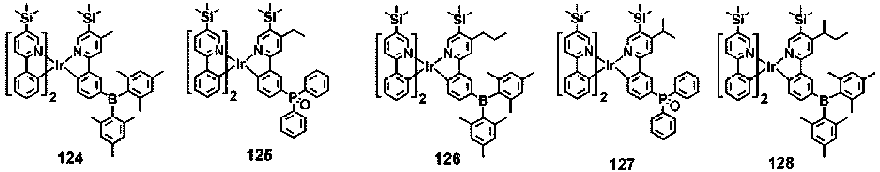

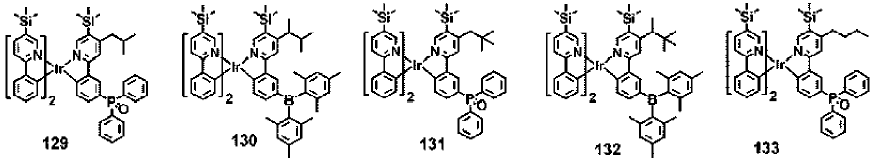

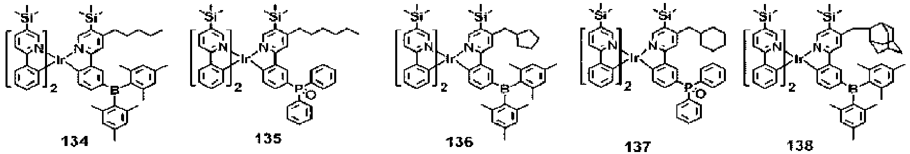

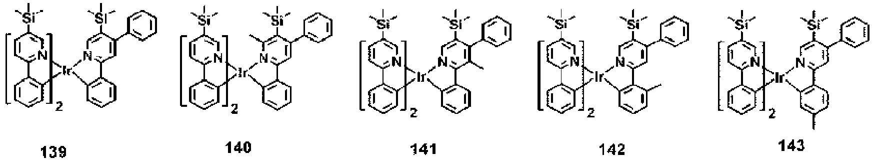

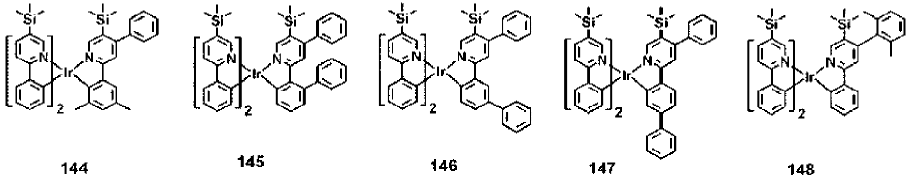

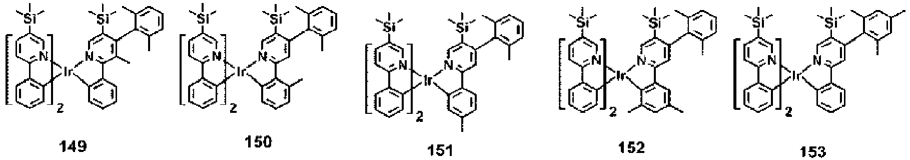

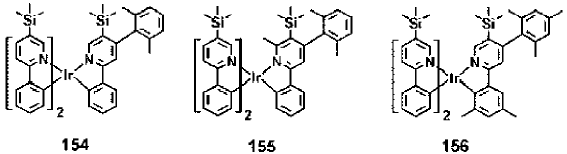

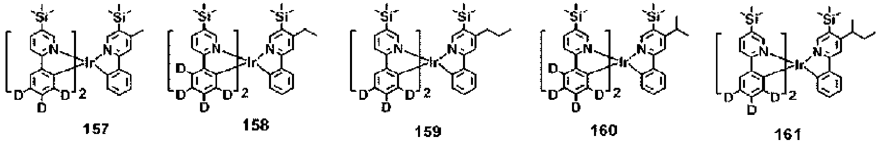

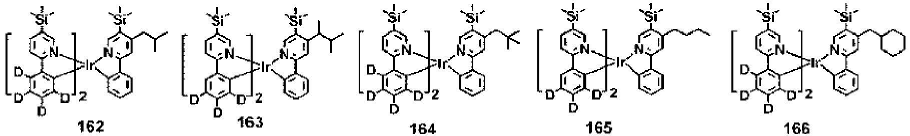

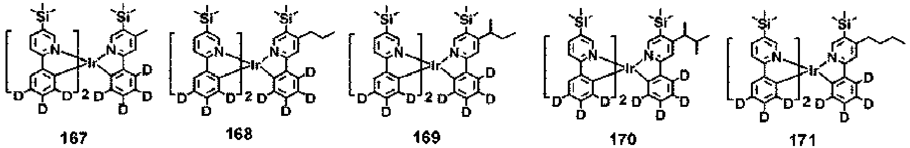

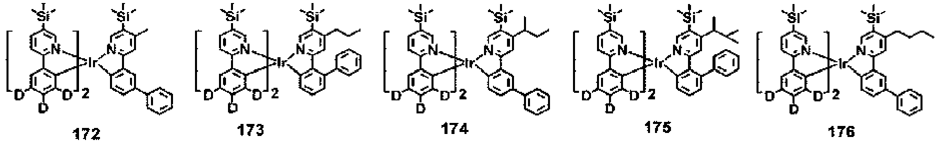

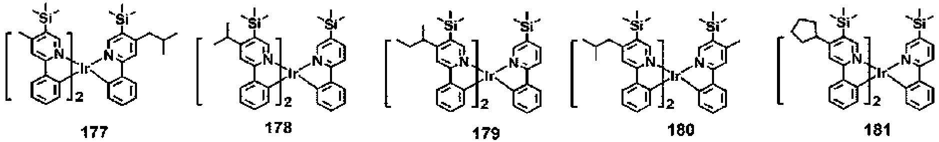

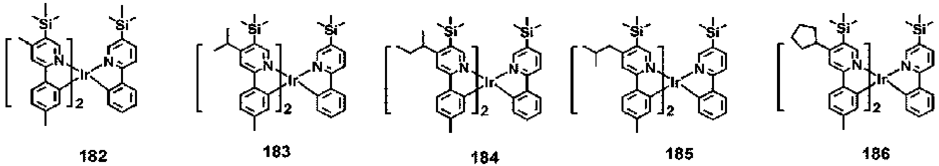

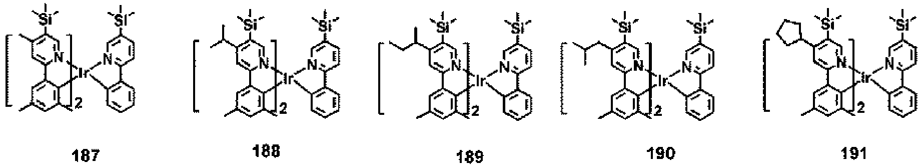

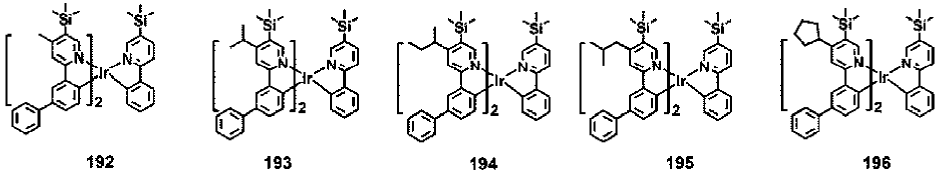

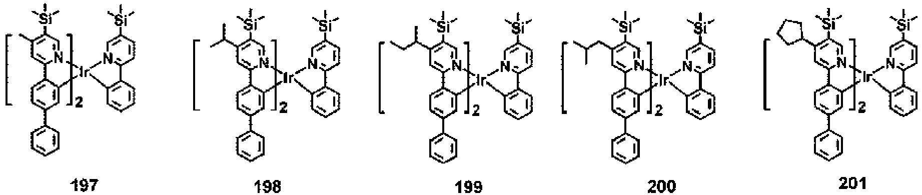

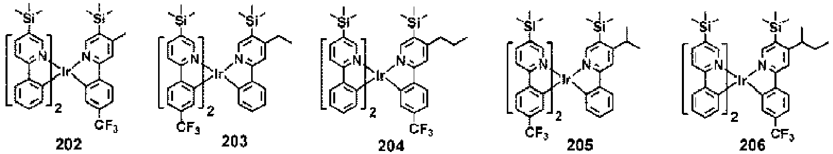

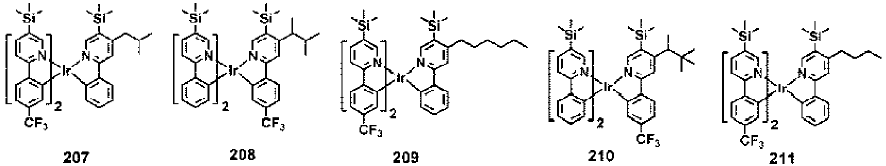

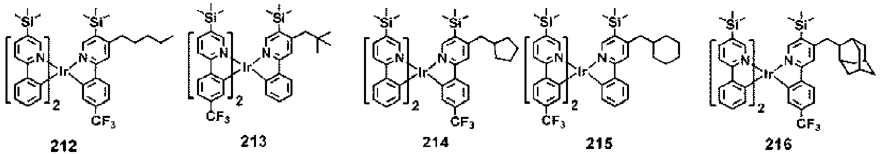

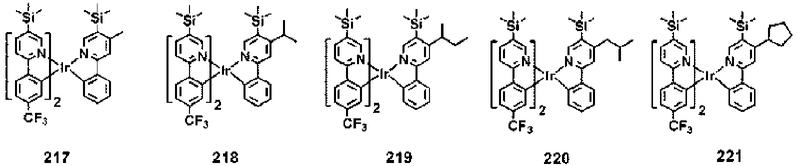

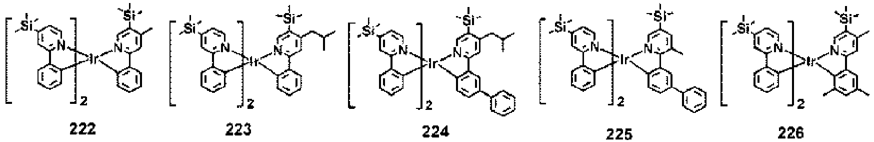

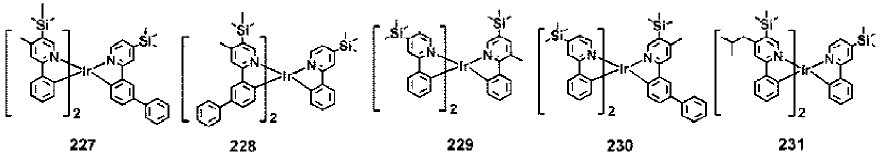

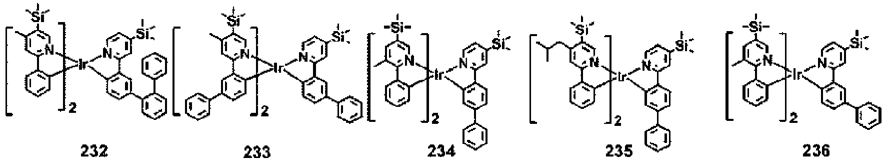

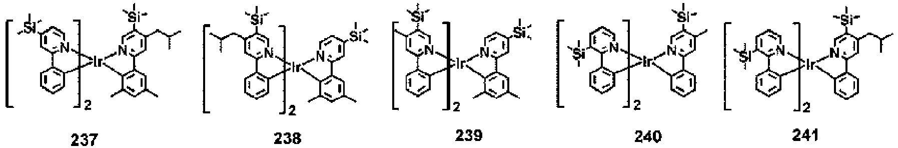

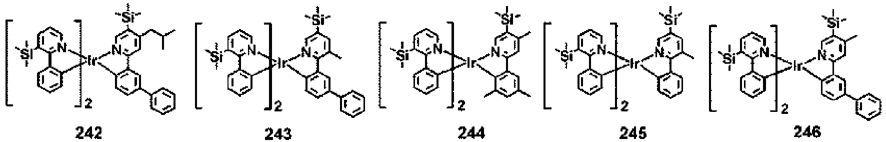

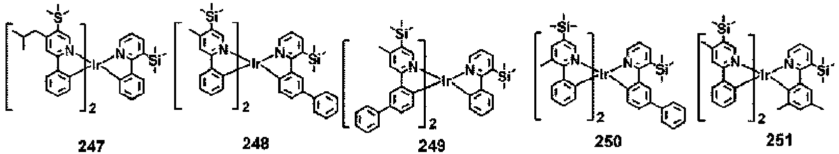

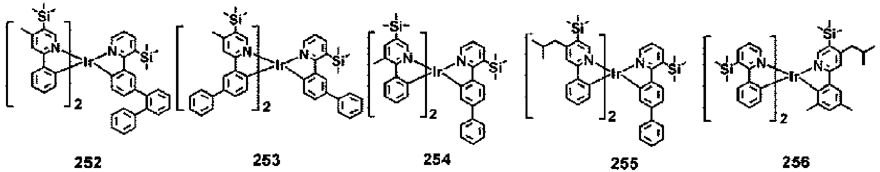

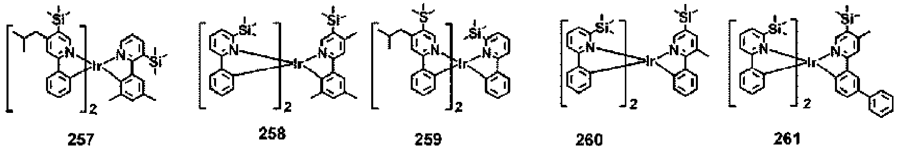

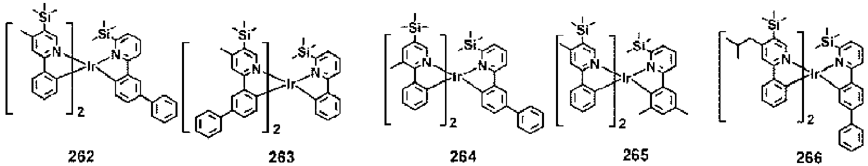

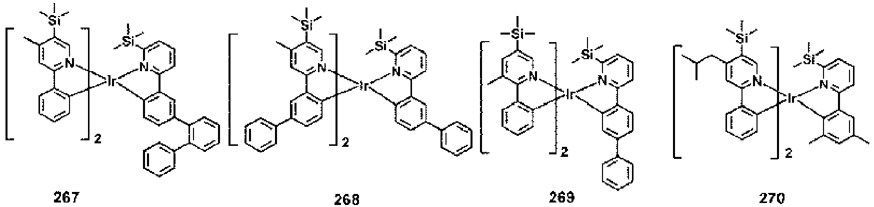

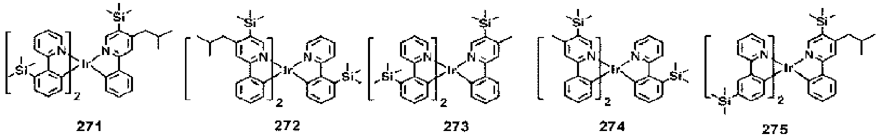

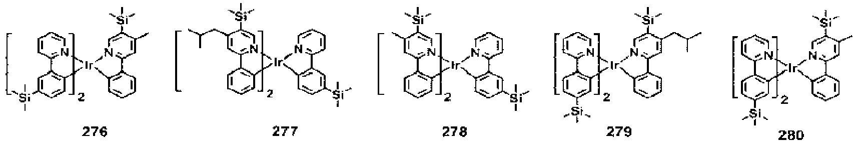

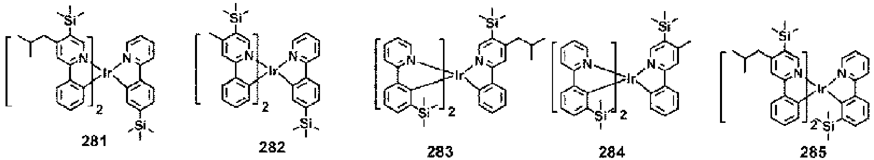

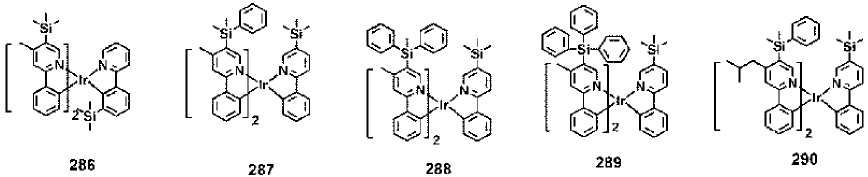

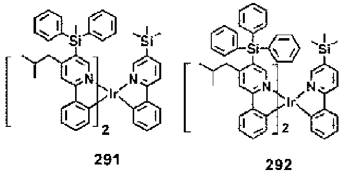

12. Dispositif émetteur de lumière organique comprenant :
une première électrode, une deuxième électrode, et une couche organique disposée entre la première électrode et la deuxième électrode, dans lequel la couche organique comprend une couche d'émission et au moins un composé organométallique selon l'une quelconque des revendications 1 à 11.

13. Dispositif émetteur de lumière organique selon la revendication 12, dans lequel la première électrode est une anode, la deuxième électrode est une cathode, et la couche organique comprend
i) une région de transport de trous disposée entre la première électrode et la couche d'émission, dans lequel la région de transport de trous comprend au moins une couche parmi une couche d'injection de trous, une couche de transport de trous, et une couche de blocage d'électrons, et
ii) une région de transport d'électrons disposée entre la couche d'émission et la deuxième électrode, dans lequel la région de transport d'électrons comprend au moins une couche parmi une couche de blocage de trous, une couche de transport d'électrons, et une couche d'injection d'électrons.

14. Dispositif émetteur de lumière organique selon la revendication 12 ou 13, dans lequel la couche d'émission comprend le composé organométallique.

15. Dispositif émetteur de lumière organique selon la revendication 14, dans lequel le composé organométallique agit comme un dopant et la couche d'émission comprend en outre un hôte.
